(19) Europäisches Patentamt / European Patent Office / Office européen des brevets

(11) EP 4 610 126 A1

(12) EUROPEAN PATENT APPLICATION
published in accordance with Art. 153(4) EPC

(43) Date of publication:
**03.09.2025 Bulletin 2025/36**

(21) Application number: **23882595.4**

(22) Date of filing: **23.10.2023**

(51) International Patent Classification (IPC):
***B60W 30/02*** *(2012.01)*

(52) Cooperative Patent Classification (CPC):
**B60G 3/00; B60L 15/20; B60W 10/08; B60W 10/22; B60W 30/02; B60W 30/08; B60W 30/09; B60W 30/095; B60W 40/00; B60W 40/02; B60W 40/04; B60W 40/06; B60W 50/14; B60W 60/00; B62D 7/15;** (Cont.)

(86) International application number:
**PCT/JP2023/038227**

(87) International publication number:
**WO 2024/090390 (02.05.2024 Gazette 2024/18)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority:
**24.10.2022 JP 2022170165**
**27.10.2022 JP 2022172777**
**01.11.2022 JP 2022175679**
**01.11.2022 JP 2022175698**
**11.11.2022 JP 2022181362**
**14.11.2022 JP 2022182131**
**21.11.2022 JP 2022186040**
**24.11.2022 JP 2022187648**
**24.11.2022 JP 2022187649**
**28.11.2022 JP 2022189546**
**26.12.2022 JP 2022209070**
**04.01.2023 JP 2023000321**
**09.03.2023 JP 2023036967**
**09.03.2023 JP 2023036968**
**09.03.2023 JP 2023036969**
**09.03.2023 JP 2023036972**
**09.03.2023 JP 2023036973**
**09.03.2023 JP 2023036974**
**09.03.2023 JP 2023036976**
**09.03.2023 JP 2023036977**
**31.03.2023 JP 2023059411**
**18.04.2023 JP 2023068062**
**20.04.2023 JP 2023069618**
**21.04.2023 JP 2023070394**
**28.04.2023 JP 2023075259**
**02.05.2023 JP 2023076253**
**02.05.2023 JP 2023076261**
**08.05.2023 JP 2023076943**
**08.05.2023 JP 2023076944**
**15.05.2023 JP 2023080353**
**19.05.2023 JP 2023083452**
**22.05.2023 JP 2023084121**
**23.05.2023 JP 2023084860**
**26.06.2023 JP 2023104424**

(71) Applicant: **SoftBank Group Corp.**
**Tokyo 105-7537 (JP)**

(72) Inventor: **SON, Masayoshi**
**Tokyo 105-7537 (JP)**

(74) Representative: **DREISS Patentanwälte PartG mbB**
**Friedrichstraße 6**
**70174 Stuttgart (DE)**

# (54) INFORMATION PROCESSING DEVICE, VEHICLE, INFORMATION PROCESSING METHOD, AND INFORMATION PROCESSING PROGRAM

(57) An information processing apparatus includes: a first processor that outputs point information that represents an imaged object as a point in an image of the object captured by a first camera; and a second processor that outputs identification information obtained by identifying the imaged object in an image of the object captured by a second camera oriented in a direction corresponding to a direction in which the first camera is oriented.



Processed by Luminess, 75001 PARIS (FR)

(Cont. next page)

FIG.1

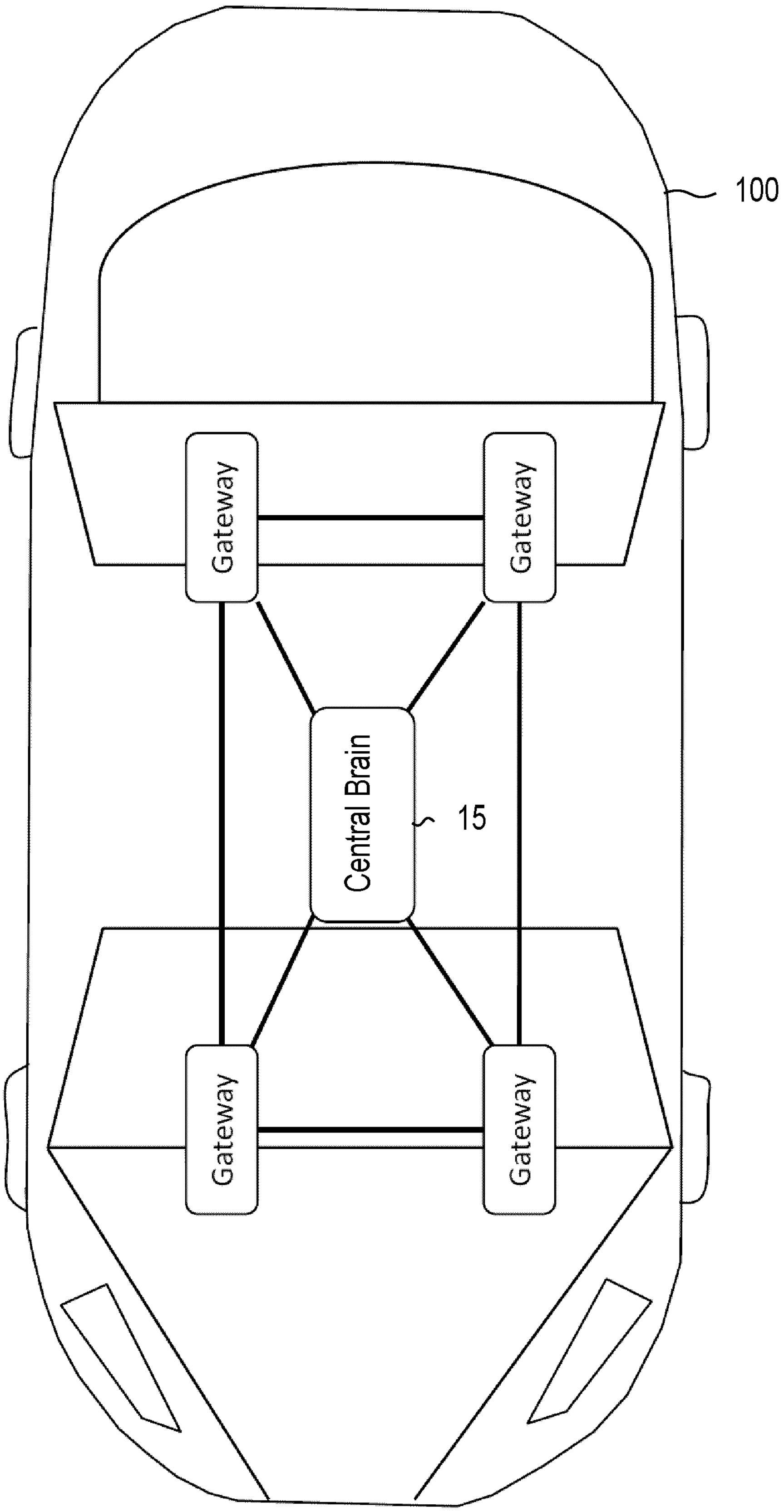


(52) Cooperative Patent Classification (CPC): (Cont.)
**G01B 11/00; G01C 3/06; G01C 21/34; G01P 13/00; G05D 1/43; G06T 7/00; G06T 7/174; G06T 7/20; G06T 7/215; G06T 7/593; G06T 7/70; G06V 10/80; G06V 10/94; G06V 20/58;**



**(Cont. next page)**

G08G 1/09; G08G 1/0968; G08G 1/16;
H01L 23/473; H04N 7/18; H04N 23/45;
H04N 23/60; H04N 23/61; H04N 23/66; H05K 7/20

## Description

Technical Field

The present disclosure relates to an information processing apparatus, a vehicle, an information processing method, and an information processing program.

Background Art

Japanese Patent Application Laid-Open (JP-A) No. 2022-035198 describes a vehicle having an autonomous driving function.

SUMMARY OF INVENTION

Technical Problem

Meanwhile, in the case of performing autonomous driving of a vehicle as described in JP-A No. 2022-035198, the autonomous driving is controlled using a plurality of images obtained by imaging surroundings of the vehicle by a camera. Therefore, in the autonomous driving according to the related art, there is a problem that the amount of data acquired by a processor that controls the autonomous driving increases, and the amount of computation required for the control of the autonomous driving increases.

Therefore, an object of the present disclosure is to provide an information processing apparatus, a vehicle, an information processing method, and an information processing program capable of reducing the amount of data output to a predetermined output destination in the case of outputting imaging information of an object imaged by a camera to the output destination. Solution to Problem

An information processing apparatus according to a first aspect includes: a first processor that outputs point information that represents an imaged object as a point in an image of the object captured by a first camera; and a second processor that outputs identification information obtained by identifying the imaged object in an image of the object captured by a second camera oriented in a direction corresponding to a direction in which the first camera is oriented.

According to a second aspect, the information processing apparatus according to the first aspect further includes a third processor that associates the point information output from the first processor with the identification information output from the second processor.

According to a third aspect, in the information processing apparatus according to the first or second aspect, a frame rate of the first camera is variable, and the first processor changes the frame rate of the first camera according to a predetermined factor.

According to a fourth aspect, in the information processing apparatus according to the third aspect, the first processor calculates a score for an external environment for a predetermined target.

According to a fifth aspect, in the information processing apparatus according to the fourth aspect, the first processor changes the frame rate of the first camera according to the calculated score for the external environment.

According to a sixth aspect, in the information processing apparatus according to any one of the first to fifth aspects, the first processor outputs coordinate values of a point indicating an existence position of the imaged object in the image of the object captured by the first camera on at least two coordinate axes in a three-dimensional orthogonal coordinate system, and the information processing apparatus further includes a third processor that associates the point information output from the first processor with the identification information output from the second processor.

According to a seventh aspect, in the information processing apparatus according to the sixth aspect, the first processor outputs coordinate values of at least two diagonal points at vertices of a polygon surrounding a contour of the object recognized from the image captured by the first camera.

According to an eighth aspect, in the information processing apparatus according to the seventh aspect, the first processor outputs coordinate values of a plurality of vertices of the polygon surrounding the contour of the object recognized from the image captured by the first camera.

According to a ninth aspect, the information processing apparatus according to any one of the first to eighth aspects further includes a third processor that associates the point information output from the first processor with the identification information output from the second processor, and controls autonomous driving of a movable body based on the point information and the identification information.

According to a tenth aspect, in the information processing apparatus according to the ninth aspect, the third processor calculates a control variable for controlling the autonomous driving of the movable body based on detection information detected by a detection unit, and controls the autonomous driving of the movable body based on the calculated control variable, the point information, and the identification information.

According to an eleventh aspect, in the information processing apparatus according to any one of the first to tenth aspects, the first processor outputs the point information based on at least one of a visible light image and an infrared image of the object captured by the first camera, and the information processing apparatus further includes a third processor that associates the point information output from the first processor with the identification information output from the second processor.

According to a twelfth aspect, in the information processing apparatus according to the eleventh aspect, the first processor outputs the point information based on the infrared image of the object captured by an infrared camera included in the first camera in a case where the object is not identified from the visible light image of the object captured by a visible light camera included in the first camera due to a predetermined factor.

According to a thirteenth aspect, in the information processing apparatus according to the twelfth aspect, the first processor synchronizes a timing at which the visible light camera captures the visible light image with a timing at which the infrared camera captures the infrared image.

According to a fourteenth aspect, in the information processing apparatus according to any one of the first to thirteenth aspects, the first processor outputs the point information obtained from the image of the object captured by the first camera and a radar signal based on a reflected wave of an electromagnetic wave emitted to the object by a radar from the object, and the information processing apparatus further includes a third processor that associates the point information output from the first processor with the identification information output from the second processor.

According to a fifteenth aspect, in the information processing apparatus according to the fourteenth aspect, the first processor synchronizes a timing at which the first camera captures the image with a timing at which the radar acquires three-dimensional point cloud data of the object based on the radar signal.

According to a sixteenth aspect, in the information processing apparatus according to the fourteenth or fifteenth aspect, the number of images per unit time captured by the first camera and the number of pieces of three-dimensional point cloud data per unit time acquired by the radar are larger than the number of images per unit time captured by the second camera.

According to a seventeenth aspect, in the information processing apparatus according to any one of the first to sixteenth aspects, the second processor outputs label information indicating a type of the imaged object in the image of the object captured by the second camera, and the information processing apparatus further includes a third processor that associates the point information output from the first processor with the label information output from the second processor.

According to an eighteenth aspect, in the information processing apparatus according to the seventeenth aspect, the third processor associates position information of the object indicated by the point information with the label information for the object present at a position indicated by the position information.

According to a nineteenth aspect, in the information processing apparatus according to the eighteenth aspect, the third processor associates the point information output from the first processor with the label information at the same timing as a timing at which the second processor outputs the label information.

According to a twentieth aspect, in the information processing apparatus according to the eighteenth or nineteenth aspect, the third processor associates new point information with the label information in a case where the new point information is output from the first processor after the point information and the label information are associated with each other.

According to a twenty-first aspect, the information processing apparatus according to any one of the first to twentieth aspects further includes a third processor that associates the point information output from the first processor with the identification information output from the second processor, in which the first processor derives, as the point information, a coordinate value of a point indicating an existence position of the object in a depth direction of the object in a three-dimensional orthogonal coordinate system from the image of the object captured by the first camera.

According to a twenty-second aspect, in the information processing apparatus according to the twenty-first aspect, the first processor derives, as the point information, a coordinate value in the depth direction from images of the object captured by a plurality of the first cameras.

According to a twenty-third aspect, in the information processing apparatus according to the twenty-first or twenty-second aspect, the first processor derives, as the point information, coordinate values in a width direction, a height direction, and the depth direction of the object from the image of the object captured by the first camera and a radar signal based on a reflected wave of an electromagnetic wave emitted to the object by a radar from the object.

According to a twenty-fourth aspect, in the information processing apparatus according to any one of the twenty-first to twenty-third aspects, the first processor derives, as the point information, coordinate values in a width direction, a height direction, and the depth direction of the object from the image of the object captured by the first camera and a result of imaging structured light emitted to the object by an irradiation device.

According to a twenty-fifth aspect, in the information processing apparatus according to any one of the twenty-first to twenty-fourth aspects, the first processor derives, as the point information, a coordinate value in the depth direction at a second time point from coordinate values in a width direction, a height direction, and the depth direction of the object in the three-dimensional orthogonal coordinate system at a first time point and coordinate values in the width direction and the height direction at the second time point which is a time point next to the first time point.

According to a twenty-sixth aspect, the information processing apparatus according to the first aspect further includes a third processor that associates the point information output from the first processor with the identification information output from the second processor, in which the third processor derives, as the point information, a coordinate value of a point indicating an existence position of the object in a depth direction of the object in a three-dimensional orthogonal coordinate system from the image of the object captured by the first camera.

According to a twenty-seventh aspect, in the information processing apparatus according to any one of the first to twenty-sixth aspects, the first processor outputs the point information based on an image of the object captured by an event camera, the second processor outputs the identification information based on the image of the object captured by the second camera oriented in a direction corresponding to a direction in which the event camera is oriented, and the information processing apparatus further includes a third processor that associates the point information output from the first processor with the identification information output from the second processor.

According to a twenty-eighth aspect, in the information processing apparatus according to the twenty-seventh aspect, the first processor outputs the point information based on the image of the object captured by the event camera in a case where the object is not identified from a visible light image of the object captured by a visible light camera due to a predetermined factor.

According to a twenty-ninth aspect, in the information processing apparatus according to the twenty-eighth aspect, the predetermined factor includes at least one of a case where a movement speed of the object is equal to or higher than a predetermined value and a case where a light quantity change of ambient light per unit time is equal to or larger than a predetermined value.

According to a thirtieth aspect, in the information processing apparatus according to any one of the twenty-seventh to twenty-ninth aspects, the event camera is a camera that outputs an event image representing a difference portion between an image captured at a current time and an image captured at a previous time.

According to a thirty-first aspect, in the information processing apparatus according to any one of the first to thirties aspects, the second processor outputs the captured image of the object at a first frame rate, the first processor outputs motion information indicating a motion of the imaged object at a second frame rate higher than the first frame rate, and the information processing apparatus further includes a third processor that performs vehicle driving control based on the image and the motion information.

According to a thirty-second aspect, in the information processing apparatus according to the thirty-first aspect, the second frame rate is 10 times or more the first frame rate.

According to a thirty-third aspect, in the information processing apparatus according to the thirty-first or thirty-second aspect, the second frame rate is 100 frames/second or higher.

According to a thirty-fourth aspect, in the information processing apparatus according to any one of the thirty-first to thirty-third aspects, the first processor outputs vector information of a motion of a point indicating an existence position of the object along a predetermined coordinate axis.

According to a thirty-fifth aspect, in the information processing apparatus according to the thirty-fourth aspect, vector information of a motion of the point indicating the existence position of the object along each of three coordinate axes in a three-dimensional orthogonal coordinate system is output by using two first processors.

According to a thirty-sixth aspect, in the information processing apparatus according to the thirty-fifth aspect, the third processor has a capability of processing a plurality of pieces of information in units of 1/1 billion seconds.

According to a thirty-seventh aspect, in the information processing apparatus according to the first aspect, only a point indicating an existence position of the object is extracted from an image of the object captured by a camera with a frame rate of 100 frames/second or higher, and vector information of a motion of the point indicating the existence position of the object along a predetermined coordinate axis is output from a processor.

According to a thirty-eighth aspect, in the information processing apparatus according to the thirty-fifth aspect, the first processor outputs the vector information for at least two diagonal points at vertices of a quadrangle surrounding a contour of the object.

According to a thirty-ninth aspect, in the information processing apparatus according to any one of the first to thirty-eighth aspects, the first processor extracts a point indicating an existence position of the object from the image of the object, and outputs motion information indicating a motion of the point indicating the existence position of the object along a predetermined coordinate axis at a frame rate of 1000 frames/second or higher.

According to a fortieth aspect, in the information processing apparatus according to the thirty-ninth aspect, the first processor outputs, as the motion information, vector information of a motion of a center point or a center-of-gravity point of the object along the predetermined coordinate axis.

According to a forty-first aspect, in the information processing apparatus according to the thirty-ninth or fortieth aspect, the first processor outputs, as the motion information, vector information of a motion along the predetermined coordinate axis for at least two diagonal points at vertices of a quadrangle surrounding a contour of the object.

According to a forty-second aspect, in the information processing apparatus according to any one of the thirty-ninth to forty-first aspects, the image includes an infrared image.

According to a forty-third aspect, in the information processing apparatus according to any one of the thirty-ninth to forty-second aspects, the image includes a visible light image and an infrared image synchronized with each other.

According to a forty-fourth aspect, in the information processing apparatus according to any one of the thirty-ninth to forty-third aspects, vector information of a motion of the point indicating the existence position of the object along each of three coordinate axes in a three-dimensional orthogonal coordinate system is output as the motion information by using two first processors.

According to a forty-fifth aspect, in the information processing apparatus according to any one of the thirty-ninth to forty-fourth aspects, the first processor derives a distance to the object based on a reflected wave of an electromagnetic wave emitted to the object from the object, and outputs, as the motion information, vector information of a motion of the point indicating the existence position of the object along each of three coordinate axes in a three-dimensional orthogonal coordinate system.

According to a forty-sixth aspect, the information processing apparatus according to any one of the thirty-ninth to forty-fifth aspects further includes: the second processor that outputs the image of the object at a frame rate of lower than 1000 frames/second; and a third processor that performs response control for the object based on the motion information and the image output from the second processor.

According to a forty-seventh aspect, in the information processing apparatus according to any one of the first to forty-sixth aspects, the first processor extracts a point indicating an existence position of the object from an image in which the object appears, and outputs the point indicating the existence position of the object.

According to a forty-eighth aspect, the information processing apparatus according to the forty-seventh aspect further includes a camera configured to change a frame rate, in which the first processor calculates a score for an external environment, determines the frame rate of the camera according to the score, outputs a control signal for instructing the camera to capture an image at the determined frame rate, and extracts the point indicating the existence position of the object from the image captured by the camera, and outputs the point indicating the existence position of the object.

According to a forty-ninth aspect, in the information processing apparatus according to the forty-eighth aspect, the information processing apparatus is mounted on a vehicle, and the first processor calculates a risk level for traveling of the vehicle as the score for the external environment, determines the frame rate of the camera according to the risk level, outputs a control signal for instructing the camera to capture the image at the determined frame rate, and extracts the point indicating the existence position of the object from the image captured by the camera, and outputs the point indicating the existence position of the object.

According to a fiftieth aspect, in the information processing apparatus according to any one of the forty-seventh to forty-ninth aspects, the first processor extracts the object from the image, and extracts, in a case where the existence position of the object is a predetermined region, the point indicating the existence position of the object and outputs the point indicating the existence position of the object.

According to a fifty-first aspect, in the information processing apparatus according to any one of the forty-seventh to fiftieth aspects, the first processor extracts the object from the image, calculates a score for each object, and extracts the point indicating the existence position of the object whose score is equal to or higher than a predetermined threshold, and outputs the point indicating the existence position of the object.

According to a fifty-second aspect, the information processing apparatus according to any one of the first to fifty-first aspects further includes: a first camera that has a first horizontal view angle; a second camera that has a second horizontal view angle wider than the first horizontal view angle; and an adjustment unit that adjusts an imaging direction of the first camera, in which the first processor controls the adjustment unit such that the imaging direction of the first camera is directed to the detected object in a case where a motion of the object in a blind spot of the first camera is detected in the image acquired by the second camera.

According to a fifty-third aspect, in the information processing apparatus according to the fifty-second aspect, the horizontal view angle of the second camera is 360°.

According to a fifty-fourth aspect, in the information processing apparatus according to the fifty-third aspect, an adjustment range of the imaging direction in a horizontal direction of the adjustment unit is a range within ±135° with respect to a reference direction.

According to a fifty-fifth aspect, in the information processing apparatus according to any one of the fifty-second to fifty-fourth aspects, the first camera has a higher resolution per unit view angle than the second camera.

According to a fifty-sixth aspect, in the information processing apparatus according to any one of the fifty-second to fifty-fifth aspects, the first processor acquires information regarding a distance to the object in the image by using the image acquired by the first camera and the image acquired by the second camera.

According to a fifty-seventh aspect, in the information processing apparatus according to any one of the first to fifty-sixth aspects, the information processing apparatus includes: the first processor that outputs motion information indicating a motion of an object extracted from an image; the second processor that outputs type information indicating a type of the object extracted from the image; a third processor that performs response control for the object based on the motion information and the type information; and an acquisition unit that acquires an image acquired by an external camera installed outside a movable body on which the own apparatus is mounted and position information of the external camera, in which the second processor outputs the type information indicating the type of the object extracted from the image acquired by the external camera in association with the position information of the external camera.

According to a fifty-eighth aspect, in the information processing apparatus according to the fifty-seventh aspect, in a case where the object extracted from the image acquired by the external camera is an object that affects traveling of the movable body, the second processor outputs the type information of the object while adding identification information indicating that the object is the object that affects the traveling.

According to a fifty-ninth aspect, in the information processing apparatus according to the fifty-eighth aspect, the object that affects the traveling of the movable body is a person or an animal.

According to a sixtieth aspect, in the information processing apparatus according to any one of the fifty-seventh to fifty-ninth aspects, the acquisition unit acquires the image and the position information from the external camera positioned in front of a traveling route of the movable body.

According to a sixty-first aspect, in the information processing apparatus according to the sixtieth aspect, the acquisition unit acquires the image and the position information only from the external camera closest to the own apparatus in front of the traveling route of the movable body.

According to a sixty-second aspect, in the information processing apparatus according to the sixtieth or sixty-first aspect, the acquisition unit specifies the external camera positioned in front of the traveling route of the movable body based on route information of a navigation system that guides the traveling route of the movable body.

According to a sixty-third aspect, in the information processing apparatus according to any one of the first to sixty-second aspects, the information processing apparatus includes: an imaging unit that sequentially moves a camera to a first position and a second position that is different from the first position at least in a horizontal direction, and causes the camera to capture an image at each of the first position and the second position; and a processing unit that calculates a three-dimensional position of an object appearing in each of a first image and a second image based on the first image captured at the first position and the second image captured at the second position.

According to a sixty-fourth aspect, in the information processing apparatus according to the sixty-third aspect, the imaging unit includes a moving unit that rotates a member to which the camera is attached such that the camera cyclically moves along an annular path passing through each of the first position and the second position.

According to a sixty-fifth aspect, in the information processing apparatus according to the sixty-fourth aspect, the processing unit calculates a score for an external environment, and determines a frame rate of the camera according to the calculated score, and the moving unit changes a rotation speed of the member according to the frame rate determined by the processing unit.

According to a sixty-sixth aspect, in the information processing apparatus according to any one of the sixty-third to sixty-fifth aspects, the processing unit corrects a deviation between two-dimensional positions of the object in the first image and the second image due to an imaging time difference between the first image and the second image, and calculates the three-dimensional position of the object.

According to a sixty-seventh aspect, in the information processing apparatus according to the sixty-sixth aspect, the processing unit corrects the deviation between the two-dimensional positions of the object by performing matching between a first image captured at the first position at a first time and a first image captured at the first position at a second time, and estimating a two-dimensional position of the object in a virtual first image obtained in a case where imaging is performed at the first position at a third time which is an imaging time at the second position based on a matching result.

According to a sixty-eighth aspect, the information processing apparatus according to any one of the first to sixty-seventh aspects further includes a third processor that associates the point information output from the first processor with the identification information output from the second processor, in which in a case where the image captured by the first camera is not clear, the third processor uses the image captured by the second camera as a substitute for the image captured by the first camera.

According to a sixty-ninth aspect, in the information processing apparatus according to the sixty-eighth aspect, in a case where the image captured by the first camera is not clear, the third processor executes processing of sharpening the image captured by the first camera.

According to a seventieth aspect, in the information processing apparatus according to any one of the first to sixty-ninth aspects, the second processor acquires position information of the image captured by the second camera by using an image of the object captured by another apparatus present in a vicinity of the own apparatus and position information of the object.

According to a seventy-first aspect, in the information processing apparatus according to the seventieth aspect, the second processor synchronizes a frame of the second camera with a frame of the image of the object from the another apparatus in consideration of a transmission time of the image of the object and the position information of the object from the another apparatus.

According to a seventy-second aspect, in the information processing apparatus according to any one of the first to seventy-first aspects, the first processor switches a first coordinate value or a second coordinate value of a point indicating an existence position of the imaged object in the image of the object captured by the first camera on at least two coordinate axes in a three-dimensional orthogonal coordinate system, the first coordinate value indicating an existence position of a center point or a center-of-gravity point of the object, and the second coordinate value indicating existence positions of at least two diagonal points at vertices of a polygon surrounding a contour of the object at a predetermined timing, and outputs the first coordinate value or the second coordinate value.

According to a seventy-third aspect, in the information processing apparatus according to the seventy-second aspect, the first processor switches a coordinate value to be output from the first coordinate value to the second coordinate value in a case where the imaged object is not identified by the second processor from the image of the object captured by the second camera due to a predetermined factor.

According to a seventy-fourth aspect, in the information processing apparatus according to the seventy-second or seventy-third aspect, the first processor switches a coordinate value to be output from the second coordinate value to the first coordinate value in a case where a movement speed of the object is equal to or lower than a predetermined threshold or in a case where a movement direction of the object is a predetermined direction.

According to a seventy-fifth aspect, the information processing apparatus according to any one of the seventy-second to seventy-fourth aspects further includes a third processor that associates the first coordinate value or the second coordinate value output from the first processor with the identification information output from the second processor.

According to a seventy-sixth aspect, in the information processing apparatus according to any one of the first to seventy-fifth aspects, the first processor stops the output of the point information for the object in a case where it is determined that a possibility that the object present in a passage through which a movable body passes comes into contact with the movable body is low.

According to a seventy-seventh aspect, in the information processing apparatus according to the seventy-sixth aspect, the first processor determines that a possibility that the object comes into contact with the movable body is low in a case where the object is not present on a movement route of the movable body in the passage and the object moves away from the movement route.

According to a seventy-eighth aspect, in the information processing apparatus according to any one of the first to seventy-seventh aspects, the first processor outputs the point information based on the image of the object captured by the first camera, and calculates and outputs motion information indicating a motion of a point from a time series of the point information, the information processing apparatus further includes a third processor that associates the motion information output from the first processor with the identification information output from the second processor, and in a case where pieces of motion information of a plurality of objects whose directions of motions correspond to each other are detected, the third processor removes the pieces of motion information of the plurality of objects and associates remaining motion information with the identification information.

According to a seventy-ninth aspect, in the information processing apparatus according to the seventy-eighth aspect, the first processor calculates a direction of the motion of the point from the time series of the point information by using Hough transform, and calculates a speed of the motion from a change in point information of the calculated direction of the motion of the point.

According to an eightieth aspect, in the information processing apparatus according to the seventy-eighth or seventy-ninth aspect, the third processor associates the motion information output from the first processor with the identification information output from the second processor, and controls autonomous driving of a movable body based on the motion information and the identification information.

According to an eighty-first aspect, in the information processing apparatus according to any one of the first to eightieth aspects, information processing apparatus includes at least one processor, and the processor outputs the point information based on an image of the object captured by a camera, and outputs, in a case where a certain number or more of points whose movement direction is the same one side direction in an upward-downward direction and whose movement amount in the upward-downward direction is within a certain range have been detected based on the point information output based on images of a plurality of frames, only a point other than the detected certain number or more of points from among points included in the point information.

According to an eighty-second aspect, in the information processing apparatus according to the eighty-first aspect, in a case where a movable body in which the camera is provided is traveling straight, the processor further outputs a point whose movement amount in a left-right direction is equal to or larger than a threshold from among the detected certain number or more of points.

According to an eighty-third aspect, in the information processing apparatus according to any one of the first to eighty-second aspects, the information processing apparatus includes a first movable body processor used for a first movable body, in which the first movable body processor recognizes a type of a first object included in surroundings of the first movable body based on a first image obtained by imaging the surroundings of the first movable body, a second movable body processor used for a second movable body recognizes a type of a second object included in surroundings of the second movable body based on a second image obtained by imaging the surroundings of the second movable body, and in a case where the first movable body processor recognizes the second movable body as the type of the first object and the second movable body processor recognizes the first movable body as the type of the second object, the first movable body processor sets an identifier indicating that the first movable body has been recognized by the second movable body processor.

According to an eighty-fourth aspect, in the information processing apparatus according to the eighty-third aspect, the second movable body is a movable body configured to perform autonomous driving, and the first movable body processor sets the identifier in a case where the first movable body processor recognizes the second movable body as the type of the first object, the second movable body processor recognizes the first movable body as the type of the second object, and the second movable body is performing the autonomous driving.

According to an eighty-fifth aspect, in the information processing apparatus according to the eighty-third or eighty-fourth aspect, the first movable body and the second movable body are movable bodies configured to perform autonomous driving, and the first movable body processor controls the autonomous driving of the first movable body based on behavior of the second movable body in a case where the identifier is set and the second movable body is performing the autonomous driving.

According to an eighty-sixth aspect, in the information processing apparatus according to the eighty-fifth aspect, the second movable body processor controls the autonomous driving of the second movable body, and the first movable body processor acquires control information regarding control of the autonomous driving of the second movable body by the second movable body processor as information indicating the behavior, and controls the autonomous driving of the first movable body based on the control information.

According to an eighty-seventh aspect, in the information processing apparatus according to the eighty-sixth aspect, a first priority level is assigned to the first movable body, a second priority level is assigned to the second movable body, and the first movable body processor acquires the control information under a condition that the first priority level is higher than the second priority level.

According to an eighty-eighth aspect, in the information processing apparatus according to any one of the eighty-fifth to eighty-seventh aspects, the first movable body processor outputs first point information that represents the first object as a point based on a third image obtained by imaging the surroundings of the first movable body at a frame rate higher than a frame rate of the imaging performed to obtain the first image, associates second movable body information for specifying the second movable body recognized as the type of the first object by the first movable body processor with the first point information, and controls the autonomous driving of the first movable body based on the second movable body information and the first point information associated with each other.

According to an eighty-ninth aspect, in the information processing apparatus according to the eighty-eighth aspect, the first movable body processor includes a first processor, a second processor, and a third processor, the first processor outputs the first point information, the second processor recognizes the type of the first object based on the first image, and the third processor associates the second movable body information with the first point information, and controls the autonomous driving of the first movable body.

According to a ninetieth aspect, in the information processing apparatus according to any one of the eighty-third to eighty-ninth aspects, the second movable body is a movable body configured to perform autonomous driving, the second movable body processor outputs second point information that represents the second object as a point based on a fourth image obtained by imaging the surroundings of the second movable body at a frame rate higher than a frame rate of the imaging performed to obtain the second image, associates first movable body information for specifying the first movable body recognized as the type of the second object by the second movable body processor with the second point information, and executes control processing of controlling the autonomous driving of the second movable body based on the first movable body information and the second point information associated with each other, and the first movable body processor sets the identifier in a case where the first movable body processor recognizes the second movable body as the type of the first object, the second movable body processor recognizes the first movable body as the type of the second object, and the second movable body processor executes the control processing.

According to a ninety-first aspect, in the information processing apparatus according to any one of the eighty-fifth to ninetieth aspects, the first movable body processor controls the autonomous driving of the first movable body according to a control content for avoiding a contact between the first movable body and the second movable body.

According to a ninety-second aspect, in the information processing apparatus according to any one of the eighty-third to ninety-first aspects, in a case where the identifier is set, the first movable body processor causes a notification device to notify that the first movable body has been recognized by the second movable body processor.

According to a ninety-third aspect, in the information processing apparatus according to any one of the first to ninety-second aspects, the information processing apparatus includes at least one processor, and the processor outputs images of an imaged object at a first frame rate, derives, for each of the images output at the first frame rate, label information indicating a type of the object included in the image, outputs pieces of position information indicating an existence position of the object based on the images of the imaged object at a second frame rate higher than the first frame rate, and associates position information at each time point corresponding to an output timing of the image output at the first frame rate among the pieces of position information sequentially output at the second frame rate with the label information derived for the same object as the object corresponding to the position information.

According to a ninety-fourth aspect, in the information processing apparatus according to the ninety-third aspect, the processor associates the label information associated immediately before with position information that is not associated with the label information among the pieces of position information output at the second frame rate.

According to a ninety-fifth aspect, in the information processing apparatus according to the ninety-third or ninety-fourth aspect, the processor outputs at least one point indicating an existence position of the object as the position information.

According to a ninety-sixth aspect, in the information processing apparatus according to any one of the ninety-third to ninety-fifth aspects, the processor derives the label information based on a first image output at the first frame rate and having a relatively high resolution, and derives the position information based on a second image having a relatively low resolution.

According to a ninety-seventh aspect, in the information processing apparatus according to any one of the second to ninety-sixth aspects, the third processor determines that objects satisfying a predetermined condition among objects appearing in a first image captured by the first camera and objects appearing in a second image captured by the second camera are the same object, and associates the point information with the identification information for the objects determined to be the same.

According to a ninety-eighth aspect, in the information processing apparatus according to the ninety-seventh aspect, the predetermined condition includes matching between a position of the object appearing in the first image and a position of the object appearing in the second image as a first condition, matching between a contour of the object appearing in the first image and a contour appearing in the second image as a second condition, and matching between a type of the object estimated for the object appearing in the first image and a type of the object estimated for the object appearing in the second image as a third condition, and the third processor determines that the object appearing in the first image and the object appearing in the second image are the same object in a case where at least one of the first condition, the second condition, and the third condition is satisfied.

According to a ninety-ninth aspect, in the information processing apparatus according to any one of the first to ninety-eighth aspects, the information processing apparatus includes an extraction unit, an integration unit, an estimation unit, and an update unit, the extraction unit extracts first plane coordinates indicating an existence position of an object in a two-dimensional space at time t from an image in which the object appears, the integration unit combines first depth information detected for a depth direction of the object in a three-dimensional space, the first plane coordinates, and the first depth information to generate three-dimensional coordinates of the object at time t, the extraction unit extracts second plane coordinates indicating an existence position of the object in the two-dimensional space at a time next to time t, the estimation unit estimates second depth information corresponding to the next time based on shape information of a space in which the object is present and a change from the first plane coordinates to the second plane coordinates, and the update unit integrates the second plane coordinates and the estimated second depth information, and updates the three-dimensional coordinates of the object at the next time.

According to a 100-th aspect, in the information processing apparatus according to the ninety-ninth aspect, the integration unit detects the first depth information from point cloud data detected by a sensor.

According to a 101-th aspect, in the information processing apparatus according to the 100-th aspect, in a case where the second plane coordinates at the next time after movement of the object are extracted, and depth information obtained from the point cloud data corresponding to the next time is not acquired, the estimation of the second depth information and the update are performed.

According to a 102-th aspect, in the information processing apparatus according to any one of the ninety-ninth to 101-th aspects, the shape information includes a shape of a road surface obtained from an image acquired by a high-resolution camera and point cloud data detected by a sensor, and a preset shape of the object, and the estimation unit estimates the second depth information by calculating a movement amount in a depth direction in a case where the shape of the moving object changes from the first plane coordinates to the second plane coordinates with respect to the shape of the road surface.

According to a 103-th aspect, in the information processing apparatus according to any one of the ninety-ninth to 102-th aspects, each of a plurality of points at vertices of a box representing a contour of the object is a point corresponding to coordinates indicating the existence position of the object, the extraction unit extracts, for each of the points, the first plane coordinates and the second plane coordinates of the point, the integration unit generates, for each of the points, the three-dimensional coordinates of the object at the point, the estimation unit estimates, for each of the points, the second depth information at the point, and the update unit updates, for each of the points, the three-dimensional coordinates of the object at the point.

According to a 104-th aspect, the information processing apparatus according to any one of the first to 103-th aspects further includes a third processor that associates the point information output from the first processor with the identification information output from the second processor, in which the first processor outputs the point information at a next time point according to a predetermined priority for the identification information associated with the point information in a case where there are a plurality of pieces of the point information.

According to a 105-th aspect, in the information processing apparatus according to the 104-th aspect, the first processor derives, as the point information, a coordinate value of a point indicating an existence position of the object in a depth direction of the object in a three-dimensional orthogonal coordinate system from the image of the object captured by the first camera at a first time point, and the first processor derives a coordinate value in the depth direction at a second time point which is a time point next to the first time point according to the predetermined priority for the identification information associated with the point information in a case where there are a plurality of pieces of the point information.

According to a 106-th aspect, in the information processing apparatus according to the 104-th or 105-th aspect, the first processor sets a high priority for an object that shows behavior and sets a lower priority for an object that does not show the behavior according to a presence or absence of the behavior of the object indicated by the identification information.

According to a 107-th aspect, in the information processing apparatus according to the 106-th aspect, the first processor sets a higher priority for an object that shows the behavior according to a risk factor of the object.

According to a 108-th aspect, in the information processing apparatus according to the 107-th aspect, the first processor derives the point information at the next time point by using the priority in a case where the number of pieces of point information is equal to or larger than a predetermined number.

According to a 109-th aspect, in the information processing apparatus according to any one of the first to 108-th aspects, the first processor derives, as the point information, a coordinate value of a point indicating an existence position of the object in a depth direction of the object in a three-dimensional orthogonal coordinate system from the image of the object captured by the first camera at each time point at which a predetermined condition for the image is satisfied.

According to a 110-th aspect, in the information processing apparatus according to the 109-th aspect, the first processor sets each time point satisfying the predetermined condition as a second time point, and derives, as the point information, a coordinate value in the depth direction at the second time point from coordinate values in a width direction, a height direction, and the depth direction of the object in the three-dimensional orthogonal coordinate system at a first time point and coordinate values in the width direction and the height direction at the second time point which is a time point next to the first time point.

According to a 111-th aspect, in the information processing apparatus according to the 110-th aspect, the first processor sets, as the predetermined condition, change amounts of the coordinate values in the width direction and the height direction at the second time point with respect to the coordinate values in the width direction and the height direction at the first time point and derives the coordinate value in the depth direction at a predetermined frequency for the change amounts.

According to a 112-th aspect, in the information processing apparatus according to any one of the first to 111-th aspects, the first processor derives, as the point information, a coordinate value of a point indicating an existence position of the object in a depth direction of the object in a three-dimensional orthogonal coordinate system from the image of the object captured by the first camera, and the first processor learns correction information of the coordinate value in the depth direction from predetermined sensor information.

According to a 113-th aspect, in the information processing apparatus according to the 112-th aspect, the first processor collects the sensor information and learns the correction information for a specific travel situation in the collected sensor information in a case where a difference between the derived coordinate value in the depth direction and a coordinate value in the depth direction detected by a predetermined sensor is equal to or larger than a threshold.

According to a 114-th aspect, in the information processing apparatus according to the 113-th aspect, the first processor derives, as the point information, a coordinate value in the depth direction at a second time point from coordinate values in a width direction, a height direction, and the depth direction of the object in the three-dimensional orthogonal coordinate system at a first time point and coordinate values in the width direction and the height direction at the second time point which is a time point next to the first time point.

According to a 115-th aspect, in the information processing apparatus according to the first aspect, the information processing apparatus includes: an information acquisition unit that is configured to acquire a plurality of pieces of information related to a vehicle; an inference unit that infers a plurality of index values from the plurality of pieces of information acquired by the information acquisition unit by using deep learning; and a driving control unit that performs driving control of the vehicle based on the plurality of index values.

According to a 116-th aspect, in the information processing apparatus according to the 115-th aspect, the inference unit infers the plurality of index values from the plurality of pieces of information by multivariate analysis by an integration method using the deep learning.

According to a 117-th aspect, in the information processing apparatus according to the 115-th or 116-th aspect, the information acquisition unit acquires the plurality of pieces of information in units of 1/1 billion seconds, and the inference unit and the driving control unit perform the inference of the plurality of index values and the driving control of the vehicle in units of 1/1 billion seconds by using the plurality of pieces of information acquired in units of 1/1 billion seconds.

According to a 118-th aspect, the information processing apparatus according to any one of the 115-th to 117-th aspects further includes a strategy setting unit that sets a traveling strategy until the vehicle reaches a destination, in which the traveling strategy includes at least one theoretical value of an optimal route to the destination, a traveling speed, a tilt, and braking, and the driving control unit includes a strategy update unit that updates the traveling strategy based on a difference between the plurality of index values and the theoretical value.

According to a 119-th aspect, in the information processing apparatus according to any one of the 115-th to 118-th aspects, the information acquisition unit includes a sensor provided at a lower portion of the vehicle and configured to detect a temperature, a material, and a tilt of a ground on which the vehicle is traveling.

According to a 120-th aspect, in the information processing apparatus according to the first aspect, the information processing apparatus includes: an acquisition unit that acquires a detection result of detecting an object related to operation of a control device mounted on a vehicle, the control device controlling autonomous driving of the vehicle; and an execution unit that performs cooling in the control device based on the detection result.

According to a 121-th aspect, in the information processing apparatus according to the 120-th aspect, the acquisition unit extracts, as the detection result, a point indicating an existence position of the object from an image of one frame of the object, and acquires motion information indicating a motion of the point indicating the existence position of the object along a predetermined coordinate axis at a frame rate of 100 frames/second or higher.

According to a 122-th aspect, the information processing apparatus according to the 121-th aspect further includes a prediction unit that predicts the operation of the control device by using the detection result, in which the prediction unit predicts the operation of the control device by using a learning model generated by machine learning using, as learning data, the detection result and an operation status of the control device when the detection result is acquired.

According to a 123-th aspect, in the information processing apparatus according to the 122-th aspect, the prediction unit further predicts a temperature change of each of a plurality of portions in the control device, and the execution unit controls cooling of the portion in the control device.

According to a 124-th aspect, in the information processing apparatus according to the first aspect, the information processing apparatus includes: a calculation unit that calculates, for each of a plurality of combinations of a predetermined number of pieces of sensor information included in a vehicle, a wheel speed and an inclination of each of four wheels of the vehicle, and index values for controlling the wheel speed, the inclination, and a suspension for each suspension supporting the wheel, and calculate the wheel speed, the inclination, and a control variable for each suspension by aggregating the index values; and a control unit that controls autonomous driving based on the control variable.

According to a 125-th aspect, in the information processing apparatus according to the 124-th aspect, the calculation unit calculates the control variable from the index values by multivariate analysis by an integration method using deep learning.

According to a 126-th aspect, in the information processing apparatus according to the 124-th or 125-th aspect, the control unit controls the autonomous driving in units of 1/1 billion seconds based on the control variable.

According to a 127-th aspect, in the information processing apparatus according to the first aspect, the information processing apparatus includes: an acquisition unit that acquires a plurality of pieces of information related to a vehicle from a detection unit including a sensor that detects a situation around the vehicle at a second cycle shorter than a first cycle at which surroundings of the vehicle are imaged, as a cycle for detecting the situation around the vehicle; a calculation unit that calculates index values related to the situation around the vehicle from the plurality of pieces of acquired information, and calculates a control variable for controlling behavior of the vehicle from the calculated index values; and a control unit that controls the behavior of the vehicle based on the calculated control variable.

According to a 128-th aspect, in the information processing apparatus according to the 127-th aspect, the calculation unit calculates the control variable from the index values by multivariate analysis by an integration method using deep learning.

According to a 129-th aspect, in the information processing apparatus according to the 127-th or 128-th aspect, the acquisition unit acquires the plurality of pieces of information in units of 1/1 billion seconds, and the calculation unit performs the calculation of the index values and the control variable in units of 1/1 billion seconds by using the plurality of pieces of information acquired in units of 1/1 billion seconds.

According to a 130-th aspect, in the information processing apparatus according to any one of the 127-th to 129-th aspects, the calculation unit predicts a collision of a target with the vehicle based on the plurality of pieces of acquired information, and in a case where a prediction result indicates an unavoidable collision, the calculation unit calculates, as the control variable, a control variable corresponding to damage of the vehicle in the unavoidable collision, the damage not exceeding a predetermined threshold.

According to a 131-th aspect, in the information processing apparatus according to the 130-th aspect, the damage of the vehicle is at least one of a deformation position and a deformation amount of the vehicle.

According to a 132-th aspect, in the information processing apparatus according to the 130-th or 131-th aspect, the control variable corresponding to the damage of the vehicle is at least one of a collision angle and a vehicle speed of the vehicle.

According to a 133-th aspect, in the information processing apparatus according to the first aspect, the first processor extracts a point indicating an existence position of the object from an image in which the object appears, and outputs the point indicating the existence position of the object.

According to a 134-th aspect, the information processing apparatus according to the 133-th aspect further includes a camera configured to change a frame rate, in which the first processor calculates a score for an external environment, determines the frame rate of the camera according to the score, outputs a control signal for instructing the camera to capture an image at the determined frame rate, and extracts the point indicating the existence position of the object from the image captured by the camera, and outputs the point indicating the existence position of the object.

According to a 135-th aspect, in the information processing apparatus according to the 134-th aspect, the information processing apparatus is mounted on a vehicle, and the first processor calculates a risk level for traveling of the vehicle as the score for the external environment, determines the frame rate of the camera according to the risk level, outputs a control signal for instructing the camera to capture the image at the determined frame rate, and extracts the point indicating the existence position of the object from the image captured by the camera, and outputs the point indicating the existence position of the object.

According to a 136-th aspect, in the information processing apparatus according to any one of the 133-th to 135-th aspects, the first processor extracts the object from the image, and extracts, in a case where the existence position of the object is a predetermined region, the point indicating the existence position of the object and outputs the point indicating the existence position of the object.

According to a 137-th aspect, in the information processing apparatus according to any one of the 133-th to 136-th aspects, the first processor extracts the object from the image, calculates a score for each object, and extracts the point indicating the existence position of the object whose score is equal to or higher than a predetermined threshold, and outputs the point indicating the existence position of the object.

A vehicle according to a 138-th aspect is a vehicle including: a pair of camera units each including a camera; and a processor, in which a first camera unit extracts a point indicating an existence position of an object in front of the vehicle from an image in which the object appears and outputs the point indicating the existence position of the object, a second camera unit extracts a point indicating an existence position of an object behind the vehicle from an image in which the object appears, and outputs the point indicating the existence position of the object, and the processor controls traveling of the vehicle based on the existence positions of the objects output from the first camera unit and the second camera unit.

According to a 139-th aspect, in the vehicle according to the 138-th aspect, the camera included in each of the camera units is configured to change a frame rate, and one of the first camera unit and the second camera unit sets the frame rate of the camera according to an object detection situation in the other of the first camera unit and the second camera unit, and extracts the point indicating the existence position of the object from the image captured by the camera at the set frame rate, and outputs the point indicating the existence position of the object.

According to a 140-th aspect, the vehicle according to the 138-th or 139-th aspect further includes: another camera unit that includes a high-resolution camera having a higher resolution than the camera, and is connected to each of the camera units, in which each of the camera units is configured to acquire information regarding the object specified based on information of the high-resolution camera, and one of the first camera unit and the second camera unit acquires the information regarding the object in the other of the first camera unit and the second camera unit.

In an information processing method according to a 141-th aspect, a computer executes processing of: outputting point information that represents an imaged object as a point in an image of the object captured by a first camera; and outputting identification information obtained by identifying the imaged object in an image of the object captured by a second camera oriented in a direction corresponding to a direction in which the first camera is oriented.

An information processing program according to a 142-th aspect causes a computer to execute processing of: outputting point information that represents an imaged object as a point in an image of the object captured by a first camera; and outputting identification information obtained by identifying the imaged object in an image of the object captured by a second camera oriented in a direction corresponding to a direction in which the first camera is oriented.

Note that the summary of the disclosure described above does not enumerate all the necessary features of the disclosure. Further, a sub-combination of the feature groups can also be included in the disclosure.

## BRIEF DESCRIPTION OF DRAWINGS

Fig. 1 is a schematic diagram showing an example of a vehicle on which a central brain is mounted according to a first embodiment.

Fig. 2 is a block diagram showing an example of a configuration of an information processing apparatus according to the first embodiment.

Fig. 3 is a block diagram showing an example of a configuration of an information processing apparatus according to a second embodiment.

Fig. 4 is an explanatory diagram showing an example of point information output from a motion processing unit (MoPU) according to a third embodiment.

Fig. 5 is a block diagram showing an example of a configuration of an information processing apparatus according to a fifth embodiment.

Fig. 6 is a block diagram showing an example of a configuration of an information processing apparatus according to a sixth embodiment.

Fig. 7A is an explanatory diagram showing an example of association between point information and label information according to a seventh embodiment.

Fig. 7B is a flowchart showing an example of a flow of processing of associating a feature point and the label information with each other, which is executed by a central brain according to the seventh embodiment.

Fig. 8 is an explanatory diagram showing a schematic configuration of a vehicle according to an eighth embodiment.

Fig. 9 is a block diagram showing an example of a functional configuration of a cooling execution apparatus according to the eighth embodiment.

Fig. 10 is a first block diagram showing an example of a configuration of an information processing apparatus according to a ninth embodiment.

Fig. 11 is a second block diagram showing an example of a configuration of the information processing apparatus according to the ninth embodiment.

Fig. 12A is a diagram schematically showing coordinate detection in time series for an object in the ninth embodiment.

Fig. 12B is a flowchart in a case where an update frequency of a z coordinate value is determined according to change amounts in the ninth embodiment.

Fig. 12C is a flowchart in a case where correction information is learned in the ninth embodiment.

Fig. 13 is a block diagram showing an example of a configuration of an information processing apparatus according to a tenth embodiment.

Fig. 14A is a first explanatory diagram for describing an image of an object captured by an event camera according to the tenth embodiment.

Fig. 14B is a second explanatory diagram for describing an image of the object captured by the event camera according to the tenth embodiment.

Fig. 14C is a third explanatory diagram for describing an image of the object captured by the event camera according to the tenth embodiment.

Fig. 15 is a first block diagram showing an example of a configuration of an information processing apparatus according to an eleventh embodiment.

Fig. 16 is a second block diagram showing an example of a configuration of the information processing apparatus according to the eleventh embodiment.

Fig. 17 is a first block diagram showing an example of a configuration of an information processing apparatus according to a twelfth embodiment.

Fig. 18 is a second block diagram showing an example of a configuration of the information processing apparatus according to the twelfth embodiment.

Fig. 19 is a first block diagram showing an example of a configuration of an information processing apparatus according to a thirteenth embodiment.

Fig. 20 is a second block diagram showing an example of a configuration of the information processing apparatus according to the thirteenth embodiment.

Fig. 21A is a first diagram for describing processing in a case where a feature point is not extracted from an object present on a sidewalk in the thirteenth embodiment.

Fig. 21B is a second diagram for describing the processing in a case where the feature point is not extracted from the object present on the sidewalk in the thirteenth embodiment.

Fig. 22 is a block diagram of an information processing apparatus according to a fourteenth embodiment.

Fig. 23 is a first diagram showing imaging directions and imaging view angle ranges of a high-resolution camera and an omnidirectional camera mounted on a vehicle according to the fourteenth embodiment.

Fig. 24 is a first diagram showing an imaging range relationship between an image acquired by the omnidirectional camera and an image acquired by the high-resolution camera 30L according to the fourteenth embodiment.

Fig. 25 is a second diagram showing imaging directions and imaging view angle ranges of the high-resolution camera and the omnidirectional camera mounted on the vehicle according to the fourteenth embodiment.

Fig. 26 is a second diagram showing an imaging range relationship between an image acquired by the omnidirectional camera and an image acquired by the high-resolution camera 30L according to the fourteenth embodiment.

Fig. 27 is a block diagram of an information processing apparatus according to a fifteenth embodiment.

Fig. 28 is a diagram showing an example of a camera management database according to the fifteenth embodiment.
Fig. 29 is a first diagram for describing a vehicle according to the fifteenth embodiment.
Fig. 30 is a diagram showing an example of an image acquired from an external camera according to the fifteenth embodiment.
Fig. 31 is a diagram showing an example of an object management database according to the fifteenth embodiment.
Fig. 32 is a second diagram for describing the vehicle according to the fifteenth embodiment.
Fig. 33 is a third diagram for describing the vehicle according to the fifteenth embodiment.
Fig. 34 is a block diagram showing an example of a configuration of an information processing apparatus according to a sixteenth embodiment.
Fig. 35 is a perspective view showing a camera and a moving unit according to the sixteenth embodiment.
Fig. 36A is a first explanatory diagram for describing processing of correcting a deviation of a two-dimensional position of an object according to the sixteenth embodiment.
Fig. 36B is a second explanatory diagram for describing the processing of correcting the deviation of the two-dimensional position of the object according to the sixteenth embodiment.
Fig. 37 is a block diagram showing a functional configuration of a central brain according to a seventeenth embodiment.
Fig. 38A is a first diagram for describing a method of calculating a direction of a motion of a point from a time series of point information in the seventeenth embodiment.
Fig. 38B is a second diagram for describing the method of calculating the direction of the motion of the point from the time series of the point information in the seventeenth embodiment.
Fig. 39 is a diagram showing an example of pieces of motion information of a plurality of objects in the seventeenth embodiment.
Fig. 40 is a diagram showing an example of motion information after removal in the seventeenth embodiment.
Fig. 41 is a flowchart showing a flow of association processing executed by the central brain according to the seventeenth embodiment.
Fig. 42 is a diagram for describing point information output processing executed by an MoPU according to an eighteenth embodiment.
Fig. 43 is a block diagram showing an example of a configuration of an information processing apparatus according to a nineteenth embodiment.
Fig. 44 is a conceptual diagram showing an example of processing contents of a first determination unit, a second determination unit, a third determination unit, and a setting unit of a first vehicle according to the nineteenth embodiment.
Fig. 45 is a conceptual diagram showing an example of contents of processing executed by an inference unit and a driving control unit of the first vehicle in a case where an identifier has not been set by the setting unit according to the nineteenth embodiment.
Fig. 46 is a conceptual diagram showing an example of contents of processing performed by the inference unit and the driving control unit of the first vehicle in a case where the identifier is set by the setting unit according to the nineteenth embodiment.
Fig. 47 is a conceptual diagram showing an example of an aspect in which a frontal collision between the first vehicle and a second vehicle is avoided according to the nineteenth embodiment.
Fig. 48 is a first flowchart showing an example of a flow of autonomous driving control processing according to the nineteenth embodiment.
Fig. 49 is a second flowchart showing an example of a flow of the autonomous driving control processing according to the nineteenth embodiment.
Fig. 50 is a third flowchart showing an example of a flow of the autonomous driving control processing according to the nineteenth embodiment.
Fig. 51 is a conceptual diagram showing an example of an aspect in which a notification that the first vehicle has been recognized by the second vehicle is made according to the nineteenth embodiment.
Fig. 52A is a diagram showing an example of an aspect of object recognition according to a twentieth embodiment.
Fig. 52B is a diagram showing an example of an aspect of extraction of a feature point of an object according to the twentieth embodiment.
Fig. 53 is a diagram showing an example of an aspect of an MoPU according to the twentieth embodiment.
Fig. 54 is a diagram showing an example of a flowchart of processing in the MoPU according to the twentieth embodiment.
Fig. 55 is a diagram for describing a configuration of a vehicle according to a twenty-first embodiment.
Fig. 56 is a block diagram showing an example of a configuration of an information processing apparatus according to a twenty-second embodiment.
Fig. 57 is a flowchart showing an example of rate change processing according to the twenty-second embodiment.

Fig. 58 is a diagram for describing a viewing angle of a camera in the twenty-second embodiment.
Fig. 59 is a flowchart showing an example of handover processing according to the twenty-second embodiment.
Fig. 60 is a first block diagram showing an example of a configuration of an information processing apparatus according to a twenty-third embodiment.
Fig. 61 is a second block diagram showing an example of a configuration of the information processing apparatus according to the twenty-third embodiment.
Fig. 62 is a diagram schematically showing an example of a system according to a twenty-fourth embodiment.
Fig. 63 is an explanatory diagram for describing a learning phase in the system according to the twenty-fourth embodiment.
Fig. 64 is an explanatory diagram for describing a cooling execution phase in the system according to the twenty-fourth embodiment.
Fig. 65 is a first diagram schematically showing an example of an SoCBox and a cooling unit according to the twenty-fourth embodiment.
Fig. 66 is a second view schematically showing an example of the SoCBox and the cooling unit according to the twenty-fourth embodiment.
Fig. 67 is a third diagram schematically showing an example of the SoCBox and the cooling unit according to the twenty-fourth embodiment.
Fig. 68 is a diagram schematically showing a risk prediction capability of ultra-high performance autonomous driving artificial intelligence (AI) according to a twenty-fifth embodiment.
Fig. 69 is a flowchart executed by a central brain according to the twenty-fifth embodiment.
Fig. 70 is a first explanatory diagram for describing an example of autonomous driving control by the central brain according to the twenty-fifth embodiment.
Fig. 71 is a second explanatory diagram for describing an example of the autonomous driving control by the central brain according to the twenty-fifth embodiment.
Fig. 72 is a third explanatory diagram for describing an example of the autonomous driving control by the central brain according to the twenty-fifth embodiment.
Fig. 73 is a fourth explanatory diagram for describing an example of the autonomous driving control by the central brain according to the twenty-fifth embodiment.
Fig. 74 is a fifth explanatory diagram for describing an example of the autonomous driving control by the central brain according to the twenty-fifth embodiment.
Fig. 75 is a schematic diagram showing a state in which another vehicle is traveling around a vehicle, as an explanatory diagram for describing an example of autonomous driving control by a central brain according to a twenty-sixth embodiment.
Fig. 76 is a flowchart executed by the central brain according to the twenty-sixth embodiment.
Fig. 77 is an explanatory diagram schematically showing an example of a hardware configuration of a computer functioning as the information processing apparatus or the cooling execution apparatus.

## DESCRIPTION OF EMBODIMENTS

Hereinafter, embodiments of the present disclosure will be described, but the following embodiments do not limit the disclosure. In addition, not all combinations of features described in the embodiments are essential to the solution of the disclosure. An information processing apparatus according to an embodiment of the technology of the disclosure may obtain an index value necessary for driving control with high accuracy based on a large amount of information related to vehicle control. Therefore, at least a part of the information processing apparatus according to the disclosure may be mounted on a vehicle and implements the vehicle control.

### (First Embodiment)

First, a first embodiment according to the present embodiment will be described. As an example, at least a part of the information processing apparatus according to the disclosure is mounted on a vehicle 100 and performs autonomous driving control of the vehicle 100. Furthermore, the information processing apparatus can provide a traveling system that can implement autonomous driving at Level 6 in real time based on data obtained by various sensor inputs in artificial intelligence (AI)/multivariate analysis/goal seek/strategy planning/optimal probabilistic solution/optimal speed solution/optimal course management/edge and is adjusted based on a delta optimal solution. The vehicle 100 is an example of a "target".
Here, "Level 6" is a level representing the autonomous driving and corresponds to a level higher than Level 5 representing fully autonomous driving. Level 5 represents the fully autonomous driving, but Level 5 is equivalent to a level of human driving, and there is still a probability that an accident or the like occurs. Level 6 represents a level higher than Level 5, and corresponds to a level at which a probability that an accident occurs is lower than that of Level 5.

Computational power at Level 6 is about 1000 times the computational power at Level 5. Therefore, Level 6 can implement high-performance driving control that cannot be implemented at Level 5.

Fig. 1 is a schematic diagram showing an example of the vehicle 100 on which a central brain 15 is mounted. A plurality of gateways are communicably connected to the central brain 15. The central brain 15 is connected to an external cloud server via the gateway. The central brain 15 is configured to be able to access the external cloud server via the gateway. On the other hand, the central brain 15 cannot be directly accessed from the outside due to the presence of the gateway.

The central brain 15 outputs a request signal to the cloud server every time a predetermined time elapses. Specifically, the central brain 15 outputs a request signal indicating an inquiry to the cloud server every 1/1 billion seconds. As an example, the central brain 15 controls the autonomous driving of Level L6 based on a plurality of pieces of information acquired via the gateway.

Fig. 2 is a block diagram showing an example of a functional configuration of an information processing apparatus 10 according to the first embodiment. The information processing apparatus 10 includes an image processing unit (IPU) 11, a motion processing unit (MoPU) 12, the central brain 15, and a memory 16. The central brain 15 includes a graphics neural network processing unit (GNPU) 13 and a central processing unit (CPU) 14.

The IPU 11 is built in an ultra-high-resolution camera (not shown) installed in the vehicle 100. The IPU 11 executes predetermined image processing such as Bayer conversion, demosaicing, noise removal, and sharpening on an image of an object present around the vehicle 100 captured by the ultra-high-resolution camera, and outputs the processed image of the object at a frame rate of 10 frames/second and a resolution of 12 million pixels, for example. In addition, the IPU 11 outputs identification information obtained by identifying the imaged object in the image of the object captured by the ultra-high-resolution camera. The identification information is information necessary for identifying what the imaged object is (for example, whether the object is a person or an obstacle). In the embodiment, the IPU 11 outputs, as the identification information, label information (for example, information indicating whether the imaged object is a dog, a cat, or a bear) indicating the type (kind) of the imaged object. Furthermore, the IPU 11 outputs position information indicating a position of the imaged object in a camera coordinate system of the ultra-high-resolution camera. The image, the label information, and the position information output from the IPU 11 are supplied to the central brain 15 and the memory 16. The IPU 11 is an example of a "second processor", and the ultra-high-resolution camera is an example of a "second camera".

The MoPU 12 is built in another camera (not shown) different from the ultra-high-resolution camera installed in the vehicle 100. The MoPU 12 outputs point information that represents the imaged object as a point in an image of the object captured at a frame rate of 100 frames/second or higher by the another camera oriented in a direction corresponding to that of the ultra-high-resolution camera, for example, at a frame rate of 100 frames/second or higher. The point information output from the MoPU 12 is supplied to the central brain 15 and the memory 16. As described above, the image used by the MoPU 12 to output the point information and the image used by the IPU 11 to output the identification information are images captured by the another camera and the ultra-high-resolution camera oriented in the corresponding direction (images obtained by performing imaging). Here, the "corresponding direction" is a direction in which an imaging range of the another camera and an imaging range of the ultra-high-resolution camera overlap each other. In the above case, the another camera captures the object while being oriented in a direction overlapping the imaging range of the ultra-high-resolution camera. For example, the ultra-high-resolution camera and the another camera imaging the object while being oriented in the corresponding direction are implemented by obtaining a correspondence between the camera coordinate systems of the ultra-high-resolution camera and the another camera in advance.

For example, the MoPU 12 outputs, as the point information, coordinate values of a point indicating an existence position of the object on at least two coordinate axes in a three-dimensional orthogonal coordinate system. The coordinate values indicate a center point (or a center-of-gravity point) of the object as an example. The MoPU 12 outputs, as the coordinate values on the two coordinate axes, a coordinate value (hereinafter referred to as "x coordinate value") on an axis (x axis) along a width direction and a coordinate value (hereinafter referred to as "y coordinate value") on an axis (y axis) along a height direction in the three-dimensional orthogonal coordinate system. The x axis is an axis along a vehicle width direction of the vehicle 100, and the y axis is an axis along the height direction of the vehicle 100.

With the above configuration, the point information for 1 second output from the MoPU 12 includes the x coordinate values and the y coordinate values of 100 frames or more, so that it is possible to grasp a motion (a movement direction and a movement speed) of the object on the x axis and the y axis in the three-dimensional orthogonal coordinate system based on the point information. That is, the point information output from the MoPU 12 includes the position information indicating the position of the object in the three-dimensional orthogonal coordinate system and motion information indicating the motion of the object.

As described above, the point information output from the MoPU 12 does not include information necessary for identifying what the imaged object is (for example, whether the image object is a person or an obstacle), and includes only information indicating a motion (the movement direction and the movement speed) of the center point (or the center-of-gravity point) of the object on the x axis and the y axis. Since the point information output from the MoPU 12 does not include image information, the amount of data output to the central brain 15 and the memory 16 can be dramatically reduced. The MoPU 12 is an example of a "first processor", and the another camera is an example of a "first camera".

As described above, in the embodiment, the frame rate of the another camera in which the MoPU 12 is built is higher than the frame rate of the ultra-high-resolution camera in which the IPU 11 is built. Specifically, the frame rate of the another camera is 100 frames/second or higher, and the frame rate of the ultra-high-resolution camera is 10 frames/second. That is, the frame rate of the another camera is 10 times or more the frame rate of the ultra-high-resolution camera.

The central brain 15 associates the point information output from the MoPU 12 with the label information output from the IPU 11. For example, the central brain 15 acquires the point information for the object and does not acquire the label information in some cases due to the frame rate difference between the another camera and the ultra-high-resolution camera. In this state, the central brain 15 recognizes the x coordinate value and the y coordinate value of the object based on the point information, and does not recognize what the object is.

Thereafter, in a case where the label information for the object is acquired, the central brain 15 derives the type (for example, PERSON) of the label information. Then, the central brain 15 associates the label information with the point information acquired above. As a result, the central brain 15 recognizes the x coordinate value and the y coordinate value of the object based on the point information, and recognizes what the object is. The central brain 15 is an example of a "third processor".

Here, in a case where there are a plurality of objects such as an object A and an object B imaged by the ultra-high-resolution camera and the another camera, the central brain 15 associates the point information and the label information with each other for each object as follows. The central brain 15 acquires pieces of point information (hereinafter referred to as "point information A" and "point information B") for the object A and the object B, but does not acquire the label information in some cases due to the frame rate difference between the another camera and the ultra-high-resolution camera. In this state, the central brain 15 recognizes an x coordinate value and a y coordinate value of the object A based on the point information A and recognizes an x coordinate value and a y coordinate value of the object B based on the point information B, but does not recognize what the objects are.

Thereafter, in a case where one piece of label information is acquired, the central brain 15 derives the type (for example, PERSON) of the one piece of label information. Then, the central brain 15 specifies the point information to be associated with the one piece of label information based on the position information output from the IPU 11 together with the one piece of label information and position information included in the acquired point information A and point information B. For example, the central brain 15 specifies point information including position information indicating a position closest to the position of the object indicated by the position information output from the IPU 11, and associates the point information with the one piece of label information. In a case where the point information specified above is the point information A, the central brain 15 associates the one piece of label information with the point information A, recognizes the x coordinate value and the y coordinate value of the object A based on the point information A, and recognizes what the object A is.

As described above, in a case where there are a plurality of objects imaged by the ultra-high-resolution camera and the another camera, the central brain 15 associates the point information and the label information with each other based on the position information output from the IPU 11 and the position information included in the point information output from the MoPU 12.

In addition, the central brain 15 recognizes the object (a person, an animal, a road, a signal, a sign, a pedestrian crossing, an obstacle, a building, or the like) present around the vehicle 100 based on the image and the label information output from the IPU 11. Furthermore, the central brain 15 recognizes the position and the motion of the recognized object present around the vehicle 100 based on the point information output from the MoPU 12. The central brain 15 performs, for example, control (speed control) of a motor for driving wheels, brake control, and steering wheel control based on the recognized information, and controls autonomous driving of the vehicle 100 as response control for the object. For example, the central brain 15 controls the autonomous driving of the vehicle 100 so as to avoid a collision with the object based on the position information and the motion information included in the point information output from the MoPU 12. In the central brain 15, the GNPU 13 may execute processing related to image recognition, and the CPU 14 may execute processing related to the vehicle control.

In general, the ultra-high-resolution camera is used to perform image recognition in autonomous driving. Here, it is possible to recognize what an object included in an image is by using the image captured by the ultra-high-resolution camera (an image obtained by performing imaging using the ultra-high-resolution camera). However, it is not sufficient for the autonomous driving of Level 6. For Level 6, it is also necessary to recognize a motion of an object with higher accuracy. As the MoPU 12 recognizes the motion of the object with higher accuracy, for example, an avoidance operation in which the vehicle 100 traveling by the autonomous driving avoids an obstacle can be performed with higher accuracy. However, the ultra-high-resolution camera can acquire only about 10 frames per second, and accuracy in analyzing the motion of the object is lower than that of the camera on which the MoPU 12 is mounted. On the other hand, the camera on which the MoPU 12 is mounted can perform outputting at a high frame rate of 100 frames/second, for example.

Therefore, the information processing apparatus 10 according to the first embodiment includes two independent processors of the IPU 11 and the MoPU 12. The information processing apparatus 10 imparts a role of acquiring information necessary for identifying the imaged object to the IPU 11 built in the ultra-high-resolution camera, and imparts a role of detecting the position and the motion of the object to the MoPU 12 built in the another camera. The MoPU 12 represents the imaged object as a point, and analyzes in which direction on at least the x axis and the y axis in the three-dimensional orthogonal coordinate system and at what speed the coordinates of the point move. Since detection of the entire contour of the object and what the object is can be performed using the image acquired from the ultra-high-resolution camera, the MoPU 12 can grasp behavior of the entire object as long as the MoPU 12 knows how the center point of the object moves, for example.

According to a method of analyzing only the movement and the speed of the center point of the object, it is possible to greatly reduce the amount of data output to the central brain 15 and greatly reduce the amount of computation in the central brain 15 as compared with the case of determining how the entire image of the object moves. For example, in the case of outputting an image of 1000 pixels × 1000 pixels to the central brain 15 at a frame rate of 1000 frames/second, when color information is included, data of 4 billion bits/second is output to the central brain 15. Since the MoPU 12 outputs only the point information indicating the motion of the center point of the object, the amount of data output to the central brain 15 can be compressed to 20000 bits/second. That is, the amount of data output to the central brain 15 is compressed to 1/200000.

It is possible to implement object recognition including the motion of the object with a small amount of data by using the low-frame-rate and high-resolution image and the label information output from the IPU 11 and the high-frame-rate and lightweight point information output from the MoPU 12 in combination as described above.

Furthermore, in the information processing apparatus 10, the central brain 15 associates the point information output from the MoPU 12 with the label information output from the IPU 11, so that it is possible to grasp information regarding what type of object is making what type of motion.

(Second Embodiment)

Next, a second embodiment according to the present embodiment will be described while omitting or simplifying an overlapping portion with the above embodiment.

Fig. 3 is a block diagram showing an example of a configuration of an information processing apparatus 10 according to the second embodiment. As shown in Fig. 3, the information processing apparatus 10 mounted on a vehicle 100 includes an MoPU 12L corresponding to a left eye, an MoPU 12R corresponding to a right eye, an IPU 11, and a central brain 15.

The MoPU 12L includes a camera 302L, a radar 32L, an infrared camera 34L, and a core 17L. The MoPU 12R includes a camera 302R, a radar 32R, an infrared camera 34R, and a core 17R. Hereinafter, the MoPU 12L and the MoPU 12R are referred to as "MoPU 12" when not distinguished, the camera 302L and the camera 302R are referred to as "camera 302" when not distinguished, the radar 32L and the radar 32R are referred to as "radar 32" when not distinguished, the infrared camera 34L and the infrared camera 34R are referred to as "infrared camera 34" when not distinguished, and the core 17L and the core 17R are referred to as "core 17" when not distinguished.

The camera 302 included in the MoPU 12 images an object with a larger number of frames (120, 240, 480, 960 or 1920 frames/sec) than that of an ultra-high-resolution camera (for example, 10 frames/sec) included in the IPU 11. A frame rate of the camera 302 is variable. The camera 302 is an example of a "first camera".

The radar 32 included in the MoPU 12 acquires a radar signal which is a signal based on a reflected wave of an electromagnetic wave applied to the object from the object. The infrared camera 34 included in the MoPU 12 is a camera that captures an infrared image (a camera that images infrared rays from the object to acquire an infrared image indicating the object).

The core 17 (implemented by one or more CPUs, for example) included in the MoPU 12 extracts a feature point for each image of one frame captured by the camera 302 (an image of one frame obtained by being captured by the camera 302), and outputs, as point information, an x coordinate value and a y coordinate value of the object in the above-described three-dimensional orthogonal coordinate system. For example, the core 17 uses, as the feature point, a center point (center-of-gravity point) of the object extracted from the image. The point information output by the core 17 includes position information and motion information as in the above embodiment.

The IPU 11 includes the ultra-high-resolution camera (not shown), and outputs an image of the object captured by the ultra-high-resolution camera (an image obtained by imaging the object by the ultra-high-resolution camera), label information indicating the type of the object, and position information indicating a position of the object in a camera coordinate system of the ultra-high-resolution camera.

The central brain 15 acquires the point information output from the MoPU 12, and the image, the label information, and the position information output from the IPU 11. Then, the central brain 15 associates the label information for the object present at a position corresponding to the position information included in the point information output from the MoPU 12 and the position information output from the IPU 11 with the point information. As a result, the information processing apparatus 10 can associate information indicating what the object indicated by the label information is with the position and a motion of the object indicated by the point information.

Here, the MoPU 12 changes the frame rate of the camera 302 according to a predetermined factor. In the second embodiment, the MoPU 12 changes the frame rate of the camera 302 according to a score for an external environment as an example of the predetermined factor. In this case, the MoPU 12 calculates the score for the external environment for the vehicle 100, and changes the frame rate of the camera 302 according to the calculated score. Then, the MoPU 12 outputs a control signal for capturing the image at the changed frame rate to the camera 302. As a result, the camera 302 captures the image at the frame rate indicated by the control signal (the camera 302 captures the image at the frame rate indicated by the control signal to acquire the image). With such a configuration, in the information processing apparatus 10, the image of the object can be captured at a frame rate suitable for the external environment (the object can be imaged at the frame rate suitable for the external environment).

The information processing apparatus 10 mounted on the vehicle 100 includes a plurality of types of sensors (not shown). The MoPU 12 calculates a risk level for movement of the vehicle 100 as the score for the external environment for the vehicle 100 based on sensor information (such as center of gravity shift in a weight, detection of road material, detection of outside-air temperature, detection of outside-air humidity, detection of vertical and lateral inclination angles of slopes, detection of a freezing state and a moisture level of a road, detection of a material, a wear condition, and a tire pressure of each tire, a road width, the presence or absence of no-passing zones, vehicle type information of an oncoming vehicle and preceding and following vehicles, cruising states of such vehicles, or a surrounding situation (birds, animals, soccer balls, accident vehicles, earthquakes, housework, winds, typhoons, heavy rain, light rain, snowstorm, fog, or the like)) taken in from the plurality of types of sensors and the point information. The risk level indicates the degree of risk of a place where the vehicle 100 is to travel in the future. In this case, the MoPU 12 changes the frame rate of the camera 302 according to the calculated risk level. The vehicle 100 is an example of a "movable body". With such a configuration, in the information processing apparatus 10, the frame rate of the camera 302 can be changed according to the risk level for the movement of the vehicle 100. The sensor is an example of a "detection unit", and the sensor information is an example of "detection information".

For example, the MoPU 12 increases the frame rate of the camera 302 as the calculated risk level is higher. In a case where the calculated risk level is lower than a first threshold, the MoPU 12 changes the frame rate of the camera 302 to 120 frames/second. In a case where the calculated risk level is equal to or higher than the first threshold and lower than a second threshold, the MoPU 12 changes the frame rate of the camera 302 to any one of 240, 480, and 960 frames/second. In a case where the calculated risk level is equal to or higher than the second threshold, the MoPU 12 changes the frame rate of the camera 302 to 1920 frames/second. In a case where the risk level is any of the above, the MoPU 12 may cause the camera 302 to capture the image at the selected frame rate (cause the camera 302 to perform imaging at the selected frame rate), and may also output a control signal to the radar 32 and the infrared camera 34 to acquire the radar signal and capture the infrared image with a numerical value corresponding to the frame rate.

For example, the MoPU 12 decreases the frame rate of the camera 302 as the calculated risk level is lower. In a case where the calculated risk level is equal to or higher than the first threshold and lower than the second threshold in a state in which the frame rate of the camera 302 is set to 1920 frames/second, the MoPU 12 changes the frame rate of the camera 302 to any one of 240, 480, and 960 frames/second. In a case where the calculated risk level is lower than the first threshold in a state in which the frame rate of the camera 302 is set to 120 frames/second, the MoPU 12 changes the frame rate of the camera 302 to 1920 frames/second. In a case where the calculated risk level is lower than the first threshold in a state in which the frame rate of the camera 302 is set to any one of 240, 480, and 960 frames/second, the MoPU 12 changes the frame rate of the camera 302 to 120 frames/second. In this case, similarly to the above, the MoPU 12 outputs the control signal to the radar 32 and the infrared camera 34 to acquire the radar signal and capture the infrared image with the numerical value corresponding to the changed frame rate of the camera 302 (acquire the radar signal and perform imaging for obtaining the infrared image with the numerical value corresponding to frame rate of changed camera 302).

Furthermore, the MoPU 12 may calculate the risk level by using big data regarding traveling already known before the vehicle 100 travels, such as long-tail incident artificial intelligence (AI) data (for example, trip data of the vehicle in which an autonomous driving control scheme of Level 5 is implemented) or map information, as information for predicting the risk level.

In the above description, the risk level is calculated as the score for the external environment, but an index serving as the score for the external environment is not limited to the risk level. For example, the MoPU 12 may calculate the score for the external environment other than the risk level based on a movement direction, a speed, or the like of the object caught on the camera 302, and change the frame rate of the camera 302 according to the score. Hereinafter, a case where the MoPU 12 calculates a speed score which is a score related to the speed of the object caught on the camera 302 and changes the frame rate of the camera 302 according to the speed score will be described. As an example, the speed score is set to be higher as the speed of the object is higher and is set to be lower as the speed of the object is lower. Then, the MoPU 12 increases the frame rate of the camera 302 as the calculated speed score is higher, and decreases the frame rate of the camera 302 as the calculated speed score is lower. Therefore, in a case where the calculated speed score is equal to or higher than a threshold due to a high speed of the object, the MoPU 12 changes the frame rate of the camera 302 to 1920 frames/second. In a case where the calculated speed score is lower than the threshold due to a low speed of the object, the MoPU 12 changes the frame rate of the camera 302 to 120 frames/second. In this case, similarly to the above, the MoPU 12 outputs the control signal to the radar 32 and the infrared camera 34 to acquire the radar signal and capture the infrared image with the numerical value corresponding to the changed frame rate of the camera 302 (acquire the radar signal and perform imaging for obtaining the infrared image with the numerical value corresponding to frame rate of changed camera 302).

Next, a case where the MoPU 12 calculates a direction score which is a score related to the movement direction of the object caught on the camera 302 and changes the frame rate of the camera 302 according to the direction score will be described. As an example, the direction score is set to be higher in a case where the movement direction of the object is a direction approaching the road, and is set to be lower in a case where the movement direction is a direction away from the road. Then, the MoPU 12 increases the frame rate of the camera 302 as the calculated direction score is higher, and decreases the frame rate of the camera 302 as the calculated direction score is lower. Specifically, the MoPU 12 specifies the movement direction of the object by using AI or the like, and calculates the direction score based on the specified movement direction. Then, in a case where the calculated direction score is equal to or higher than a threshold because the movement direction of the object is the direction approaching the road, the MoPU 12 changes the frame rate of the camera 302 to 1920 frames/second. In a case where the calculated direction score is lower than the threshold because the movement direction of the object is the direction away from the road, the MoPU 12 changes the frame rate of the camera 302 to 120 frames/second. In this case, similarly to the above, the MoPU 12 outputs the control signal to the radar 32 and the infrared camera 34 to acquire the radar signal and capture the infrared image with the numerical value corresponding to the changed frame rate of the camera 302 (acquire the radar signal and perform imaging for obtaining the infrared image with the numerical value corresponding to frame rate of changed camera 302).

Furthermore, the MoPU 12 may output the point information only for an object for which the calculated score for the external environment is equal to or higher than a predetermined threshold. In this case, for example, the MoPU 12 may determine whether or not to output the point information for the object according to the movement direction or an existence position of the object caught on the camera 302. For example, the MoPU 12 need not output the point information for an object having a low influence on the traveling of the vehicle 100. Specifically, the MoPU 12 calculates the movement direction of the object caught on the camera 302, and does not output the point information for an object such as a pedestrian moving away from the road. On the other hand, the MoPU 12 outputs the point information for an object approaching the road (for example, an object such as a pedestrian who is likely to jump out onto the road) or an object present in the road (for example, an object such as a pedestrian or a bicycle crossing a pedestrian crossing provided on a road). With such a configuration, in the information processing apparatus 10, it is not necessary to output the point information for an object having a low influence on the traveling of the vehicle 100.

In the above description, in a case where there is an object in the road on which the vehicle 100 travels, the MoPU 12 outputs the point information for the object, but the technology of the disclosure is not limited to this aspect. For example, in a case where it can be determined that a possibility that an object comes into contact with the vehicle 100 is low even in a case where the object is present in the road on which the vehicle 100 travels, the MoPU 12 may stop the output of the point information for the object. The road is an example of a "passage".

Here, the MoPU 12 determines that the possibility that the object comes into contact with the vehicle 100 is low in a case where the object is not present on a movement route of the vehicle 100 in the road and the object moves away from the movement route. As an example, a situation where the object is not on the movement route of the vehicle 100 in the road is exemplified by a case where the object is positioned in a lane different from a lane in which the vehicle 100 is traveling on the road having a plurality of lanes. In addition, for example, a case where the object moves away from the movement route of the vehicle 100 is exemplified by a case where the object is moving in a direction away from the lane in which the vehicle 100 is traveling on the road having a plurality of lanes.

With the above configuration, it is possible to reduce the amount of data output to the central brain 15 while reducing a processing load on the MoPU 12 as compared with a case where the point information for the object is always output in a case where the object is present in the road on which the vehicle 100 travels.

Furthermore, in the above description, a case where the MoPU 12 calculates the risk level has been exemplified, but the technology of the disclosure is not limited to this aspect. For example, the central brain 15 may calculate the risk level instead of the MoPU 12. In this case, the central brain 15 calculates the risk level for the movement of the vehicle 100 as the score for the external environment for the vehicle 100 based on the sensor information taken in from the plurality of types of sensors and the point information output from the MoPU 12. Then, the central brain 15 outputs, to the MoPU 12, an instruction to change the frame rate of the camera 302 according to the calculated risk level.

Furthermore, in the above description, a case where the MoPU 12 outputs the point information based on the image captured by the camera 302 (the image obtained by performing imaging using the camera 302) has been exemplified, but the technology of the disclosure is not limited to this aspect. For example, the MoPU 12 may output the point information based on the radar signal and the infrared image instead of the image captured by the camera 302 (the image obtained by performing imaging using the camera 302). The MoPU 12 can derive the x coordinate value and the y coordinate value of the object from the infrared image of the object captured by the infrared camera 34, similarly to the image captured by the camera 302 (the image obtained by performing imaging using the camera 302). The radar 32 can acquire three-dimensional point cloud data of the object based on the radar signal. That is, the radar 32 can detect a coordinate on a z axis in the three-dimensional orthogonal coordinate system. Here, the z axis is an axis along a depth direction of the object and a traveling direction of the vehicle 100, and hereinafter, a coordinate value on the z axis is referred to as a "z coordinate value". In this case, the MoPU 12 derives coordinate values of the object on three coordinate axes (the x axis, the y axis, and the z axis) as the point information by combining the x coordinate value and the y coordinate value of the object imaged by the infrared camera 34 at the same timing as a timing at which the radar 32 acquires the three-dimensional point group data of the object and the z coordinate value of the object indicated by the three-dimensional point group data, by using the principle of a stereo camera. Then, the MoPU 12 outputs the derived point information to the central brain 15.

Furthermore, in the above description, a case where the MoPU 12 derives the point information has been exemplified, but the technology of the disclosure is not limited to this aspect. For example, the central brain 15 may derive the point information instead of the MoPU 12. The central brain 15 derives the point information, for example, by combining information detected by the camera 302L, the camera 302R, the radar 32, and the infrared camera 34. As a specific example, the central brain 15 performs triangulation based on an x coordinate value and a y coordinate value of the object imaged by the camera 302L and an x coordinate value and a y coordinate value of the object imaged by the camera 302R, thereby deriving the coordinate values of the object on three coordinate axes (the x axis, the y axis, and the z axis) as the point information.

Furthermore, in the above description, a case where the central brain 15 controls autonomous driving of the vehicle 100 based on the image and the label information output from the IPU 11 and the point information output from the MoPU 12 has been exemplified, but the technology of the disclosure is not limited to this aspect. For example, the central brain 15 may perform operation control of a robot based on the information output from the IPU 11 and the MoPU 12. The robot may be a humanoid smart robot that performs work instead of a human. In this case, the central brain 15 controls motions of arms, palms, fingers, feet, and the like of the robot based on the information output from the IPU 11 and the MoPU 12, and causes the robot to make motions such as gripping, grasping, holding, carrying, moving, transporting, throwing, kicking, and avoiding the object. In a case where the central brain 15 performs the operation control of the robot, the IPU 11 and the MoPU 12 may be mounted at positions corresponding to a right eye and a left eye of the robot. That is, the IPU 11 and the MoPU 12 for the right eye may be mounted on the right eye, and the IPU 11 and the MoPU 12 for the left eye may be mounted on the left eye.

In addition, in a case where the image captured by the camera 302 is not clear because dirt adheres to a lens of the camera 302, dirt adheres to a windshield, or the like, it may be difficult to control the autonomous driving of the vehicle 100.

Therefore, in a case where the image captured by the camera 302 is not clear, the central brain 15 may use the image captured by the ultra-high-resolution camera of the IPU 11 as a substitute for the image captured by the camera 302. Examples of the case where the image captured by the camera 302 is not clear include a case where a predetermined region of the image captured by the camera 302 is extremely dark or has a low contrast even though the vehicle 100 is traveling outdoors in daytime.

The central brain 15 can continue the control of the autonomous driving of the vehicle 100 by using the image captured by the ultra-high-resolution camera of the IPU 11 as a substitute for the image captured by the camera 302.

In a case where the image captured by the camera 302 is not clear, the central brain 15 may execute processing of sharpening the image captured by the camera 302. As such processing, for example, the central brain 15 may operate a wiper to eject a cleaning liquid to remove the dirt from the windshield.

Thereafter, in a case where the image captured by the camera 302 becomes clear, the central brain 15 may return the processing to use the image captured by the camera 302 for the control of the autonomous driving of the vehicle 100.

The information processing apparatus 10 may acquire the image captured by the camera 302 of another vehicle 100 from the another vehicle 100. Furthermore, the information processing apparatus 10 may acquire, from the another vehicle 100, the position information included in the point information output from the MoPU 12 of the another vehicle 100. In this case, it is desirable that the another vehicle 100 that acquires the image and the position information is present, for example, in the vicinity of the vehicle 100 and travels in the same direction as the vehicle 100.

In a case where the image (another apparatus image) captured by the camera 302 of the another vehicle 100 and the position information included in the point information output from the MoPU 12 of the another vehicle 100 are acquired from the another vehicle 100, the MoPU 12 compares the image (own apparatus image) captured by the camera 302 of the own vehicle 100 with the another apparatus image, and extracts a range common to both images. Then, the MoPU 12 may acquire the position information included in the point information of the own apparatus image by using the image of the extracted range and the position information acquired from the another vehicle 100.

The MoPU 12 extracts a range common to both images by an arbitrary method. For example, the MoPU 12 may detect the presence of a subject (a human, an object, or the like) common to both images and extract a range common to both images by using the detection result.

Furthermore, the MoPU 12 may synchronize a frame of the own apparatus image and a frame of the another apparatus image in consideration of a transmission time of the image and the position information from the another vehicle 100. The MoPU 12 synchronizes the frame of the own apparatus image and the frame of the another apparatus image, so that it is possible to extract a common range using two images captured at the same timing. Since the common range can be extracted using two images captured at the same timing, the MoPU 12 can accurately acquire the position information included in the point information of the own apparatus image.

In a case where the information processing apparatus 10 is included in the robot, the image and the position information may be acquired not from the another vehicle 100 but from an apparatus having a configuration similar to the configuration shown in Fig. 2, for example, a robot present in the vicinity of the robot.

(Third Embodiment)

Next, a third embodiment according to the present embodiment will be described while omitting or simplifying an overlapping portion with the above embodiments.

As an example, an information processing apparatus 10 according to the third embodiment has a configuration shown in Fig. 2 similar to that of the first embodiment.

An MoPU 12 according to the third embodiment outputs, as point information, a plurality of coordinate values which are coordinate values indicating existence positions of at least two diagonal points at vertices of a polygon surrounding a contour of an object recognized from an image captured by another camera (an image obtained by performing imaging using the another camera). Similarly to the first embodiment, the coordinate values indicated by the plurality of coordinate values are an x coordinate value and a y coordinate value of the object in the above-described three-dimensional orthogonal coordinate system. The plurality of coordinate values are an example of "second coordinate values".

Fig. 4 is an explanatory diagram showing an example of the point information output from the MoPU 12 according to the third embodiment. Fig. 4 shows bounding boxes 21, 22, 23, and 24 in which a contour of each of four objects included in the image captured by the another camera (the image obtained by performing imaging using the another camera) is surrounded by a quadrangle. Fig. 4 shows an aspect in which the MoPU 12 outputs the coordinate values of two diagonal points at vertices of the quadrangular bounding boxes 21, 22, 23, and 24 surrounding the contours of the objects as the plurality of coordinate values. As described above, the MoPU 12 may present the object not as a point but as an object having a certain size.

Furthermore, in the case of representing the object as the object having a certain size, the MoPU 12 may output, as the plurality of coordinate values, coordinate values of a plurality of vertices of the polygon surrounding the contour of the object, instead of the coordinate values of two diagonal points at vertices of the polygon surrounding the contour of the object recognized from the image captured by the another camera (the image obtained by performing imaging using the another camera). For example, taking Fig. 4 as an example, the MoPU 12 may output, as the plurality of coordinate values, coordinate values of all four vertices of the bounding boxes 21, 22, 23, and 24 in which the contour of the object is surrounded by a quadrangle.

In the above description, a case where the MoPU 12 outputs the plurality of coordinate values from the image of the object captured by the another camera as the point information has been exemplified, but the technology of the disclosure is not limited to this aspect. The MoPU 12 may switch and output, as the point information, a single coordinate value indicating an existence position of a center point or a center-of-gravity point of the object or the plurality of coordinate values at a predetermined timing on at least two coordinate axes (for example, the x axis and the y axis) of the three-dimensional orthogonal coordinate system from the image of the object captured by the another camera. The single coordinate value is an example of a "first coordinate value".

For example, in a case where an IPU 11 cannot identify the imaged object from the image of the object captured by an ultra-high-resolution camera due to a predetermined factor as the predetermined timing, the MoPU 12 switches the coordinate value to be output as the point information from the single coordinate value to the plurality of coordinate values. Here, in a case where the IPU 11 cannot identify the type of the imaged object and cannot output label information to a central brain 15, the IPU 11 outputs instruction information for switching the coordinate value to be output as the point information to the MoPU 12. As an example, in a case where the instruction information is acquired, the MoPU 12 determines that the IPU 11 cannot identify the imaged object, and switches the coordinate value to be output as the point information from the single coordinate value to the plurality of coordinate values.

With the above configuration, for example, in a case where the IPU 11 cannot identify the imaged object due to an influence of darkness, bad weather, or the like as the predetermined factor, the MoPU 12 can play a role of grasping a size of the object instead of the IPU 11 by switching the coordinate value to be output as the point information to the plurality of coordinate values.

Furthermore, in a case where a movement speed of the object is equal to or lower than a predetermined threshold or in a case where a movement direction of the object is a predetermined direction as the predetermined timing, the MoPU 12 switches the coordinate value to be output as the point information from the plurality of coordinate values to the single coordinate value.

The MoPU 12 calculates a speed score which is a score for the speed of the object caught on the another camera. As an example, the speed score is set to be higher as the movement speed of the object is higher and is set to be lower as the movement speed of the object is lower. Then, in a case where the calculated speed score is equal to or lower than a predetermined threshold because the movement speed of the object is lower than the threshold, the MoPU 12 switches the coordinate value to be output as the point information from the plurality of coordinate values to the single coordinate value.

Furthermore, the MoPU 12 calculates a direction score which is a score for the movement direction of the object caught on the another camera. As an example, the direction score is set to be higher in a case where the movement direction of the object is a direction approaching the road, and is set to be lower in a case where the movement direction is a direction away from the road. Then, in a case where the calculated direction score is lower than a threshold because the movement direction of the object is the direction away from the road as the predetermined direction, the MoPU 12 switches the coordinate value to be output as the point information from the plurality of coordinate values to the single coordinate value.

With the above configuration, the coordinate value to be output as the point information is switched to the single coordinate value in a case where a risk level indicating the degree of risk of a place where the vehicle 100 is to travel in the future is low, so that it is possible to reduce the amount of data output to the central brain 15 while reducing a processing load on the MoPU 12.

(Fourth Embodiment)

Next, a fourth embodiment according to the present embodiment will be described while omitting or simplifying an overlapping portion with the above embodiments.

As an example, an information processing apparatus 10 according to the fourth embodiment has a configuration shown in Fig. 2 similar to that of the first embodiment.

A vehicle 100 on which the information processing apparatus 10 according to the fourth embodiment is mounted includes a sensor including at least one of a radar, a light detection and ranging (LiDAR), a high-pixel, telephoto, ultra-wide angle, 360-degrees, high-performance camera, a vision sensor, a sound sensor, an ultrasonic sensor, a vibration sensor, an infrared sensor, an ultraviolet sensor, a radio wave sensor, a temperature sensor, and a humidity sensor. Examples of sensor information taken in from the sensor by the information processing apparatus 10 include center of gravity shift in a weight, detection of road material, detection of outside-air temperature, detection of outside-air humidity, detection of vertical and lateral inclination angles of slopes, detection of a freezing state and a moisture level of a road, detection of a material, a wear condition, and a tire pressure of each tire, a road width, the presence or absence of no-passing zones, an oncoming vehicle, vehicle type information of preceding and following vehicles, cruising states of such vehicles, and a surrounding situation (birds, animals, soccer balls, accident vehicles, earthquakes, housework, winds, typhoons, heavy rain, light rain, snowstorm, fog, or the like). The sensor is an example of a "detection unit", and the sensor information is an example of "detection information".

A central brain 15 according to the fourth embodiment calculates a control variable for controlling autonomous driving of the vehicle 100 based on the sensor information detected by the sensor. The central brain 15 acquires the sensor information every 1/1 billion seconds. Specifically, the central brain 15 calculates control variables for controlling a wheel speed and an inclination of each of four wheels of the vehicle 100 and a suspension supporting the wheels. The inclination of the wheel includes both an inclination of the wheel with respect to an axis horizontal to the road and an inclination of the wheel with respect to an axis perpendicular to the road. In this case, the central brain 15 calculates a total of 16 control variables for controlling the wheel speed of each of the four wheels, the inclination of each of the four wheels with respect to the axis horizontal to the road, the inclination of each of the four wheels with respect to the axis perpendicular to the road, and the suspension supporting each of the four wheels.

Then, the central brain 15 controls the autonomous driving of the vehicle 100 based on the control variables calculated above, point information output from an MoPU 12, and label information output from an IPU 11. Specifically, the central brain 15 controls in-wheel motors respectively mounted on the four wheels based on 16 control variables described above, thereby controlling the wheel speed and the inclination of each of the four wheels of the vehicle 100 and the suspension supporting each of the four wheels to perform the autonomous driving. Furthermore, the central brain 15 recognizes a position and a motion of a recognized object present around the vehicle 100 based on the point information and the label information, and controls the autonomous driving of the vehicle 100 to avoid a collision with the object, for example, based on the recognized information. As the central brain 15 controls the autonomous driving of the vehicle 100 in this manner, for example, in a case where the vehicle 100 travels on a mountain road, it is possible to perform optimal steering suitable for the mountain road, and in a case where the vehicle 100 is parked in a parking lot, it is possible to perform traveling at an optimal angle suitable for the parking lot.

Here, the central brain 15 may be capable of inferring the control variable from the sensor information and information that can be acquired from a server (not shown) or the like via a network using machine learning, more specifically, deep learning. In other words, the central brain 15 can be implemented by AI.

The central brain 15 can obtain the control variable by performing multivariate analysis (see, for example, Formula (2)) by an integration method as shown in the following Formula (1) using computational power for implementing Level 6 (hereinafter also referred to as "computational power of Level 6"), the computational power being computational power for the sensor information and long-tail incident AI data of every 1/1 billion seconds. More specifically, each control variable is obtained at an edge level and in real time while obtaining an integral value of various ultra high resolution delta values with the computational power of Level 6, and a result (that is, each control variable) obtained in the next 1/1 billion seconds can be acquired as the highest probabilistic value. In order to implement such a configuration, for example, an integral value obtained by time-integrating delta values (for example, minute time change values) of a function (in other words, a function indicating behavior of each variable) capable of specifying each variable (for example, the sensor information and the information that can be acquired via the network) such as an air resistance, a road resistance, a road element (for example, garbage), or a slip coefficient is input to a deep learning model (for example, a trained model obtained by performing deep learning on a neural network) of the central brain 15. The deep learning model of the central brain 15 outputs the control variable (for example, the control variable with the highest certainty level (that is, an evaluation value)) corresponding to the input integral value. The output of the control variable is performed in units of 1/1 billion seconds.

[Math. 1]

$$\mathrm{v} = \int_a^b f(A)dt \qquad (1)$$

[Math. 2]

$$V_n = DL\big(f(A,B,C,D,\cdots,N)(dA_n/dt)\big) \qquad (2)$$

As an example, in Formula (1), "f(A)" is an expression in which the function indicating the behavior of each variable such as the air resistance, the road resistance, the road element (for example, garbage), or the slip coefficient is expressed in a simplified manner. Furthermore, as an example, Formula (1) is a formula indicating a time integral v of "f(A)" from time a to time b. In Formula (2), DL represents deep learning (for example, a deep learning model optimized by performing deep learning on a neural network), $dA_n/dt$ represents the delta value of $f(A,B,C,D,\cdots,N)$, A, B, C, D, ..., and N represent the variables such as the air resistance, the road resistance, the road element (for example, garbage), and the slip coefficient, $f(A,B,C,D,\cdots,N)$ represents a function representing behavior of A, B, C, D, ..., and N, and $V_n$ represents a value (control variable) output from the deep learning model optimized by performing deep learning on the neural network.

Here, a mode example in which the integral value obtained by time-integrating the delta values of the function is input to the deep learning model of the central brain 15 is described, but this is merely an example. For example, the integral value (for example, the result obtained in the next 1/1 billion seconds) obtained by time-integrating the delta values of the function indicating the behavior of each variable such as the air resistance, the road resistance, the road element, or the slip coefficient may be inferred by the deep learning model of the central brain 15, and as an inference result, an integral value with the highest certainty level (that is, the evaluation value) may be acquired by the central brain 15 every 1/1 billion seconds.

Here, a mode example in which the integral value is input to the deep learning model or the integral value is output from the deep learning model is described, but this is merely an example, and the technology of the disclosure can be established without using the integral value. For example, at least one control variable may be inferred by the deep learning model optimized by performing deep learning on the neural network using training data in which values corresponding to A, B, C, D, ..., and N are used as example data and a value corresponding to the at least one control variable (for example, the result obtained in the next 1/1 billion seconds) is used as ground truth data.

The control variable obtained by the central brain 15 can be further refined by increasing the number of times the deep learning is performed. For example, it is possible to calculate a more accurate control variable by using enormous data such as rotation of a tire or a motor, a steering angle, a material of a road, weather, a garbage, an influence of quadratic deceleration, slip, steering for of balance loss and recovery, and a speed control method, or long-tail incident AI data.

(Fifth Embodiment)

Next, a fifth embodiment according to the present embodiment will be described while omitting or simplifying an overlapping portion with the above embodiments.

Fig. 5 is a block diagram showing an example of a configuration of an information processing apparatus 10 according to the fifth embodiment. Fig. 5 shows only a configuration of a part of the information processing apparatus 10.

As shown in Fig. 5, in an MoPU 12, a visible light image and an infrared image of an object captured by a camera 30 are input to a core 17 at a frame rate of 100 frames/second or higher. The camera 30 includes a visible light camera 305A capable of capturing the visible light image of the object and an infrared camera 305B capable of capturing the infrared image of the object. Then, the core 17 outputs point information to a central brain 15 based on at least one of the visible light image and the infrared image that are input.

Here, in a case where the object can be identified from the visible light image of the object captured by the visible light camera 305A, the core 17 outputs the point information based on the visible light image. On the other hand, in a case where the object is not identified from the visible light image due to a predetermined factor, the core 17 outputs the point information based on the infrared image of the object captured by the infrared camera 305B. For example, it is assumed that the core 17 cannot identify the object from the visible light image due to an influence of darkness as the predetermined factor. In this case, the core 17 detects heat of the object by using the infrared camera 305B, and outputs the point information of the object based on the infrared image which is the detection result. The technology of the disclosure is not limited thereto, and the core 17 may output the point information based on the visible light image and the infrared image.

Furthermore, the MoPU 12 synchronizes a timing at which the visible light camera 305A captures the visible light image (imaging for obtaining the visible light image is performed by the visible light camera 305A) with a timing at which the infrared camera 305B captures the infrared image (imaging for obtaining the infrared image is performed by the infrared camera 305B). Specifically, the MoPU 12 outputs a control signal to the camera 30 so as to capture the visible light image and the infrared image at the same timing (the MoPU 12 performs imaging of visible light and imaging of infrared light). As a result, the number of images per second captured by the visible light camera 305A (the number of images per second obtained by performing imaging using the visible light camera 305A) and the number of images per second captured by the infrared camera 305B (the number of images per second obtained by performing imaging using the infrared camera 305B) are synchronized with each other (for example, 1920 frames/sec).

(Sixth Embodiment)

Next, a sixth embodiment according to the present embodiment will be described while omitting or simplifying an overlapping portion with the above embodiments.

Fig. 6 is a block diagram showing an example of a configuration of an information processing apparatus 10 according to the sixth embodiment. Fig. 6 shows only a configuration of a part of the information processing apparatus 10.

As shown in Fig. 6, in an MoPU 12, an image of an object captured by a camera 30 and a radar signal based on a reflected wave of an electromagnetic wave emitted to the object by a radar 32 from the object are input to a core 17 at a frame rate of 100 frames/second or higher. Then, the core 17 outputs point information to a central brain 15 based on the image of the object and the radar signal that are input. The core 17 can derive an x coordinate value and a y coordinate value of the object from the input image of the object. As described above, the radar 32 can acquire three-dimensional point cloud data of the object based on the radar signal and detect a coordinate on the z axis in the above-described three-dimensional orthogonal coordinate system. In this case, the core 17 derives coordinate values of the object on three coordinate axes (the x axis, the y axis, and the z axis) as the point information by combining the x coordinate value and the y coordinate value of the object imaged by the camera 30 at the same timing as a timing at which the radar 32 acquires the three-dimensional point group data of the object and the z coordinate value of the object indicated by the three-dimensional point group data, by using the principle of a stereo camera. The image of the object input to the core 17 may include at least one of a visible light image and an infrared image.

Furthermore, the MoPU 12 synchronizes a timing at which the camera 30 captures the image (the camera 30 performs imaging) with a timing at which the radar 32 acquires the three-dimensional point cloud data of the object based on the radar signal. Specifically, the MoPU 12 captures the image at the same timing and outputs a control signal to the camera 30 and the radar 32 so as to acquire the three-dimensional point cloud data of the object. As a result, the number of images per second captured by the camera 30 (the number of images per second obtained by performing imaging using the camera 30) is synchronized with the number of pieces of three-dimensional point cloud data per second acquired by the radar 32 (for example, 1920 frames/sec). In this manner, the number of images per second captured by the camera 30 (the number of images per second obtained by performing imaging using the camera 30) and the number of pieces of three-dimensional point cloud data per second acquired by the radar 32 are larger than a frame rate of an ultra-high-resolution camera included in an IPU 11, that is, the number of images per second captured by the ultra-high-resolution camera (the number of images per second obtained by performing imaging using the ultra-high-resolution camera).

(Seventh Embodiment)

Next, a seventh embodiment according to the present embodiment will be described while omitting or simplifying an overlapping portion with the above embodiments.

As an example, an information processing apparatus 10 according to the seventh embodiment has a configuration shown in Fig. 2 similar to that of the first embodiment.

A central brain 15 according to the seventh embodiment associates, with label information, point information output from an MoPU 12 at the same timing as a timing at which an IPU 11 outputs the label information. Furthermore, in a case where new point information is output from the MoPU 12 after the point information and the label information are associated with each other, the central brain 15 also associates the new point information with the label information. The new point information is point information of the same object as an object indicated by the point information associated with the label information, and is one or more pieces of point information from when the association is performed to when the next label information is output. In the seventh embodiment, similarly to the above embodiment, a frame rate of another camera in which the MoPU 12 is built is 100 frames/second or higher (for example, 1920 frames/sec), and a frame rate of an ultra-high-resolution camera in which the IPU 11 is built is 10 frames/second.

Fig. 7A is an explanatory diagram showing an example of the association between the point information and the label information according to the seventh embodiment. In the following description, the number of pieces of point information per second output from the MoPU 12 is referred to as an "output rate of the point information", and the number of pieces of label information per second output from the IPU 11 is referred to as an "output rate of the label information".

Fig. 7A shows a time series of an output rate of point information P4 of an object B14. The output rate of the point information P4 for the object B14 is 1920 frames/second. Further, the point information P4 moves from right to left in the figure. An output rate of label information for the object B14 is 10 frames/second, which is lower than the output rate of the point information P4.

First, at time t0, the label information for the object B14 is not output from the IPU 11. Therefore, at time t0, the central brain 15 recognizes coordinate values (position information) of the object B14 based on the point information P4, and does not recognize what the object B14 is.

Next, at time t1, the label information for the object B14 is output from the IPU 11. Therefore, the central brain 15 derives label information "PERSON" for the object B14 based on the label information. Then, the central brain 15 associates the label information "PERSON" derived at time t1 with the coordinate values (position information) of the point information P4 output from the MoPU 12 at time t1. As a result, at time t1, the central brain 15 recognizes the coordinate values (position information) of the object B14 based on the point information P4 and recognizes what the object B14 is.

In Fig. 7A, a timing at which the next label information for the object B14 is output from the IPU 11 is time t2. Therefore, at time t2, the central brain 15 derives the label information "PERSON" for the object B14 based on the label information output from the IPU 11. Then, the central brain 15 associates the label information "PERSON" derived at time t2 with the coordinate values (position information) of the point information P4 output from the MoPU 12 at time t2.

Here, the point information P4 for the object B14 is acquired by the central brain 15, and the label information is not acquired in a period from time t1 to time t2 due to the frame rate difference between the another camera in which the MoPU 12 is built and the ultra-high-resolution camera in which the IPU 11 is built. In this case, the central brain 15 associates the point information P4 acquired in the period from time t1 to time t2 with the label information "PERSON" associated with the immediately preceding time t1. Here, the point information P4 acquired by the central brain 15 in the period from time t1 to time t2 is an example of the "new point information". In the example shown in Fig. 7A, a plurality of pieces of point information P4 are output from the MoPU 12 in the period from time t1 to time t2, and thus, the central brain 15 acquires the plurality of pieces of point information P4. Therefore, in the example shown in Fig. 7A, the central brain 15 associates any one of the plurality of pieces of point information P4 acquired in the period from time t1 to time t2 with the label information "PERSON" associated with the immediately preceding time t1. Unlike the example shown in Fig. 7A, in a case where one piece of point information P4 is output from the MoPU 12 in the period from time t1 to time t2, the central brain 15 associates the one piece of point information P4 with the label information "PERSON" associated with the immediately preceding time t1.

Here, even in a case where there is a period in which the type of the object whose motion is being tracked is uncertain, the central brain 15 continuously outputs the point information of the object at a high frame rate, and thus, a risk of losing the coordinate values (position information) of the object is low. Therefore, in a case where the association between the point information and the label information is performed once, the central brain 15 can presumptively assign the immediately preceding label information to the point information acquired before the next label information is acquired.

The central brain 15 derives a speed and an acceleration of the object based on a time series of coordinate values of the point information. Furthermore, the central brain 15 predicts the motion of the object based on the time series of coordinate values of the point information. The label information of the object may be used for the prediction of the motion of the object.

Here, it is necessary that the label information and the coordinate values of the point information associated with each other are related to the same object. That is, it is necessary to avoid association between label information of an object A and coordinate values of point information of an object B different from the object A. The following Conditions 1 to 3 are conditions for a target object of label information and a target object of coordinate values of point information to be the same object.

<Condition 1>

A relative positional relationship between a high-resolution image output from the IPU 11 (hereinafter referred to as an IPU image) and an image captured by the camera on which the MoPU 12 is mounted (hereinafter referred to as an MoPU image) can be specified from installation positions (view angle difference) of the camera on which the IPU 11 is mounted and the camera on which the MoPU 12 is mounted. In a case where a position of an object appearing in the IPU image and a position of an object appearing in the MoPU image match each other, the two objects indicate the same object. Therefore, the matching between the position of the object appearing in the IPU image and the position of the object appearing in the MoPU image is defined as Condition 1 that the two objects indicate the same object. "The matching between the positions" means that the objects appearing in the IPU image and the MoPU image can be regarded as being at the same position in consideration of the view angle difference between the IPU image and the MoPU image.

<Condition 2>

Although the MoPU image has a low resolution, a contour of the object is recognizable. In a case where the contour of the object appearing in the IPU image and the contour of the object appearing in the MoPU image match each other, the two objects may indicate the same object. Therefore, the matching between the contour of the object appearing in the IPU image and the contour of the object appearing in the MoPU image is defined as Condition 2 that the two objects indicate the same object. "The matching between the contours" means that a similarity between the contour of the object appearing in the IPU image and the contour of the object appearing in the MoPU image is equal to or higher than a certain level. For example, the contour of the object appearing in the MoPU image and the contour of the object appearing in the IPU image may be superimposed on each other in consideration of a positional deviation, and in a case where a ratio at which positions of the contours of the objects in both images coincide with each other is equal to or higher than a predetermined threshold, it may be determined that the similarity between the contours of the objects appearing in both images is equal to or higher than the certain value.

<Condition 3>

It is possible to estimate what the object is to some extent from a motion of the point information of the object recognized by the MoPU 12. For example, a motion of a human and a motion of an automobile are clearly different from each other. Structures such as signs and signals do not move at all. In a case where the type of the object estimated from the motion of the point information of the object identified by the MoPU 12 matches the type of the object (label information) estimated from the IPU image, there is a possibility that the two objects indicate the same object. Therefore, matching between the type of the object estimated from the motion of the point information of the object identified by the MoPU and the type of the object (label information) estimated from the IPU image is defined as Condition 3 that the two objects indicate the same object. "The matching between the types of the objects" means that the type of the object estimated from the motion of the point information of the object identified by the MoPU 12 and the type of the object (label information) estimated from the IPU image do not contradict each other.

In a case where all of the above Conditions 1 to 3 are satisfied, the central brain 15 determines that the target object of the label information and the target of the coordinate values of the point information indicate the same target, and associates the point information with the label information for both target objects. Fig. 7B is a flowchart showing an example of a flow of processing of associating between the point information and the label information, which is executed by the central brain 15 according to the seventh embodiment.

In step S1, the central brain 15 extracts objects satisfying Condition 1, that is, objects whose positions match, among objects appearing in the IPU image and objects appearing in the MoPU image. In step S2, the central brain 15 further extracts objects satisfying Condition 2, that is, objects whose contours match, from the objects satisfying Condition 1 among the objects appearing in the IPU image and the objects appearing in the MoPU image. In step S3, the central brain 15 further extracts objects satisfying Condition 3, that is, objects whose types match, from the objects satisfying both Condition 1 and Condition 2 among the object appearing in the IPU image and the object appearing in the MoPU image. In step S4, the central brain 15 associates the coordinate values of the point information with the label information for the object extracted in step S3, that is, the object satisfying all the Conditions 1 to 3. In the above description, a case where objects satisfying all Conditions 1 to 3 are determined to be the same object has been exemplified. However, objects satisfying one or two of Conditions 1 to 3 may be determined to be the same object, and the coordinate values of the point information and the label information may be associated with each other for the object. In this case, at least one of Conditions 1 to 3 may be set as an essential condition. For example, even in a case where Condition 3 (matching between the pieces of label information) is set as the essential condition and the other two conditions are not satisfied, it may be determined that the corresponding objects indicate the same object. Further, reliability of identity of the objects may be derived based on the number of satisfied conditions, and the reliability may be used for the vehicle control. For example, in a case where all of Conditions 1 to 3 are satisfied, the vehicle control suitable to the object may be performed.

(Eighth Embodiment)

Next, an eighth embodiment according to the present embodiment will be described while omitting or simplifying an overlapping portion with the above embodiments.

Heat generation becomes a problem in a case where an information processing apparatus 10 that controls autonomous driving of a vehicle 100 performs advanced arithmetic processing. Therefore, the eighth embodiment provides the vehicle 100 having a cooling function for the information processing apparatus 10.

Fig. 8 is an explanatory diagram showing a schematic configuration of the vehicle 100 according to the eighth embodiment. As shown in Fig. 8, the information processing apparatus 10, a cooling execution apparatus 110, and a cooling unit 120 are mounted on the vehicle 100.

The information processing apparatus 10 according to the eighth embodiment is an apparatus that controls the autonomous driving of the vehicle 100, and has, as an example, a configuration shown in Fig. 2 similar to that of the first embodiment. The cooling execution apparatus 110 acquires an object detection result of the information processing apparatus 10, and causes the cooling unit 120 to cool the information processing apparatus 10 based on the detection result. The cooling unit 120 cools the information processing apparatus 10 by using at least one cooling means such as air cooling means, water cooling means, and liquid nitrogen cooling means. Hereinafter, a central brain 15 (specifically, a CPU 14 included in the central brain 15) that controls the autonomous driving of the vehicle 100 is described as a cooling target in the information processing apparatus 10, but the cooling target is not limited thereto.

The information processing apparatus 10 and the cooling execution apparatus 110 are communicably connected via a network (not shown). The network may be any one of a vehicle network, the Internet, a local area network (LAN), and a mobile communication network. The mobile communication network may conform to any one of a 5th generation (5G) communication scheme, a long term evolution (LTE) communication scheme, a 3rd generation (3G) communication scheme, and a subsequent communication scheme including a 6th generation (6G) communication scheme.

Fig. 9 is a block diagram showing an example of a functional configuration of the cooling execution apparatus 110 according to the eighth embodiment. As shown in Fig. 9, the cooling execution apparatus 110 includes an acquisition unit 112, an execution unit 114, and a prediction unit 116 as functional configurations.

The acquisition unit 112 acquires the object detection result of the information processing apparatus 10. For example, the acquisition unit 112 acquires point information of an object output from an MoPU 12 as the detection result.

The execution unit 114 performs the cooling of the central brain 15 based on the object detection result acquired by the acquisition unit 112. For example, in a case where movement of the object is recognized based on the point information of the object output from the MoPU 12, the execution unit 114 causes the cooling unit 120 to start cooling the central brain 15.

The execution unit 114 is not limited to performing cooling of the central brain 15 based on the object detection result, and may perform cooling of the central brain 15 based on a prediction result for an operation status of the information processing apparatus 10.

Here, the prediction unit 116 predicts the operation status of the information processing apparatus 10, specifically, the central brain 15, based on the object detection result acquired by the acquisition unit 112. For example, the prediction unit 116 acquires a learning model stored in a predetermined storage region. Then, the prediction unit 116 predicts the operation status of the central brain 15 by inputting the point information of the object output from the MoPU 12 acquired by the acquisition unit 112 to the learning model. Here, the learning model outputs a status and a change amount of computing power of the central brain 15 as the operation status. Furthermore, the prediction unit 116 may predict and output a temperature change of the information processing apparatus 10, specifically, the central brain 15, together with the operation status. For example, the prediction unit 116 predicts the temperature change of the central brain 15 based on the number of pieces of point information of the object output from the MoPU 12 acquired by the acquisition unit 112. In this case, the prediction unit 116 predicts that the temperature change increases as the number of pieces of point information increases, and predicts that the temperature change decreases as the number of pieces of point information decreases.

In the above case, the execution unit 114 causes the cooling unit 120 to start cooling the central brain 15 based on the prediction result for the operation status of the central brain 15 from the prediction unit 116. For example, in a case where the status and the change amount of the computing power of the central brain 15 predicted as the operation status exceed predetermined thresholds, the execution unit 114 starts cooling by the cooling unit 120. Furthermore, in a case where a temperature based on the temperature change of the central brain 15 predicted as the operation status exceeds a predetermined threshold, the execution unit 114 starts cooling by the cooling unit 120.

Furthermore, the execution unit 114 may perform the cooling of the central brain 15 by using cooling means corresponding to the prediction result for the temperature change of the central brain 15 from the prediction unit 116. For example, the execution unit 114 may cause the cooling unit 120 to perform cooling by using a larger number of cooling means as the predicted temperature of the central brain 15 is higher. As a specific example, in a case where it is predicted that the temperature of the central brain 15 exceeds a first threshold, the execution unit 114 causes the cooling unit 120 to perform cooling using one cooling means. On the other hand, in a case where it is predicted that the temperature of the central brain 15 exceeds a second threshold higher than the first threshold, the execution unit 114 causes the cooling unit 120 to perform cooling using a plurality of cooling means.

Furthermore, the execution unit 114 may perform the cooling of the central brain 15 by using stronger cooling means as the predicted temperature of the central brain 15 is higher. For example, in a case where it is predicted that the temperature of the central brain 15 exceeds the first threshold, the execution unit 114 causes the cooling unit 120 to perform cooling using the air cooling means. Furthermore, in a case where it is predicted that the temperature of the central brain 15 exceeds the second threshold higher than the first threshold, the execution unit 114 causes the cooling unit 120 to perform cooling using the water cooling means. Furthermore, in a case where it is predicted that the temperature of the central brain 15 exceeds a third threshold higher than the second threshold, the execution unit 114 causes the cooling unit 120 to perform cooling using the liquid nitrogen cooling means.

Furthermore, the execution unit 114 may determine the cooling means to be used for cooling based on the number of pieces of point information of the object output from the MoPU 12 acquired by the acquisition unit 112. In this case, the execution unit 114 may perform the cooling of the central brain 15 by using stronger cooling means as the number of pieces of point information is larger. For example, in a case where the number of pieces of point information exceeds a first threshold, the execution unit 114 causes the cooling unit 120 to perform cooling using the air cooling means. In addition, in a case where the number of pieces of point information exceeds a second threshold larger than the first threshold, the execution unit 114 causes the cooling unit 120 to perform cooling using the water cooling means. Furthermore, in a case where the number of pieces of point information exceeds a third threshold larger than the second threshold, the execution unit 114 causes the cooling unit 120 to perform cooling using the liquid nitrogen cooling means.

In some cases, a mobile object present on a roadway may be detected as a trigger for operation of the central brain 15. For example, in a case where a mobile object present on a roadway is detected when the vehicle 100 is performing the autonomous driving, the central brain 15 may execute arithmetic processing for controlling the vehicle 100 with respect to the object. As described above, heat generation when the central brain 15 that controls the autonomous driving of the vehicle 100 executes advanced arithmetic processing becomes a problem. Therefore, the cooling execution apparatus 110 according to the eighth embodiment predicts heat dissipation of the central brain 15 based on the object detection result of the information processing apparatus 10, and perform the cooling of the central brain 15 before or simultaneously with the start of heat dissipation. As a result, the central brain 15 is suppressed from becoming high temperature during the autonomous driving of the vehicle 100, and an advanced arithmetic operation during the autonomous driving becomes possible.

(Ninth Embodiment)

Next, a ninth embodiment according to the present embodiment will be described while omitting or simplifying an overlapping portion with the above embodiments.

An MoPU 12 included in an information processing apparatus 10 according to the ninth embodiment derives a z coordinate value of an object as point information from an image of the object captured by a camera. Hereinafter, each aspect of the information processing apparatus 10 according to the ninth embodiment will be sequentially described.

The information processing apparatus 10 according to a first aspect has a configuration shown in Fig. 3 similar to that of the second embodiment.

In the first aspect, the MoPU 12 derives the z coordinate value of the object as the point information from images of the object captured by a plurality of cameras 302, specifically, cameras 302L and 302R. As described above, in a case where one MoPU 12 is used, it is possible to derive an x coordinate value and a y coordinate value of the object as the point information. Here, in a case where two MoPUs 12 are used, it is possible to derive the z coordinate value of the object as the point information based on the images of the object captured by the two cameras 302 using the principle of a stereo camera. Therefore, in the first aspect, the z coordinate value of the object is derived as the point information based on the images of the object captured by the camera 302L of the MoPU 12L and the camera 302R of the MoPU 12R using the principle of the stereo camera.

The information processing apparatus 10 according to a second aspect has a configuration shown in Fig. 3 similar to that of the second embodiment.

In the second aspect, the MoPU 12 derives the x coordinate value, the y coordinate value, and the z coordinate value of the object as the point information from the image of the object captured by the camera 302 and a radar signal based on a reflected wave of an electromagnetic wave emitted to the object by a radar 32 from the object. As described above, the radar 32 can acquire three-dimensional point cloud data of the object based on the radar signal. That is, the radar 32 can detect the coordinate on the z axis in the above-described three-dimensional orthogonal coordinate system. In this case, the MoPU 12 derives the coordinate values of the object on three coordinate axes as the point information by combining the x coordinate value and the y coordinate value of the object imaged by the camera 302 at the same timing as a timing at which the radar 32 acquires the three-dimensional point group data of the object and the z coordinate value of the object indicated by the three-dimensional point group data, by using the principle of the stereo camera.

The information processing apparatus 10 according to the third aspect has the configuration shown in Fig. 10. Fig. 10 is a first block diagram showing an example of a configuration of the information processing apparatus 10 according to the ninth embodiment. Fig. 10 shows only a configuration of a part of the information processing apparatus 10.

In the third aspect, the MoPU 12 derives the z coordinate value of the object as the point information from an image of the object captured by a camera 30 and a result of imaging structured light emitted to the object by an irradiation device 130.

As shown in Fig. 10, in the MoPU 12, the image of the object captured by the camera 30 and distortion information indicating a distortion of a pattern of the structured light which is the result of imaging, by a camera 140, the structured light emitted to the object by the irradiation device 130 are input to a core 17 at a frame rate of 100 frames/second or higher. Then, the core 17 outputs the point information to a central brain 15 based on the image of the object and the distortion information that are input.

Here, a structured light method is used as one of methods for identifying a three-dimensional position or shape of the object. The structured light method irradiates the object with the structured light patterned in a dot shape, and acquires depth information from the distortion of the pattern. The structured light method is disclosed, for example, in a reference (http://ex-press.jp/wp-content/uploads/2018/10/018_teledyne_3rd.pdf).

The irradiation device 130 shown in Fig. 10 irradiates the object with the structured light. In addition, the camera 140 images the structured light emitted to the object by the irradiation device 130. Then, the camera 140 outputs the distortion information based on the distortion of the pattern of the imaged structured light to the core 17.

Here, the MoPU 12 synchronizes a timing at which the camera 30 captures the image (the camera 30 performs imaging) with a timing at which the camera 140 images the structured light. Specifically, the MoPU 12 outputs a control signal to the camera 30 and the camera 140 so as to capture the image at the same timing (perform imaging of the object at the same timing). As a result, the number of images per second captured by the camera 30 (the number of images per second obtained by performing imaging using the camera 30) and the number of images per second captured by the camera 140 (the number of images per second obtained by performing imaging using the camera 140) are synchronized with each other (for example, 1920 frames/sec). As described above, the number of images per second captured by the camera 30 (the number of images per second obtained by performing imaging using the camera 30) and the number of images per second captured by the camera 140 (the number of images per second obtained by performing imaging using the camera 140) are larger than a frame rate of an ultra-high-resolution camera included in an IPU 11, that is, the number of images per second captured by the ultra-high-resolution camera.

Then, the core 17 derives the z coordinate value of the object as the point information by combining the x coordinate value and the y coordinate value of the object imaged by the camera 140 at the same timing as the timing at which the structured light is imaged by the camera 30 and the distortion information based on the distortion of the pattern of the structured light.

The information processing apparatus 10 according to the fourth aspect has a configuration shown in Fig. 11. Fig. 11 is a second block diagram showing an example of a configuration of the information processing apparatus 10 according to the ninth embodiment. Fig. 11 shows only a configuration of a part of the information processing apparatus 10.

The block diagram shown in Fig. 11 is obtained by adding a Lidar sensor 18 to the configuration of the block diagram shown in Fig. 2. The Lidar sensor 18 is a sensor that acquires point cloud data including the object present in a three-dimensional space and a road surface on which a vehicle 100 is traveling. The information processing apparatus 10 can derive position information of the object in a depth direction, that is, the z coordinate value of the object by using the point cloud data acquired by the Lidar sensor 18. It is assumed that the point cloud data acquired by the Lidar sensor 18 is acquired at intervals longer than those of the x coordinate value and the y coordinate value of the object output from the MoPU 12. Further, the MoPU 12 includes the camera 30 similarly to the third aspect of the ninth embodiment.

In the fourth aspect, the MoPU 12 derives the coordinate values of the object on three coordinate axes as the point information by combining the x coordinate value and the y coordinate value of the object imaged by the camera 30 at the same timing as a timing at which the Lidar sensor 18 acquires the point cloud data of the object and the z coordinate value of the object indicated by the point cloud data, by using the principle of the stereo camera.

Here, in the fourth aspect, the MoPU 12 derives a z coordinate value of the object at time t+1 as the point information based on an x coordinate value, a y coordinate value, and a z coordinate value of the object at time t and an x coordinate value and a y coordinate value of the object at a time point (for example, time t+1) next to time t. Time t is an example of a "first time point", and time t+1 is an example of a "second time point". In the fourth aspect, the z coordinate value of the object at time t+1 is derived using shape information, that is, geometry. This will be described in detail below.

Fig. 12A is a diagram schematically showing coordinate detection in time series for the object in the ninth embodiment. In Fig. 12A, J indicates a position of the object represented by a rectangle, and the position of the object moves in time series from J1 to J2. In Fig. 12, the coordinate values of the object at time t at which the object is positioned at J1 are (x1,y1,z1), and the coordinate values of the object at time t+1 at which the object is positioned at J2 are (x2,y2,z2).

First, time t will be described.

The MoPU 12 derives the x coordinate value and the y coordinate value of the object from the image of the object captured by the camera 30. Subsequently, the MoPU 12 integrates the z coordinate value of the object indicated by the point cloud data acquired from the Lidar sensor 18, the x coordinate value, and the y coordinate value to derive three-dimensional coordinate values (x1,y1,z1) of the object at time t.

Next, time t+1 will be described.

The MoPU 12 derives the z coordinate value of the object at time t+1 based on the geometry of the space and a change in the x coordinate value and the y coordinate value of the object from time t to time t+1. The geometry of the space includes a shape of the road surface obtained from the image captured by the ultra-high-resolution camera included in the IPU 11 (the image obtained by performing imaging using the ultra-high-resolution camera) and the point cloud data of the Lidar sensor 18, and a shape of the vehicle 100.

The geometry indicating the shape of the road surface is generated in advance at time t. The MoPU 12 can simulate a case where the vehicle 100 travels on the road surface by using the geometry indicating the shape of the vehicle 100 together with the geometry indicating the shape of the road surface, and can estimate movement amounts on the respective axes of the x axis, the y axis, and the z axis.

Therefore, the MoPU 12 derives the x coordinate value and the y coordinate value of the object at time t+1 from the image of the object captured by the camera 30. The MoPU 12 can derive the z coordinate value of the object at time t+1 by calculating the movement amount on the z axis in a case where a change from the x coordinate value and the y coordinate value (x1,y1) of the object at time t to the x coordinate value and the y coordinate value (x2,y2) of the object at time t+1 is made by the simulation. Then, the MoPU 12 integrates the x coordinate value, the y coordinate value, and the z coordinate value to derive the three-dimensional coordinate values (x2,y2,z2) of the object at time t+1.

As shown in Fig. 12A, since the object moves in the depth direction during movement of plane coordinates (that is, the x axis and the y axis), it is also necessary to detect the movement in a z axis direction in order to control autonomous driving of the vehicle 100 with high accuracy. Here, in some cases, the MoPU 12 is not able to acquire the z coordinate value of the object that can be derived from the point cloud data of the Lidar sensor 18 at a speed as high as those for the x coordinate value and the y coordinate value of the object. Therefore, in the fourth aspect, the MoPU 12 derives the z coordinate value of the object at time t+1 from the x coordinate value, the y coordinate value, and the z coordinate value of the object at time t and the x coordinate value and the y coordinate value of the object at time t+1. As a result, in the information processing apparatus 10 according to the fourth aspect, the MoPU 12 can implement two-dimensional motion detection by high-frame-rate imaging and three-dimensional motion detection with high performance and low data volume.

Furthermore, in a case where a plurality of pieces of point information are detected, the MoPU 12 may derive the z coordinate value of the object at the next time point according to a priority determined for label information associated with the point information. For example, in the central brain 15, the point information and the label information are associated with each other, and a priority in the case of processing the z coordinate value is predetermined for the object indicated by the label information. Hereinafter, an example of the priority will be described. For example, in a case where the label information indicating the type of the object indicates an object that shows behavior, such as a person, a preceding vehicle, an animal, or an obstacle, and the behavior of the object is a target that affects traveling, a category with a high priority (RANK: A) is set. On the other hand, in a case where the label information indicates a static object such as a sign or a roadside installation and indicates an object that does not show behavior, a low priority (RANK: B) is set. As described above, in the MoPU 12, the priority can be set according to the presence or absence of the behavior of the object in the label information. Furthermore, a magnitude of the behavior of the object may be acquired from the central brain 15, the behavior of the object may be weighted, and the priority of the object may be updated. For example, the priority is updated such that a greater weight is applied for an object with significant behavior and a smaller weight is applied for an object with minor behavior.

In addition, RANK of the priority is not limited to A and B, and may be set in stages according to the type of the object, such as A to C or A to D, if appropriate. In addition, a subdivided priority may be set for the above-described high priority. For example, a person and a preceding vehicle can also be regarded as an object having a high risk level that can lead to a large accident. Therefore, RANK: A for the high priority is divided into RANK: A1 and RANK: A2, and a person and a preceding vehicle are set to RANK: A1, and an animal, an obstacle, or the like is set to RANK: A2. In this manner, the priority may be set according to a risk factor of the object. Among preceding vehicles, a large truck, a truck loaded with luggage, or the like can be said to have a higher risk level than that of a normal vehicle. Therefore, the priorities may be subdivided and identified by the label information, and a priority higher than that of a normal vehicle may be set in the MoPU 12.

In addition, it may be determined whether or not to set a processing order using the priority depending on the number of objects (that is, the number of pieces of label information associated with the point information). For example, in a case where the number of objects is equal to or larger than a predetermined number (for example, three), the z coordinate value of each object is derived according to the priority, and in a case where the number of objects is smaller than the predetermined number and is small, the z coordinate value of each object is processed without particularly determining the processing order. In addition, it may be determined whether or not to set the processing order using the priority depending on a distance between the objects and a density of the objects.

Furthermore, the priority is not limited to a case of deriving the z coordinate value of the object as the point information according to the ninth embodiment, and may also be applied to the first to eighth embodiments described above. In a case where there are a plurality of pieces of point information, the MoPU 12 may derive the point information at the next time point according to the priority determined for the label information.

Furthermore, the MoPU 12 may determine an update frequency of the z coordinate value according to change amounts of the x coordinate value and the y coordinate value, and derive the z coordinate value according to the frequency. For example, in a case where the change amounts of the x coordinate value and the y coordinate value are small, it is assumed that a travel environment is in a state in which the road is a flat road or a road with good visibility, a speed of the autonomous driving is moderate, and behavior of the autonomous driving also hardly changes. In such a case, it is considered that the object can be sufficiently identified only by acquiring the x coordinate value and the y coordinate value. Therefore, in a case where the change amounts of the x coordinate value and the y coordinate value are equal to or smaller than a threshold, a frequency of the derivation of the z coordinate value is set to a low frequency, and in a case where the x coordinate value and the y coordinate value are equal to or larger than the threshold, the frequency of the derivation of the z coordinate value is set to a high frequency. In this manner, the update frequency is set for the derivation of the z coordinate value. The change amounts of the x coordinate value and the y coordinate value are an example of a "predetermined condition for an image", and the update frequency determined according to the change amounts is an example of "each time point satisfying the predetermined condition". Although it is assumed that the point information for one second includes the x coordinate value and the y coordinate value of 100 frames or more, it is sufficient if an average thereof is used for each time point. In addition, an interval between time t and time t+1 is a matter that can be designed if appropriate.

Fig. 12B is a flowchart in a case where the update frequency of the z coordinate value is determined according to the change amounts. It is assumed that at least the three-dimensional coordinate values (x1,y1,z1) at time t which is the first time point and the x coordinate value and the y coordinate value at time t+1 are derived.

In step S300, the MoPU 12 acquires the x coordinate value and the y coordinate value at time t and the x coordinate value and the y coordinate value at time t+1.

In step S302, the MoPU 12 determines whether or not the change amounts of the x coordinate value and the y coordinate value from time t to time t+1 are equal to or larger than the threshold. In a case where the change amounts are equal to or larger than the threshold, the processing proceeds to step S304, and in a case where the change amounts are smaller than the threshold, the processing proceeds to step S306.

In step S304, the MoPU 12 sets the update frequency of the z coordinate value to a high frequency.

In step S306, the MoPU 12 sets the update frequency of the z coordinate value to a low frequency.

In step S308, the MoPU 12 derives the z coordinate value at the corresponding time in a case where an update timing has arrived according to the set frequency. In a case where the update timing based on the set frequency has arrived, the processing of S308 is executed to derive the z coordinate value regardless of the execution of steps S300 to S306.

In this way, the position of the object can be specified with high accuracy when necessary by deriving the z coordinate value according to a travel situation while reducing a processing load. The setting of the update frequency is applicable to the case of deriving the z coordinate value from the image in the above-described first to fourth aspects.

Furthermore, the MoPU 12 may learn correction information in a case where there is a difference between an estimated movement amount on the z axis and the z coordinate value detected by the Lidar sensor 18. For example, sensor information in a case where a difference between an estimated z coordinate value and a detected z coordinate value is equal to or larger than a threshold is collected, and the correction information for depth estimation for the object is learned from data. The travel situation of the vehicle 100 to be corrected is specified from the sensor information, and the correction information is learned for the specified travel situation to be corrected. As a method of specifying the travel situation to be corrected, for example, it is sufficient if the sensor information is converted into a feature value, and an item of a feature value deviating from an average feature value is set as a learning condition. As a learning method, it is sufficient if any method that can output the correction information using the sensor information of the travel situation to be corrected such as deep learning as an input is used. The correction information can be learned as an estimation model that outputs the z coordinate value as a correction candidate in a case where the input travel situation is applicable as a correction target. In addition, accuracy of the corrected z coordinate value can be verified, and the correction information can be relearned.

Fig. 12C is a flowchart in a case where the correction information is learned. It is assumed that the three-dimensional coordinate values of the object at time t are derived by integrating the z coordinate value, the x coordinate value, and the y coordinate value at time t at each time point.

In step S400, the MoPU 12 acquires the z coordinate value estimated for each time and the z coordinate value detected by the Lidar sensor 18.

In step S402, the MoPU 12 collects the sensor information in which the difference between the estimated z coordinate value and the detected z coordinate value is equal to or larger than the threshold.

In step S404, the MoPU 12 specifies the travel situation to be corrected from the collected sensor information.

In step S406, the MoPU 12 learns the correction information by using the sensor information regarding the travel situation to be corrected as learning data.

The MoPU 12 applies the learned correction information at the time of estimating the z coordinate value, outputs the z coordinate value as the correction candidate, and corrects the z coordinate value.

As described above, even in the travel situation where the accuracy is unstable, the position of the object can be specified using the correction information. The learning of the correction information is applicable to the case of deriving the z coordinate value from the image in the above-described first to fourth aspects.

Furthermore, in the above description, a case where the MoPU 12 derives the z coordinate value of the object as the point information from the image of the object captured by the camera 30 has been exemplified, but the technology of the disclosure is not limited to this aspect. For example, instead of the MoPU 12, the central brain 15 may derive the z coordinate value of the object as the point information. In this case, the central brain 15 derives the z coordinate value of the object as the point information by executing the processing executed by the MoPU 12 in the above description on the image of the object captured by the camera 30. As an example, the central brain 15 derives the z coordinate value of the object as the point information from the images of the object captured by the plurality of cameras 302, specifically, the cameras 302L and 302R. In this case, the central brain 15 derives the z coordinate value of the object as the point information based on the images of the object captured by the camera 302L of the MoPU 12L and the camera 302R of the MoPU 12R using the principle of the stereo camera.

(Tenth Embodiment)

Next, a tenth embodiment according to the present embodiment will be described while omitting or simplifying an overlapping portion with the above embodiments.

Fig. 13 is a block diagram showing an example of a configuration of an information processing apparatus 10 according to the tenth embodiment. Fig. 13 shows only a configuration of a part of the information processing apparatus 10.

As shown in Fig. 13, in an MoPU 12, an image of an object (hereinafter referred to as "event image") captured by an event camera 30C is input to a core 17. Then, the core 17 outputs point information to a central brain 15 based on the input event image. The event camera is disclosed, for example, in a reference (https://dendenblog.xyz/event-based-camera/).

Fig. 14 is an explanatory diagram for describing the image (event image) of the object captured by the event camera 30C. Fig. 14A is a diagram showing the object to be imaged by the event camera 30C. Fig. 14B is a diagram showing an example of the event image. Fig. 14C is a diagram showing an example in which the center of gravity of a difference portion between an image captured at a current time (an image obtained by performing imaging at the current time) and an image captured at a previous time (an image obtained by performing imaging at the previous time), indicated by the event image, is calculated as the point information. In the event image, the difference portion between the image captured at the current time (the image obtained by performing imaging at the current time) and the image captured at the previous time (the image obtained by performing imaging at the previous time) is extracted as a point. Therefore, in a case where the event camera 30C is used, for example, a point of each moving portion in a person region shown in Fig. 14A is extracted as shown in Fig. 14B.

Meanwhile, the core 17 extracts a person as the object and then extracts coordinates (for example, only one point) of a feature point representing the person region as shown in Fig. 14C. As a result, the amount of data to be transferred to the central brain 15 and a memory 16 can be reduced. Since the event image can extract the person as the object at an arbitrary frame rate, in the case of the event camera 30C, the event image can be extracted at a frame rate equal to or higher than the maximum frame rate (for example, 1920 frames/second) of a camera 30 mounted on the MoPU 12 in the above embodiment, and the point information of the object can be obtained with high accuracy.

In the information processing apparatus 10 according to the tenth embodiment, the MoPU 12 may include a visible light camera 305A in addition to the event camera 30C, similarly to the above-described embodiment. In this case, in the MoPU 12, a visible light image of the object captured by the visible light camera 305A and the event image are input to the core 17. Then, the core 17 outputs the point information to the central brain 15 based on at least one of the visible light image and the event image that are input.

For example, in a case where the object can be identified from the visible light image of the object captured by the visible light camera 305A, the core 17 outputs the point information based on the visible light image. On the other hand, in a case where the object is not identified from the visible light image due to a predetermined factor, the core 17 outputs the point information based on the event image. The predetermined factor includes at least one of a case where a movement speed of the object is equal to or higher than a predetermined value and a case where a light quantity change of ambient light per unit time is equal to or larger than a predetermined value. For example, in a case where the object is not identified from the visible light image due to a high speed of a motion of the object, the core 17 identifies the object based on the event image, and outputs an x coordinate value and a y coordinate value of the object as the point information. Furthermore, in a case where the object is not identified from the visible light image due to a sudden light quantity change of the ambient light such as backlight, the core 17 identifies the object based on the event image, and outputs the x coordinate value and the y coordinate value of the object as the point information. With such a configuration, in the information processing apparatus 10, it is possible to selectively use the camera 30 that images the object according to the predetermined factor.

(Eleventh Embodiment)

Next, an eleventh embodiment according to the present embodiment will be described while omitting or simplifying an overlapping portion with the above embodiments.

Fig. 15 is a first block diagram showing an example of a configuration of an information processing apparatus 10 according to the eleventh embodiment, and Fig. 16 is a second block diagram showing an example of a configuration of the information processing apparatus 10 according to the eleventh embodiment.

As shown in Fig. 15, an image from a camera attached to a left side of a vehicle 100 and an image from a camera attached to a right side of the vehicle 100 may be input to a core 12A of an MoPU 12. Each of the images is, for example, an image including color information of 1000 pixels × 1000 pixels, and may be input to the core 12A at a frame rate of 1000 frames/second. The core 12A of the MoPU 12 may transfer, based on the images, vector information of a motion along each of three coordinate axes (x axis, y axis, and z axis) in a three-dimensional orthogonal coordinate system to a central brain 15 at a frame rate of 1000 frames/second. In addition, as shown in Fig. 16, the image from the camera attached to the left side of the vehicle 100 and the image from the camera attached to the right side of the vehicle 100 may be processed using different cores $12A_1$ and $12A_2$, respectively.

(Twelfth Embodiment)

Next, a twelfth embodiment according to the present embodiment will be described while omitting or simplifying an overlapping portion with the above embodiments.

Fig. 17 is a first block diagram showing an example of a configuration of an information processing apparatus 10 according to the twelfth embodiment, and Fig. 18 is a second block diagram showing an example of a configuration of the information processing apparatus 10 according to the twelfth embodiment.

As shown in Fig. 17, an MoPU 12 may output motion information based on at least one of a visible light image and an infrared image. The visible light image is an image captured by a visible light camera, and the infrared image is an image captured by an infrared camera. The visible light image and the infrared image are input to a core 12A at a frame rate of 1000 frames/second or higher. The visible light image and the infrared image are preferably synchronized with each other. By using the infrared image in object detection by the MoPU 12, it is possible to detect an object even in a case where it is difficult to perform object detection using the visible light image at night, for example. The MoPU 12 may output the motion information based on only the infrared image among the visible light image and the infrared image, or may output the motion information based on both the visible light image and the infrared image.

Furthermore, as shown in Fig. 18, the MoPU 12 may output the motion information based on an image and a radar signal. The radar signal is a signal based on a reflected wave of an electromagnetic wave emitted to the object from the object. The MoPU 12 may derive a distance to the object based on the image and the radar signal, and output, as the motion information, vector information of a motion of a point indicating an existence position of the object along each of three axes in a three-dimensional orthogonal coordinate system. The image may include at least one of the visible light image and the infrared image. The image and the radar signal are input to the core 12A at a frame rate of 1000 frames/second or higher.

Furthermore, in the above description, a case where a central brain 15 performs driving control of a vehicle 100 based on an image output from an IPU 11 and the motion information output from the MoPU 12 has been exemplified, but the technology of the disclosure is not limited to this aspect. The central brain 15 may perform motion control of a robot as response control for the object based on the image output from the IPU 11 and the motion information output from the MoPU 12. The robot may be, for example, a humanoid smart robot that performs work instead of a human. For example, the central brain 15 may control motions of arms, palms, fingers, and feet of the robot based on the image output from the IPU 11 and the motion information output from the MoPU 12, and may control motions such as gripping, grasping, holding, carrying, moving, transporting, throwing, kicking, and avoiding the object. For example, the IPU 11 and the MoPU 12 may be mounted at positions corresponding to a right eye and a left eye of the robot.

(Thirteenth Embodiment)

Next, a thirteenth embodiment according to the present embodiment will be described while omitting or simplifying an overlapping portion with the above embodiments. The thirteenth embodiment is characterized in that a frame rate at the time of capturing an image is variable.

(Information Processing Apparatus Mounted on Vehicle 100: Smart Car)

Fig. 19 is a block diagram of an information processing apparatus 213 according to the thirteenth embodiment mounted on a vehicle 100. As shown in Fig. 19, the information processing apparatus 213 mounted on the vehicle 100 includes an MoPU 12L corresponding to a left eye, an MoPU 12R corresponding to a right eye, an IPU 11, a core 12X, and a central brain 15.

The MoPU 12L includes a camera 313L, a radar 32L, an infrared camera 34L, and a dedicated core 12AL. The MoPU 12R includes a camera 313R, a radar 32R, an infrared camera 34R, and a dedicated core 12AR. The radars 32L and 32R detect the above-described radar signal. The infrared cameras 34L and 34R acquire the above-described infrared images.

The IPU 11 includes a high-resolution camera (not shown) as described above, detects an object from a high-resolution image captured by the high-resolution camera, and outputs information indicating the type of the object (hereinafter simply referred to as "label information").

Only processing in the MoPU 12L corresponding to the left eye will be described below.

The camera 313L included in the MoPU 12L captures an image with a larger number of frames (120, 240, 480, 960, or 1920 frames/sec) than that of the high-resolution camera (for example, imaging at 10 frames/second) included in the IPU 11. The camera 313L is a camera capable of changing a frame rate.

The core 12AL (implemented by one or more CPUs, for example) of the MoPU 12L extracts a feature point for each image of one frame captured by the camera 313L, and outputs coordinate values (X,Y) thereof. The MoPU 12L outputs, for example, a center point (center-of-gravity point) of the object extracted from the image as the feature point. The feature points may be two diagonal points at vertices of a rectangle surrounding the object in a pseudo manner. In addition, in the case of being represented as an object having a certain size, there is no need to use only two coordinate points that are at least diagonal at vertices of a quadrangle surrounding a contour of the object recognized from the image captured by the camera, and a plurality of coordinate points including the contour may be extracted.

Specifically, the MoPU 12L outputs coordinate values (X,Y) of the feature point extracted from one object. For example, in a case where a plurality of objects (for example, an object A, an object B, and an object C) appear in one image, the MoPU 12L may output coordinate values (Xn,Yn) of the feature point extracted from each of the plurality of objects. A series of feature points of the image captured at each time corresponds to motion information of the object.

Furthermore, for example, a case where the MoPU 12L cannot identify the object due to an influence of darkness is assumed. In this case, the MoPU 12L may detect heat of the object using the infrared camera 34L, and output the coordinates (Xn,Yn) of the object based on the infrared image that is the detection result and the image captured by the camera 313L. In addition, the capturing of the image by the camera 313L and the capturing of the infrared image by the infrared camera 34L may be synchronized with each other. In this case, for example, the number of images per second captured by the camera 313L and the number of images per second captured by the infrared camera 34L are synchronized with each other (for example, 1920 frames/sec).

Furthermore, the MoPU 12L may acquire a coordinate value of the object on a Z axis based on three-dimensional point cloud data acquired by the radar 32L. In this case, the capturing of the image by the camera 313L and the acquisition of the three-dimensional point group data by the radar 32L may be synchronized with each other. For example, the number of pieces of three-dimensional point cloud data per second acquired by the radar 32L is synchronized with the number of images per second captured by the camera 313L (for example, 1920 frames/sec).

In addition, the number of images per second captured by the camera 313L, the number of images per second captured by the infrared camera 34L, and the number of pieces of three-dimensional point cloud data per second acquired by the radar 32L may be made the same, and data acquisition timings may be synchronized with each other.

The core 12X acquires coordinates of the feature point output from the MoPU 12L and the label information (information indicating whether the object is a dog, a cat, or a bear) of the target output from the IPU 11. Then, the core 12X outputs the label information and the coordinates corresponding to the feature point in association with each other. This makes it possible to associate information indicating what the object indicated by the feature point represents with motion information of the object indicated by the feature point.

The above is the processing in the MoPU 12L corresponding to the left eye. The MoPU 12R corresponding to the right eye executes the same processing as the MoPU 12L corresponding to the left eye.

A coordinate value Zn of the feature point in a depth direction may be further calculated using the principle of a stereo camera based on the image captured by the camera 313L of the MoPU 12L and the image captured by the camera 313R of the MoPU 12R.

(Information Processing Apparatus Mounted on Robot: Smart Robot)

Fig. 20 is a block diagram of an information processing apparatus 310 according to the thirteenth embodiment mounted on a robot. As shown in Fig. 20, the information processing apparatus 310 mounted on the robot includes an MoPU 12L corresponding to a left eye, an MoPU 12R corresponding to a right eye, an infrared camera 34, a structured light 3613, a core 12X, and a central brain 15. The information processing apparatus 310 mounted on the robot has a function similar to that of the information processing apparatus 213 mounted on the vehicle 100.

For example, in a case where the MoPU 12L cannot identify an object due to an influence of darkness, the MoPU 12L detects heat of the object by using the infrared camera 34, and outputs coordinates (Xn,Yn) of the object based on an infrared image that is the detection result and an image captured by a camera 313L. In addition, the capturing of the image by the camera 313L and the capturing of the infrared image by the infrared camera 34 may be synchronized with each other. In this case, for example, the number of images per second captured by the camera 313L is synchronized with the number of images per second captured by the infrared camera 34 (for example, 1920 frames/sec).

The core 12X may also use the structured light 3613 to obtain coordinates Zn of the object in a depth direction. The structured light 3613 is disclosed, for example, in a reference (http://ex-press.jp/wp-content/uploads/2018/10/018_teledyne_3rd.pdf). In this case, the capturing of the images by the cameras 313L and 313R and measurement of three-dimensional data by the structured light 3613 may be synchronized with each other. For example, the number of images per second captured by the cameras 313L and 313R may be synchronized with the number of pieces of three-dimensional data per second measured by the structured light 3613 (for example, 1920 frames/sec).

Furthermore, both the infrared image captured by the infrared camera 34 and the three-dimensional data measured by the structured light 3613 may be used in combination.

(Change of Frame rate According to External Environment)

The information processing apparatuses 213 and 310 may change the frame rate of the camera according to an external environment. For example, the information processing apparatuses 213 and 310 calculate a score for the external environment, and determine the frame rates of the cameras 313L and 313R according to the score. Then, the information processing apparatuses 213 and 310 output a control signal for instructing the cameras 313L and 313R to capture the images at the determined frame rate. The cameras 313L and 313R capture the images at the determined frame rate. Then, the information processing apparatuses 213 and 310 extract a point indicating an existence position of the object from the images captured by the cameras 313L and 313R, and output the point indicating the existence position of the object.

The information processing apparatus 213 mounted on the vehicle 100 includes a plurality of types of sensors (not shown). One or more processors included in the information processing apparatus 213 mounted on the vehicle 100 calculate a risk level of a place where the own vehicle 100 is to travel in the future as the score for the external environment based on sensor information (such as center of gravity shift in a weight, detection of road material, detection of outside-air temperature, detection of outside-air humidity, detection of vertical and lateral inclination angles of slopes, detection of a freezing state and a moisture level of a road, detection of a material, a wear condition, and a tire pressure of each tire, a road width, the presence or absence of no-passing zones, an oncoming vehicle, vehicle type information of preceding and following vehicles, cruising states of such vehicles, or a surrounding situation (birds, animals, soccer balls, accident vehicles, earthquakes, housework, winds, typhoons, heavy rain, light rain, snowstorm, fog, or the like)) taken in from the plurality of types of sensors (not shown).

Then, the one or more processors included in the information processing apparatus 213 switch the number of images captured per second (frame rate) based on the calculated risk level and a threshold.

For example, in a case where the risk level is lower than a first threshold, the one or more processors included in the information processing apparatus 213 select 120 frames/second, and output a control signal to the cameras 313L and 313R, the radars 32L and 32R, and the infrared cameras 34L and 34R so as to capture the images, acquire the radar signals, or capture the infrared image at the frame rate.

Furthermore, for example, in a case where the risk level is equal to or higher than the first threshold and lower than a fourth threshold, the one or more processors included in the information processing apparatus 213 select any one of 240, 480, and 960 frames/second and output a control signal to each device so as to acquire various data at the frame rate.

Furthermore, for example, in a case where the risk level is equal to or higher than the fourth threshold, the one or more processors included in the information processing apparatus 213 select 1920 frames/second and output a control signal to each device so as to acquire various data at the frame rate.

Furthermore, the one or more processors included in the information processing apparatus 213 may predict the risk level by using big data related to traveling already known before the vehicle 100 travels, such as long-tail incident artificial intelligence (AI) data (for example, trip data of the vehicle in which an autonomous driving control scheme of Level 5 is implemented) or map information, as information for predicting the risk level.

Furthermore, the one or more processors included in the information processing apparatus 310 mounted on the robot may calculate the score for the external environment based on, for example, a speed of the object caught on the cameras 313L and 313R, and change the frame rate according to the score. For example, the score for the external environment is calculated to be higher as the speed of the object is higher. Therefore, in a case where the score for the external environment is high, the one or more processors included in the information processing apparatus 310 mounted on the robot selects 1920 frames/second, and outputs a control signal to each device so as to acquire various data at the frame rate. Furthermore, in a case where the score for the external environment is low, the one or more processors included in the information processing apparatus 310 mounted on the robot selects 120 frames/second, and outputs a control signal to each device so as to acquire various data at the frame rate. Other control is similar to that of the information processing apparatus 213 mounted on the vehicle 100 described above.

(Output of Feature Point According to Region where Object is Detected)

In a case where the existence position of the object appearing in the image is a predetermined region, the information processing apparatuses 213 and 310 may set a point indicating the existence position of the object. In this case, the information processing apparatuses 213 and 310 determine whether or not to output the feature point of the object according to a region where the object is detected. For example, the cores 12AL and 12AR of the information processing apparatus 213 mounted on the vehicle 100 do not extract a feature point from an object (for example, an object present on a sidewalk) different from an object detected in a road region where the vehicle 100 travels. Fig. 21 is a diagram for describing processing in a case where the feature point is not extracted from the object present on the sidewalk, for example.

In Fig. 21A, objects B1 to B4 are extracted. Originally, coordinates representing a feature point are extracted for each of the objects B1 to B4.

In this case, for example, as shown in Fig. 21B, the cores 12AL and 12AR included in the information processing apparatus 213 mounted on the vehicle 100 sequentially detect a road boundary L from an image of a region in front of the vehicle 100 using a known technique. Then, the cores 12AL and 12AR included in the information processing apparatus 213 extract the coordinates representing the feature points only from the objects B1 to B3 positioned on a road specified by the road boundary L.

Furthermore, for example, the cores 12AL and 12AR included in the information processing apparatus 213 may extract the coordinates representing the feature points only from the objects B1, B3, and B4 without extracting an object region itself for the object B2 different from the objects B1, B3, and B4 positioned on the road.

(Output of Feature Point According to Motion of Object)

The information processing apparatuses 213 and 310 may calculate a score for each object appearing in the image and extract a point indicating an existence position of an object whose score is equal to or higher than a predetermined threshold. In this case, for example, the information processing apparatuses 213 and 310 may determine whether or not to output the feature point of the object according to the motion of the object. For example, the cores 12AL and 12AR of the information processing apparatus 213 need not extract the feature point from an object that does not affect the traveling of the vehicle 100. Specifically, the cores 12AL and 12AR of the information processing apparatus 213 calculate a movement direction, a speed, or the like of the object appearing in the image by using AI or the like. Then, for example, the cores 12AL and 12AR of the information processing apparatus 213 do not extract the feature point from a pedestrian or the like moving away from the road. On the other hand, the cores 12AL and 12AR of the information processing apparatus 213 extract the feature point from an object approaching the road (for example, a child who is likely to jump out onto the road).

Furthermore, the one or more processors included in the information processing apparatus 213 can also extract a feature point from an image captured by an event camera (https://dendenblog.xyz/event-based-camera/), for example. Fig. 14 shows a diagram for describing the image captured by the event camera.

As shown in Fig. 14, in the image captured by the event camera, a difference portion between an image captured at the current time and an image captured at the previous time is extracted as the point. Therefore, in a case where the event camera is used, for example, a point of each moving portion in a person region shown in Fig. 14A is extracted as shown in Fig. 14B.

Meanwhile, the one or more processors included in the information processing apparatus 213 extract a person as the object and then extract coordinates (for example, only one point) of a feature point representing the person region as shown in Fig. 14C. As a result, the amount of information to be transferred to the central brain 15 and a memory 16 can be reduced. Since the image captured by the event camera enables the extraction of the person as the object at an arbitrary frame rate, the cameras 313L and 313R mounted on the MoPUs 12L and 12R capture the images at a frame rate of up to 1920 frames/second. However, in the case of the event camera, the image can be extracted at a frame rate of 1920 frames/second or higher, and the motion information of the object can be obtained with higher accuracy.

As described above, the information processing apparatuses 213 and 310 according to the thirteenth embodiment extract the point indicating the existence position of the object from the image in which the object appears, and output the point indicating the existence position of the object. As a result, the amount of information to be transferred to the core 12X, the central brain 15, and the memory 16 can be reduced. In addition, as the point indicating the position of the object is associated with the label information output from the IPU 11, it is possible to grasp information regarding what type of object is making what type of motion. In particular, since the cameras 313L and 313R mounted on the MoPUs 12L and 12R can capture the images at a frame rate of up to 1920 frames/second, the motion information of the object can be obtained with high accuracy.

Furthermore, the information processing apparatuses 213 and 310 include the cameras 313L and 313R capable of changing the frame rate, calculate the score for the external environment, and determines the frame rate of the camera according to the score. Then, the information processing apparatuses 213 and 310 output a control signal for instructing the cameras 313L and 313R to capture the images at the determined frame rate, extract the point indicating the existence position of the object from the images captured by the cameras 313L and 313R, and output the point indicating the existence position of the object. As a result, it is possible to capture an image at a frame rate suitable for the external environment.

Furthermore, the information processing apparatus 213 calculates the risk level for the traveling of the vehicle 100 as the score for the external environment, determines the frame rate of the cameras 313L and 313R according to the risk level, outputs the control signal for instructing the cameras 313L and 313R to capture the images at the determined frame rate, and extracts the point indicating the position of the object from the images captured by the cameras 313L and 313R. As a result, the frame rate can be changed according to the risk level for the traveling of the vehicle 100.

Furthermore, the information processing apparatuses 213 and 310 extract the object from the image, and in a case where the existence position of the object is the predetermined region, the information processing apparatuses 213 and 310 extract the point indicating the existence position of the object, and outputs the point indicating the existence position of the object. As a result, the cores 12AL and 12AR of the information processing apparatuses 213 and 310 do not need to acquire a point in a region having low importance for control processing.

Furthermore, the information processing apparatuses 213 and 310 extract the object from the image, calculate the score for each object, extract the point indicating the existence position of the object whose score is equal to or higher than the predetermined threshold, and output the point indicating the existence position of the object. As a result, the cores 12AL and 12AR of the information processing apparatuses 213 and 310 do not need to acquire a point of an object having low importance for the control processing.

(Fourteenth Embodiment)

Next, a fourteenth embodiment according to the present embodiment will be described while omitting or simplifying an overlapping portion with the above embodiments. The fourteenth embodiment is characterized in that an MoPU 12 includes a plurality of cameras having different view angles.

(Information Processing Apparatus Mounted on Vehicle: Smart Car)

Fig. 22 is a block diagram of an information processing apparatus 410 according to the fourteenth embodiment mounted on a vehicle 50 (see Fig. 23). Fig. 23 is a diagram showing an imaging direction and an imaging view angle range of a high-resolution camera 30L and an omnidirectional camera 30R mounted on the vehicle 50. For convenience of description, a direction along an arrow H shown in Fig. 23 is a top-bottom direction of the vehicle 50, a direction along an arrow W is a left-right direction of the vehicle 50, and a direction along an arrow D is a front-rear direction of the vehicle 50.

As shown in Fig. 22, the information processing apparatus 410 mounted on the vehicle 50 (see Fig. 23) includes an IPU 11, the MoPU 12, and a central brain 15.

The IPU 11 includes a high-resolution camera 30A as described above and a core 11A (implemented by one or more CPUs, for example), detects an object from a high-resolution image captured by the camera 30A, and outputs information indicating the type of the object.

The MoPU 12 includes the high-resolution camera 30L, the omnidirectional camera 30R, an adjustment unit 40, and a core 12A (implemented by one or more CPUs, for example), detects the object from images captured by the high-resolution camera 30L and the omnidirectional camera 30R, and outputs motion information indicating a motion of the object.

The high-resolution camera 30L is a camera having a predetermined horizontal view angle, and has a higher resolution per unit view angle than the omnidirectional camera 30R. In the embodiment, the horizontal view angle of the high-resolution camera 30L is 45° as an example, but is not limited thereto, and may be any view angle. Furthermore, the horizontal view angle of the high-resolution camera 30L may be changed by, for example, a zoom function or the like. The high-resolution camera 30L is an example of a "first camera" in the technology of the disclosure.

Further, the omnidirectional camera 30R is a camera having a horizontal view angle of 360°. The omnidirectional camera 30R is an example of a "second camera" in the technology of the disclosure. The "second camera" is not limited to the omnidirectional camera 30R as long as the camera has a horizontal view angle wider than the horizontal view angle of the "first camera", and may be any camera such as a camera having a horizontal view angle of 270°, for example.

As shown in Fig. 23, the high-resolution camera 30L and the omnidirectional camera 30R are installed on a roof of the vehicle 50. The high-resolution camera 30L is installed so as to be rotatable about a rotation axis parallel to a height direction H of the vehicle 50, and is configured such that the imaging direction can be adjusted in the horizontal direction by the adjustment unit 40 described below. The imaging direction of the high-resolution camera 30L is normally directed to a front side of the vehicle 50.

In addition, the high-resolution camera 30L and the omnidirectional camera 30R are installed at different positions in the left-right direction of the vehicle 50. The high-resolution camera 30L is installed on a relatively left side, and the omnidirectional camera 30R is installed on a relatively right side. As described in the above embodiment, the MoPU 12 according to the embodiment can calculate a coordinate value Z of a feature point in a depth direction by using the principle of a stereo camera based on the image acquired by the high-resolution camera 30L and the image acquired by the omnidirectional camera 30R.

In a case where the coordinate value Z of the feature point in the depth direction is calculated using the principle of the stereo camera based on the images acquired by the two cameras having different view angles, for example, it is sufficient if the image acquired by the omnidirectional camera 30R having the wider view angle is a corrected image obtained by performing trimming such that the imaging direction and the imaging range coincide with those of the image acquired by the high-resolution camera 30L having the narrower view angle.

The adjustment unit 40 includes, for example, a motor, and is configured to be able to adjust the imaging direction in the horizontal direction by rotating the high-resolution camera 30L under the control of the core 12A. The adjustment unit 40 is configured to be able to adjust the imaging direction of the high-resolution camera 30L in a positive direction (right rotation direction) and a negative direction (left rotation direction) with the front side of the vehicle 50 as a reference direction (0°) for the imaging direction of the high-resolution camera 30L.

In a case where a motion of an object in a blind spot of the high-resolution camera 30L is detected in the image acquired by the omnidirectional camera 30R, the core 12A controls the adjustment unit 40 such that the imaging direction of the high-resolution camera 30L is directed to the detected object.

Here, the control of the imaging direction of the high-resolution camera 30L in the core 12A will be described in detail. Fig. 24 is a diagram showing an imaging range relationship between the image acquired by the omnidirectional camera 30R and the image acquired by the high-resolution camera 30L.

As shown in Fig. 24, an image GR acquired by the omnidirectional camera 30R is an image having a horizontal view angle of 360°. That is, the image GR is an image in a range of $\pm 180°$ with the front side of the vehicle 50 as the reference direction (0°) for the imaging direction of the high-resolution camera 30L.

An image GL acquired by the high-resolution camera 30L is an image having a horizontal view angle of 45°. The imaging direction of the high-resolution camera 30L is normally set so as to be directed to the front side of the vehicle 50. Therefore, the image GL is usually an image in a range of $\pm 22.5°$ with the front side of vehicle 50 as the reference direction (0°) for the imaging direction of the high-resolution camera 30L.

As an example, a case where a mobile object B is present in a direction of -100° with the front side of the vehicle 50 as the reference direction (0°) as shown in Fig. 23 will be described. In this case, as shown in Fig. 24, in the image GR acquired by the omnidirectional camera 30R, the mobile object B appears at a position corresponding to -100° with the front side of the vehicle 50 as the reference direction (0°).

In a case where the mobile object B is detected in the image GR, the core 12A determines whether or not the mobile object B is included in the imaging range of the high-resolution camera 30L. The mobile object B shown in Figs. 23 and 24 is out of the imaging range of the high-resolution camera 30L and is in a blind spot of the high-resolution camera 30L.

In this case, as shown in Figs. 25 and 26, the core 12A controls the adjustment unit 40 such that the imaging direction of the high-resolution camera 30L in the horizontal direction is directed to a center position of the mobile object B (the direction of -100°).

It is sufficient if the adjustment of the imaging direction of the high-resolution camera 30L is performed such that the mobile object B is included in the image GL acquired after the adjustment of the imaging direction, and is not limited to an aspect of adjusting the imaging direction so as to coincide with the center position of the mobile object B. For example, in a case where the adjustment is performed such that the mobile object B appears at an end portion on a rotation direction side in the image GL, a rotation amount of the high-resolution camera 30L can be reduced as compared with a case where the adjustment is performed such that the mobile object B appears at the center of the image GL.

Furthermore, a movement direction of the mobile object B in the image GR acquired by the omnidirectional camera 30R may be predicted and reflected in adjustment control of the imaging direction of the high-resolution camera 30L.

For example, as in the above example, in a case where the imaging direction of the high-resolution camera 30L is adjusted from the reference direction (0°) toward the center position of the mobile object B (the direction of -100°), and the mobile object B moves toward the reference direction, an adjustment target of the imaging direction of the high-resolution camera 30L may be corrected to an angle having an absolute value smaller than -100°. As a result, the rotation amount of the high-resolution camera 30L can be reduced.

Furthermore, in a case where the imaging direction of the high-resolution camera 30L is adjusted from the reference direction (0°) toward the center position of the mobile object B (the direction of -100°), and the mobile object B moves to a side opposite to the reference direction, the adjustment target of the imaging direction of the high-resolution camera 30L may be corrected to an angle having an absolute value larger than -100°. As a result, it is possible to prevent the mobile object B from not being included in the imaging range of the high-resolution camera 30L after the adjustment of the imaging direction of the high-resolution camera 30L.

In the above case, a correction amount from the adjustment target may be changed according to a movement speed of the mobile object B in the image GR acquired by the omnidirectional camera 30R. For example, the correction amount from the adjustment target may be increased as the movement speed of the mobile object B is higher, and the correction amount from the adjustment target may be decreased as the movement speed of the mobile object B is lower. As a result, the imaging direction of the high-resolution camera 30L can be more appropriately adjusted.

As described above, in the information processing apparatus 410 according to the fourteenth embodiment, in a case where the MoPU 12 detects the motion of the object in the blind spot of the first camera (in this example, the omnidirectional camera 30R) in the image acquired by the second camera (in this example, the high-resolution camera 30L), the adjustment unit 40 is controlled to direct the imaging direction of the first camera toward the detected object.

As a result, in a case where the moving object is detected while acquiring information of a wide range by using the image acquired by the second camera, the mobile object can be detected by using the image acquired by the first camera together, so that accuracy in detection of the mobile object can be improved.

The horizontal view angle of the second camera is 360°. As a result, information regarding the entire periphery of a movable body on which the information processing apparatus 410 is mounted can be acquired.

The first camera has a higher resolution per unit view angle than the second camera. As a result, the accuracy in detection of the mobile object can be further improved.

In the information processing apparatus 410 according to the fourteenth embodiment, an adjustment range of the imaging direction in the horizontal direction of the adjustment unit 40 is set to a range within ±135°, preferably, the range within ±135° is a range within ±90° with respect to the reference direction, and in a case where the mobile object is at a position deviating from the adjustment range, the adjustment of the imaging direction need not be performed.

By limiting the adjustment range of the imaging direction to the vicinity of the front side in this manner, the first camera can concentrate on detection of the vicinity of the front side having high importance in movement control of the movable body on which the information processing apparatus 410 is mounted, so that followability to a mobile object in the vicinity of the front side can be improved.

Furthermore, the MoPU 12 may acquire information regarding a distance to the object in the image by using the image acquired by the first camera and the image acquired by the second camera. As described above, even with the images acquired by two cameras having different view angles, it is possible to acquire the information regarding the distance to the object in the image by using the principle of the stereo camera, and by adopting such an aspect, it is possible to increase the amount of information acquired by the MoPU 12.

(Fifteenth Embodiment)

Next, a fifteenth embodiment according to the present embodiment will be described while omitting or simplifying an overlapping portion with the above embodiments. The fifteenth embodiment is characterized in that an IPU 11 outputs type information indicating the type of an object extracted from an image acquired by an external camera in association with position information of the external camera.

(Information Processing Apparatus Mounted on Vehicle: Smart Car)

Fig. 27 is a block diagram of an information processing apparatus 410 according to the fifteenth embodiment mounted on a vehicle 50 (see Fig. 29).

As shown in Fig. 27, the information processing apparatus 410 mounted on the vehicle 50 (see Fig. 29) includes the IPU 11, an MoPU 12, a central brain 15, and a navigation system 45.

The IPU 11 includes a camera 30A, a core 11A (implemented by one or more CPUs, for example), and an acquisition unit 415, detects the object from an image captured by the camera 30A and an image captured by an external camera 60 installed outside the vehicle 50, and outputs information indicating the type of the object.
The acquisition unit 415 acquires the image acquired by the external camera 60 installed outside the vehicle 50 and position information of the external camera 60, and includes, for example, one or more CPUs and a wireless communication unit for wireless connection to an external device.
A plurality of external cameras 60A, 60B, 60C, and the like are installed outside the vehicle 50. The external cameras 60A, 60B, and 60C are connected to a management server 70 via a network. Here, the network may be any network such as the Internet, a local area network (LAN), or a wide area network (WAN).
The MoPU 12 includes a camera 30B and a core 12A (implemented by one or more CPUs, for example), detects the object from an image captured by the camera 30B, and outputs motion information indicating a motion of the object.
The navigation system 45 is a system for providing movement guidance for the vehicle 50, and for example, a system equivalent to a known car navigation system can be used.

(Detailed Description of Processing in IPU 11)

Next, processing in the IPU 11 in the present embodiment will be described in detail.
First, the management server 70 that manages the plurality of external cameras 60A, 60B, and 60C installed outside the vehicle 50 will be described. The management server 70 includes a camera management database.
Fig. 28 is a diagram showing an example of the camera management database managed by the management server 70. As shown in Fig. 28, the camera management database stores a camera ID, an address, and an installation position in association with each other. The camera ID is a unique ID given to each of the external cameras 60. The address is information indicating an address when each of the external cameras 60 is connected via the network, and is, for example, information such as an internet protocol (IP) address. A version of the IP address is not limited, and can be various versions such as Internet Protocol version 4 (IPv4) or Internet Protocol version 6 (IPv6). The installation position is information indicating a position where each of the external cameras 60 is installed, and is, for example, information such as global positioning system (GPS) coordinates (for example, latitude, longitude, and the like).
The external camera 60 is, for example, a camera installed in a building, a traffic light, a median strip, or the like along a road.
The management server 70 can be connected to an arbitrary external camera 60 by referring to the camera management database. Furthermore, the camera management database can also be referred to by the external device connected to the management server 70. The acquisition unit 415 of the IPU 11 is configured to be wirelessly connectable to the management server 70.
When the vehicle 50 moves, the acquisition unit 415 is connected to the management server 70, and specifies the external camera 60 closest to the vehicle 50 among the external cameras 60 positioned in front of a traveling route of the vehicle 50 based on the camera management database stored in the management server 70 and the position information and traveling direction information of the vehicle 50 acquired from the navigation system 45.
In the embodiment, as an example, the external camera 60 positioned in front of the traveling route of the vehicle 50 is the external camera 60 positioned in a predetermined width range with respect to a central axis of a vehicle body in a front-rear direction in front of the vehicle body of the vehicle 50.
The external camera 60 positioned in front of the traveling route of the vehicle 50 is not limited to the above aspect, and may be any external camera 60 as long as the external camera 60 is positioned in front of the traveling route of the vehicle 50. For example, in a situation where the vehicle 50 is being guided by the navigation system 45, the external camera 60 may be positioned in a predetermined range from a route set by the navigation system 45.
Then, the acquisition unit 415 acquires a current image acquired by the specified external camera 60 and the position information of the external camera 60.
In the embodiment, the acquisition unit 415 acquires the image from the specified external camera 60 every 1 second until the vehicle 50 passes near the specified external camera 60. Here, a time interval for acquiring the image is not limited to 1 second, and may be any aspect such as 10 seconds, 5 seconds, or 0.1 seconds.
The acquisition of the image by the acquisition unit 415 is not limited to the above aspect, and may be performed in any aspect such as acquiring the image at every predetermined traveling distance of the vehicle 50 until the vehicle 50 passes near the specified external camera 60, or acquiring the image only once from the specified external camera 60.
For example, in a case where there are a plurality of external cameras 60A to 60N around the vehicle 50 as shown in Fig. 29, the acquisition unit 415 specifies the external camera 60G closest to the vehicle 50 among the external cameras 60 positioned in front of the traveling route of the vehicle 50, and acquires a current image acquired by the specified external camera 60G and position information of the external camera 60G.
The acquisition of the current image from the specified external camera 60G may be performed via the management server 70, or may be performed by direct connection to the external camera 60G.

The core 11A of the IPU 11 outputs the type information indicating the type of the object extracted from the image acquired by the external camera 60 in association with the position information of the external camera 60.

In the example shown in Fig. 29, the acquisition unit 415 acquires the image from the external camera 60G. Fig. 30 is a diagram showing an example of the image acquired from the external camera 60G. As shown in Fig. 30, two cars and a person are shown in an image GEx acquired from the external camera 60G.

The core 11A of the IPU 11 extracts the two cars and the person as objects B1 to B3 from the image GEx. Next, the core 11A determines the type of the object for each of the objects B1 to B3. Then, the core 11A outputs the type information indicating the type of the object for each of the objects B1 to B3 in association with the position information of the external camera 60G, and registers the type information in an object management database DB. The object management database DB is stored in a memory 16 (see Fig. 2), for example.

At this time, in a case where the extracted object is an object that may affect traveling of the vehicle 50, the core 11A adds identification information (hereinafter referred to as "caution flag") indicating that the extracted object is an object that may affect the traveling, and outputs the type information of the object.

Examples of the object that may affect the traveling of the vehicle 50 include a person and an animal. In the embodiment, as an example, in a case where the extracted object is a person or an animal, the core 11A adds the caution flag and outputs the type information of the object.

Fig. 31 is a diagram showing an example of the object management database DB managed in the information processing apparatus 410. As shown in Fig. 31, the object management database DB stores an object ID, a registration date and time, an object position, an object type, and the presence or absence of the caution flag in association with each other.

The object ID is a unique ID given to each object detected by the core 11A. The registration date and time is information regarding a date and time when the object is registered in the object management database DB. The object position is information indicating the position of the external camera 60 that has imaged the object, and is the position information of the external camera 60 acquired by the acquisition unit 415. The object type is information indicating the type of the object, and is, for example, information such as a person, an animal, a car, a motorcycle, a bicycle, or a traffic light. The presence or absence of the caution flag is information indicating whether or not the caution flag has been added to the object.

As described in the above embodiment, the central brain 15 performs driving control of the vehicle 50 based on the image and the identification information output from the IPU 11 based on the image acquired by the camera 30A included in the IPU 11 and the motion information output from the MoPU 12 based on the image acquired by the camera 30B included in the MoPU 12.

In addition, the central brain 15 according to the embodiment can grasp in advance an object that is positioned in front of the vehicle 50 and that may affect the traveling of the vehicle 50 by referring to the object management database DB. Therefore, the driving control of the vehicle 50 can be more appropriately performed.

For example, as shown in Fig. 29, in a stage where the vehicle 50 is positioned in front of the external camera 60G, it is possible to grasp in advance an object that is positioned around the external camera 60G and that may affect the traveling of the vehicle 50. In this example, as shown in Fig. 30, it is possible to grasp that a person (the object B3 in the figure) is present around the external camera 60G.

As a result, in consideration of a possibility that a person jumps out around the external camera 60G, the central brain 15 can perform preliminary control such as deceleration before the vehicle 50 reaches the periphery of the external camera 60G, or preparation for immediately applying a brake in a case where the person jumps out.

As a result, as shown in Fig. 32, even in a case where the person jumps out when the vehicle 50 reaches the periphery of the external camera 60G, the preliminary control is performed, so that it is possible to cope with the situation with a margin.

As described above, in the information processing apparatus 410 according to the fifteenth embodiment, the IPU 11 outputs the type information indicating the type of the object extracted from the image acquired by the external camera 60 in association with the position information of the external camera 60. As a result, the central brain 15 can perform the driving control of the vehicle 50 in consideration of even the image acquired by the external camera 60 installed outside the vehicle 50 on which the information processing apparatus 410 is mounted.

In addition, in a case where the object extracted from the image acquired by the external camera 60 is an object that may affect the traveling of the vehicle 50, such as a person or an animal, the IPU 11 outputs the type information of the object while adding the identification information indicating that the object is an object that may affect the traveling. As a result, the central brain 15 can perform the driving control of the vehicle 50 in consideration of the object that may affect the traveling.

In addition, the acquisition unit 415 acquires the image and the position information from the external camera 60 positioned in front of the traveling route of the vehicle 50. As a result, the central brain 15 can perform the preliminary control for the object that may affect the traveling before reaching the installation position of the external camera 60.

In addition, the acquisition unit 415 acquires the image and the position information only from the external camera closest to the own apparatus in front of the traveling route of the vehicle 50. As a result, the amount of communication data in the acquisition unit 415 can be reduced.

A method of specifying the external camera 60 from which the acquisition unit 415 acquires the image and the position information is not limited to the above aspect, and may be any aspect. For example, the acquisition unit 415 may specify the external camera 60 positioned in front of the traveling route of the vehicle 50 based on route information of the navigation system 45 that guides the traveling route of the vehicle 50, and acquire the image and the position information from the specified external camera 60.

For example, as shown in Fig. 33, it is assumed that a traveling route R of the vehicle 50 is set by the navigation system 45. In this case, the acquisition unit 415 may specify the external cameras 60A, 60B, 60C, 60E, 60F, and 60G installed along the traveling route R as the external cameras 60 positioned in front of the traveling route of the vehicle 50, and acquire the images and the pieces of position information from the specified external cameras 60.

In this case, for the acquisition of the images and the pieces of position information, the acquisition unit 415 does not necessarily need to acquire the images and the pieces of position information from all the external cameras 60 installed along the traveling route R, and for example, may acquire the image and the position information only from the external camera 60 positioned within a predetermined distance range from the vehicle 50.

Furthermore, in a case where the camera management database manages information regarding an imaging direction and/or an imaging range of the camera in addition to the camera ID, the address, and the installation position, the acquisition unit 415 may specify the external camera 60 that can image the vehicle 50 during the traveling of the vehicle 50 along the traveling route R among the external cameras 60 installed along the traveling route R, and acquire the image and the position information from the specified external camera 60. With such an aspect, even in the case of the external camera 60 installed along the traveling route R, the image and the position information are not acquired from the external camera 60 that cannot image the vehicle 50, and data that cannot be used for traveling control is not acquired, which contributes to reduction in the amount of communication data and reduction in a processing amount of the acquisition unit 415.

(Sixteenth Embodiment)

Next, a sixteenth embodiment according to the present embodiment will be described while omitting or simplifying an overlapping portion with the above embodiments.

Fig. 34 is a block diagram showing an example of a configuration of an information processing apparatus 10 according to the sixteenth embodiment.

As shown in Fig. 34, the information processing apparatus 10 according to the sixteenth embodiment includes only one MoPU 12. The MoPU 12 includes an imaging unit 3616, and the imaging unit 3616 includes a single camera 30 and a moving unit 3816 that moves the camera 30. As shown in Fig. 35, the moving unit 3816 includes a disc-shaped rotating member 4016, and the rotating member 4016 is disposed such that an axis thereof is approximately along a horizontal direction. In addition, the moving unit 3816 includes an actuator 42 including a motor or the like, and the rotating member 4016 is rotated about the axis of the rotating member 4016 by the actuator 42.

The camera 30 is attached to a peripheral edge portion of the rotating member 4016 such that an imaging optical axis is parallel to the axis of the rotating member 4016. As a result, in a case where the rotating member 4016 is rotated by the actuator 42, the camera 30 is sequentially moved to a first position P1 and a second position P2 that is different from the first position P1 in the horizontal direction. More specifically, the camera 30 is cyclically moved along an annular path passing through each of the first position P1 and the second position P2.

Here, the MoPU 12 determines a frame rate FR of the camera 30 according to a score for an external environment, and the imaging unit 3616 of the MoPU 12 rotates the rotating member 4016 by the actuator 42 at a rotation cycle (= 1/FR) according to the determined frame rate FR. Furthermore, the moving unit 3816 of the imaging unit 3616 causes the camera 30 to capture an image at each of a timing of being positioned at the first position P1 and a timing of being positioned at the second position P2. As a result, an imaging cycle of the camera 30 becomes the reciprocal of twice the frame rate (= $1/(2\times FR)$).

The MoPU 12 includes a core 17. In the present embodiment, since there is a difference in imaging time between a first image captured at the first position P1 and a second image captured at the second position P2, a deviation occurs between two-dimensional positions of an object in the first image and the second image as compared with a case where the first image and the second image are captured at the same time. Therefore, the core 17 corrects the deviation between the two-dimensional positions of the object in the first image and the second image due to the imaging time difference between the first image and the second image.

Specifically, for example, as shown in Fig. 36A, a case where a two-dimensional position (XlA(t1),YlA(t1)) of an object A is calculated from a first image captured at the first position P1 at a first time t1, a two-dimensional position (XrA(t3),YrA(t3)) of the object A is calculated from a second image captured at the second position P2 at a third time t3, and a two-dimensional position (XlA(t2),YlA(t2)) of the object A is calculated from a first image captured at the first position P1 at a second time t2 (t1 < t2 < t3) is considered.

In this case, the core 17 performs matching between the first image captured at the first position P1 at the first time t1 and the first image captured at the first position P1 at the second time t2. In addition, the core 17 estimates the two-dimensional position of the object A in a virtual first image obtained in a case where image capturing is performed at the first position P1 at the third time t3 which is an imaging time at the second position P2 based on a matching result (see also a two-dimensional position (XlA(t3),YlA(t3)) expressed as "estimated two-dimensional position of the object A at time t3" in Fig. 36B).

As a result, the estimated two-dimensional position (XlA(t3),YlA(t3)) of the object A and the two-dimensional position (XrA(t3),YrA(t3)) of the object A are output from the MoPU 12 including the core 17 to the central brain 15 at a cycle according to the frame rate FR. Then, the central brain 15 calculates a three-dimensional position (XA(t3),YA(t3),ZA (t3)) of the object A at time t3 from the estimated two-dimensional position (XlA(t3),YlA(t3)) of the object A and the two-dimensional position (XrA(t3),YrA(t3)) of the object A.

For example, as shown in Fig. 36A, a case where a two-dimensional position (XlB(t1),YlB(t1)) of an object B is calculated from a first image captured at the first position P1 at the first time t1, a two-dimensional position (XrB(t3),YrB(t3)) of the object B is calculated from a second image captured at the second position P2 at the third time t3, and a two-dimensional position (XlB(t2),YlB(t2)) of the object A is calculated from the first image captured at the first position P1 at the second time t2 (t1 < t2 < t3) is considered.

In this case, the core 17 performs matching between the first image captured at the first position P1 at the first time t1 and the first image captured at the first position P1 at the second time t2. In addition, the core 17 estimates the two-dimensional position of the object B in a virtual first image obtained in a case where image capturing is performed at the first position P1 at the third time t3 which is an imaging time at the second position P2 based on a matching result (see also a two-dimensional position (XlB(t3),YlB(t3)) expressed as "estimated two-dimensional position of the object B at time t3" in Fig. 36B).

As a result, the estimated two-dimensional position (XlB(t3),YlB(t3)) of the object B and the two-dimensional position (XrB(t3),YrB(t3)) of the object B are output from the MoPU 12 including the core 17 to the central brain 15 at a cycle according to the frame rate FR. Then, the central brain 15 calculates a three-dimensional position (XB(t3),YB(t3),ZB(t3)) of the object B at time t3 from the estimated two-dimensional position (XlB(t3),YlB(t3)) and the two-dimensional position (XrB(t3),YrB(t3)) of the object B. As described above, the MoPU 12 including the core 17 is an example of a processing unit according to the disclosure together with the central brain 15 that calculates the three-dimensional position of the object.

As described above, in the information processing apparatus 10 according to the sixteenth embodiment, the imaging unit 3616 sequentially moves the camera 30 to the first position P1 and the first position P2 that is different from the first position P1 at least in the horizontal direction, and causes the camera 30 to capture the image at each of the first position P1 and the second position P2. Then, the processing unit (the MoPU 12 and the central brain 15) calculates the three-dimensional position of the object appearing in each of the first image and the second image based on the first image captured at the first position P1 and the second image captured at the second position P2. As a result, it is not necessary to provide a plurality of cameras 30 to calculate the three-dimensional position of the object, so that the configuration of the information processing apparatus 10 can be simplified.

In addition, in the sixteenth embodiment, the imaging unit 3616 includes the moving unit 3816 that rotates the rotating member 4016 to which the camera 30 is attached such that the camera 30 cyclically moves along the annular path passing through each of the first position P1 and the second position P2. As a result, for example, the implementation become easier as compared with an aspect in which the camera 30 linearly reciprocates between the first position P1 and the second position P2.

Furthermore, in the sixteenth embodiment, the processing unit (MoPU 12) calculates the score for the external environment, and determines the frame rate FR of the camera 30 according to the calculated score, and the moving unit 3816 changes a rotation speed of the rotating member 4016 according to the frame rate FR determined by the processing unit (MoPU 12). As a result, the frame rate FR of the camera 30 can be continuously changed.

In addition, in the sixteenth embodiment, the processing unit (the MoPU 12 and the central brain 15) corrects the deviation between the two-dimensional positions of the object in the first image and the second image due to the imaging time difference between the first image and the second image, and calculates the three-dimensional position of the object. As a result, accuracy in the calculation of the three-dimensional position of the object can be improved.

In addition, in the sixteenth embodiment, the processing unit (the core 17 of the MoPU 12) corrects the deviation between the two-dimensional positions of the object by performing matching between the first image captured at the first position P1 at the first time and the first image captured at the first position P1 at the second time and estimating the two-dimensional position of the object in the virtual first image obtained in a case where the imaging is performed at the first position P1 at the third time which is the imaging time at the second position based on the matching result. As a result, it is possible to improve the accuracy in the calculation of the three-dimensional position of the object by relatively simple processing.

In the sixteenth embodiment, an aspect in which the sequential movement of the camera 30 to the first position P1 and the second position P2 is implemented by rotating the rotating member 4016 to which the camera 30 is attached such that the camera 30 cyclically moves along the annular path passing through each of the first position P1 and the second position P2 has been described. However, the disclosure is not limited thereto, and the sequential movement of the camera 30 to the first position P1 and the second position P2 may be implemented by, for example, linearly reciprocating the camera 30 between the first position P1 and the second position P2.

Furthermore, in the sixteenth embodiment, an aspect in which the frame rate FR of the camera 30 is determined according to the score for the external environment, and the rotation speed of the rotating member 4016 is changed according to the determined frame rate FR has been described, but the disclosure is not limited thereto. For example, the rotation speed of the rotating member 4016 may be constant, and the frame rate FR of the camera 30 may be set to the reciprocal of an integral multiple of a time obtained by dividing the rotation cycle of the rotating member 4016 by 2.

(Seventeenth Embodiment)

Next, a seventeenth embodiment according to the present embodiment will be described while omitting or simplifying an overlapping portion with the above embodiments.

As an example, an information processing apparatus 10 according to the seventeenth embodiment has a configuration shown in Fig. 2 similar to that of the first embodiment.

An MoPU 12 according to the seventeenth embodiment outputs point information that represents an imaged object as a point in an image of the object captured by another camera, and calculates and outputs motion information indicating a motion of the point from a time series of point information. Specifically, the MoPU 12 calculates a direction of the motion of the point from the time series of point information by using the Hough transform, and calculates a speed of the motion from a change in point information of the calculated direction of the motion of the point.

For example, the direction of the motion of the point is calculated from the time series of point information as shown in Fig. 38A by using the Hough transform as shown in Fig. 38B.

An IPU 11 outputs identification information obtained by identifying the imaged object in an image of the object captured by an ultra-high-resolution camera in an imaging direction corresponding to the another camera.

A central brain 15 associates the motion information output from the MoPU 12 with the identification information output from the IPU 11. As shown in Fig. 37, the central brain 15 functionally includes an acquisition unit 170, a motion detection unit 172, a removal unit 174, and an association unit 176.

The acquisition unit 170 acquires the motion information output from the MoPU 12 and the identification information output from the IPU 11.

The motion detection unit 172 detects pieces of motion information of a plurality of objects whose directions of motions correspond to each other based on the motion information output from the MoPU 12. Specifically, in a case where an angle formed by the directions of the motions indicated by the pieces of motion information is equal to or smaller than a threshold, and the number of pieces of motion information of the plurality of objects whose directions of the motions correspond to each other is equal to or larger than a threshold, it is determined that the pieces of motion information of the plurality of objects whose directions of the motions correspond to each other have been detected.

For example, as shown in Fig. 39, pieces of motion information M1 to M6 of a plurality of objects whose directions of motions correspond to each other are detected from pieces of motion information M1 to M8 of the plurality of objects.

In a case where the pieces of motion information of the plurality of objects whose directions of the motions correspond to each other have been detected, the removal unit 174 removes the pieces of motion information of the plurality of objects.

For example, as shown in Fig. 40, the pieces of motion information M1 to M6 of the plurality of objects whose directions of the motions correspond to each other are removed from the pieces of motion information M1 to M8 of the plurality of objects, whereby the pieces of motion information M7 and M8 are obtained.

The association unit 176 associates the motion information after the removal with the identification information output from the IPU 11, and controls autonomous driving of a movable body based on the motion information and the identification information associated with each other.

Next, association processing executed by the central brain 15 will be described with reference to Fig. 41. At this time, it is assumed that the motion information is input from the MoPU 12 to the central brain 15 and the identification information is input from the IPU 11 to the central brain 15.

First, in step S100, the acquisition unit 170 acquires the motion information output from the MoPU 12 and the identification information output from the IPU 11.

In step S102, the motion detection unit 172 detects the pieces of motion information of the plurality of objects whose directions of the motions correspond to each other based on the motion information output from the MoPU 12.

In step S104, in a case where the pieces of motion information of the plurality of objects whose directions of the motions correspond to each other has been detected, the removal unit 174 removes the pieces of motion information of the plurality of objects.

In step S106, the association unit 176 associates the motion information after the removal with the identification information output from the IPU 11.

As described above, in the information processing apparatus 10 according to the seventeenth embodiment, in a case where the pieces of motion information of the plurality of objects whose directions of the motions correspond to each other has been detected, the central brain 15 removes the pieces of motion information of the plurality of objects and associates the remaining motion information with the identification information. As a result, in a case where many small objects whose directions of motions correspond to each other have been detected from the motion information output from the MoPU 12, the association with the identification information can be made after removing the small objects. For example, noise during rainfall or snowfall can be removed from the motion information output from the MoPU 12.

(Eighteenth Embodiment)

Next, an eighteenth embodiment according to the present embodiment will be described while omitting or simplifying an overlapping portion with the above embodiments.

As an example, an information processing apparatus 10 according to the eighteenth embodiment has a configuration shown in Fig. 2 similar to that of the first embodiment.

Similarly to the first embodiment, an MoPU 12 according to the eighteenth embodiment outputs point information that represents an imaged object as a point in an image of the object captured by another camera.

Then, as shown in Fig. 42, in a case where a certain number or more of points whose movement direction is the same one side direction in an upward-downward direction and whose movement amount in the upward-downward direction is within a certain range have been detected based on the point information output based on images of a plurality of frames, the MoPU 12 outputs only a point other than the detected certain number or more of points among the points included in the point information. The upward-downward direction here refers to a top-bottom direction of the image and refers to a direction corresponding to a height direction of the vehicle 100. A left-right direction here refers to a left-right direction of the image, and refers to a direction corresponding to a vehicle width direction of a vehicle 100. The certain range in this case may be set in advance as a fixed value or may be set according to a condition of a road surface. Furthermore, the certain number in this case may be set in advance as a fixed value, or may be set according to the number of points included in the point information, for example, a value of 10% of the number of points included in the point information.

Fig. 42 shows an example in which three points Q1, Q2, and Q3 are included in the point information in each of images of three consecutive frames. In addition, Fig. 42 shows an example in which the point Q1 and the point Q2 move in the same one side direction in the upward-downward direction, and the movement amount in the upward-downward direction is within the certain range. In addition, Fig. 42 shows an example in which the point Q3 moves in a lower-left direction after moving in an upper-left direction.

In the example of Fig. 42, the MoPU 12 outputs only the point Q3 from among the three points Q1, Q2, and Q3 included in the point information based on the point information output based on the images of the three consecutive frames. This is because it is estimated that the points Q1 and Q2 are actually stationary, but the points Q1 and Q2 appear to move in the image due to the vehicle 100 bouncing as a result of the condition of the road surface or the like.

The point information indicating the point output by the MoPU 12 is associated with label information output from the IPU 11 by the central brain 15 as in the first embodiment.

As described above, according to the present embodiment, among pieces of point information to be output, information indicating a point estimated to appear to move in the image although the point is actually stationary is excluded. Therefore, according to the embodiment, in a case where the point information that is imaging information of the object imaged by the camera is output to a predetermined output destination, the amount of data output to the output destination can be reduced.

In the embodiment, in a case where the vehicle 100 is traveling straight, the MoPU 12 may further output a point whose movement amount in the left-right direction is equal to or larger than a threshold from among the detected certain number or more of points. The MoPU 12 can determine whether or not the vehicle 100 is traveling straight by using a known technique such as a technique of determining whether or not the vehicle 100 is traveling straight by using a steering angle of the vehicle 100 or a technique of determining whether or not the vehicle 100 is traveling straight by using a left-right wheel speed ratio for front wheels and rear wheels.

Furthermore, in the embodiment, the central brain 15 may execute processing of outputting only a point other than the detected certain number or more of points among the points included in the point information instead of the MoPU 12.

(Nineteenth Embodiment)

Next, a nineteenth embodiment according to the present embodiment will be described while omitting or simplifying an overlapping portion with the above embodiments.

Fig. 43 is a block diagram showing an example of a configuration of an information processing apparatus 10 according to the nineteenth embodiment. Fig. 43 shows only a configuration of a part of the information processing apparatus 10. The information processing apparatus 10 is an example of an "information processing apparatus" and a "computer" according to the disclosure.

The information processing apparatus 10 is mounted on a plurality of vehicles 200. In the example shown in Fig. 43, a first vehicle 200A and a second vehicle 200B are shown as an example of the plurality of vehicles 200. The first vehicle 200A is an example of a "first movable body" according to the disclosure, and the second vehicle 200B is an example of a "second movable body" according to the disclosure. Hereinafter, for convenience of description, the first vehicle 200A and the second vehicle 200B will be referred to as "vehicle 200" in a case where it is not necessary to distinguish the first vehicle 200A and the second vehicle 200B for description.

The information processing apparatus 10 includes a central brain 15, a communication I/F 202, a first memory 204, and a second memory 206. Here, the I/F is an abbreviation of "interface".

The central brain 15 of the information processing apparatus 10 mounted on the first vehicle 200A is used for the first vehicle 200A. The central brain 15 of the information processing apparatus 10 mounted on the second vehicle 200B is used for the second vehicle 200B. The central brain 15 of the information processing apparatus 10 mounted on the first vehicle 200A is an example of a "first movable body processor" according to the disclosure, and the central brain 15 of the information processing apparatus 10 mounted on the second vehicle 200B is an example of a "second movable body processor" according to the disclosure.

Hereinafter, for convenience of description, the information processing apparatus 10 mounted on the first vehicle 200A is referred to as the "information processing apparatus 10 of the first vehicle 200A", and the information processing apparatus 10 mounted on the second vehicle 200B is referred to as the "information processing apparatus 10 of the second vehicle 200B". Further, hereinafter, for convenience of description, the central brain 15 of the information processing apparatus 10 of the first vehicle 200A is referred to as the "central brain 15 of the first vehicle 200A", and the central brain 15 of the information processing apparatus 10 of the second vehicle 200B is referred to as the "central brain 15 of the second vehicle 200B".

The communication I/F 202, the first memory 204, and the second memory 206 are connected to the central brain 15. The communication I/F 202 is a communication interface including a communication processor, an antenna, and the like, and is included in a gateway shown in Fig. 1. The communication I/F 202 manages communication using the central brain 15 between different vehicles 200. For example, the central brain 15 of the first vehicle 200A and the central brain 15 of the second vehicle 200B exchange various signals via the communication I/F 202 of the first vehicle 200A and the communication I/F 202 of the second vehicle 200B. Examples of a communication standard applied to the communication I/F 202 include a wireless communication standard such as Wi-Fi (registered trademark) or 5th generation mobile communication system (5G).

The first memory 204 is, for example, a non-volatile memory (for example, a flash memory). The first memory 204 stores various programs including a program 208, various parameters, and the like. The program 208 is an example of an "information processing program" according to the disclosure.

The second memory 206 is, for example, a volatile memory (for example, a random access memory (RAM)). The second memory 206 is a memory in which information is temporarily stored, and is used as a work memory by a processor such as the central brain 15.

Meanwhile, in the first vehicle 200A and the second vehicle 200B, autonomous driving is performed under the control of the information processing apparatus 10 as described in the first embodiment and the like. In the autonomous driving of the first vehicle 200A, driving of the first vehicle 200Ais controlled based on information (for example, information regarding a current position and a current speed) regarding the second vehicle 200B that is another vehicle around the first vehicle 200A. Meanwhile, the second vehicle 200B also performs the autonomous driving in the same manner. In this case, the second vehicle 200B recognizes the first vehicle 200A, and then predicts a motion of the first vehicle 200A to perform the autonomous driving.

As described above, in a case where the first vehicle 200Aand the second vehicle 200B recognize each other and predict the motions thereof to perform the autonomous driving, for example, both the first vehicle 200A and the second vehicle 200B may change courses thereof in order to avoid a frontal collision between the first vehicle 200A and the second vehicle 200B. However, both the first vehicle 200A and the second vehicle 200B change the courses even though it is sufficient to change the course of only one of the first vehicle 200A and the second vehicle 200B, which may hinder traveling of surrounding vehicles (for example, a following vehicle of the first vehicle 200A, a following vehicle of the second vehicle 200B, a vehicle traveling in parallel to the first vehicle 200A, and a vehicle traveling in parallel to the second vehicle 200B) other than the first vehicle 200A and the second vehicle 200B.

The first vehicle 200A also changes the course even though it is sufficient to change only the course of the second vehicle 200B by the control of the autonomous driving of the first vehicle 200A and the second vehicle 200B in order to avoid the frontal collision, and in this case, for example, there is a possibility of giving discomfort to an occupant due to a sudden course change. The same applies not only to a scene where the frontal collision is to be avoided but also to a scene where a contact at the time of lane change and/or a contact at the time of platooning is to be avoided.

In addition, in a conventionally known technique (for example, a technique described in Patent Literature 1), it is difficult for a driver or the like of the first vehicle 200A to grasp whether or not the second vehicle 200B has recognized the first vehicle 200A. Therefore, it is difficult to change a driving method of the first vehicle 200A or change how the driver of the first vehicle 200A feels about the second vehicle 200B depending on whether or not the second vehicle 200B has recognized the first vehicle 200A.

Therefore, in the nineteenth embodiment, autonomous driving control processing is executed by the central brain 15 in view of such circumstances.

The central brain 15 reads the program 208 from the first memory 204 and executes the read program 208 on the second memory 206 to execute the autonomous driving control processing. The autonomous driving control processing is implemented by the central brain 15 operating as a first determination unit 15A, a second determination unit 15B, a third determination unit 15C, a setting unit 15D, an inference unit 15E, an adjustment unit 15F, and a driving control unit 15G according to the program 208 executed on the second memory 206.

Respective pieces of priority level information 209 different from each other are assigned to the plurality of vehicles 200. The priority level information 209 is information indicating a priority level of the vehicle 200 that is preferentially processed by the setting unit 15D among the plurality of vehicles 200. The priority level indicated by the priority level information 209 assigned to the first vehicle 200A is an example of a "first priority level" according to the disclosure, and the priority level indicated by the priority level information 209 assigned to the second vehicle 200B is an example of a "second priority level" according to the disclosure. The priority level information 209 is stored in the first memory 204 of the information processing apparatus 10 of each vehicle 200.

Fig. 44 is a conceptual diagram showing an example of processing contents of the first determination unit 15A, the second determination unit 15B, the third determination unit 15C, and the setting unit 15D of the first vehicle 200A.

Label information 210 is input from an IPU 11 to the central brain 15 of the first vehicle 200A. The label information 210 is the same information as the label information described in the first embodiment.

The label information 210 input to the central brain 15 of the first vehicle 200A is an example of "second movable body information for specifying the second movable body" according to the disclosure. The label information 210 input to the central brain 15 of the second vehicle 200B is an example of "first movable body information for specifying the first movable body" according to the disclosure.

The first determination unit 15A acquires the label information 210 and recognizes, by referring to the label information 210, the type of an object (an example of a "first object" according to the disclosure) appearing in a first image which is an image obtained by imaging the surroundings of the first vehicle 200A using an ultra-high-resolution camera of the first vehicle 200A (hereinafter also simply referred to as "first image"). Then, the first determination unit 15A determines whether or not the type recognized as the type of the object appearing in the first image is the second vehicle 200B.

The information processing apparatus 10 of the second vehicle 200B also recognizes the type of an object (an example of a "second object" according to the disclosure) appearing in a second image which is an image obtained by imaging the surroundings of the second vehicle 200B using an ultra-high-resolution camera of the second vehicle 200B (hereinafter also simply referred to as a "second image"), in the same manner. Then, it is determined whether or not the recognized type is the first vehicle 200A.

In a case where the first determination unit 15A determines that the second vehicle 200B appears in the first image, the central brain 15 of the first vehicle 200A transmits a request signal 212 to the information processing apparatus 10 of the second vehicle 200B via the communication I/F 202. The request signal 212 is a signal for requesting the information processing apparatus 10 of the second vehicle 200B to transmit a response signal 214.

The communication I/F 202 of the second vehicle 200B receives the request signal 212 transmitted by the central brain 15 of the first vehicle 200A. The central brain 15 of the second vehicle 200B transmits the response signal 214 corresponding to the request signal 212 to the information processing apparatus 10 of the first vehicle 200A via the communication I/F 202 of the second vehicle 200B.

In a case where the response signal 214 is transmitted from the central brain 15 of the second vehicle 200B, the communication I/F 202 of the first vehicle 200A receives the response signal 214. The central brain 15 of the first vehicle 200A acquires the response signal 214 received by the communication I/F 202.

The response signal 214 includes driving information 214A, recognition information 214B, and control information 214C. The response signal 214 also includes the priority level information 209 assigned to the second vehicle 200B.

The driving information 214A is information indicating whether or not the second vehicle 200B is performing the autonomous driving. The recognition information 214B is information indicating whether or not the first vehicle 200A has been recognized by the information processing apparatus 10 of the second vehicle 200B. The control information 214C is information for controlling the autonomous driving of the second vehicle 200B by the central brain 15 of the second vehicle 200B.

The first determination unit 15A determines, by referring to the label information 210 and the driving information 214A, whether or not the type recognized as the type of the object appearing in the first image is the second vehicle 200B that is performing the autonomous driving.

In a case where the first determination unit 15A determines that the type recognized as the type of the object appearing in the first image is the second vehicle 200B that is performing the autonomous driving, the second determination unit 15B determines, by referring to the recognition information 214B, whether or not the information processing apparatus 10 of the second vehicle 200B has recognized the first vehicle 200A.

In a case where the second determination unit 15B determines that the information processing apparatus 10 of the second vehicle 200B has recognized the first vehicle 200A, the third determination unit 15C determines whether or not the priority level of the first vehicle 200A is higher than the priority level of the second vehicle 200B. The determination by the third determination unit 15C is performed using the priority level information 209 included in the response signal 214 and the priority level information 209 stored in the first memory 204. The priority level information 209 included in the response signal 214 is information assigned to the second vehicle 200B, and the priority level information 209 stored in the first memory 204 is information assigned to the first vehicle 200A. The third determination unit 15C determines whether or not the level indicated by the priority level information 209 assigned to the first vehicle 200A is higher than the level indicated by the priority level information 209 assigned to the second vehicle 200B.

Here, in a case where it is determined that the level indicated by the priority level information 209 assigned to the first vehicle 200A is higher than the level indicated by the priority level information 209 assigned to the second vehicle 200B, the setting unit 15D sets an identifier 216 indicating that the first vehicle 200A has been recognized by the second vehicle 200B. The setting of the identifier 216 is implemented by storing the identifier 216 in the second memory 206 by the setting unit 15D. Examples of the identifier 216 include a flag.

Fig. 45 is a conceptual diagram showing an example of contents of processing executed by the inference unit 15E and the driving control unit 15G of the first vehicle 200A in a case where the identifier 216 has not been set by the setting unit 15D.

In a case where the identifier 216 has not been set by the setting unit 15D, the central brain 15 controls the autonomous driving of the first vehicle 200A in the same manner as described in the first embodiment and the like based on sensor information 218, association information 219, and unset information 222. The sensor information 218 is the same information as the sensor information described in the first embodiment and the like. The association information 219 is information in which first point information and the label information 210 are associated with each other in the same manner as described in the first embodiment and the like. The first point information is the same information as the point information described in the first embodiment and the like. That is, the first point information is point information that represents, as a point, the object (an example of the "first object" according to the disclosure) included in the surroundings of the first vehicle 200A based on a third image which is an image obtained by imaging the surroundings of the first vehicle 200A at a frame rate higher than a frame rate of imaging performed to obtain the first image (hereinafter also simply referred to as "third image"). The unset information 222 is information indicating that the identifier 216 has not been set.

Here, a mode example in which the association information 219 is obtained by the central brain 15 of the first vehicle 200A is described. However, the central brain 15 of the second vehicle 200B also obtains second-vehicle-side association information (not shown) as information similar to the association information 219. The second-vehicle-side association information is information in which second point information obtained in the same manner as the point information described in the first embodiment and the like and information obtained in the same manner as the label information 210 are associated with each other. The second point information is point information that represents, as a point, the object (an example of the "second object" according to the disclosure) included in the surroundings of the second vehicle 200B based on a fourth image which is an image obtained by imaging the surroundings of the second vehicle 200B at a frame rate higher than the frame rate of imaging performed to obtain the second image (hereinafter also simply referred to as "fourth image"). The second-vehicle-side association information is used by the central brain 15 of the second vehicle 200B in processing similar to that of the central brain 15 of the first vehicle 200A.

In order to implement the control of the autonomous driving of the first vehicle 200A, the central brain 15 calculates a first control variable 224 as a control variable for controlling the autonomous driving of the first vehicle 200A based on the sensor information 218 and the association information 219. The first control variable 224 is a variable synonymous with the control variable described in the first embodiment and the like.

The first control variable 224 is calculated by the inference unit 15E. The inference unit 15E includes a deep learning model 226, and calculates the first control variable 224 by using the deep learning model 226.

The deep learning model 226 is a trained model obtained by performing deep learning using training data for a neural network. Examples of the training data used here include a data set in which example data and ground truth data assuming the first control variable 224 are associated with each other. Examples of the example data include data obtained in advance by a test and/or computer simulation using an actual machine as data assuming the sensor information 218, data obtained in advance by a test and/or computer simulation using an actual machine as data assuming the association information 219, and data indicating whether or not the identifier 216 has been set.

The inference unit 15E inputs the sensor information 218, the association information 219, and the unset information 222 to the deep learning model 226. The deep learning model 226 outputs the first control variable 224 (for example, a control variable with the highest certainty level) corresponding to the sensor information 218, the association information 219, and the unset information 222 that are input.

Here, a calculation method of calculating the first control variable 224 by using the deep learning model 226 has been exemplified, but this is merely an example, and the first control variable 224 may be calculated by using various calculation methods (for example, multivariate analysis by an integration method) described in the fourth embodiment.

The driving control unit 15G controls the autonomous driving of the first vehicle 200A based on the first control variable 224 calculated by the inference unit 15E in the same manner as described in the first embodiment and the like.

Fig. 46 is a conceptual diagram showing an example of contents of processing performed by the inference unit 15E and the driving control unit 15G of the first vehicle 200A in a case where the identifier 216 has been set by the setting unit 15D.

In a case where the identifier 216 has been set by the setting unit 15D, the central brain 15 controls the autonomous driving of the first vehicle 200A in the same manner as described in the first embodiment and the like based on the sensor information 218, the association information 219, and set information 228. The set information 228 is information indicating that the identifier 216 has been set.

The inference unit 15E inputs the sensor information 218, the association information 219, and the set information 228 to the deep learning model 226. The deep learning model 226 outputs the first control variable 224 corresponding to the sensor information 218, the association information 219, and the set information 228 that are input.

The central brain 15 controls the autonomous driving of the first vehicle 200A based on the control information 214C (see Fig. 44) acquired from the information processing apparatus 10 of the second vehicle 200B. In order to implement such a configuration, in the example shown in Fig. 46, the adjustment unit 15F acquires the first control variable 224 and the control information 214C. The acquisition of the control information 214C by the adjustment unit 15F is performed under the condition that the priority level indicated by the priority level information 209 assigned to the first vehicle 200A is higher than the priority level indicated by the priority level information 209 (in the example shown in Fig. 44, the priority level information 209 included in the response signal 214) assigned to the second vehicle 200B. In the nineteenth embodiment, in a case where the identifier 216 has been set, the control information 214C is acquired from the response signal 214 (see Fig. 44) by the adjustment unit 15F.

The adjustment unit 15F generates a second control variable 230 by adjusting the first control variable 224 based on the control information 214C. Since the control information 214C is information for controlling the autonomous driving of the second vehicle 200B by the central brain 15 of the second vehicle 200B, the adjustment unit 15F can predict the autonomous driving of the second vehicle 200B from the control information 214C, and adjusts the first control variable 224 by reflecting a result of predicting the autonomous driving of the second vehicle 200B in the first control variable 224. The second control variable 230 obtained by adjusting the first control variable 224 by the adjustment unit 15F is used by the driving control unit 15G. That is, the driving control unit 15G controls the autonomous driving of the first vehicle 200A based on the second control variable 230.

Accordingly, in a case where the second vehicle 200B is performing the autonomous driving, the autonomous driving of the first vehicle 200A is controlled based on behavior of the second vehicle 200B. That is, the driving control unit 15G predicts the behavior of the second vehicle 200B during the autonomous driving, and controls the autonomous driving of the first vehicle 200A based on the predicted behavior.

For example, as shown in Fig. 47, in a case where the first vehicle 200A and the second vehicle 200B are traveling straight while facing each other, the autonomous driving of the first vehicle 200A is controlled according to a control content for avoiding a contact (here, the front collision, for example) between the first vehicle 200A and the second vehicle 200B. The driving control unit 15G of the first vehicle 200A predicts, based on the control information 214C, that the second vehicle 200B that is performing the autonomous driving changes the course of the second vehicle 200B. Therefore, the driving control unit 15G of the first vehicle 200A determines that the contact between the first vehicle 200A and the second vehicle 200B can be avoided even in a case where the first vehicle 200A travels straight without changing the course of the first vehicle 200A. Then, the driving control unit 15G of the first vehicle 200A controls the autonomous driving of the first vehicle 200A such that the first vehicle 200A travels straight as it is.

Figs. 48 to 50 are flowcharts showing an example of a flow of the autonomous driving control processing executed by the central brain 15 of the first vehicle 200A. The flow of the autonomous driving control processing shown in the flowcharts of Figs. 48 to 50 is an example of an "information processing method" according to the disclosure.

In the autonomous driving control processing shown in Fig. 48, first, in step ST10, the first determination unit 15A acquires the label information 210 from the IPU 11. After the processing of step ST10 is executed, the autonomous driving control processing proceeds to step ST12.

In step ST12, the first determination unit 15A determines whether or not the type recognized as the type of the object appearing in the first image is the second vehicle 200B by referring to the label information 210. In step ST12, in a case where the type recognized as the type of the object appearing in the first image is not the second vehicle 200B, a negative determination is made, and the autonomous driving control processing proceeds to step ST34 shown in Fig. 49.

In step ST12, in a case where the type recognized as the type of the object appearing in the first image is the second vehicle 200B, an affirmative determination is made, and the autonomous driving control processing proceeds to step ST14.

In step ST14, the central brain 15 transmits the request signal 212 to the information processing apparatus 10 of the second vehicle 200B. After the processing of step ST14 is executed, the autonomous driving control processing proceeds to step ST16.

In step ST16, the central brain 15 determines whether or not the response signal 214 has been received by the communication I/F 202. In step ST16, in a case where the response signal 214 has not been received by the communication I/F 202, a negative determination is made, and the autonomous driving control processing proceeds to step ST18. In step ST16, in a case where the response signal 214 has been received by the communication I/F 202, an affirmative determination is made, and the autonomous driving control processing proceeds to step ST20.

In step ST18, the central brain 15 determines whether or not a predetermined time (for example, a time determined in advance within a range of several milliseconds to several hundred milliseconds) has elapsed since the execution of the processing of step ST16. In step ST18, in a case where the predetermined time has not elapsed since the execution of the processing of step ST16, a negative determination is made, and the autonomous driving control processing proceeds to step ST16. In step ST18, in a case where the predetermined time has elapsed since the execution of the processing of step ST16, an affirmative determination is made, and the autonomous driving control processing proceeds to step ST34 shown in Fig. 49.

In step ST20, the first determination unit 15A acquires the driving information 214A from the response signal 214. After the processing of step ST20 is executed, the autonomous driving control processing proceeds to step ST22.

In step ST22, the first determination unit 15A determines, by referring to the label information 210 and the driving information 214A, whether or not the type recognized as the type of the object appearing in the first image is the second vehicle 200B that is performing the autonomous driving. In step ST22, in a case where the type recognized as the type of the object appearing in the first image is not the second vehicle 200B that is performing the autonomous driving, a negative determination is made, and the autonomous driving control processing proceeds to step ST34 shown in Fig. 49. In step ST22, in a case where the type recognized as the type of the object appearing in the first image is the second vehicle 200B that is performing the autonomous driving, an affirmative determination is made, and the autonomous driving control processing proceeds to step ST24.

In step ST24, the second determination unit 15B acquires the recognition information 214B from the response signal 214. After the processing of step ST24 is executed, the autonomous driving control processing proceeds to step ST26.

In step ST26, the second determination unit 15B determines whether or not the information processing apparatus 10 of the second vehicle 200B has recognized the first vehicle 200A by referring to the recognition information 214B. In step ST26, in a case where the information processing apparatus 10 of the second vehicle 200B has not recognized the first vehicle 200A, a negative determination is made, and the autonomous driving control processing proceeds to step ST34 shown in Fig. 49. In step ST26, in a case where the information processing apparatus 10 of the second vehicle 200B has recognized the first vehicle 200A, an affirmative determination is made, and the autonomous driving control processing proceeds to step ST28.

In step ST28, the third determination unit 15C acquires the priority level information 209 (that is, the priority level information 209 assigned to the second vehicle 200B) included in the response signal 214 and the priority level information 209 (that is, the priority level information 209 assigned to the first vehicle 200A) stored in the first memory 204. After the processing of step ST28 is executed, the autonomous driving control processing proceeds to step ST30.

In step ST30, the third determination unit 15C determines whether or not the level indicated by the priority level information 209 assigned to the first vehicle 200A (hereinafter also referred to as the "priority level of the first vehicle 200A") is higher than the level indicated by the priority level information 209 assigned to the second vehicle 200B (hereinafter also referred to as the "priority level of the second vehicle 200B"). In step ST28, in a case where the priority level of the first vehicle 200A is not higher than the priority level of the second vehicle 200B, a negative determination is made, and the autonomous driving control processing proceeds to step ST34 shown in Fig. 49. In step ST28, in a case where the priority level of the first vehicle 200A is higher than the priority level of the second vehicle 200B, an affirmative determination is made, and the autonomous driving control processing proceeds to step ST32.

In step ST32, the setting unit 15D sets the identifier 216 by storing the identifier 216 in the second memory 206. After the processing of step ST32 is executed, the autonomous driving control processing proceeds to step ST40 shown in Fig. 50.

In step ST34 shown in Fig. 49, the inference unit 15E inputs the sensor information 218, the association information 219, and the unset information 222 to the deep learning model 226. After the processing of step ST34 is executed, the autonomous driving control processing proceeds to step ST36.

In step ST36, the inference unit 15E acquires the first control variable 224 output from the deep learning model 226 in response to the sensor information 218, the association information 219, and the unset information 222 being input to the deep learning model 226. After the processing of step ST36 is executed, the autonomous driving control processing proceeds to step ST38.

In step ST38, the driving control unit 15G controls the autonomous driving of the first vehicle 200A based on the first control variable 224. After the processing of step ST38 is executed, the autonomous driving control processing proceeds to step ST52 shown in Fig. 50.

In step ST40 shown in Fig. 50, the inference unit 15E inputs the sensor information 218, the association information 219, and the set information 228 to the deep learning model 226. After the processing of step ST40 is executed, the autonomous driving control processing proceeds to step ST42.

In step ST42, the inference unit 15E acquires the first control variable 224 output from the deep learning model 226 in response to the sensor information 218, the association information 219, and the set information 228 being input to the deep learning model 226 by the inference unit 15E. After the processing of step ST42 is executed, the autonomous driving control processing proceeds to step ST44.

In step ST44, the adjustment unit 15F acquires the control information 214C from the response signal 214. After the processing of step ST44 is executed, the autonomous driving control processing proceeds to step ST46.

In step ST46, the adjustment unit 15F generates the second control variable 224 by adjusting the first control variable 230 acquired in step ST42 based on the control information 214C acquired in step ST44. After the processing of step ST46 is executed, the autonomous driving control processing proceeds to step ST48.

In step ST48, the driving control unit 15G controls the autonomous driving of the first vehicle 200A based on the second control variable 230. After the processing of step ST48 is executed, the autonomous driving control processing proceeds to step ST50.

In step ST50, the setting unit 15D cancels the setting of the identifier 216 by erasing the identifier 216 from the second memory 206. After the processing of step ST50 is executed, the autonomous driving control processing proceeds to step ST52.

In step ST52, the central brain 15 determines whether or not a condition for ending the autonomous driving control processing is satisfied. As an example of the condition for ending the autonomous driving control processing, there is a condition that an instruction to end the autonomous driving control processing is given to the information processing apparatus 10 of the first vehicle 200A. In step ST52, in a case where the condition for ending the autonomous driving control processing is not satisfied, a negative determination is made, and the autonomous driving control processing proceeds to step ST10 shown in Fig. 48. In step ST52, in a case where the condition for ending the autonomous driving control processing is satisfied, an affirmative determination is made, and the autonomous driving control processing ends.

As described above, in the nineteenth embodiment, in a case where the central brain 15 of the first vehicle 200A has recognized the second vehicle 200B that is performing the autonomous driving and the central brain 15 of the second vehicle 200B has recognized the first vehicle 200A, the identifier 216 is set by the setting unit 15D. As a result, it is possible to contribute to changing behavior of the first vehicle 200A between a case where the second vehicle 200B that is performing the autonomous driving has recognized the first vehicle 200A and a case where the second vehicle 200B that is performing the autonomous driving has not recognized the first vehicle 200A, in a case where the first vehicle 200A has recognized the second vehicle 200B that is performing the autonomous driving around the first vehicle 200A.

In the nineteenth embodiment, the autonomous driving of the first vehicle 200A is controlled based on the behavior of the second vehicle 200B that is performing the autonomous driving under the condition that the identifier 216 is set. Therefore, in a case where the first vehicle 200A has recognized the second vehicle 200B that is performing the autonomous driving around the first vehicle 200A, the behavior of the first vehicle 200A can be changed between a case where the second vehicle 200B that is performing the autonomous driving has recognized the first vehicle 200A and a case where the second vehicle 200B that is performing the autonomous driving has not recognized the first vehicle 200A.

Further, in the nineteenth embodiment, the autonomous driving of the first vehicle 200A is controlled by the central brain 15 of the first vehicle 200A based on the control information 214C. The control information 214C is information for controlling the autonomous driving of the second vehicle 200B by the central brain 15 of the second vehicle 200B. Therefore, the central brain 15 of the first vehicle 200A can control the autonomous driving of the first vehicle 200A after predicting the behavior of the second vehicle 200B that is performing the autonomous driving with high accuracy as compared with a case where the autonomous driving of the first vehicle 200A is controlled without using the control information 214C.

In addition, in the nineteenth embodiment, the control information 214C is acquired by the central brain 15 of the first vehicle 200A, and the autonomous driving of the first vehicle 200A is controlled based on the control information 214C under the condition that the priority level of the first vehicle 200A is higher than the priority level of the second vehicle 200B. As a result, the adjustment of the first control variable 224 and the control of the autonomous driving based on the second control variable 230 (see Fig. 46) can be prevented from being performed by the central brain 15 of the second vehicle 200B.

As described above, since unnecessary processing (for example, the adjustment of the first control variable 224 and the control of the autonomous driving based on the second control variable 230 (see Fig. 46)) is not executed by the central brain 15 of the second vehicle 200B, a processing load on the central brain 15 of the second vehicle 200B can be reduced.

As shown in Fig. 47, in a case where the first vehicle 200A and the second vehicle 200B travel straight while facing each other, the course of the second vehicle 200B is changed because the autonomous driving is controlled based on the control variable obtained in the same manner as the first control variable 224. On the other hand, the first vehicle 200A travels straight without changing the course according to the control of the autonomous driving based on the second control variable 230. Accordingly, the first vehicle 200A can avoid the contact (the front collision in the example shown in Fig. 47) with the second vehicle 200B without unnecessary course changes. In addition, since the first vehicle 200A travels straight without unnecessary course changes, it is possible to prevent the traveling of the following vehicle of the first vehicle 200A and/or the vehicle traveling in parallel to the first vehicle 200A from being hindered.

In the nineteenth embodiment described above, a mode example in which the central brain 15 operates as the first determination unit 15A, the second determination unit 15B, the third determination unit 15C, the setting unit 15D, the inference unit 15E, the adjustment unit 15F, and the driving control unit 15G has been described, but the disclosure is not limited thereto. For example, as shown in Fig. 51, the central brain 15 may further operate as a notification control unit 15H. For example, in this case, the notification control unit 15H causes a notification device 232 to notify that the first vehicle 200A has been recognized by the central brain of the second vehicle 200B under the condition that the identifier 216 is set by the setting unit 15D.

A first example of the notification device 232 is a display 232A. In this case, the notification control unit 15H displays a message 234 and/or visible information such as a mark indicating that the first vehicle 200A has been recognized by the central brain 15 of the second vehicle 200B on a screen of the display 232A. A second example of the notification device 232 is a sound reproduction device 232B including a speaker. In this case, the notification control unit 15H causes the sound reproduction device 232B to reproduce a sound indicating that the first vehicle 200A has been recognized by the central brain 15 of the second vehicle 200B. The display 232A and the sound reproduction device 232B are merely examples, and any device may be used as long as the device can cause the driver or the like of the first vehicle 200A to perceive information indicating that the first vehicle 200A has been recognized by the central brain 15 of the second vehicle 200B.

As described above, in a case where a notification that the first vehicle 200A has been recognized by the central brain 15 of the second vehicle 200B is made under the condition that the identifier 216 is set by the setting unit 15D, the driver or the like of the first vehicle 200A can notice that the first vehicle 200A has been recognized by the central brain of the second vehicle 200B. As a result, for example, the driver of the first vehicle 200A can change the driving method of the first vehicle 200A or change how the driver of the first vehicle 200A feels about the second vehicle 200B depending on whether or not the second vehicle 200B has recognized the first vehicle 200A.

In addition, in the nineteenth embodiment described above, a condition for setting the identifier 216 by the setting unit 15D includes a first condition that the second vehicle 200B that is performing the autonomous driving has been recognized by the central brain 15 of the first vehicle 200A and a second condition that the first vehicle 200A has been recognized by the central brain 15 of the second vehicle 200B, but the disclosure is not limited thereto. For example, the identifier 216 may be set by the setting unit 15D in a case where the following third condition is satisfied in addition to the first condition and the second condition. The third conditions refers to a condition that the central brain 15 of the second vehicle 200B executes control processing of controlling the autonomous driving of the second vehicle 200B based on the second-vehicle-side association information in the same manner as that in which the autonomous driving of the first vehicle 200A is controlled based on the association information 219 (for example, in the same manner as the example shown in Figs. 45 and 46).

As the identifier 216 is set in a case where the first to third conditions are satisfied as described above, it is possible to reduce a frequency of setting the identifier 216 as compared with a case where the identifier 216 is set in a case where only the first condition and the second condition are satisfied. As a result, for example, since a frequency of executing the processing (see Fig. 46) by the adjustment unit 15F is reduced, an arithmetic operation load on the central brain 15 of the first vehicle 200A can be reduced.

In the nineteenth embodiment described above, a mode example in which the identifier 216 is set in a case where the first condition and the second condition are satisfied has been described, but the disclosure is not limited thereto. For example, the identifier 216 may be set in a case where the second vehicle 200B has been recognized regardless of whether or not the second vehicle 200B is performing the autonomous driving, and the first vehicle 200Ahas been recognized by the central brain 15 of the second vehicle 200B. As a result, it is possible to contribute to changing the behavior of the first vehicle 200A between a case where the second vehicle 200B has recognized the first vehicle 200A and a case where the second vehicle 200B has not recognized the first vehicle 200A, in a case where the first vehicle 200A has recognized the second vehicle 200B around the first vehicle 200A.

In the nineteenth embodiment described above, a mode example in which the second control variable 230 is generated by adjusting the first control variable 224 based on the control information 214C by the adjustment unit 15F has been described, but the disclosure is not limited thereto. For example, the second control variable 224 may be obtained using a deep learning model obtained by optimizing a neural network in a manner of performing deep learning on the neural network such that the sensor information 218, the association information 219, the set information 228, and the control information 214C are input and the second control variable 224 is output. In this case, the adjustment unit 15F becomes unnecessary.

In the nineteenth embodiment described above, it has been described on the assumption that the IPU 11 performs object recognition and generates the label information 210, but the disclosure is not limited thereto, and at least one processor (for example, the MoPU 12, a GNPU 13, and/or a CPU 14) other than the IPU 11 may perform the object recognition and generate the label information 210.

In the nineteenth embodiment described above, a mode example in which the autonomous driving control processing is executed by the central brain 15 has been described, but the disclosure is not limited thereto, and at least one processor (for example, the IPU 11, the MoPU 12, and/or a processor or the like present in a place other than the vehicle 200) other than the central brain 15 may execute the autonomous driving control processing, or the central brain 15 and the at least one processor may execute the autonomous driving control processing in a distributed manner.

In the nineteenth embodiment described above, a mode example in which the information processing apparatus 10 is mounted on the vehicle 200 has been described, but the disclosure is not limited thereto. The information processing apparatus 10 may be an external apparatus (for example, a server) provided in a place other than the vehicle 200, and the autonomous driving of the vehicle 200 may be controlled according to a result of the autonomous driving control processing executed by the external apparatus.

In the nineteenth embodiment described above, the vehicle 200 is exemplified, but the technology of the disclosure is also applicable to a movable body (for example, an aircraft or a ship) other than the vehicle 200.

(Twentieth Embodiment)

Next, a twentieth embodiment according to the present embodiment will be described while omitting or simplifying an overlapping portion with the above embodiments.

<Twentieth Embodiment>

As described above, a high-resolution camera (IPU 11) is responsible for acquiring image information necessary for recognizing what an imaged object is, and an MoPU 12 is responsible for detecting a motion of the object. Fig. 52A is a diagram showing an example of an aspect of object recognition performed based on a high-resolution image captured by the high-resolution camera (not shown) mounted on the IPU 11. The IPU 11 executes predetermined image processing on the high-resolution image captured by the high-resolution camera, and outputs the processed image of the object at a frame rate of, for example, 10 frames/second and a resolution of 12 million pixels. The high-resolution image output from the IPU 11 is sequentially supplied to a central brain 15. The central brain 15 recognizes object included in each of the high-resolution images output from the IPU 11 at 10 frames/second, and derives label information indicating the type of the object. In a case where a plurality of objects are included in the image, the label information is derived for each of the plurality of objects. Fig. 52A shows a state in which objects B11 to B14 positioned on a road are extracted from a high-resolution image 101A output from the IPU 11, and the label information is assigned for each of the objects B11 to B14. The IPU 11 may execute processing of deriving the label information.

Fig. 52B is a diagram showing an example of an aspect of extraction of a feature point of the object performed based on an image captured by a camera (not shown) on which the MoPU 12 is mounted. An image 101B used to extract the feature point shown in Fig. 52B is captured at the same timing as the high-resolution image 101A shown in Fig. 52A.

The camera on which the MoPU 12 is mounted can capture the image at a frame rate (for example, 10 frames/second) higher than the frame rate (for example, 1920 frames/second) of the high-resolution image output from the IPU 11. The MoPU 12 extracts the feature point indicating an existence position of the object from the captured image of the object, and outputs coordinate values (X,Y) of the extracted feature point at a frame rate of, for example, 1920 frames/second. The coordinate values of the feature point indicating the existence position of the object is an example of "position information" in the technology of the disclosure.

Fig. 52B shows a state in which the objects B11 to B14 positioned on the road are extracted from the image 101B captured by the camera on which the MoPU 12 is mounted, and coordinate values (Xn,Yn) of feature points Q1 to Q4 are output for the respective objects B11 to B14. The objects B11 to B14 shown in Fig. 52B are the same as the objects B11 to B14 shown in Fig. 52A, respectively. A resolution of the image 101B to be processed by the MoPU 12 may be lower than that of the high-resolution image 101A in the IPU 11.

The MoPU 12 outputs a center point (center-of-gravity point) of the object extracted from the image as the feature point. The feature points may be two diagonal points at vertices of a rectangle surrounding the object in a pseudo manner. In addition, in a case where the object is represented as an object having a certain size, there is no need to use only two coordinate points that are at least diagonal at vertices of a quadrangle surrounding a contour of the object recognized from the image captured by the camera, and a plurality of coordinate points including the contour may be extracted. A time series of coordinate values of the feature point output at 1920 frames/second corresponds to motion information of the object.

The coordinate values of the feature point output from the MoPU 12 are sequentially supplied to the central brain 15. The central brain 15 associates the coordinate values of the feature point from the MoPU 12 with the label information derived based on the high-resolution image from the IPU 11.

As described above, an information processing apparatus according to the twentieth embodiment of the technology of the disclosure includes one or more processors (the IPU 11, the MoPU 12 and the central brain 15). Any one of the processors outputs the captured image of the object at a first frame rate (for example, 10 frames/second). For each of the images output at the first frame rate, any one of the processors derives the label information indicating the type of the object included in the image. Any one of the processors outputs position information (the coordinate values of the feature point) indicating the existence position of the object from the captured image of the object at a second frame rate (for example, 1920 frames/second) higher than the first frame rate. One of the processors associates position information at each time point (time t1 or t2) corresponding to an output timing of the image output at the first frame rate among pieces of position information (the coordinate values of the feature point) sequentially output at the second frame rate with label information derived for the same object as the object corresponding to the position information.

One of the processors associates position information at each time point (that is, a period from time t1 to time t2) that does not correspond to the output timing (time t1 or t2) of the image output at the first frame rate among the pieces of position information (the coordinate values of the feature point) output at the second frame rate with label information (label information based on the image at time t1) associated immediately before with the position information.

In order to suppress a risk of occurrence of an accident in autonomous driving of a vehicle, it is important to recognize a motion of an object present around the own vehicle with high time resolution. The recognition of the motion of the object with high time resolution is implemented by the MoPU 12 acquiring the coordinate values of the feature point of the object at, for example, 1920 frames/second. Although it is not possible to grasp what the object is from the feature point of the object, it is more important to recognize the motion of the object with high time resolution than to recognize what the object is for the purpose of avoiding a collision with the object.

The recognition of what the object is implemented by deriving the label information based on the high-resolution image from the IPU 11. By associating the coordinate values of the feature point of the object with the label information of the object, it is possible to recognize what the object is and to recognize the motion of the object.

Due to a difference in frame rate between outputs of the IPU 11 and the MoPU 12, the label information is not acquired at the same timing as the coordinate values (position information) of the feature point. Therefore, the association between the feature point and the label information is performed only for a feature point at each time point corresponding to an output timing of the high-resolution image output at a frame rate of 10 frames/second among the feature points sequentially output at a frame rate of 1920 frames/second. Specifically, the label information is associated with two of feature points of 576 frames. As described above, in the information processing apparatus according to the present embodiment, the association between the feature point and the label information is discrete. As a result, there is a period in which the type of the object whose motion is being tracked is uncertain. Even in a case where the type of the object is uncertain, it is important to track the motion of the object at a high frame rate in order to suppress the risk of occurrence of an accident. In addition, since the feature point is continuously extracted at a high frame rate, a risk of losing the extracted feature point is low. Therefore, in a case where a feature point and the label information are associated with each other once, the same label information can be presumptively assigned for a feature point extracted at the subsequent timing. In the embodiment, a case where the central brain 15 associates the feature point with the label information has been exemplified, but another processor included in the information processing apparatus may associate the feature point with the label information. Although a z coordinate in a z axis direction is not particularly mentioned, the z coordinate corresponding to an x coordinate and a y coordinate of the feature point may naturally be acquired by various methods.

(Twenty-First Embodiment)

Next, a twenty-first embodiment according to the present embodiment will be described while omitting or simplifying an overlapping portion with the above embodiments.

As an example, an information processing apparatus 10 according to the twenty-first embodiment has a configuration shown in Fig. 11 similar to that of the ninth embodiment. An IPU 11 detects an object from a high-resolution image captured by a high-resolution camera, and outputs label information indicating the type of the object. In addition, feature points may be two diagonal points at vertices of a rectangle surrounding the object in a pseudo manner.

In the present embodiment, it is assumed that one MoPU 12 is used, and in a case where one MoPU 12 is used, it is possible to acquire vector information of a motion of a point indicating an existence position of the object along each of two coordinate axes (an X axis and a Y axis) in a three-dimensional orthogonal coordinate system. Therefore, a Z axis detected as a depth direction in a three-dimensional space is extracted from point cloud data acquired by a Lidar sensor 18 and integrated with the X axis and the Y axis. As a result, the MoPU 12 outputs the vector information of the motion of the point indicating the existence position of the object along each of the three coordinate axes (the X axis, the Y axis, and the Z axis) in the three-dimensional orthogonal coordinate system by using the principle of a stereo camera. The Z axis is an axis along a depth method (traveling of a vehicle). In the embodiment, Z axis information at a time (for example, t+1) next to time t is updated using shape information, that is, geometry. Details of a configuration of the MoPU 12 are described below.

The Lidar sensor 18 acquires the point cloud data including the object present in the three-dimensional space and a road surface on which the vehicle is traveling. By using the point cloud data acquired by the Lidar sensor 18, the highly accurate Z axis information of the object can be extracted, but it takes more time for the acquisition than plane coordinates (the X axis and the Y axis). It is assumed that the Lidar sensor 18 acquires the point cloud data at an acquisition interval longer than those of the plane coordinates acquired by the MoPU 12.

[Functional Configuration of MoPU 12]

Fig. 53 is a block diagram including a functional configuration of the MoPU 12. As shown in Fig. 53, the MoPU 12 includes a camera 30, a radar 32, an infrared camera 34, an extraction unit 35, an integration unit 36, an estimation unit 37, and an update unit 38. The radar 32 detects a radar signal. The infrared camera 34 acquires an infrared image. Although a case where the extraction unit 35, the integration unit 36, the estimation unit 37, and the update unit 38 are included in the MoPU 12 is described as an example, the disclosure is not limited thereto, and the extraction unit 35, the integration unit 36, the estimation unit 37, and the update unit 38 may be included in a core 12X in the information processing apparatus 10 or another apparatus.

Fig. 12A is a diagram schematically showing coordinate detection in time series for the object. In Fig. 12A, J indicates a position of the object represented by a rectangle, and the position of the object moves in time series from J1 to J2. Since the object moves in the depth direction during movement of the plane coordinates, it is also necessary to detect the movement in the Z axis direction. However, there is a case where the Z axis information detected from the point cloud data of the Lidar sensor 18 cannot be acquired at a higher speed than a speed at which the plane coordinates are acquired by the MoPU 12. Therefore, in the embodiment, the Z axis information at time t+1 is complemented by estimating the geometry of the road surface from the image of the high-resolution camera of the IPU 11 and the point cloud data of the Lidar sensor 18. It can be estimated that z2 of depth information at time t+1 uses geometry of the object on the road surface, that is, the vehicle. z2 is estimated by calculating a movement amount on the Z axis from z1 to z2 from a change in a case where the extracted plane coordinates (x1,y1) are moved to (x2,y2). In this way, the MoPU 12 can implement two-dimensional motion detection by high-frame-rate imaging and three-dimensional motion detection with high performance and low data volume.

The extraction unit 35 extracts the plane coordinates (Xn,Yn) indicating the existence position of the object in the two-dimensional space from the image in which the object appears. n in the plane coordinates is represented as a series of each time, and for example, the plane coordinates at time t=1 are represented as plane coordinates (X1,Y1), and the plane coordinates at the next time t+1 are represented as plane coordinates (X2,Y2). The time is represented as time t or the next time t+1. The next time t+1 is an example, and time t+m that is advanced by an arbitrary time m from time t may be a time next to time t. The plane coordinates (X1,Y1) at time t are an example of first plane coordinates according to the disclosure, and the plane coordinates (X2,Y2) at the next time t+1 (t+m) are an example of second plane coordinates according to the disclosure. The extraction unit 35 extracts the feature point for each image of one frame captured by the camera 30, and outputs the plane coordinates (Xn,Yn) of a center point (center-of-gravity point) of the object extracted from the image as the feature point. Xn and Yn are coordinate values at each time in time series. The feature points may be two diagonal points at vertices of a rectangle surrounding the object in a pseudo manner. In addition, in the case of being represented as an object having a certain size, there is no need to use only two coordinate points that are at least diagonal at vertices of a quadrangle surrounding a contour of the object recognized from the image captured by the camera 30, and a plurality of coordinate points including the contour may be extracted.

The integration unit 36 detects Z axis information (Z1) which is the depth information of the object at time t from the point cloud data acquired from the Lidar sensor 18. The integration unit 36 integrates the plane coordinates (X1,Y1) and the detected Z axis information (Z1) to generate three-dimensional coordinates (X1,Y1,Z1) of the object at time t. The detection of the Z axis information may be performed by the Lidar sensor 18. The Z axis information (Z1) at time t is an example of first depth information according to the disclosure.

The estimation unit 37 estimates Z axis information (Z2) corresponding to time t+1 based on geometry of a space in which the object is present and a change from the plane coordinates (X1,Y1) at time t to the plane coordinates (X2,Y2) at time t+1. The geometry of the space includes a shape of the road surface obtained from the image acquired by the high-resolution camera of the IPU 11 and the point cloud data detected by the Lidar sensor 18, and a preset shape of the object. The object whose shape is to be set is the vehicle on which the information processing apparatus 10 is loaded. The geometry indicating the shape of the road surface is generated in advance at time t. By using the geometry of the vehicle together with the geometry of the road surface, it is possible to simulate a case where the vehicle travels on the road surface, and to estimate the movement amount on each of the X axis, the Y axis, and the Z axis. Therefore, the estimation unit 37 can estimate the Z axis information (Z2) corresponding to time t+1 by calculating the movement amount in the depth direction in a case where a change from the plane coordinates (X1,Y1) to the plane coordinates (X2,Y2) is made by the simulation. The Z axis information (Z2) at time t+1 is an example of second depth information according to the disclosure.

The update unit 38 integrates the plane coordinates (X2,Y2) at time t+1 and the estimated z axis information (Z2) to update three-dimensional coordinates (X2,Y2,Z2) of the object at time t+1. In a case where the plane coordinates (X2,Y2) at the next time t+1 after the movement of the object are extracted, and the Z axis information (Z2) obtained from the point cloud data corresponding to time t+1 cannot be acquired, the estimation of the z axis information (Z2) and the update of the three-dimensional coordinates may be performed.

As described above, the MoPU 12 outputs the three-dimensional coordinates (Xn,Yn,Zn) obtained in time series to the core 12X as the coordinates of the feature point. Specifically, the MoPU 12 outputs coordinate values (Xn,Yn,Zn) of the feature point extracted from one object. For example, in a case where a plurality of objects (for example, an object A, an object B, and an object C) appear in one image, the MoPU 12L may output the coordinate values (Xn,Yn,Zn) of the feature point extracted from each of the plurality of objects. A series of feature points of the image captured at each time corresponds to motion information of the object.

(Flow of Processing)

The MoPU 12 in the information processing apparatus 10 executes the flowchart shown in Fig. 54. The MoPU 12 executes a series of processing of the flowchart, for example, at a cycle of acquiring the image in the camera 30 or at a predetermined time interval corresponding to the cycle.

In step S500, the extraction unit 35 extracts the plane coordinates (X1,Y1) indicating the existence position of the object in the two-dimensional space from the image in which the object appears at time t.

In step S502, the integration unit 36 detects the Z axis information (Z1), which is the depth information of the object at time t, from the point cloud data acquired from the Lidar sensor 18.

In step S504, the integration unit 36 integrates the plane coordinates (X1,Y1) and the detected Z axis information (Z1) to generate the three-dimensional coordinates (X1,Y1,Z1) of the object at time t.

In step S506, the extraction unit 35 extracts the plane coordinates (X2,Y2) at the next time t+1.

In step S508, the estimation unit 37 estimates the Z axis information (Z2) corresponding to time t+1 based on the geometry of the space in which the object is present and a change from the plane coordinates (X1,Y1) at time t to the plane coordinates (X2,Y2) at time t+1.

In step S510, the update unit 38 integrates the plane coordinates (X2,Y2) at time t+1 and the estimated Z axis information (Z2) to update the three-dimensional coordinates (X2,Y2,Z2) of the object at time t+1.

The above is the flow of the processing executed by the MoPU 12 to output the three-dimensional coordinates (Xn,Yn,Zn) in time series.

(Other Modification)

In the above description, a mode in which the MoPU 12 outputs the motion information indicating the motion of the center point of the object has been exemplified. However, the technology of the disclosure is not limited to this aspect. The MoPU 12 may output the motion information for two coordinate points that are at least diagonal at vertices of a quadrangle (bounding box) surrounding the contour of the object recognized from the image captured by the camera 30. As described above, a point corresponding to the coordinates indicating the existence position of the object is set as each of a plurality of points at the vertices of the bounding box representing the contour of the object. In this case, the extraction unit 35 extracts, for each of the points, the plane coordinates (X1,Y1) of the point at time t and the plane coordinates (X2,Y2) of the point at time t+1. The integration unit 36 generates, for each of the points, the three-dimensional coordinates (X1,Y1,Z1) of the object corresponding to the point at time t. The estimation unit 37 estimates the z axis information (Z2) of the point at time t+1 for each of the points. The update unit 38 updates the three-dimensional coordinates (X2,Y2,Z2) of the object corresponding to the point at time t+1 for each of the points.

(Twenty-Second Embodiment)

Next, a twenty-second embodiment according to the present embodiment will be described while omitting or simplifying an overlapping portion with the above embodiments.

The twenty-second embodiment is different from the smart car according to the thirteenth embodiment in that an IPU 11 and an MoPU 12 are provided on a front side and a rear side of a vehicle. Differences from the thirteenth embodiment will be described below. The same components are denoted by the same reference numerals, and a detailed description thereof will be omitted.

As shown in Fig. 55, a front IPU 11Fr and a front MoPU unit 12Fr that monitor a region in front of a vehicle 1, and a rear IPU 11Rr and a rear MoPU unit 12Rr that monitor a region behind the vehicle 1 are provided in the vehicle 1. The front MoPU unit 12Fr is an example of a "first camera unit" according to the technology of the disclosure, and the rear MoPU unit 12Rr is an example of a "second camera unit" according to the technology of the disclosure.

In the front IPU 11Fr, a high-resolution camera (not shown) is directed to the region in front of the vehicle, and in the rear IPU 11Rr, a high-resolution camera (not shown) is directed to the region behind the vehicle. Furthermore, in the front MoPU unit 12Fr, a camera 313L, a radar 32L, and an infrared camera 34L are directed to the region in front of the vehicle, and in the rear MoPU unit 12Rr, a camera 313L, a radar 32L, and an infrared camera 34L are directed to the region behind the vehicle.

Fig. 56 is a block diagram of an information processing apparatus 220 according to the twenty-second embodiment mounted on the vehicle 1. As shown in Fig. 56, each of the front MoPU unit 12Fr and the rear MoPU unit 12Rr includes an MoPU 12L corresponding to a left eye and an MoPU 12R corresponding to a right eye. A core 12X of the front MoPU unit 12Fr and a core 12X of the rear MoPU unit 12Rr are communicably connected to each other. Further, the core 12X of the front MoPU unit 12Fr and the core 12X of the rear MoPU unit 12Rr are connected to a central brain 15.

In the information processing apparatus 220 according to the present embodiment, coordinates of a feature point on the front side of the vehicle and label information of a target are acquired by the front IPU 11Fr and the front MoPU unit 12Fr, and coordinates of a feature point on the rear side of the vehicle and label information of a target are acquired by the rear IPU 11Rr and the rear MoPU unit 12Rr. As a result, the central brain 15 controls the vehicle 1. The front MoPU unit 12Fr and the rear MoPU unit 12Rr are configured to obtain coordinate values (Xn,Yn,Zn) of a feature point based on common coordinate axes (an x axis, a y axis, and a z axis). As a result, the central brain 15 according to the embodiment can accurately perform vehicle control even for an object approaching from behind while the vehicle 1 is stopped or traveling. That is, in the vehicle having an autonomous driving function, an avoidance operation for the object approaching from behind the vehicle is improved as compared with a case where only the region in front of the vehicle is monitored.

(Change of Frame Rate According to Alert State)

In the information processing apparatus 220, a frame rate of one of the front MoPU unit 12Fr and the rear MoPU unit 12Rr is changed based on a detection status of the other of the front MoPU unit 12Fr and the rear MoPU unit 12Rr.

Specifically, the front MoPU unit 12Fr and the rear MoPU unit 12Rr increase the frame rates of the cameras 313L and 313R, which are usually 240 frames/second or lower, to 960 frames/second or higher in a case where there is an object approaching the vehicle 1 at a speed of a predetermined value or higher and it is thus determined to be in an alert state. That is, the front MoPU unit 12Fr and the rear MoPU unit 12Rr are configured to change the frame rate in a case where a relative speed of the object in front of or behind the vehicle 1 with respect to the vehicle 1 exceeds a preset threshold. Hereinafter, rate changing processing of changing the frame rate according to the embodiment will be described with reference to Fig. 57. Fig. 57 shows an example of processing in the front MoPU unit 12Fr.

In step S600 of Fig. 57, the core 12X of the front MoPU unit 12Fr acquires the coordinates of the feature point and the label information of the target in the front MoPU unit 12Fr.

In step S602, the core 12X of the front MoPU unit 12Fr acquires vector information of the feature point and the label information of the target in the rear MoPU unit 12Rr.

In step S604, the core 12X of the front MoPU unit 12Fr executes determination processing for the alert state based on the acquired information. For example, the alert state is started in a case where the relative speed of the object behind the vehicle 1 with respect to the vehicle 1 exceeds the preset threshold. In addition, for example, in a case where the object of concern present in front of or behind the vehicle 1 moves away from the vehicle 1 or disappears, the alert state is ended.

In step S606, the core 12X of the front MoPU unit 12Fr determines whether or not the alert state has started. In a case where the core 12X determines that the alert state has started (YES in step S606), the processing proceeds to step S608. On the other hand, in a case where the core 12X determines that the alert state has not started (NO in step S606), the processing returns to step S600.

In step S608, the core 12X of the front MoPU unit 12Fr sets the frame rates of the cameras 313L and 313R in the front MoPU unit 12Fr to be high.

In step S610, the core 12X of the front MoPU unit 12Fr determines whether or not the alert state has ended. In a case where the core 12X determines that the alert state has ended (YES in step S610), the processing proceeds to step S612. On the other hand, in a case where the core 12X determines that the alert state has not ended (NO in step S610), the processing returns to step S600.

In step S612, the core 12X of the front MoPU unit 12Fr sets the frame rates of the cameras 313L and 313R in the front MoPU unit 12Fr to be low. Then, the processing returns to step S600.

As described above, with the rate change processing according to the embodiment, it is possible to cope with the following aspects. For example, it is assumed that there is no object approaching the vehicle 1 in front of the vehicle, and a two-wheeled vehicle, an animal, or the like that passes the vehicle 1 while wobbling appears from behind the vehicle. In this case, in the front MoPU unit 12Fr, even in a case where the frame rate has been decreased in order to reduce a processing load, the frame rate can be increased based on object approach detection in the rear MoPU unit 12Rr. As a result, after the object passes the vehicle 1, the front MoPU unit 12Fr can perform monitoring with high accuracy.

In the above embodiment, in a case where the alert state is started, the frame rate is changed from a low state to a high state. However, the frame rate may be increased stepwise instead of being changed at once. For example, in a case where a normal frame rate is 240 frames/second, and the alert state is started, the frame rate may be first set to 960 frames/second, and in a case where the alert state continues for a predetermined time (for example, 1 second), the frame rate may be set to 1920 frames/second. Such a stepwise increase in the frame rate is not limited to two steps, and the number of steps can be set according to the number of frame rates of the cameras 313L and 313R. In addition, not only in the case of increasing the frame rate, but also in the case of decreasing the frame rate, the frame rate may be decreased stepwise according to the alert state.

(Handover of Target Label)

The information processing apparatus 220 according to the embodiment can provide the generated label information of the target in one of the front MoPU unit 12Fr and the rear MoPU unit 12Rr to the other of the front MoPU unit 12Fr and the rear MoPU unit 12Rr.

For example, as shown in Fig. 58, it is assumed that each of viewing angles M of the cameras 313L and 313R of the front MoPU unit 12Fr and the rear MoPU unit 12Rr is 180 degrees. On the other hand, it is assumed that viewing angles V of the high-resolution cameras of the front IPU 11Fr and the rear IPU 11Rr are narrower than the viewing angles M of the cameras 313L and 313R. In this case, for an object in an outer peripheral portion of a visual field that cannot be imaged by the high-resolution camera of the IPU 11, the label information of the target is not assigned even in a case where the coordinate values can be acquired by the MoPU 12. Therefore, the label information of the target already generated in one of the front MoPU unit 12Fr and the rear MoPU unit 12Rr can be provided to the other of the front MoPU unit 12Fr and the rear MoPU unit 12Rr by handover processing of Fig. 59. Fig. 59 is an example of processing in the front MoPU unit 12Fr.

In step S700 of Fig. 59, the core 12X of the front MoPU unit 12Fr acquires the coordinates of the feature point and the label information of the target in the front MoPU unit 12Fr.

In step S702, the core 12X of the front MoPU unit 12Fr acquires the vector information of the feature point and the label information of the target in the rear MoPU unit 12Rr.

In step S704, the core 12X of the front MoPU unit 12Fr determines whether or not the label information has not been able to be acquired in step S700. In a case where the core 12X determines that the label information has not been able to be acquired (YES in step S704), the processing proceeds to step S706. On the other hand, in a case where the core 12X determines that the label information has been able to be acquired (NO in step S704), the processing returns to step S700.

In step S706, the core 12X of the front MoPU unit 12Fr determines whether or not predicted coordinates based on the vector information match current coordinates. That is, it is determined whether or not the coordinates of the feature point predicted based on the vector information acquired from the rear MoPU unit 12Rr match a current feature point acquired in the front MoPU unit 12Fr. In a case where the core 12X determines that the predicted coordinates based on the vector information match the current coordinates (YES in step S706), the processing proceeds to step S708. On the other hand, in a case where the core 12X determines that the predicted coordinates based on the vector information do not match the current coordinates (NO in step S706), the processing returns to step S700.

In step S708, the core 12X of the front MoPU unit 12Fr assigns a label of the target in the rear MoPU unit 12Rr to the feature point detected in the front MoPU unit 12Fr. Then, the processing returns to step S700.

As described above, with the handover processing according to the embodiment, the following effects are obtained even in a case where the viewing angles V of the high-resolution cameras of the front IPU 11Fr and the rear IPU 11Rr are narrow and the feature point is detected outside the viewing angles V. That is, the label of the target already detected by one of the front MoPU unit 12Fr and the rear MoPU unit 12Rr and assigned can be applied to the other of the front MoPU unit 12Fr and the rear MoPU unit 12Rr. Therefore, for example, in a situation where the object passes the vehicle 1, the front MoPU unit 12Fr can specify the target immediately after the rear MoPU unit 12Rr extracts the feature point.

(Twenty-Third Embodiment)

Next, a twenty-third embodiment according to the present embodiment will be described while omitting or simplifying an overlapping portion with the above embodiments.

Fig. 60 is a first block diagram showing an example of a configuration of an information processing apparatus according to the twenty-third embodiment. An information processing apparatus 10 according to the present embodiment includes at least an information acquisition unit 1023 that can acquire a plurality of pieces of information related to a vehicle, an inference unit 2023 that infers a plurality of index values from the plurality of pieces of information acquired by the information acquisition unit 1023, and a driving control unit 3023 that performs driving control of the vehicle based on the plurality of index values.

The information acquisition unit 1023 can acquire various information related to the vehicle. The information acquisition unit 1023 can include, for example, communication means for acquiring information that can be acquired from a sensor attached to each portion of the vehicle, a server (not shown), or the like via a network. Examples of the sensor included in the information acquisition unit 1023 include a radar, a LiDAR, a high-pixel, telephoto, ultra-wide angle, 360-degrees, high-performance camera, vision recognition, a microsound sensor, an ultrasonic sensor, a vibration sensor, an infrared sensor, an ultraviolet sensor, an electromagnetic wave sensor, a temperature sensor, a humidity sensor, spot AI weather forecast, a high-precision multi-channel GPS, low-altitude satellite information, and the like. Alternatively, long-tail incident AI data and the like can be provided. The long-tail incident AI data is trip data of an automobile in which Level 5 is implemented.

Examples of information that can be acquired by the plurality of types of sensors include a temperature and a material of the ground (for example, a road), an outside-air temperature, a tilt of the ground, a freezing state and a moisture level of the road, a material, a wear condition, and a tire pressure of each tire, a road width, the presence or absence of no-passing zones, the presence or absence of an oncoming vehicle, vehicle type information of preceding and following vehicles, cruising states of such vehicles, and a surrounding situation (birds, animals, soccer balls, accident vehicles, earthquakes, housework, winds, typhoons, heavy rain, light rain, snowstorm, fog, or the like). In the present embodiment, these pieces of information can be detected every 1/1 billion seconds (nanoseconds) by using computational power of Level 6.

It should be particularly noted that the above-described information acquisition unit 1023 includes a vehicle lower sensor provided at a lower portion of the vehicle and capable of detecting the temperature, the material, and the tilt of the ground on which the vehicle is traveling. An independent smart tilt can be executed using the vehicle lower sensor.

The inference unit 2023 may be able to infer an indexed value related to control of the vehicle from the plurality of pieces of information acquired by the information acquisition unit 1023 using machine learning, more specifically, deep learning. In other words, the inference unit 2023 can be implemented by artificial intelligence (AI).

The inference unit 2023 can obtain an accurate index value by performing multivariate analysis (see, for example, Formula (2)) by an integration method as shown in the following Formula (1) using the computational power of Level 6 for data every nanosecond and the long-tail incident AI data collected by many sensor groups and the like in the information acquisition unit 1023. More specifically, an indexed value of each variable is obtained at an edge level and in real time while obtaining an integral value of various ultra high resolution delta values with the computational power of Level 6, and a result obtained in the next nanosecond can be acquired as the highest probabilistic value.

[Math. 3]

$$\mathrm{v} = \int_a^b f(A)dt \qquad (1)$$

[Math. 4]

$$V_n = DL\big(f(A, B, C, D, \cdots, N)(dA_n/dt)\big) \qquad (2)$$

DL in the formula represents deep learning, and A, B, C, D, ..., and N represent an air resistance, a road resistance, a road element (for example, garbage), a slip coefficient, and the like.

The indexed value of each variable obtained by the inference unit 2023 can be further refined by increasing the number of times the deep learning is performed. For example, it is possible to calculate a more accurate index value by using enormous data such as rotation of a tire or a motor, a steering angle, a material of a road, weather, a garbage, an influence of quadratic deceleration, slip, steering for of balance loss and recovery, and a speed control method, or long-tail incident AI data.

The driving control unit 3023 may perform the driving control of the vehicle based on the plurality of index values specified by the inference unit 2023. The driving control unit 3023 may be able to implement autonomous driving control of the vehicle. Specifically, it is possible to acquire, as the highest probabilistic value, the result obtained in the next nanosecond from the plurality of index values and to perform the driving control of the vehicle in consideration of the probabilistic value.

With the information processing apparatus 10 having the above-described configuration, information analysis and inference can be performed using the computational power of Level 6 that is extremely greater than computational power of Level 5, and thus, it is possible to perform detailed analysis at an incomparably higher level than the related art. As a result, it is possible to perform vehicle control for safe autonomous driving. Furthermore, the multivariate analysis using the AI described above can produce a value difference of 1000 times greater than Level 5.

Fig. 61 is a second block diagram showing an example of a configuration of the information processing apparatus according to the twenty-third embodiment. An information processing apparatus 10A is different from the information processing apparatus 10 in including a strategy setting unit 4023 that sets a traveling strategy until the vehicle reaches a destination in addition to the configuration of the information processing apparatus 10 described above.

The strategy setting unit 4023 may set the traveling strategy from a current position to the destination based on information regarding the destination input by an occupant or the like of the vehicle, traffic information between the current position and the destination, or the like. At this time, information at that time point when a strategy setting is calculated, that is, data currently acquired by the information acquisition unit 1023, may be added. This is to calculate a more realistic theoretical value by taking into account not only simple calculation of a route to the destination but also a surrounding situation at that moment. The traveling strategy may include at least one theoretical value of an optimal route (strategy route) to the destination, a traveling speed, a tilt, and braking. It is preferable that the traveling strategy can include all the theoretical values of the optimal route, the traveling speed, the tilt, and the braking described above.

The plurality of theoretical values included in the traveling strategy set by the strategy setting unit 4023 can be used for the autonomous driving control in the driving control unit 3023. In addition, the driving control unit 3023 preferably includes a strategy update unit 3123 that can update the traveling strategy based on a difference between the plurality of index values inferred by the inference unit 2023 and each theoretical value set by the strategy setting unit 4023.

The index value inferred by the inference unit 2023 is information acquired during traveling of the vehicle. Specifically, the index value inferred by the inference unit 2023 is detected during actual traveling. For example, the index value is inferred based on a friction coefficient. Therefore, the strategy update unit 3123 can cope with a momentary change at the time of traveling along the strategy route by considering the index value. Specifically, the strategy update unit 3123 calculates the difference (delta value) from the theoretical value and the index value included in the traveling strategy, so that an optimal solution can be derived again and the strategy route can be reformulated. As a result, it is also possible to implement the autonomous driving control at the very limit without slipping. In addition, since the computational power of Level 6 described above can be used in such update processing, correction and fine adjustment can be performed in units of 1/1 billion seconds, and more precise traveling control can be implemented.

In addition, in a case where the information acquisition unit 1023 includes the above-described vehicle lower sensor, the vehicle lower sensor also detects the temperature, the material, and the like of the ground, so that it is possible to cope with a momentary change at the time of traveling along the strategy route. The independent smart tilt can also be executed in calculating a traveling course included in the traveling strategy. Furthermore, even in a case where another information is detected (a flying tire, debris, animals, or the like), it is possible to recalculate an optimal traveling course at an instant and perform optimal course management by coping with a momentary change at the time of traveling along the strategy route.

(Twenty-Fourth Embodiment)

Next, a twenty-fourth embodiment according to the present embodiment will be described while omitting or simplifying an overlapping portion with the above embodiments.

Heat generation is a problem when a system on chip (SoC) for autonomous driving executes advanced arithmetic processing. Therefore, in the present embodiment, there is provided a cooling execution apparatus that detects operation of processing in an SoCBox and executes cooling of the SoCBox. The cooling execution apparatus is an example of an "information processing apparatus" in the disclosure.

In some cases, a mobile object present on a roadway may be detected as a trigger for operation of the SoCBox. For example, in a case where the mobile object present on the roadway is detected during autonomous driving, the SoCBox may execute arithmetic processing for controlling a vehicle with respect to the object. However, since a temperature of the SoCBox immediately becomes high, it is difficult to perform advanced arithmetic operation in the vehicle (a problem for fully autonomous driving). Therefore, it is conceivable to predict heat dissipation due to the operation of the SoCBox and cool the SoCBox by detecting the mobile object or the like present on the roadway. For example, the heat dissipation of the SoCBox is predicted by detecting the mobile object or the like, and cooling is performed simultaneously with the heat dissipation, thereby preventing the temperature of the SoCBox from becoming high and enabling the advanced arithmetic operation in the vehicle.

The heat dissipation of the SoCBox is predicted by detecting the mobile object or the like, and cooling is performed simultaneously with the heat dissipation, thereby preventing the temperature of the SoCBox from becoming high and enabling the advanced arithmetic operation in the vehicle.

Fig. 62 schematically shows an example of a system 2400. The system 2400 includes a management server 2440, an SoCBox 2470, a cooling execution apparatus 2480, and a cooling unit 2490.

The SoCBox 2470, the cooling execution apparatus 2480, and the cooling unit 2490 are mounted on the vehicle.

The SoCBox 2470 controls the autonomous driving of the vehicle by using sensor values of a plurality of sensors mounted on the vehicle. Since a very high processing load is applied to autonomous driving control of the vehicle, the SoCBox 2470 may have a very high temperature. In a case where the SoCBox 2470 has an excessively high temperature, there is a possibility that the SoCBox 2470 is not normally operated, and the vehicle is adversely affected.

For example, the cooling execution apparatus 2480 according to the embodiment predicts operation of the SoCBox 2470 and starts cooling of the SoCBox 2470 based on the operation. For example, in a case where a mobile object that is a factor of the operation of the SoCBox 2470 is detected, the cooling execution apparatus 2480 immediately starts the cooling of the SoCBox 2470. By starting the cooling earlier than the start of heat generation due to the operation of the SoCBox 2470 or at the same time as the start of the heat generation, it is possible to reliably prevent the temperature of the SoCBox 2470 from becoming high.

The cooling execution apparatus 2480 may predict the operation of the SoCBox 2470 by AI. The operation of the SoCBox 2470 may be learned by using data collected by a vehicle 2450. For example, the management server 2440 collects the data from the vehicle 2450 and performs the learning. A subject that performs the learning is not limited to the management server 2440, and may be another apparatus.

The SoCBox 2470 and a motion processing unit (MoPU) 2458 as a sensor are mounted on the vehicle 2450. The SoCBox 2470 controls autonomous driving of the vehicle 2450 by using sensor values of a plurality of sensors including the MoPU 2458 mounted on the vehicle 2450 and external information received from a plurality of types of servers 2430.

Here, the MoPU 2458 can be built in a low-resolution camera (not shown) installed in the vehicle. The MoPU 2458 outputs motion information indicating a motion of an imaged object at a frame rate of 100 frames/second, for example. The MoPU 2458 outputs, as the motion information, vector information of a motion of a point indicating an existence position of the object along a predetermined coordinate axis. That is, the motion information output from the MoPU 2458 does not include information necessary for identifying what the imaged object is (for example, whether the imaged object is a person or an obstacle), and includes only information indicating a motion (a movement direction and a movement speed) of a center point (or a center-of-gravity point) of the object on a coordinate axis (an x axis, a y axis, or a z axis).

The server 2430 may be an example of an external apparatus. Examples of the plurality of types of servers 2430 include servers that provide traffic information, servers that provide weather information, and the like. The SoCBox 2470 transmits, to the management server 2440, a sensor value including a detection result of the MoPU 2458, the external information, and the like used for control of the autonomous driving, an operation status of the SoCBox 2470 at the time of control, and a temperature change of the SoCBox 2470 at the time of control.

The management server 2440 performs the learning by using the information received from one or more SoCBoxes 2470 and the plurality of sensors. The management server 2440 performs machine learning using, as learning data, the detection results of the MoPU 2458 acquired by the SoCBox 2470 and the operation status of the SoCBox 2470 when the SoCBox 2470 acquires these pieces of information, thereby generating a learning model that receives the information acquired by the SoCBox 2470 and outputs the operation status of the SoCBox 2470.

A vehicle 2460 is a vehicle having a cooling function according to the embodiment. An MoPU 2458 as a sensor, an SoCBox 2470, a cooling execution apparatus 2480, and a cooling unit 2490 are mounted on the vehicle 2460. The cooling execution apparatus 2480 may receive the learning model generated by the management server 2440 from the management server 2440 and store the learning model.

The cooling execution apparatus 2480 may acquire sensor values of a plurality of sensors including a detection result of the MoPU 2458 mounted on the vehicle 2460 from the plurality of sensors or from the SoCBox 2470, and may start cooling of the SoCBox 2470 by the cooling unit 2490 in a case where operation of the SoCBox 2470 is predicted. Specifically, in a case where the mobile object or the like is detected as the detection result of the MoPU 2458, the cooling execution apparatus 2480 predicts that the SoCBox 2470 operates, and starts the cooling of the SoCBox 2470 by the cooling unit 2490.

Furthermore, the cooling execution apparatus 2480 may acquire the sensor values of the plurality of sensors including the detection result of the MoPU 2458 mounted on the vehicle 2460 from the plurality of sensors or from the SoCBox 2470, and input the acquired information to the learning model to predict the operation of the SoCBox 2470.

The SoCBox 2470, the cooling execution apparatus 2480, the management server 2440, and the server 2430 may communicate via a network 2420. The network 2420 may include a vehicle network. The network 2420 may include the Internet. The network 2420 may include a local area network (LAN). The network 2420 may include a mobile communication network. The mobile communication network may conform to any one of a 5th generation (5G) communication scheme, a long term evolution (LTE) communication scheme, a 3rd generation (3G) communication scheme, and a subsequent communication scheme including a 6th generation (6G) communication scheme.

Fig. 63 is an explanatory diagram for describing a learning phase in the system 2400. Here, a camera 2452, a light detection and ranging (LiDAR) 2453, a millimeter wave sensor 2454, an ultrasonic sensor 2455, an IMU sensor 2456, a global navigation satellite system (GNSS) sensor 2457, the MoPU 2458, and a temperature sensor 2459 are shown as sensors 2451 mounted on the vehicle 2450. The vehicle 2450 need not include all of these sensors, but may include some of these sensors.

The SoCBox 2470 acquires sensor information from each sensor included in the sensor 2451. Furthermore, the SoCBox 2470 may perform communication via the network 2420, and the SoCBox 2470 receives the external information from each of the plurality of servers 2430 via the network 2420. Then, the SoCBox 2470 performs autonomous driving control of the vehicle 2450 using the acquired information.

The SoCBox 2470 records computing power as the operation of the SoCBox 2470. The SoCBox 2470 may periodically or irregularly record the computing power of the SoCBox 2470. The SoCBox 2470 may record the sensor information received from the sensor 2451, the external information received from the server 2430, and the computing power of the SoCBox 2470 at the time of acquiring these pieces of information and performing the autonomous driving control, and transmit the information to the management server 2440.

The management server 2440 includes an information acquisition unit 2442, a model generation unit 2444, and a model providing unit 2446. The information acquisition unit 2442 acquires various types of information. The management server 2440 may receive the information transmitted by the SoCBox 2470.

The model generation unit 2444 performs machine learning using the information acquired by the information acquisition unit 2442 to generate the learning model.

The model generation unit 2444 may perform machine learning using, as the learning data, the information acquired by the SoCBox 2470 and the operation status of the SoCBox 2470 when the SoCBox 2470 acquires the information, thereby generating the learning model that receives the information acquired by the SoCBox 2470 and outputs the operation status of the SoCBox 2470. Specifically, the model generation unit 2444 inputs the detection result of the MoPU 2458 as the information acquired by the SoCBox 2470, and generates the learning model that outputs a status of the power computing power and a change amount as the operation status of the SoCBox 2470.

The model providing unit 2446 provides the learning model generated by the model generation unit 2444. The model providing unit 2446 may transmit the learning model to the cooling execution apparatus 2480 mounted on the vehicle 2460.

The system 2400 may be configured to predict a temperature change of each of a plurality of portions of the SoCBox 2470. In this case, the vehicle 2450 may include a plurality of temperature sensors 2459 each of which measures the temperature change of each of the plurality of portions of the SoCBox 2470. The SoCBox 2470 may transmit the sensor information received from the sensor 2451, the external information received from the server 2430, and the temperature changes measured by the plurality of temperature sensors 2459 at the time of acquiring these pieces of information and performing the autonomous driving control to the management server 2440. The model generation unit 2444 performs machine learning using, as the learning data, the information acquired by the SoCBox 2470, the temperature change of each of the plurality of portions of the SoCBox 2470 when the SoCBox 2470 acquires the information, and the operation status of the SoCBox 2470, thereby generating the learning model that receives the information acquired by the SoCBox 2470 and outputs the temperature change of each of the plurality of portions in the SoCBox 2470 and the operation status of the SoCBox 2470.

Fig. 64 is an explanatory diagram for describing a cooling execution phase in the system 2400. Here, a camera 2462, a LiDAR 2463, a millimeter wave sensor 2464, an ultrasonic sensor 2465, an IMU sensor 2466, a GNSS sensor 2467, the MoPU 2468, and a temperature sensor 2469 are shown as sensors 2461 mounted on the vehicle 2460. The vehicle 2460 need not include all of these sensors, but may include some of these sensors.

The cooling execution apparatus 2480 includes an information acquisition unit 2482, a cooling execution unit 2484, a model storage unit 2486, and a prediction unit 2488.

The information acquisition unit 2482 acquires the information acquired by the SoCBox 2470. The information acquisition unit 2482 acquires, from the sensor 2461 or the SoCBox 2470, the sensor information acquired by the SoCBox 2470 from the sensor 2461. For example, the information acquisition unit 2482 may receive, from the SoCBox 2470, the sensor information acquired by the SoCBox 2470 from the sensor 2461. The information acquisition unit 2482 may receive, from the sensor 2461, the same sensor information as the sensor information acquired by the SoCBox 2470 from the sensor 2461. In this case, each sensor of the sensors 2461 may transmit the sensor information to each of the SoCBox 2470 and the cooling execution apparatus 2480.

The cooling execution unit 2484 starts the cooling of the SoCBox 2470 based on the detection result of the MoPU 2458 included in the sensor information. For example, in a case where the detection result of the MoPU 2458 indicates that the mobile object has been detected, the cooling execution unit 2484 starts the cooling of the SoCBox 2470.

The cooling execution unit 2484 performs the cooling of the SoCBox 2470 by using the cooling unit 2490. The cooling unit 2490 cools the SoCBox 2470 by air cooling means, water cooling means, or liquid nitrogen cooling means.

In the present embodiment, a mode in which the operation of the SoCBox 2470 is predicted in a case where the mobile object is detected has been described. However, the disclosure is not limited thereto. The prediction unit 2488 may predict the operation of the SoCBox 2470 by AI.

For example, the model storage unit 2486 stores the learning model received from the management server 2440. The prediction unit 2488 predicts the operation status of the SoCBox 2470 by inputting the detection result of the MoPU 2458 acquired by the information acquisition unit 2482 to the learning model stored in the model storage unit 2486. Here, the learning model outputs, as the operation status, the status of the power computing power of the SoCBox 2470 and the change amount. Furthermore, the prediction unit 2488 may predict and output the temperature change of each of the plurality of portions in the SoCBox 2470 together with the operation status.

The cooling execution unit 2484 may start the cooling of the SoCBox 2470 according to the operation status of the SoCBox 2470 predicted by AI. For example, in a case where the status of the power computing power of the SoCBox 2470 and the change amount predicted as the operation status exceed predetermined thresholds, the cooling execution unit 2484 starts the cooling of the SoCBox 2470. Furthermore, the cooling execution unit 2484 may start the cooling of the SoCBox 2470 according to the operation status of the SoCBox 2470 predicted by AI and the temperature change of each portion in the SoCBox 2470. For example, in a case where the status of the power computing power of the SoCBox 2470 and the change amount predicted as the operation status exceed the predetermined thresholds, and the temperature change exceeds a predetermined threshold, the cooling execution unit 2484 starts cooling of the corresponding portion in the SoCBox 2470.

The cooling unit 2490 may include a plurality of types of cooling means. For example, the cooling unit 2490 includes a plurality of types of air cooling means. For example, the cooling unit 2490 includes a plurality of types of water cooling means. For example, the cooling unit 2490 includes a plurality of types of liquid nitrogen cooling means. The cooling unit 2490 may include one or more types of air cooling means, one or more types of water cooling means, and one or more liquid nitrogen cooling means.

The plurality of cooling means may be arranged to cool different portions of the SoCBox 2470, respectively. The prediction unit 2488 may predict the temperature change of each of the plurality of portions of the SoCBox 2470 by using the information acquired by the information acquisition unit 2482. The cooling execution unit 2484 may start the cooling of the SoCBox 2470 by using cooling means selected from a plurality of cooling means for respectively cooling the plurality of portions of the SoCBox 2470 based on a prediction result of the prediction unit 2488.

The cooling execution unit 2484 may perform the cooling of the SoCBox 2470 by using cooling means corresponding to the temperature of the SoCBox 2470 predicted by the prediction unit 2488. For example, as the temperature of the SoCBox 2470 is higher, the cooling execution unit 2484 performs the cooling of the SoCBox 2470 using a larger number of cooling means. As a specific example, the cooling execution unit 2484 starts the cooling using one of the plurality of cooling means in a case where it is predicted that the temperature of the SoCBox 2470 exceeds a first threshold, and increases the number of cooling means to be used in a case where it is predicted that the temperature of the SoCBox 2470 increases and exceeds a second threshold.

The cooling execution unit 2484 may perform the cooling of the SoCBox 2470 by using stronger cooling means as the temperature of the SoCBox 2470 is higher. For example, the cooling execution unit 2484 starts the cooling using the air cooling means in a case where it is predicted that the temperature of the SoCBox 2470 exceeds the first threshold, starts the cooling using the water cooling means in a case where it is predicted that the temperature of the SoCBox 2470 still increases and exceeds the second threshold, and starts the cooling using the liquid nitrogen cooling means in a case where it is predicted that the temperature of the SoCBox 2470 still increases and exceeds a third threshold.

The SoCBox 2470 may include a plurality of processing chips, and the plurality of processing chips may be arranged at different positions on the SoCBox 2470. The plurality of cooling means may be arranged at positions corresponding to the plurality of processing chips, respectively.

For example, in a case where the number of processing chips to be used changes according to an autonomous driving control situation, cooling using the cooling means corresponding to the used processing chip is performed, so that efficient cooling can be implemented.

In the embodiment, a mode in which the SoCBox 2470 is cooled in a case where the mobile object is detected by the MoPU 2458 has been described. However, the disclosure is not limited thereto. In a case where the mobile object is detected by the MoPU 2458, electric power regeneration by heat generation of the SoCBox 2470 may be started. For example, in a case where a Peltier element is installed in the SoCBox 2470 and the mobile object is detected by the MoPU 2458, power generation by the Peltier element using heat generation of the SoCBox 2470 may be started. As the Peltier element is used, electric power can be immediately obtained at the time of heat generation in the SoCBox 2470, so that energy efficiency is improved.

Fig. 65 schematically shows an example of the SoCBox 2470 and the cooling unit 2490. Fig. 65 shows a case where the cooling unit 2490 includes one cooling means. In a case where the cooling execution apparatus 2480 detects the mobile object, the entire SoCBox 2470 can be cooled by starting cooling by the cooling unit 2490.

Fig. 66 schematically shows an example of the SoCBox 2470 and the cooling unit 2490. Fig. 66 shows a case where the cooling unit 2490 includes a plurality of cooling means that cool the plurality of portions of the SoCBox 2470, respectively. The cooling execution apparatus 2480 predicts the temperature change of each of the plurality of portions of the SoCBox 2470 by using the temperature sensor 2469, and performs the cooling using only cooling means corresponding to a corresponding portion in response to predicting that any one of the portions starts to generate heat or the temperature of any one of the portions exceeds a predetermined threshold, whereby efficient cooling can be implemented.

Fig. 67 schematically shows an example of the SoCBox 2470 and the cooling unit 2490. Fig. 67 shows a case where the cooling unit 2490 includes two types of cooling means. The cooling execution apparatus 2480 predicts the temperature change of each of the plurality of portions of the SoCBox 2470, and performs the cooling using only cooling means corresponding to a corresponding portion in response to predicting that any one of the portions starts to generate heat or the temperature of any one of the portions exceeds a predetermined threshold, whereby efficient cooling can be implemented. Furthermore, as the temperature of the SoCBox 2470 increases, the cooling execution apparatus 2480 increases the number of cooling means to be used. That is, in this example, the cooling execution apparatus 2480 first starts cooling using one of the two types of cooling means, and then starts cooling by further using the other cooling means in a case where the temperature of the SoCBox 2470 increases, whereby energy efficiency for cooling can be improved.

(Twenty-Fifth Embodiment)

Next, a twenty-fifth embodiment according to the present embodiment will be described while omitting or simplifying an overlapping portion with the above embodiments.

Fig. 68 schematically shows a risk prediction capability of ultra-high performance autonomous driving AI according to the present embodiment. In the embodiment, a plurality of types of sensor information are converted into AI data and accumulated in a cloud. The AI predicts and determines the best combination of situations every nanosecond (1/1 billion seconds) and optimizes operation of a vehicle 100.

Examples of a sensor provided in the vehicle 100 used in the embodiment include a radar, a LiDAR, a high-pixel, telephoto, ultra-wide angle, 360-degrees, high-performance camera, sensors for vision recognition, microsound, ultrasonic waves, vibration, an infrared ray, an ultraviolet ray, electromagnetic waves, a temperature, and a humidity, spot AI weather forecast, high-accuracy multi-channel GPS, low-altitude satellite information, and long-tail incident AI data. The long-tail incident AI data is trip data of an automobile in which Level 5 is implemented.

The sensor includes a sensor that detects a situation around the vehicle. The sensor that detects the situation around the vehicle detects the situation around the vehicle at a second cycle shorter than a first cycle at which the surroundings of the vehicle are imaged by a camera or the like, as a cycle for detecting the situation around the vehicle.

Examples of the sensor information to be taken in from the plurality of types of sensors include center of gravity shift in a weight, detection of road material, detection of outside-air temperature, detection of outside-air humidity, detection of vertical and lateral inclination angles of slopes, detection of a freezing state and a moisture level of a road, detection of a material, a wear condition, and a tire pressure of each tire, a road width, the presence or absence of no-passing zones, an oncoming vehicle, vehicle type information of preceding and following vehicles, cruising states of such vehicles, and a surrounding situation (birds, animals, soccer balls, accident vehicles, earthquakes, housework, winds, typhoons, heavy rain, light rain, snowstorm, fog, or the like), and in the embodiment, such detections are performed every 1/1 billion seconds.

In the embodiment, a central brain 15 functions as a calculation unit that calculates a wheel speed and an inclination of each of four wheels of the vehicle and control variables for controlling the wheel speed, the inclination, and a suspension for each suspension that supports the wheel for each of a plurality of combinations of a predetermined number of pieces of sensor information among pieces of sensor information detected by the sensors described above. The inclination of the wheel includes both an inclination of the wheel with respect to an axis horizontal to a road and an inclination of the wheel with respect to an axis perpendicular to the road.

Here, the predetermined number is, for example, three. Index values for controlling the wheel speed, the inclination, and the suspension are calculated based on the three pieces of sensor information. The number of index values calculated from the combination of the three pieces of sensor information is, for example, three. The index values for controlling the wheel speed, the inclination, and the suspension include, for example, an index value calculated from information regarding an air resistance among the pieces of sensor information, an index value calculated from information regarding a road resistance among the pieces of sensor information, and an index value calculated from information regarding a slip coefficient among the pieces of sensor information. Then, the index values calculated for each of different combinations of the plurality of pieces of sensor information are aggregated to calculate the control variables for controlling the wheel speed, the inclination, and the suspension. For example, a plurality of index values are calculated for a combination of sensors 1, 2, and 3, a plurality of index values are calculated for a combination of the sensors 4, 5, and 6, a plurality of index values are calculated for a combination of the sensors 1, 3, and 7, and the control variable is calculated by aggregating the index values. In this manner, a predetermined number of index values, for example, 300 index values, are calculated while changing the combination of the pieces of sensor information, thereby calculating the control variable. Specifically, the calculation unit may be able to calculate the control variable from the sensor information by using machine learning, more specifically, deep learning. In other words, the calculation unit can include AI.

The calculation unit can obtain an accurate control variable by performing multivariate analysis (see, for example, Formula (2)) by an integration method as shown in the following Formula (1) using computational power of Level 6 for data collected every nanosecond by many sensor groups and the like. More specifically, an indexed value of each variable is obtained at an edge level and in real time while obtaining an integral value of various ultra high resolution delta values with the computational power of Level 6, and a result obtained in the next nanosecond can be acquired as the highest probabilistic value.
[Math. 5]

$$V = \int_a^b f(A)dt \quad (1)$$

[Math. 6]

$$V_n = DL\left(f(A, B, C, \ldots, N)(dA_n/dt)\right) \quad (2)$$

DL in the formula represents deep learning, and A, B, C, D, ..., and N represent the index values calculated from the sensor information and represent, for example, the index value calculated from the air resistance, the index value calculated from the road resistance, an index value calculated from a road element, the index value calculated from the slip coefficient, and the like. In a case where the number of index values calculated while changing the combination of the predetermined number of pieces of sensor information is 300, the number of index values of A to N in the formula is also 300, and 300 index values are aggregated.
Although the wheel speed (V) is calculated in Formula (2) above, the control variables for controlling the inclination and the suspension are similarly calculated.
Specifically, the central brain 15 calculates a total of 16 control variables for controlling the wheel speed of each of the four wheels, the inclination of each of the four wheels with respect to the axis horizontal to the road, the inclination of each of the four wheels with respect to the axis perpendicular to the road, and the suspension supporting each of the four wheels. In the embodiment, 16 control variables described above are calculated every 1/1 billion seconds. The wheel speed of each of the four wheels can also be referred to as "the number of spins (rotations) of an in-wheel motor mounted on each of the four wheels", and the inclination of each of the four wheels with respect to the axis horizontal to the road can also be referred to as "a horizontal angle of each of the four wheels". For example, in a case where the vehicle travels on a mountain road, the control variable is a numerical value for performing optimal steering suitable for the mountain road, and in a case where the vehicle is parked in a parking lot, the control variable is a numerical value for traveling at an optimal angle suitable for the parking lot.
Furthermore, in the embodiment, the central brain 15 calculates a total of 16 control variables for controlling the wheel speed of each of the four wheels, the inclination of each of the four wheels with respect to the axis horizontal to the road, the inclination of each of the four wheels with respect to the axis perpendicular to the road, and the suspension supporting each of the four wheels. However, the calculation does not need to be performed by the central brain 15, and a dedicated anchor chip for calculating the control variables may be separately provided. Also in this case, DL in Formula (2) represents deep learning, and A, B, C, D, ..., and N represent value index values calculated from the sensor information. In a case where the number of indexes to be aggregated is 300 as described above, the number of indexes in such a formula is also 300.
Furthermore, in the embodiment, the central brain 15 functions as a control unit that controls the autonomous driving in units of 1/1 billion seconds based on the control variables calculated above. Specifically, the central brain 15 controls in-wheel motors respectively mounted on the four wheels based on 16 control variables described above, thereby controlling the wheel speed and the inclination of each of the four wheels of the vehicle 100 and the suspension supporting each of the four wheels to perform the autonomous driving.
The central brain 15 repeatedly executes the flowchart shown in Fig. 69.
In step S2510, the central brain 15 acquires the sensor information including road information detected by the sensor. Then, the central brain 15 proceeds to step S2511.
In step S2511, the central brain 15 calculates 16 control variables described above based on the sensor information acquired in step S2510. Then, the central brain 15 proceeds to step S2512.
In step S2512, the central brain 15 controls the autonomous driving based on the control variables calculated in step S2511. Then, the central brain 15 ends the processing of the flowchart.
Figs. 70 to 74 are explanatory diagrams for describing an example of autonomous driving control by the central brain 15. Figs. 70 to 72 are explanatory diagrams when the vehicle 100 is viewed from the front, and Figs. 73 and 74 are explanatory diagrams when the vehicle 100 is viewed from below.
Fig. 70 shows a case where the vehicle 100 is traveling on a flat road R1. The central brain 15 controls in-wheel motors 3125 respectively mounted on four wheels 3025 based on 16 control variables described above calculated for the road R1, thereby controlling a wheel speed and an inclination of each of the four wheels 3025 and a suspension 3225 supporting each of the four wheels 3025 to perform the autonomous driving.

Fig. 71 shows a case where the vehicle 100 is traveling on a mountain road R2. The central brain 15 controls in-wheel motors 3125 respectively mounted on four wheels 3025 based on 16 control variables described above calculated for the mountain road R2, thereby controlling the wheel speed and the inclination of each of the four wheels 3025 and the suspension 3225 supporting each of the four wheels 3025 to perform the autonomous driving.

Fig. 72 shows a case where the vehicle 100 is traveling in a puddle R3. The central brain 15 controls in-wheel motors 3125 respectively mounted on four wheels 3025 based on 16 control variables described above calculated for the puddle R3, thereby controlling the wheel speed and the inclination of each of the four wheels 3025 and the suspension 3225 supporting each of the four wheels 3025 to perform the autonomous driving.

Fig. 73 shows a case where the vehicle 100 makes a curve in a direction indicated by an arrow A1. The central brain 15 controls the in-wheel motors 3125 respectively mounted on the four wheels 3025 based on 16 control variables described above calculated for a curved road into which the vehicle 100 enters, thereby controlling the wheel speed and the inclination of each of the four wheels 3025 and the suspension 3225 (not shown) supporting each of the four wheels 3025 to perform the autonomous driving.

Fig. 74 shows a case where the vehicle 100 makes parallel movement in a direction indicated by an arrow A2. The central brain 15 controls the in-wheel motors 3125 respectively mounted on the four wheels 3025 based on 16 control variables described above calculated for the parallel movement in the direction indicated by the arrow A2, thereby controlling the wheel speed and the inclination of each of the four wheels 3025 and the suspension 3225 (not shown) supporting each of the four wheels 3025 to perform the autonomous driving.

States (inclinations) of the wheel 3025 and the suspension 3225 shown in Figs. 70 to 74 are merely examples, and it goes without saying that the states of the wheel 3025 and the suspension 3225 can be different from the states shown in the respective figures.

Here, an in-wheel motor mounted on a vehicle according to the related art can independently control each drive wheel, but in such a vehicle, it is not possible to control the in-wheel motor by analyzing a road condition or the like. Therefore, in the vehicle, for example, appropriate autonomous driving based on the road condition or the like cannot be performed in the case of traveling on a mountain road, a puddle, or the like.

However, in the vehicle 100 according to the embodiment, it is possible to perform the autonomous driving in which a speed, a steering angle, and the like are controlled so as to be suitable for an environment such as a road condition based on the configuration described above.

(Twenty-Sixth Embodiment)

Next, a twenty-sixth embodiment according to the present embodiment will be described while omitting or simplifying an overlapping portion with the above embodiments.

A central brain 15 functioning as an example of an information processing apparatus according to the present embodiment has at least respective functions of an acquisition unit that can acquire a plurality of pieces of information related to a vehicle, a calculation unit that calculates a control variable from the plurality of pieces of information acquired by the acquisition unit, and a control unit that performs driving control of the vehicle based on the control variable.

For example, the central brain 15 functions to calculate a wheel speed and an inclination of each of four wheels of the vehicle and control variables for controlling the wheel speed, the inclination, and a suspension for each suspension that supports the wheel by using one or more pieces of sensor information detected by sensors described above. The inclination of the wheel includes both an inclination of the wheel with respect to an axis horizontal to a road and an inclination of the wheel with respect to an axis perpendicular to the road.

Here, as the one or more pieces of sensor information, sensor information from a sensor that detects a situation around the vehicle can be applied. In addition, in a case where a plurality of pieces of sensor information are used as the one or more pieces of sensor information, a predetermined number of pieces of sensor information can be applied. The predetermined number is, for example, three. Index values for controlling the wheel speed, the inclination, and the suspension are calculated based on the three pieces of sensor information. The number of index values calculated from the combination of the three pieces of sensor information is, for example, three. The index values for controlling the wheel speed, the inclination, and the suspension include, for example, an index value calculated from information regarding an air resistance among the pieces of sensor information, an index value calculated from information regarding a road resistance among the pieces of sensor information, and an index value calculated from information regarding a slip coefficient among the pieces of sensor information.

Meanwhile, an obstacle may approach the vehicle during traveling of the vehicle. In this case, the vehicle preferably travels while changing behavior of the vehicle in order to avoid a contact with or a collision with the obstacle. Examples of the obstacle include a vehicle other than the own vehicle that is traveling, a wall surface, a guard rail, a curbstone, and other installed objects. In the following description, a case where another vehicle approaching the vehicle 100 is applied as an example of the obstacle will be described. The obstacle is an example of a target.

Fig. 75 is a diagram schematically showing a state in which other vehicles 100B, 100C, and 100D are traveling around an own vehicle 100A, the own vehicle 100A being the vehicle 100 traveling on a road with two opposite lanes. In the example of the figure, the other vehicle 100B is traveling following the own vehicle 100A, the other vehicle 100D is traveling ahead in the opposite lane, and the other vehicle 100C is traveling following the other vehicle 100D.

The central brain 15 of the own vehicle 100A controls in-wheel motors 3125 respectively mounted on four wheels 3025 based on the control variables described above calculated for a state of traveling on a traveling path that changes from moment to moment, thereby controlling a wheel speed and an inclination of each of the four wheels 3025 and a suspension 3225 supporting each of the four wheels 3025 to perform autonomous driving. In addition, the central brain 15 detects behaviors of the other vehicles 100B, 100C, and 100D around the own vehicle 100A by the sensors and acquires the behaviors as the sensor information.

The central brain 15 has a function of predicting a collision including a contact with the obstacle as the target for the own vehicle based on the acquired sensor information in order to travel while avoiding at least the obstacle. As shown in Fig. 75, in a case where the other vehicle 100D is predicted to enter a region in front of the own vehicle 100A based on the sensor information, the central brain 15 calculates a control variable indicating the behavior of the own vehicle 100A that can avoid at least a contact with the other vehicle 100D.

For example, in the example shown in Fig. 75, the own vehicle 100A collides with the other vehicle 100D on a path 100Ax1 on which the own vehicle 100A travels in a current traveling state. Therefore, the central brain 15 calculates paths such as paths 100Ax2 and 100Ax3 that avoid a collision with the other vehicle 100D, selects one of the paths, and calculates the control variable. It is sufficient if the path is selected such that a load of the control variable on the own vehicle 100A is lower than a predetermined value (for example, the load is minimized).

The central brain 15 that can implement the above-described autonomous driving will be further described. An information processing apparatus 10 according to the twenty-sixth embodiment has a configuration shown in Fig. 2 similar to that of the first embodiment. The above-described central brain 15 is also a processing apparatus in a broad sense that functions as an information processing apparatus including a gateway, and is also a processing apparatus in a narrow sense in a case where functions are classified for each processor.

In the present embodiment, the situation around the vehicle can be detected as the sensor information at a second cycle shorter than a first cycle at which the surroundings of the vehicle are imaged by a camera or the like, as a cycle for detecting the situation around the vehicle 100. That is, at Level 5 described above, the situation of the surroundings can be detected twice in 0.3 seconds by the camera or the like, but in the embodiment, the situation of the surroundings can be detected 576 times at Level 6. Then, the index value and the control variable can be calculated every 576 times of detection of the situation of the surroundings, and the behavior of the vehicle can be controlled such that the vehicle can travel faster and safer than the autonomous driving executed at Level 5.

In the above description, a case where a collision is avoided by selecting a path has been described, but the disclosure is not limited thereto. For example, in a case where it is difficult for the own vehicle 100A to avoid a collision with another vehicle, it is possible to calculate a control variable that reduces damage of the vehicle in the unavoidable collision. That is, the central brain 15 may calculate, as the control variable, a control variable corresponding to the damage of the vehicle in the unavoidable collision, the damage not exceeding a predetermined threshold. Therefore, the above-described calculation unit predicts a collision of the target with the vehicle 100 based on the plurality of pieces of acquired sensor information, and in a case where the prediction result indicates an unavoidable collision, the calculation unit includes calculating, as the control variable, a control variable corresponding to damage of the vehicle in the unavoidable collision, the damage not exceeding the predetermined threshold. As the damage of the vehicle, at least one of a deformation position and a deformation amount of the vehicle can be applied. In addition, at least one of a collision angle and a vehicle speed of the vehicle can be applied as the control variable corresponding to the damage of the vehicle.

Fig. 76 is a flowchart showing an example of a flow of processing in the central brain 15 that enables reduction of damage of the vehicle 100 in an unavoidable collision. The central brain 15 can repeatedly execute the processing shown in Fig. 76 instead of the processing shown in Fig. 69. A description of portions overlapping with the processing shown in Fig. 69 will be omitted or simplified.

**In** step S2610, the central brain 15 calculates a relationship between the own vehicle and another vehicle. Specifically, in step S2610, the collision of the target (for example, another vehicle) with the vehicle 100 is predicted based on the sensor information, and it is determined whether or not a prediction result indicates that the collision is unavoidable. Then, in step S2620, it is determined whether or not a determination result obtained by the prediction indicates that the collision is unavoidable. **In** a case where an affirmative determination is made in step S2620, the processing proceeds to step S2640, and in a case where a negative determination is made, the control variable is calculated in step S2630. **In** step S2640, the control variable for reducing the damage of the vehicle in the unavoidable collision as described above is calculated, and the processing proceeds to step S2650.

An order of the steps of processing of steps S2610, S2620, S2630, and S2640 is not limited to the above-described order. For example, after the processing of step S2630, the processing of steps S2620 and S2640 may be executed. Specifically, first, in step S2630, a collision of another vehicle with the vehicle 100 is predicted, and a control variable indicating a relationship in which a risk is minimized in terms of a correlation between the own vehicle and the another vehicle is calculated. Examples of the relationship in which the risk is minimized include a relationship including a contact and a collision and a relationship that is less likely to be the relationship including the contact and the collision among relationships avoiding the relationship including the contact and the collision. That is, the control variable having the lowest collision risk is calculated. Next, in step S2620, behavior of the vehicle 100 according to the calculated control variable predicts the collision of the another vehicle with the vehicle 100, and it is determined whether or not the collision is unavoidable as the prediction result. In this case, in a case where a negative determination is made in step S2620, it is sufficient if the processing proceeds directly to step S2650. On the other hand, in a case where an affirmative determination is made, in step S2640, a control variable that can further reduce the collision risk is calculated as compared with the control variable calculated in step S2630. Specifically, at least one of the collision angle and the vehicle speed of the vehicle is calculated, the collision angle and the vehicle speed reducing the damage of the vehicle caused by the contact or the collision between the own vehicle and the another vehicle.

The control variable related to the speed of the vehicle 100 may be selected by applying a total of 30 patterns by setting 10 patterns for each of large, medium, and small (L, M, and S) for an acceleration side, and applying a total of 30 patterns by setting 10 patterns for each of large, medium, and small (L, M, and S) for a deceleration side. In this case, the relationship between the own vehicle and the another vehicle changes from moment to moment, and in a state in which the own vehicle and the another vehicle approach each other, a distance between the own vehicle and the another vehicle decreases. Therefore, options for selecting the patterns are reduced from moment to moment, a processing time for the selection can be reduced, and adjustment of a delta difference is reduced.

Although a case where the other vehicle 100D is applied as the another vehicle for the own vehicle 100A has been described above, the control variable for reducing the collision risk with respect to the another vehicle as the target may be calculated for at least one of the other vehicles 100B, 100C, and 100D around the own vehicle 100A described above and all the other vehicles.

Therefore, the central brain 15 controls the in-wheel motors 3125 respectively mounted on the four wheels 3025, for example, based on the control variable calculated according to the prediction of the collision including the contact, thereby controlling the wheel speed and the inclination of each of the four wheels 3025 and the suspension 3225 supporting each of the four wheels 3025, so that it is possible to perform the autonomous driving while avoiding the collision or reducing the damage of the vehicle at the time of the collision.

Fig. 77 schematically shows an example of a hardware configuration of a computer 1200 that functions as the information processing apparatus 10 or the cooling execution apparatus 110. A program installed in the computer 1200 can cause the computer 1200 to function as one or more "units" of the apparatus according to the present embodiment, or cause the computer 1200 to perform an operation associated with the apparatus according to the embodiment or one or more "units" thereof, and/or can cause the computer 1200 to execute a process according to the embodiment or a stage of the process. Such a program may be executed by a CPU 1212 to cause the computer 1200 to perform a certain operation associated with some or all of the blocks in the flowcharts and block diagrams described herein.

The computer 1200 according to the embodiment includes the CPU 1212, a RAM 1214, and a graphics controller 1216, which are mutually connected by a host controller 1210. The computer 1200 also includes input/output units such as a communication interface 1222, a storage device 1224, a digital versatile disk (DVD) drive, and an IC card drive, which are connected to the host controller 1210 via an input/output controller 1220. The DVD drive may be a DVD-ROM drive, a DVD-RAM drive, or the like. The storage device 1224 may be a hard disk drive, a solid state drive, or the like. The computer 1200 also includes a read only memory (ROM) 1230 and legacy input/output units such as a keyboard, which are connected to the input/output controller 1220 via an input/output chip 1240.

The CPU 1212 operates according to the program stored in the ROM 1230 and the RAM 1214, thereby controlling each unit. The graphics controller 1216 acquire image data generated by the CPU 1212 in a frame buffer or the like provided in the RAM 1214 or itself, and causes the image data to be displayed on a display device 1218.

The communication interface 1222 communicates with other electronic devices via a network. The storage device 1224 stores the program and data to be used by the CPU 1212 in the computer 1200. The DVD drive reads the program or data from a DVD-ROM or the like and provides the program or data to the storage device 1224. The IC card drive reads the program and data from an IC card and/or writes the program and data to the IC card.

The ROM 1230 stores therein a boot program to be executed by the computer 1200 at the time of activation and/or a program that depends on hardware of the computer 1200. The input/output chip 1240 may also connect various input/output units to the input/output controller 1220 via a USB port, a parallel port, a serial port, a keyboard port, a mouse port, or the like.

The program is provided by a computer-readable storage medium such as the DVD-ROM or the IC card. The program is read from the computer-readable storage medium, installed in the storage device 1224, the RAM 1214, or the ROM 1230, which is also an example of the computer-readable storage medium, and executed by the CPU 1212. Information processing described in these programs is read by the computer 1200 and provides cooperation between the programs and various types of hardware resources described above. The apparatus or method may be configured by implementing operation or processing of information according to the use of the computer 1200.

For example, in a case where communication is performed between the computer 1200 and an external device, the CPU 1212 may execute a communication program loaded into the RAM 1214 and instruct the communication interface 1222 to execute communication processing based on processing described in the communication program. Under the control of the CPU 1212, the communication interface 1222 reads transmission data stored in a transmission buffer region provided in a recording medium such as the RAM 1214, the storage device 1224, the DVD-ROM, or the IC card, transmits the read transmission data to the network, or writes reception data received from the network to a reception buffer region or the like provided on the recording medium.

In addition, the CPU 1212 may read a necessary part of or the entire file or database stored in an external recording medium such as the storage device 1224, the DVD drive (DVD-ROM), the IC card, or the like into the RAM 1214, and may execute various types of processing on the data on the RAM 1214. Next, the CPU 1212 may write back the processed data to the external recording medium.

Various types of information such as various types of programs, data, tables, and databases may be stored in a recording medium and subjected to the information processing. The CPU 1212 may execute various types of processing on the data read from the RAM 1214, the various types of processing including various types of operations, the information processing, condition determination, conditional branching, unconditional branching, and information search/replacement, which are described throughout the disclosure and designated by a command sequence of a program, and writes back the results to the RAM 1214. In addition, the CPU 1212 may search for information in a file, a database, or the like in the recording medium. For example, in a case where a plurality of entries each having an attribute value of a first attribute associated with an attribute value of a second attribute are stored in the recording medium, the CPU 1212 may search for an entry in which the attribute value of the first attribute satisfies a designated condition among the plurality of entries, read the attribute value of the second attribute stored in the entry, and thereby acquire the attribute value of the second attribute associated with the first attribute satisfying a predetermined condition.

The program or software module described above may be stored in a computer-readable storage medium on the computer 1200 or in the vicinity of the computer 1200. Furthermore, a recording medium such as a hard disk or a RAM provided in a server system connected to a dedicated communication network or the Internet can be used as the computer-readable storage medium, thereby providing a program to the computer 1200 via the network.

The blocks in the flowcharts and block diagrams in the embodiment may represent stages of a process in which the operation is performed or "units" of the apparatus that are responsible for performing the operation. Certain stages and "units" may be implemented by a dedicated circuit, a programmable circuit provided together with a computer-readable instruction stored on a computer-readable storage medium, and/or a processor provided together with the computer-readable instruction stored on the computer-readable storage medium. The dedicated circuit may include a digital and/or analog hardware circuit, and may include an integrated circuit (IC) and/or a discrete circuit. The programmable circuit may include a reconfigurable hardware circuit including, for example, AND, OR, XOR, NAND, NOR, and other logical operations, a flip-flop, a register, and a memory element, such as a field programmable gate array (FPGA) and a programmable logic array (PLA).

The computer-readable storage medium may include any tangible device capable of storing an instruction to be executed by a suitable device, so that the computer-readable storage medium having the instruction stored therein includes an article including an instruction that may be executed to create means for performing the operation specified in the flowcharts or block diagrams. Examples of the computer-readable storage medium may include an electronic storage medium, a magnetic storage medium, an optical storage medium, an electromagnetic storage medium, and a semiconductor storage medium. More specific examples of the computer-readable storage medium may include a floppy (registered trademark) disk, a diskette, a hard disk, a random access memory (RAM), a read only memory (ROM), an erasable programmable read only memory (EPROM or flash memory), an electrically erasable programmable read only memory (EEPROM), a static random access memory (SRAM), a compact disc read only memory (CD-ROM), a digital versatile disk (DVD), a Blu-Ray disk, a memory stick, and an integrated circuit card.

The computer-readable instruction may include a source code or an object code described in any combination of one or more programming languages, including an assembler instruction, an instruction-set-architecture (ISA) instruction, a machine instruction, a machine-dependent instruction, a microcode, a firmware instruction, state setting data, or an object-oriented programming language such as Smalltalk (registered trademark), JAVA (registered trademark), or C++, and a procedural programming language according to the related art, such as the "C" programming language or similar programming languages.

The computer-readable instruction may be provided for a processor of a general purpose computer, a special purpose computer, or another programmable data processing apparatus, or a programmable circuit, either locally or via a local area network (LAN) or a wide area network (WAN) such as the Internet, to cause the processor of the general purpose computer, the special purpose computer, or the another programmable data processing apparatus or the programmable circuit to execute the computer-readable instruction to generate means for performing the operation designated in the flowcharts or block diagrams. Examples of the processor include a computer processor, a processing unit, a microprocessor, a digital signal processor, a controller, and a microcontroller.

Although the disclosure has been described with reference to the embodiments, the technical scope of the disclosure is not limited to the scope described in the embodiments. It is apparent to those skilled in the art that various modifications or improvements can be made to the above embodiments. It is apparent from the description of the claims that such changed modes or improved modes can also be included in the technical scope of the disclosure.

It should be noted that an order of execution of processing such as operations, procedures, steps, and stages in the apparatuses, systems, programs, and methods shown in the claims, the specification, and the drawings can be implemented in any order unless "before", "prior to", or the like is explicitly stated, and unless the output of the previous processing is used in the later processing. Even in a case where the operation flow in the claims, the specification, and the drawings is described using the terms "first", "next,", and the like for convenience, it does not mean that it is essential to execute the operation flow in this order.

In the embodiments, the processing to be executed by each processor (such as the IPU 11, the MoPU 12, or the central brain 15) is merely an example, and a processor that executes each processing is not limited. For example, the processing executed by the MoPU 12 in the embodiments may be executed by the central brain 15 instead of the MoPU 12, or may be executed by a processor other than the IPU 11, the MoPU 12, and the central brain 15.

The disclosure of Japanese Patent Application No. 2022-170165 filed on October 24, 2022, the disclosure of Japanese Patent Application No. 2022-172777 filed on October 27, 2022, the disclosure of Japanese Patent Application No. 2022-175679 filed on November 1, 2022, the disclosure of Japanese Patent Application No. 2022-175698 filed on November 1, 2022, the disclosure of Japanese Patent Application No. 2022-181362 filed on November 11, 2022, the disclosure of Japanese Patent Application No. 2022-182131 filed on November 14, 2022, the disclosure of Japanese Patent Application No. 2022-186040 filed on November 21, 2022, the disclosure of Japanese Patent Application No. 2022-187648 filed on November 24, 2022, the disclosure of Japanese Patent Application No. 2022-187649 filed on November 24, 2022, the disclosure of Japanese Patent Application No. 2022-189546 filed on November 28, 2022, the disclosure of Japanese Patent Application No. 2022-209070 filed on December 26, 2022, the disclosure of Japanese Patent Application No. 2023-000321 filed on January 4, 2023, the disclosure of Japanese Patent Application No. 2023-036967 filed on March 9, 2023, the disclosure of Japanese Patent Application No. 2023-036968 filed on March 9, 2023, the disclosure of Japanese Patent Application No. 2023-036969 filed on March 9, 2023, the disclosure of Japanese Patent Application No. 2023-036972 filed on March 9, 2023, the disclosure of Japanese Patent Application No. 2023-036973 filed on March 9, 2023, the disclosure of Japanese Patent Application No. 2023-036974 filed on March 9, 2023, the disclosure of Japanese Patent Application No. 2023-036976 filed on March 9, 2023, the disclosure of Japanese Patent Application No. 2023-036977 filed on March 9, 2023, the disclosure of Japanese Patent Application No. 2023-059411 filed on March 31, 2023, the disclosure of Japanese Patent Application No. 2023-068062 filed on April 18, 2023, the disclosure of Japanese Patent Application No. 2023-069618 filed on April 20, 2023, the disclosure of Japanese Patent Application No. 2023-070394 filed on April 21, 2023, the disclosure of Japanese Patent Application No. 2023-075259 filed on April 28, 2023, the disclosure of Japanese Patent Application No. 2023-076253 filed on May 2, 2023, the disclosure of Japanese Patent Application No. 2023-076261 filed on May 2, 2023, the disclosure of Japanese Patent Application No. 2023-076943 filed on May 8, 2023, the disclosure of Japanese Patent Application No. 2023-076944 filed on May 8, 2023, the disclosure of Japanese Patent Application No. 2023-080353 filed on May 15, 2023, the disclosure of Japanese Patent Application No. 2023-083452 filed on May 19, 2023, the disclosure of Japanese Patent Application No. 2023-084121 filed on May 22, 2023, the disclosure of Japanese Patent Application No. 2023-084860 filed on May 23, 2023, and the disclosure of Japanese Patent Application No. 2023-104424 filed on June 26, 2023 are incorporated herein by reference in their entirety.

All documents, patent applications, and technical standards mentioned herein are incorporated herein by reference to the same extent as if each individual document, patent application, and technical standard were specifically and individually stated.

## Claims

**1.** An information processing apparatus comprising:

a first processor that outputs point information that represents an imaged object as a point in an image of the object captured by a first camera; and
a second processor that outputs identification information obtained by identifying the imaged object in an image of the object captured by a second camera oriented in a direction corresponding to a direction in which the first camera is oriented.

**2.** The information processing apparatus according to claim 1, further comprising a third processor that associates the point information output from the first processor with the identification information output from the second processor.

**3.** The information processing apparatus according to claim 1, wherein

a frame rate of the first camera is variable, and
the first processor changes the frame rate of the first camera according to a predetermined factor.

**4.** The information processing apparatus according to claim 3, wherein
the first processor calculates a score for an external environment for a predetermined target.

**5.** The information processing apparatus according to claim 4, wherein
the first processor changes the frame rate of the first camera according to the calculated score for the external environment.

**6.** The information processing apparatus according to claim 1, wherein

the first processor outputs coordinate values of a point indicating an existence position of the imaged object in the image of the object captured by the first camera on at least two coordinate axes in a three-dimensional orthogonal coordinate system, and
the information processing apparatus further comprises a third processor that associates the point information output from the first processor with the identification information output from the second processor.

**7.** The information processing apparatus according to claim 6, wherein
the first processor outputs coordinate values of at least two diagonal points at vertices of a polygon surrounding a contour of the object recognized from the image captured by the first camera.

**8.** The information processing apparatus according to claim 7, wherein
the first processor outputs coordinate values of a plurality of vertices of the polygon surrounding the contour of the object recognized from the image captured by the first camera.

**9.** The information processing apparatus according to claim 1, further comprising a third processor that associates the point information output from the first processor with the identification information output from the second processor, and controls autonomous driving of a movable body based on the point information and the identification information.

**10.** The information processing apparatus according to claim 9, wherein

the third processor
calculates a control variable for controlling the autonomous driving of the movable body based on detection information detected by a detection unit, and
controls the autonomous driving of the movable body based on the calculated control variable, the point information, and the identification information.

**11.** The information processing apparatus according to claim 1, wherein

the first processor outputs the point information based on at least one of a visible light image and an infrared image of the object captured by the first camera, and
the information processing apparatus further comprises a third processor that associates the point information output from the first processor with the identification information output from the second processor.

**12.** The information processing apparatus according to claim 11, wherein
the first processor outputs the point information based on the infrared image of the object captured by an infrared camera included in the first camera in a case where the object is not identified from the visible light image of the object captured by a visible light camera included in the first camera due to a predetermined factor.

**13.** The information processing apparatus according to claim 12, wherein
the first processor synchronizes a timing at which the visible light camera captures the visible light image with a timing at which the infrared camera captures the infrared image.

**14.** The information processing apparatus according to claim 1, wherein

the first processor outputs the point information obtained from the image of the object captured by the first camera and a radar signal based on a reflected wave of an electromagnetic wave emitted to the object by a radar from the object, and
the information processing apparatus further comprises a third processor that associates the point information output from the first processor with the identification information output from the second processor.

**15.** The information processing apparatus according to claim 14, wherein
the first processor synchronizes a timing at which the first camera captures the image with a timing at which the radar acquires three-dimensional point cloud data of the object based on the radar signal.

**16.** The information processing apparatus according to claim 14, wherein
the number of images per unit time captured by the first camera and the number of pieces of three-dimensional point cloud data per unit time acquired by the radar are larger than the number of images per unit time captured by the second camera.

**17.** The information processing apparatus according to claim 1, wherein

the second processor outputs label information indicating a type of the imaged object in the image of the object captured by the second camera, and
the information processing apparatus further comprises a third processor that associates the point information output from the first processor with the label information output from the second processor.

**18.** The information processing apparatus according to claim 17, wherein
the third processor associates position information of the object indicated by the point information with the label information for the object present at a position indicated by the position information.

**19.** The information processing apparatus according to claim 18, wherein
the third processor associates the point information output from the first processor with the label information at the same timing as a timing at which the second processor outputs the label information.

**20.** The information processing apparatus according to claim 18, wherein
the third processor associates new point information with the label information in a case where the new point information is output from the first processor after the point information and the label information are associated with each other.

**21.** The information processing apparatus according to claim 1, further comprising a third processor that associates the point information output from the first processor with the identification information output from the second processor, wherein
the first processor derives, as the point information, a coordinate value of a point indicating an existence position of the object in a depth direction of the object in a three-dimensional orthogonal coordinate system from the image of the object captured by the first camera.

**22.** The information processing apparatus according to claim 21, wherein
the first processor derives, as the point information, a coordinate value in the depth direction from images of the object captured by a plurality of the first cameras.

**23.** The information processing apparatus according to claim 21, wherein
the first processor derives, as the point information, coordinate values in a width direction, a height direction, and the depth direction of the object from the image of the object captured by the first camera and a radar signal based on a reflected wave of an electromagnetic wave emitted to the object by a radar from the object.

**24.** The information processing apparatus according to claim 21, wherein
the first processor derives, as the point information, coordinate values in a width direction, a height direction, and the depth direction of the object from the image of the object captured by the first camera and a result of imaging structured light emitted to the object by an irradiation device.

**25.** The information processing apparatus according to claim 21, wherein
the first processor derives, as the point information, a coordinate value in the depth direction at a second time point from coordinate values in a width direction, a height direction, and the depth direction of the object in the three-dimensional orthogonal coordinate system at a first time point and coordinate values in the width direction and the height direction at the second time point which is a time point next to the first time point.

**26.** The information processing apparatus according to claim 1, further comprising a third processor that associates the point information output from the first processor with the identification information output from the second processor, wherein
the third processor derives, as the point information, a coordinate value of a point indicating an existence position of the object in a depth direction of the object in a three-dimensional orthogonal coordinate system from the image of the object captured by the first camera.

**27.** The information processing apparatus according to claim 1, wherein

the first processor outputs the point information based on an image of the object captured by an event camera,
the second processor outputs the identification information based on the image of the object captured by the second camera oriented in a direction corresponding to a direction in which the event camera is oriented, and
the information processing apparatus further comprises a third processor that associates the point information output from the first processor with the identification information output from the second processor.

**28.** The information processing apparatus according to claim 27, wherein
the first processor outputs the point information based on the image of the object captured by the event camera in a case where the object is not identified from a visible light image of the object captured by a visible light camera due to a predetermined factor.

**29.** The information processing apparatus according to claim 28, wherein
the predetermined factor includes at least one of a case where a movement speed of the object is equal to or higher than a predetermined value and a case where a light quantity change of ambient light per unit time is equal to or larger than a predetermined value.

**30.** The information processing apparatus according to claim 27, wherein
the event camera is a camera that outputs an event image representing a difference portion between an image captured at a current time and an image captured at a previous time.

**31.** The information processing apparatus according to claim 1, wherein

the second processor outputs the captured image of the object at a first frame rate,
the first processor outputs motion information indicating a motion of the imaged object at a second frame rate higher than the first frame rate, and
the information processing apparatus further comprises a third processor that performs vehicle driving control based on the image and the motion information.

**32.** The information processing apparatus according to claim 31, wherein
the second frame rate is 10 times or more the first frame rate.

**33.** The information processing apparatus according to claim 31, wherein
the second frame rate is 100 frames/second or higher.

**34.** The information processing apparatus according to claim 31, wherein
the first processor outputs vector information of a motion of a point indicating an existence position of the object along a predetermined coordinate axis.

**35.** The information processing apparatus according to claim 34, wherein
vector information of a motion of the point indicating the existence position of the object along each of three coordinate axes in a three-dimensional orthogonal coordinate system is output by using two first processors.

**36.** The information processing apparatus according to claim 35, wherein

the third processor has a capability of processing a plurality of pieces of information in units of 1/1 billion seconds.

**37.** The information processing apparatus according to claim 1, wherein
only a point indicating an existence position of the object is extracted from an image of the object captured by a camera with a frame rate of 100 frames/second or higher, and vector information of a motion of the point indicating the existence position of the object along a predetermined coordinate axis is output from a processor.

**38.** The information processing apparatus according to claim 35, wherein
the first processor outputs the vector information for at least two diagonal points at vertices of a quadrangle surrounding a contour of the object.

**39.** The information processing apparatus according to claim 1, wherein
the first processor extracts a point indicating an existence position of the object from the image of the object, and outputs motion information indicating a motion of the point indicating the existence position of the object along a predetermined coordinate axis at a frame rate of 1000 frames/second or higher.

**40.** The information processing apparatus according to claim 39, wherein
the first processor outputs, as the motion information, vector information of a motion of a center point or a center-of-gravity point of the object along the predetermined coordinate axis.

**41.** The information processing apparatus according to claim 39, wherein
the first processor outputs, as the motion information, vector information of a motion along the predetermined coordinate axis for at least two diagonal points at vertices of a quadrangle surrounding a contour of the object.

**42.** The information processing apparatus according to claim 39, wherein
the image includes an infrared image.

**43.** The information processing apparatus according to claim 39, wherein
the image includes a visible light image and an infrared image synchronized with each other.

**44.** The information processing apparatus according to claim 39, wherein
vector information of a motion of the point indicating the existence position of the object along each of three coordinate axes in a three-dimensional orthogonal coordinate system is output as the motion information by using two first processors.

**45.** The information processing apparatus according to claim 39, wherein
the first processor derives a distance to the object based on a reflected wave of an electromagnetic wave emitted to the object from the object, and outputs, as the motion information, vector information of a motion of the point indicating the existence position of the object along each of three coordinate axes in a three-dimensional orthogonal coordinate system.

**46.** The information processing apparatus according to claim 39, further comprising:

the second processor that outputs the image of the object at a frame rate of lower than 1000 frames/second; and
a third processor that performs response control for the object based on the motion information and the image output from the second processor.

**47.** The information processing apparatus according to claim 1, wherein
the first processor extracts a point indicating an existence position of the object from an image in which the object appears, and outputs the point indicating the existence position of the object.

**48.** The information processing apparatus according to claim 47, further comprising a camera configured to change a frame rate, wherein

the first processor
calculates a score for an external environment,
determines the frame rate of the camera according to the score,
outputs a control signal for instructing the camera to capture an image at the determined frame rate, and

extracts the point indicating the existence position of the object from the image captured by the camera, and outputs the point indicating the existence position of the object.

**49.** The information processing apparatus according to claim 48, wherein

the information processing apparatus is mounted on a vehicle, and
the first processor
calculates a risk level for traveling of the vehicle as the score for the external environment,
determines the frame rate of the camera according to the risk level,
outputs a control signal for instructing the camera to capture the image at the determined frame rate, and
extracts the point indicating the existence position of the object from the image captured by the camera, and outputs the point indicating the existence position of the object.

**50.** The information processing apparatus according to claim 47, wherein

the first processor
extracts the object from the image, and
extracts, in a case where the existence position of the object is a predetermined region, the point indicating the existence position of the object and outputs the point indicating the existence position of the object.

**51.** The information processing apparatus according to claim 47, wherein

the first processor
extracts the object from the image,
calculates a score for each object, and
extracts the point indicating the existence position of the object whose score is equal to or higher than a predetermined threshold, and outputs the point indicating the existence position of the object.

**52.** The information processing apparatus according to claim 1, further comprising:

a first camera that has a first horizontal view angle;
a second camera that has a second horizontal view angle wider than the first horizontal view angle; and
an adjustment unit that adjusts an imaging direction of the first camera, wherein
the first processor controls the adjustment unit such that the imaging direction of the first camera is directed to the detected object in a case where a motion of the object in a blind spot of the first camera is detected in the image acquired by the second camera.

**53.** The information processing apparatus according to claim 52, wherein
the horizontal view angle of the second camera is 360°.

**54.** The information processing apparatus according to claim 53, wherein
an adjustment range of the imaging direction in a horizontal direction of the adjustment unit is a range within ±135° with respect to a reference direction.

**55.** The information processing apparatus according to claim 52, wherein
the first camera has a higher resolution per unit view angle than the second camera.

**56.** The information processing apparatus according to claim 52, wherein
the first processor acquires information regarding a distance to the object in the image by using the image acquired by the first camera and the image acquired by the second camera.

**57.** The information processing apparatus according to claim 1, wherein

the information processing apparatus comprises:
the first processor that outputs motion information indicating a motion of an object extracted from an image;
the second processor that outputs type information indicating a type of the object extracted from the image;
a third processor that performs response control for the object based on the motion information and the type information; and

an acquisition unit that acquires an image acquired by an external camera installed outside a movable body on which the own apparatus is mounted and position information of the external camera, and
the second processor outputs the type information indicating the type of the object extracted from the image acquired by the external camera in association with the position information of the external camera.

**58.** The information processing apparatus according to claim 57, wherein
in a case where the object extracted from the image acquired by the external camera is an object that affects traveling of the movable body, the second processor outputs the type information of the object while adding identification information indicating that the object is the object that affects the traveling.

**59.** The information processing apparatus according to claim 58, wherein
the object that affects the traveling of the movable body is a person or an animal.

**60.** The information processing apparatus according to claim 57, wherein
the acquisition unit acquires the image and the position information from the external camera positioned in front of a traveling route of the movable body.

**61.** The information processing apparatus according to claim 60, wherein
the acquisition unit acquires the image and the position information only from the external camera closest to the own apparatus in front of the traveling route of the movable body.

**62.** The information processing apparatus according to claim 60, wherein
the acquisition unit specifies the external camera positioned in front of the traveling route of the movable body based on route information of a navigation system that guides the traveling route of the movable body.

**63.** The information processing apparatus according to claim 1, wherein
the information processing apparatus comprises:

an imaging unit that sequentially moves a camera to a first position and a second position that is different from the first position at least in a horizontal direction, and causes the camera to capture an image at each of the first position and the second position; and
a processing unit that calculates a three-dimensional position of an object appearing in each of a first image and a second image based on the first image captured at the first position and the second image captured at the second position.

**64.** The information processing apparatus according to claim 63, wherein
the imaging unit includes a moving unit that rotates a member to which the camera is attached such that the camera cyclically moves along an annular path passing through each of the first position and the second position.

**65.** The information processing apparatus according to claim 64, wherein

the processing unit calculates a score for an external environment, and determines a frame rate of the camera according to the calculated score, and
the moving unit changes a rotation speed of the member according to the frame rate determined by the processing unit.

**66.** The information processing apparatus according to claim 63, wherein
the processing unit corrects a deviation between two-dimensional positions of the object in the first image and the second image due to an imaging time difference between the first image and the second image, and calculates the three-dimensional position of the object.

**67.** The information processing apparatus according to claim 66, wherein
the processing unit corrects the deviation between the two-dimensional positions of the object by performing matching between a first image captured at the first position at a first time and a first image captured at the first position at a second time, and estimating a two-dimensional position of the object in a virtual first image obtained in a case where imaging is performed at the first position at a third time which is an imaging time at the second position based on a matching result.

**68.** The information processing apparatus according to claim 1, further comprising a third processor that associates the point information output from the first processor with the identification information output from the second processor, wherein
in a case where the image captured by the first camera is not clear, the third processor uses the image captured by the second camera as a substitute for the image captured by the first camera.

**69.** The information processing apparatus according to claim 68, wherein
in a case where the image captured by the first camera is not clear, the third processor executes processing of sharpening the image captured by the first camera.

**70.** The information processing apparatus according to claim 1, wherein
the second processor acquires position information of the image captured by the second camera by using an image of the object captured by another apparatus present in a vicinity of the own apparatus and position information of the object.

**71.** The information processing apparatus according to claim 70, wherein
the second processor synchronizes a frame of the second camera with a frame of the image of the object from the another apparatus in consideration of a transmission time of the image of the object and the position information of the object from the another apparatus.

**72.** The information processing apparatus according to claim 1, wherein
the first processor switches a first coordinate value or a second coordinate value of a point indicating an existence position of the imaged object in the image of the object captured by the first camera on at least two coordinate axes in a three-dimensional orthogonal coordinate system, the first coordinate value indicating an existence position of a center point or a center-of-gravity point of the object, and the second coordinate value indicating existence positions of at least two diagonal points at vertices of a polygon surrounding a contour of the object at a predetermined timing, and outputs the first coordinate value or the second coordinate value.

**73.** The information processing apparatus according to claim 72, wherein
the first processor switches a coordinate value to be output from the first coordinate value to the second coordinate value in a case where the imaged object is not identified by the second processor from the image of the object captured by the second camera due to a predetermined factor.

**74.** The information processing apparatus according to claim 72, wherein
the first processor switches a coordinate value to be output from the second coordinate value to the first coordinate value in a case where a movement speed of the object is equal to or lower than a predetermined threshold or in a case where a movement direction of the object is a predetermined direction.

**75.** The information processing apparatus according to claim 72, further comprising a third processor that associates the first coordinate value or the second coordinate value output from the first processor with the identification information output from the second processor.

**76.** The information processing apparatus according to claim 1, wherein
the first processor stops the output of the point information for the object in a case where it is determined that a possibility that the object present in a passage through which a movable body passes comes into contact with the movable body is low.

**77.** The information processing apparatus according to claim 76, wherein
the first processor determines that a possibility that the object comes into contact with the movable body is low in a case where the object is not present on a movement route of the movable body in the passage and the object moves away from the movement route.

**78.** The information processing apparatus according to claim 1, wherein

the first processor outputs the point information based on the image of the object captured by the first camera, and calculates and outputs motion information indicating a motion of a point from a time series of the point information,
the information processing apparatus further comprises a third processor that associates the motion information output from the first processor with the identification information output from the second processor, and

in a case where pieces of motion information of a plurality of objects whose directions of motions correspond to each other are detected, the third processor removes the pieces of motion information of the plurality of objects and associates remaining motion information with the identification information.

**79.** The information processing apparatus according to claim 78, wherein

the first processor calculates a direction of the motion of the point from the time series of the point information by using Hough transform, and
calculates a speed of the motion from a change in point information of the calculated direction of the motion of the point.

**80.** The information processing apparatus according to claim 78, wherein
the third processor associates the motion information output from the first processor with the identification information output from the second processor, and controls autonomous driving of a movable body based on the motion information and the identification information.

**81.** The information processing apparatus according to claim 1, wherein

the information processing apparatus comprises at least one processor, and
the processor
outputs the point information based on an image of the object captured by a camera, and
outputs, in a case where a certain number or more of points whose movement direction is the same one side direction in an upward-downward direction and whose movement amount in the upward-downward direction is within a certain range have been detected based on the point information output based on images of a plurality of frames, only a point other than the detected certain number or more of points from among points included in the point information.

**82.** The information processing apparatus according to claim 81, wherein
in a case where a movable body in which the camera is provided is traveling straight, the processor further outputs a point whose movement amount in a left-right direction is equal to or larger than a threshold from among the detected certain number or more of points.

**83.** The information processing apparatus according to claim 1, wherein
the information processing apparatus comprises:

a first movable body processor used for a first movable body,
the first movable body processor
recognizes a type of a first object included in surroundings of the first movable body based on a first image obtained by imaging the surroundings of the first movable body,
a second movable body processor used for a second movable body recognizes a type of a second object included in surroundings of the second movable body based on a second image obtained by imaging the surroundings of the second movable body, and
in a case where the first movable body processor recognizes the second movable body as the type of the first object and the second movable body processor recognizes the first movable body as the type of the second object, the first movable body processor sets an identifier indicating that the first movable body has been recognized by the second movable body processor.

**84.** The information processing apparatus according to claim 83, wherein

the second movable body is a movable body configured to perform autonomous driving, and
the first movable body processor
sets the identifier in a case where the first movable body processor recognizes the second movable body as the type of the first object, the second movable body processor recognizes the first movable body as the type of the second object, and the second movable body is performing the autonomous driving.

**85.** The information processing apparatus according to claim 83, wherein

the first movable body and the second movable body are movable bodies configured to perform autonomous driving, and
the first movable body processor
controls the autonomous driving of the first movable body based on behavior of the second movable body in a case where the identifier is set and the second movable body is performing the autonomous driving.

**86.** The information processing apparatus according to claim 85, wherein

the second movable body processor controls the autonomous driving of the second movable body, and
the first movable body processor
acquires control information regarding control of the autonomous driving of the second movable body by the second movable body processor as information indicating the behavior, and
controls the autonomous driving of the first movable body based on the control information.

**87.** The information processing apparatus according to claim 86, wherein

a first priority level is assigned to the first movable body,
a second priority level is assigned to the second movable body, and
the first movable body processor acquires the control information under a condition that the first priority level is higher than the second priority level.

**88.** The information processing apparatus according to claim 85, wherein

the first movable body processor
outputs first point information that represents the first object as a point based on a third image obtained by imaging the surroundings of the first movable body at a frame rate higher than a frame rate of the imaging performed to obtain the first image,
associates second movable body information for specifying the second movable body recognized as the type of the first object by the first movable body processor with the first point information, and
controls the autonomous driving of the first movable body based on the second movable body information and the first point information associated with each other.

**89.** The information processing apparatus according to claim 88, wherein

the first movable body processor includes a first processor, a second processor, and a third processor,
the first processor outputs the first point information,
the second processor recognizes the type of the first object based on the first image, and
the third processor associates the second movable body information with the first point information, and controls the autonomous driving of the first movable body.

**90.** The information processing apparatus according to claim 83, wherein

the second movable body is a movable body configured to perform autonomous driving,
the second movable body processor
outputs second point information that represents the second object as a point based on a fourth image obtained by imaging the surroundings of the second movable body at a frame rate higher than a frame rate of the imaging performed to obtain the second image,
associates first movable body information for specifying the first movable body recognized as the type of the second object by the second movable body processor with the second point information, and
executes control processing of controlling the autonomous driving of the second movable body based on the first movable body information and the second point information associated with each other, and
the first movable body processor sets the identifier in a case where the first movable body processor recognizes the second movable body as the type of the first object, the second movable body processor recognizes the first movable body as the type of the second object, and the second movable body processor executes the control processing.

**91.** The information processing apparatus according to claim 85, wherein
the first movable body processor controls the autonomous driving of the first movable body according to a control content for avoiding a contact between the first movable body and the second movable body.

**92.** The information processing apparatus according to claim 83, wherein
in a case where the identifier is set, the first movable body processor causes a notification device to notify that the first movable body has been recognized by the second movable body processor.

**93.** The information processing apparatus according to claim 1, wherein

the information processing apparatus comprises at least one processor, and
the processor
outputs images of an imaged object at a first frame rate,
derives, for each of the images output at the first frame rate, label information indicating a type of the object included in the image,
outputs pieces of position information indicating an existence position of the object based on the images of the imaged object at a second frame rate higher than the first frame rate, and
associates position information at each time point corresponding to an output timing of the image output at the first frame rate among the pieces of position information sequentially output at the second frame rate with the label information derived for the same object as the object corresponding to the position information.

**94.** The information processing apparatus according to claim 93, wherein
the processor associates the label information associated immediately before with position information that is not associated with the label information among the pieces of position information output at the second frame rate.

**95.** The information processing apparatus according to claim 93, wherein
the processor outputs at least one point indicating an existence position of the object as the position information.

**96.** The information processing apparatus according to claim 93, wherein

the processor
derives the label information based on a first image output at the first frame rate and having a relatively high resolution, and
derives the position information based on a second image having a relatively low resolution.

**97.** The information processing apparatus according to claim 2, wherein
the third processor determines that objects satisfying a predetermined condition among objects appearing in a first image captured by the first camera and objects appearing in a second image captured by the second camera are the same object, and associates the point information with the identification information for the objects determined to be the same.

**98.** The information processing apparatus according to claim 97, wherein

the predetermined condition includes matching between a position of the object appearing in the first image and a position of the object appearing in the second image as a first condition, matching between a contour of the object appearing in the first image and a contour appearing in the second image as a second condition, and matching between a type of the object estimated for the object appearing in the first image and a type of the object estimated for the object appearing in the second image as a third condition, and
the third processor determines that the object appearing in the first image and the object appearing in the second image are the same object in a case where at least one of the first condition, the second condition, and the third condition is satisfied.

**99.** The information processing apparatus according to claim 1, wherein

the information processing apparatus comprises an extraction unit, an integration unit, an estimation unit, and an update unit,
the extraction unit extracts first plane coordinates indicating an existence position of an object in a two-dimensional space at time t from an image in which the object appears,
the integration unit combines first depth information detected for a depth direction of the object in a three-dimensional space, the first plane coordinates, and the first depth information to generate three-dimensional coordinates of the object at time t,
the extraction unit extracts second plane coordinates indicating an existence position of the object in the two-dimensional space at a time next to time t,

the estimation unit estimates second depth information corresponding to the next time based on shape information of a space in which the object is present and a change from the first plane coordinates to the second plane coordinates, and

the update unit integrates the second plane coordinates and the estimated second depth information, and updates the three-dimensional coordinates of the object at the next time.

**100.**
The information processing apparatus according to claim 99, wherein
the integration unit detects the first depth information from point cloud data detected by a sensor.

**101.**
The information processing apparatus according to claim 100, wherein
in a case where the second plane coordinates at the next time after movement of the object are extracted, and depth information obtained from the point cloud data corresponding to the next time is not acquired, the estimation of the second depth information and the update are performed.

**102.**
The information processing apparatus according to claim 99, wherein

the shape information includes a shape of a road surface obtained from an image acquired by a high-resolution camera and point cloud data detected by a sensor, and a preset shape of the object, and

the estimation unit estimates the second depth information by calculating a movement amount in a depth direction in a case where the shape of the moving object changes from the first plane coordinates to the second plane coordinates with respect to the shape of the road surface.

**103.**
The information processing apparatus according to claim 99, wherein

each of a plurality of points at vertices of a box representing a contour of the object is a point corresponding to coordinates indicating the existence position of the object,

the extraction unit extracts, for each of the points, the first plane coordinates and the second plane coordinates of the point,

the integration unit generates, for each of the points, the three-dimensional coordinates of the object at the point,

the estimation unit estimates, for each of the points, the second depth information at the point, and

the update unit updates, for each of the points, the three-dimensional coordinates of the object at the point.

**104.**
The information processing apparatus according to claim 1, further comprising a third processor that associates the point information output from the first processor with the identification information output from the second processor, wherein the first processor outputs the point information at a next time point according to a predetermined priority for the identification information associated with the point information in a case where there are a plurality of pieces of the point information.

**105.**
The information processing apparatus according to claim 104, wherein

the first processor derives, as the point information, a coordinate value of a point indicating an existence position of the object in a depth direction of the object in a three-dimensional orthogonal coordinate system from the image of the object captured by the first camera at a first time point, and

the first processor derives a coordinate value in the depth direction at a second time point which is a time point next to the first time point according to the predetermined priority for the identification information associated with the point information in a case where there are a plurality of pieces of the point information.

**106.**
The information processing apparatus according to claim 104, wherein
the first processor sets a high priority for an object that shows behavior and sets a lower priority for an object that does not show the behavior according to a presence or absence of the behavior of the object indicated by the identification information.

**107.**
The information processing apparatus according to claim 106, wherein
the first processor sets a higher priority for an object that shows the behavior according to a risk factor of the object.

**108.**
The information processing apparatus according to claim 107, wherein
the first processor derives the point information at the next time point by using the priority in a case where the number of pieces of point information is equal to or larger than a predetermined number.

**109.**
The information processing apparatus according to claim 1, wherein
the first processor derives, as the point information, a coordinate value of a point indicating an existence position of the object in a depth direction of the object in a three-dimensional orthogonal coordinate system from the image of the object captured by the first camera at each time point at which a predetermined condition for the image is satisfied.

**110.**
The information processing apparatus according to claim 109, wherein
the first processor sets each time point satisfying the predetermined condition as a second time point, and derives, as the point information, a coordinate value in the depth direction at the second time point from coordinate values in a width direction, a height direction, and the depth direction of the object in the three-dimensional orthogonal coordinate system at a first time point and coordinate values in the width direction and the height direction at the second time point which is a time point next to the first time point.

**111.** The information processing apparatus according to claim 110, wherein
the first processor sets, as the predetermined condition, change amounts of the coordinate values in the width direction and the height direction at the second time point with respect to the coordinate values in the width direction and the height direction at the first time point and derives the coordinate value in the depth direction at a predetermined frequency for the change amounts.

**112.**
The information processing apparatus according to claim 1, wherein

the first processor derives, as the point information, a coordinate value of a point indicating an existence position of the object in a depth direction of the object in a three-dimensional orthogonal coordinate system from the image of the object captured by the first camera, and
the first processor learns correction information of the coordinate value in the depth direction from predetermined sensor information.

**113.**
The information processing apparatus according to claim 112, wherein
the first processor collects the sensor information and learns the correction information for a specific travel situation in the collected sensor information in a case where a difference between the derived coordinate value in the depth direction and a coordinate value in the depth direction detected by a predetermined sensor is equal to or larger than a threshold.

**114.**
The information processing apparatus according to claim 113, wherein
the first processor derives, as the point information, a coordinate value in the depth direction at a second time point from coordinate values in a width direction, a height direction, and the depth direction of the object in the three-dimensional orthogonal coordinate system at a first time point and coordinate values in the width direction and the height direction at the second time point which is a time point next to the first time point.

**115.**
The information processing apparatus according to claim 1, wherein
the information processing apparatus comprises:

an information acquisition unit that is configured to acquire a plurality of pieces of information related to a vehicle;

an inference unit that infers a plurality of index values from the plurality of pieces of information acquired by the information acquisition unit by using deep learning; and
a driving control unit that performs driving control of the vehicle based on the plurality of index values.

**116.**
The information processing apparatus according to claim 115, wherein
the inference unit infers the plurality of index values from the plurality of pieces of information by multivariate analysis by an integration method using the deep learning.

**117.**
The information processing apparatus according to claim 115, wherein
the information acquisition unit acquires the plurality of pieces of information in units of 1/1 billion seconds, and the inference unit and the driving control unit perform the inference of the plurality of index values and the driving control of the vehicle in units of 1/1 billion seconds by using the plurality of pieces of information acquired in units of 1/1 billion seconds.

**118.**
The information processing apparatus according to claim 115, further comprising a strategy setting unit that sets a traveling strategy until the vehicle reaches a destination, wherein

the traveling strategy includes at least one theoretical value of an optimal route to the destination, a traveling speed, a tilt, and braking, and
the driving control unit includes a strategy update unit that updates the traveling strategy based on a difference between the plurality of index values and the theoretical value.

**119.**
The information processing apparatus according to claim 115, wherein
the information acquisition unit includes a sensor provided at a lower portion of the vehicle and configured to detect a temperature, a material, and a tilt of a ground on which the vehicle is traveling.

**120.**
The information processing apparatus according to claim 1, wherein
the information processing apparatus comprises:

an acquisition unit that acquires a detection result of detecting an object related to operation of a control device mounted on a vehicle, the control device controlling autonomous driving of the vehicle; and
an execution unit that performs cooling in the control device based on the detection result.

**121.**
The information processing apparatus according to claim 120, wherein
the acquisition unit extracts, as the detection result, a point indicating an existence position of the object from an image of one frame of the object, and acquires motion information indicating a motion of the point indicating the existence position of the object along a predetermined coordinate axis at a frame rate of 100 frames/second or higher.

**122.**
The information processing apparatus according to claim 121, further comprising a prediction unit that predicts the operation of the control device by using the detection result, wherein
the prediction unit predicts the operation of the control device by using a learning model generated by machine learning using, as learning data, the detection result and an operation status of the control device when the detection result is acquired.

**123.**
The information processing apparatus according to claim 122, wherein

the prediction unit further predicts a temperature change of each of a plurality of portions in the control device, and
the execution unit controls cooling of the portion in the control device.

**124.**
The information processing apparatus according to claim 1, wherein

the information processing apparatus comprises:

a calculation unit that calculates, for each of a plurality of combinations of a predetermined number of pieces of sensor information included in a vehicle, a wheel speed and an inclination of each of four wheels of the vehicle, and index values for controlling the wheel speed, the inclination, and a suspension for each suspension supporting the wheel, and calculate the wheel speed, the inclination, and a control variable for each suspension by aggregating the index values; and
a control unit that controls autonomous driving based on the control variable.

**125.**
The information processing apparatus according to claim 124, wherein
the calculation unit calculates the control variable from the index values by multivariate analysis by an integration method using deep learning.

**126.**
The information processing apparatus according to claim 124, wherein
the control unit controls the autonomous driving in units of 1/1 billion seconds based on the control variable.

**127.**
The information processing apparatus according to claim 1, wherein
the information processing apparatus comprises:

an acquisition unit that acquires a plurality of pieces of information related to a vehicle from a detection unit including a sensor that detects a situation around the vehicle at a second cycle shorter than a first cycle at which surroundings of the vehicle are imaged, as a cycle for detecting the situation around the vehicle;
a calculation unit that calculates index values related to the situation around the vehicle from the plurality of pieces of acquired information, and calculates a control variable for controlling behavior of the vehicle from the calculated index values; and
a control unit that controls the behavior of the vehicle based on the calculated control variable.

**128.**
The information processing apparatus according to claim 127, wherein
the calculation unit calculates the control variable from the index values by multivariate analysis by an integration method using deep learning.

**129.**
The information processing apparatus according to claim 127, wherein
the acquisition unit acquires the plurality of pieces of information in units of 1/1 billion seconds, and the calculation unit performs the calculation of the index values and the control variable in units of 1/1 billion seconds by using the plurality of pieces of information acquired in units of 1/1 billion seconds.

**130.**
The information processing apparatus according to claim 127, wherein
the calculation unit predicts a collision of a target with the vehicle based on the plurality of pieces of acquired information, and in a case where a prediction result indicates an unavoidable collision, the calculation unit calculates, as the control variable, a control variable corresponding to damage of the vehicle in the unavoidable collision, the damage not exceeding a predetermined threshold.

**131.**
The information processing apparatus according to claim 130, wherein
the damage of the vehicle is at least one of a deformation position and a deformation amount of the vehicle.

**132.**
The information processing apparatus according to claim 130, wherein
the control variable corresponding to the damage of the vehicle is at least one of a collision angle and a vehicle speed of the vehicle.

**133.**

The information processing apparatus according to claim 1, wherein
the first processor extracts a point indicating an existence position of the object from an image in which the object appears, and outputs the point indicating the existence position of the object.

**134.**
The information processing apparatus according to claim 133, further comprising a camera configured to change a frame rate, wherein

the first processor
calculates a score for an external environment,
determines the frame rate of the camera according to the score,
outputs a control signal for instructing the camera to capture an image at the determined frame rate, and
extracts the point indicating the existence position of the object from the image captured by the camera, and outputs the point indicating the existence position of the object.

**135.**
The information processing apparatus according to claim 134, wherein

the information processing apparatus is mounted on a vehicle, and
the first processor
calculates a risk level for traveling of the vehicle as the score for the external environment,
determines the frame rate of the camera according to the risk level,
outputs a control signal for instructing the camera to capture the image at the determined frame rate, and
extracts the point indicating the existence position of the object from the image captured by the camera, and outputs the point indicating the existence position of the object.

**136.**
The information processing apparatus according to claim 133, wherein

the first processor
extracts the object from the image, and
extracts, in a case where the existence position of the object is a predetermined region, the point indicating the existence position of the object and outputs the point indicating the existence position of the object.

**137.**
The information processing apparatus according to claim 133, wherein

the first processor
extracts the object from the image,
calculates a score for each object, and
extracts the point indicating the existence position of the object whose score is equal to or higher than a predetermined threshold, and outputs the point indicating the existence position of the object.

**138.**
A vehicle comprising:

a pair of camera units each including a camera; and
a processor, wherein
a first camera unit extracts a point indicating an existence position of an object in front of the vehicle from an image in which the object appears and outputs the point indicating the existence position of the object,
a second camera unit extracts a point indicating an existence position of an object behind the vehicle from an image in which the object appears, and outputs the point indicating the existence position of the object, and
the processor controls traveling of the vehicle based on the existence positions of the objects output from the first camera unit and the second camera unit.

**139.**
The vehicle according to claim 138, wherein

the camera included in each of the camera units is configured to change a frame rate, and
one of the first camera unit and the second camera unit
sets the frame rate of the camera according to an object detection situation in the other of the first camera unit and the second camera unit, and
extracts the point indicating the existence position of the object from the image captured by the camera at the set frame rate, and outputs the point indicating the existence position of the object.

**140.**
The vehicle according to claim 138 or 139, further comprising:

another camera unit that includes a high-resolution camera having a higher resolution than the camera, and is connected to each of the camera units, wherein
each of the camera units is configured to acquire information regarding the object specified based on information of the high-resolution camera, and
one of the first camera unit and the second camera unit
acquires the information regarding the object in the other of the first camera unit and the second camera unit.

**141.**
An information processing method in which a computer executes processing of:

outputting point information that represents an imaged object as a point in an image of the object captured by a first camera; and
outputting identification information obtained by identifying the imaged object in an image of the object captured by a second camera oriented in a direction corresponding to a direction in which the first camera is oriented.

**142.**
An information processing program for causing a computer to execute processing of:

outputting point information that represents an imaged object as a point in an image of the object captured by a first camera; and
outputting identification information obtained by identifying the imaged object in an image of the object captured by a second camera oriented in a direction corresponding to a direction in which the first camera is oriented.

FIG.1

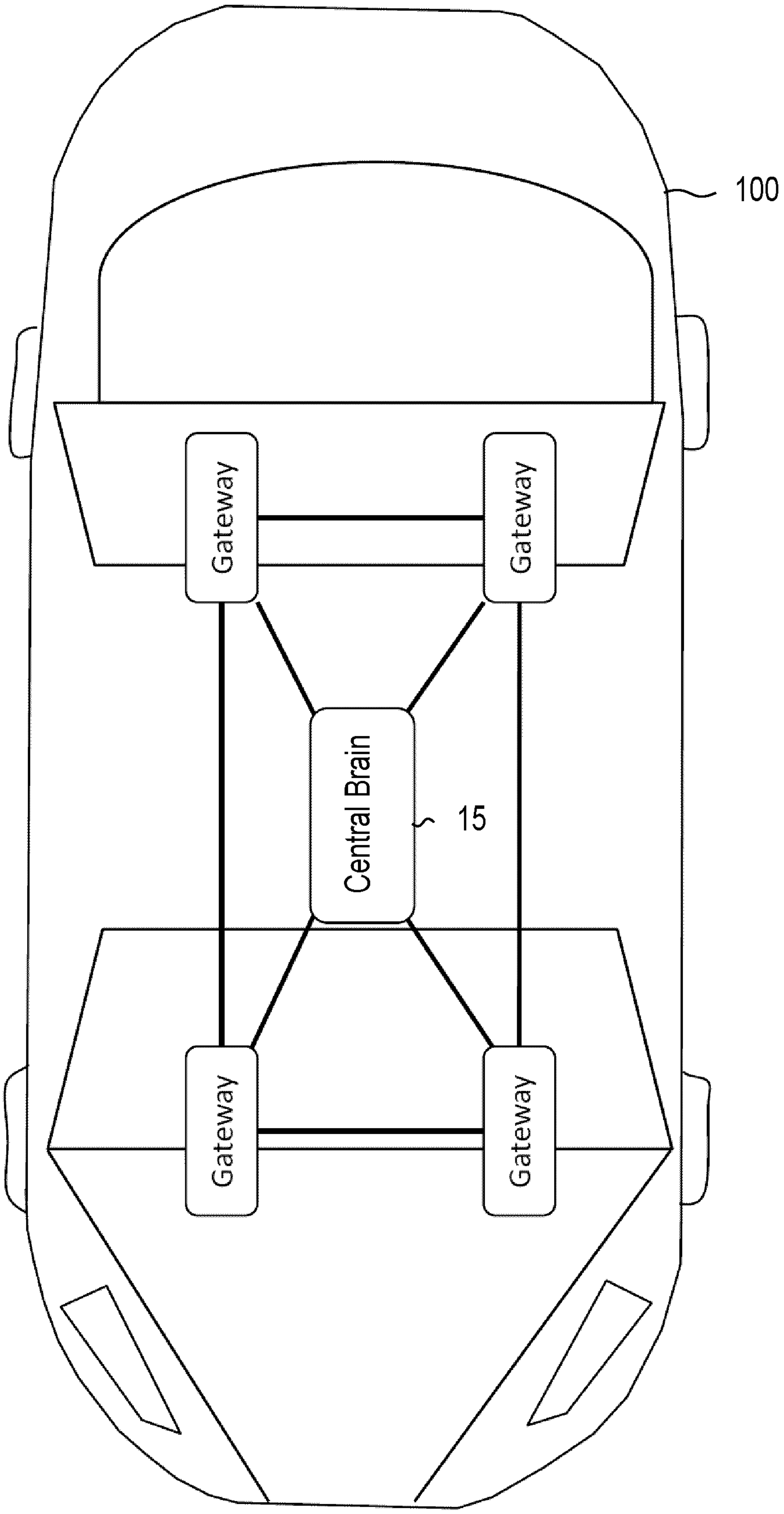

FIG.2

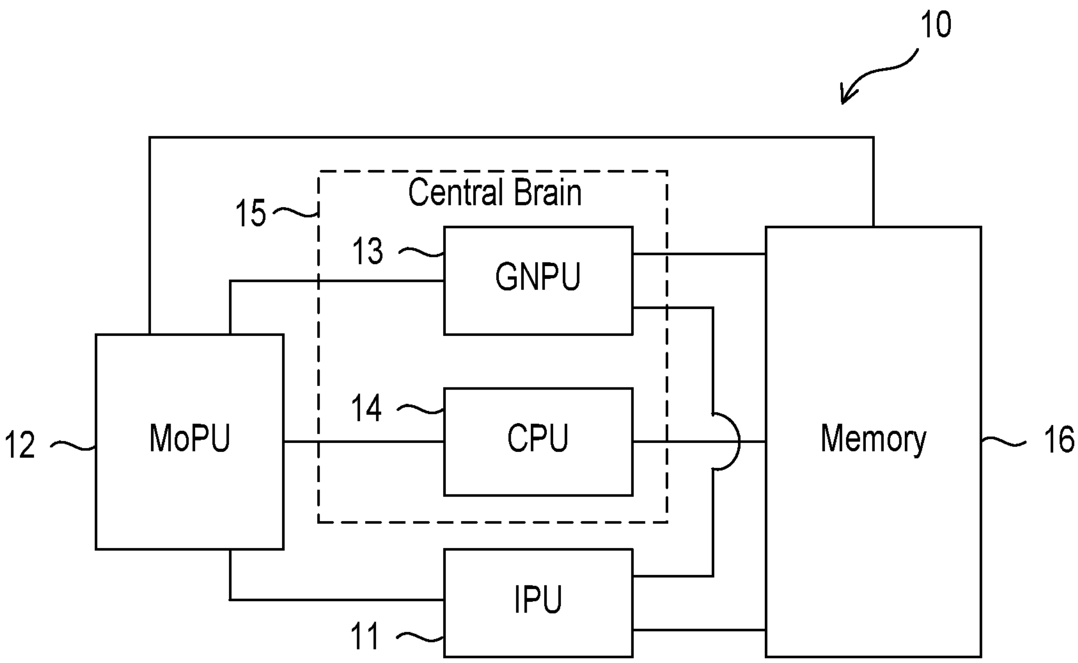

FIG.3

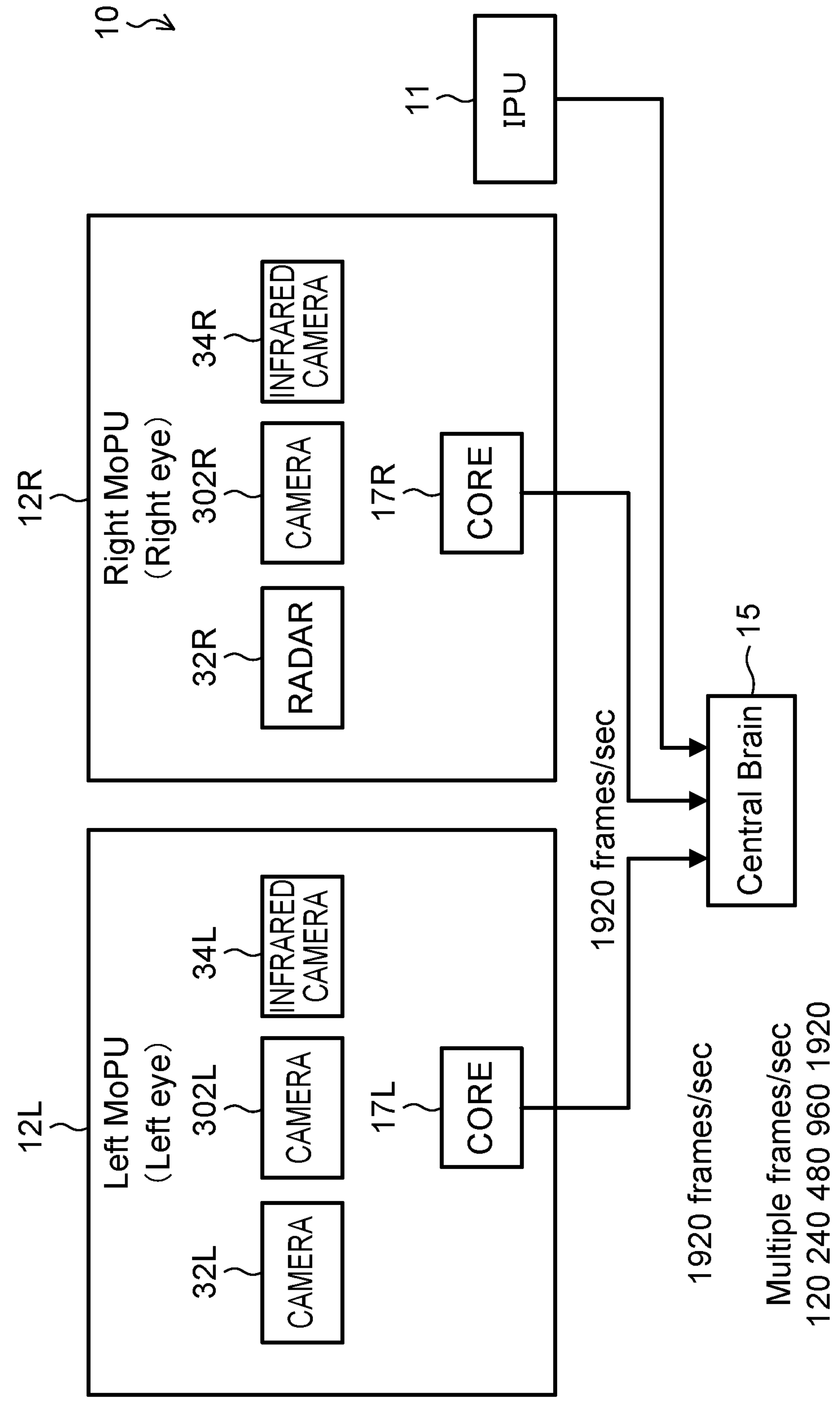
10
11
IPU
12R
Right MoPU
(Right eye)
32R
RADAR
302R
CAMERA
34R
INFRARED CAMERA
17R
CORE
12L
Left MoPU
(Left eye)
32L
CAMERA
302L
CAMERA
34L
INFRARED CAMERA
17L
CORE
1920 frames/sec
15
Central Brain
1920 frames/sec
Multiple frames/sec
120 240 480 960 1920

FIG.4

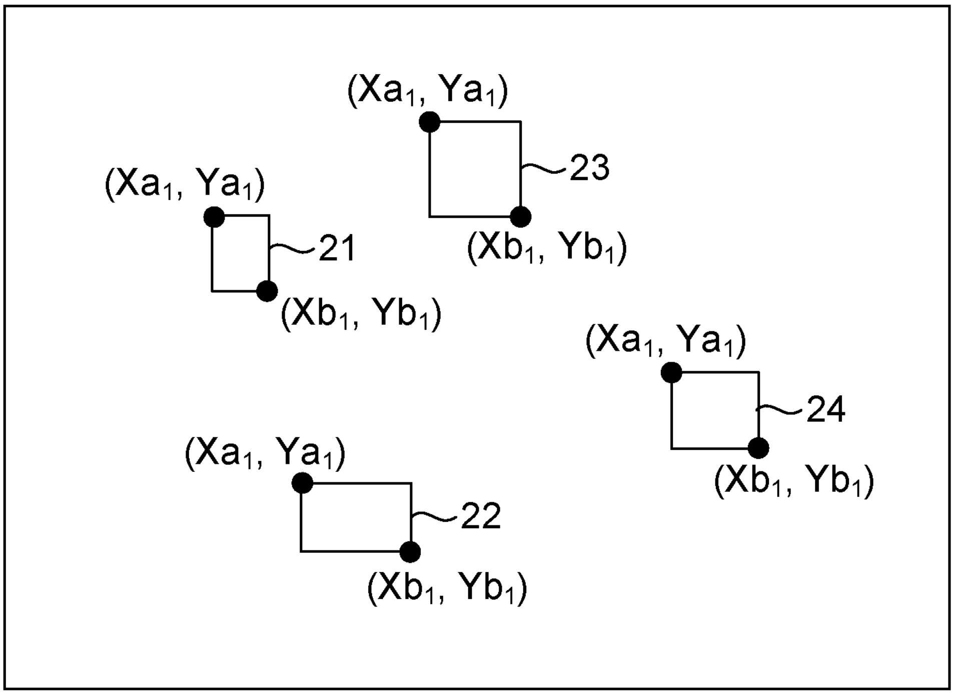
(Xa1, Ya1)
23
(Xb1, Yb1)
(Xa1, Ya1)
21
(Xb1, Yb1)
(Xa1, Ya1)
24
(Xb1, Yb1)
(Xa1, Ya1)
22
(Xb1, Yb1)

FIG.5

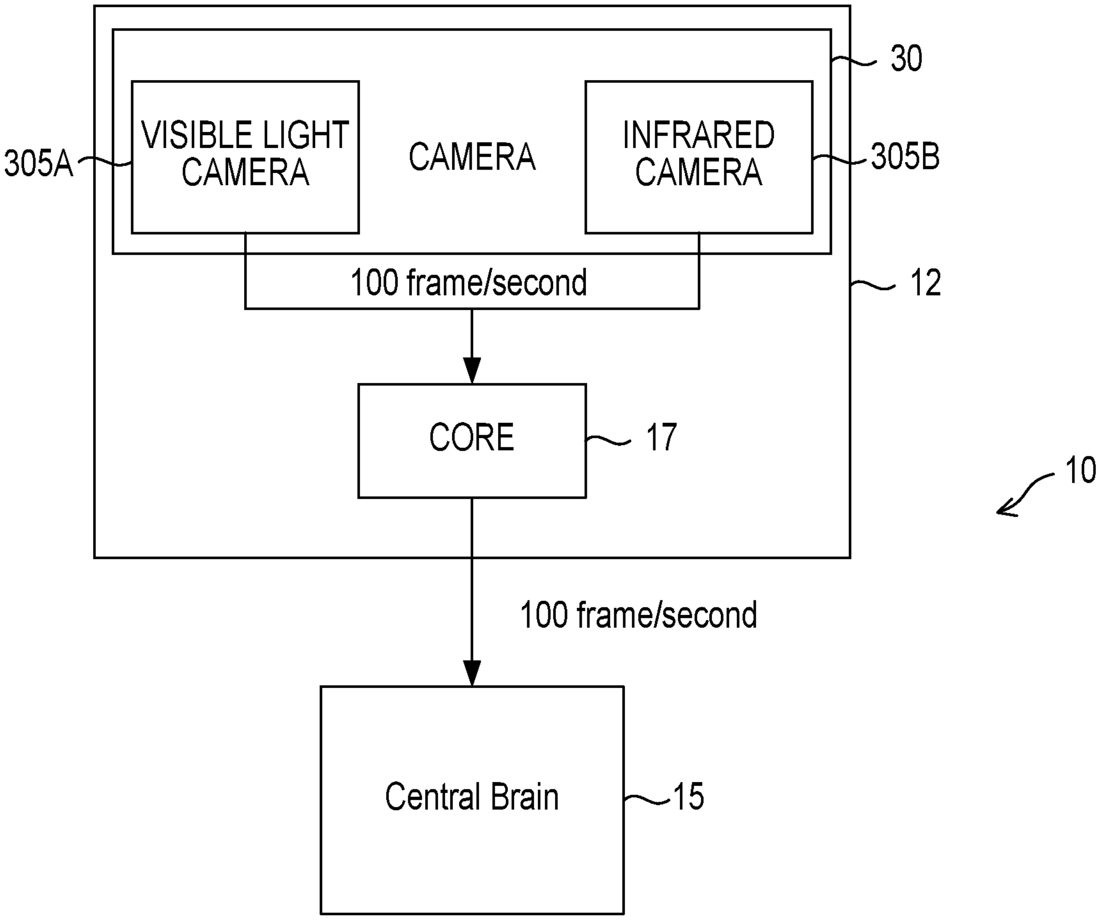
VISIBLE LIGHT CAMERA
CAMERA
INFRARED CAMERA
305A
305B
30
100 frame/second
12
CORE
17
10
100 frame/second
Central Brain
15

FIG.6

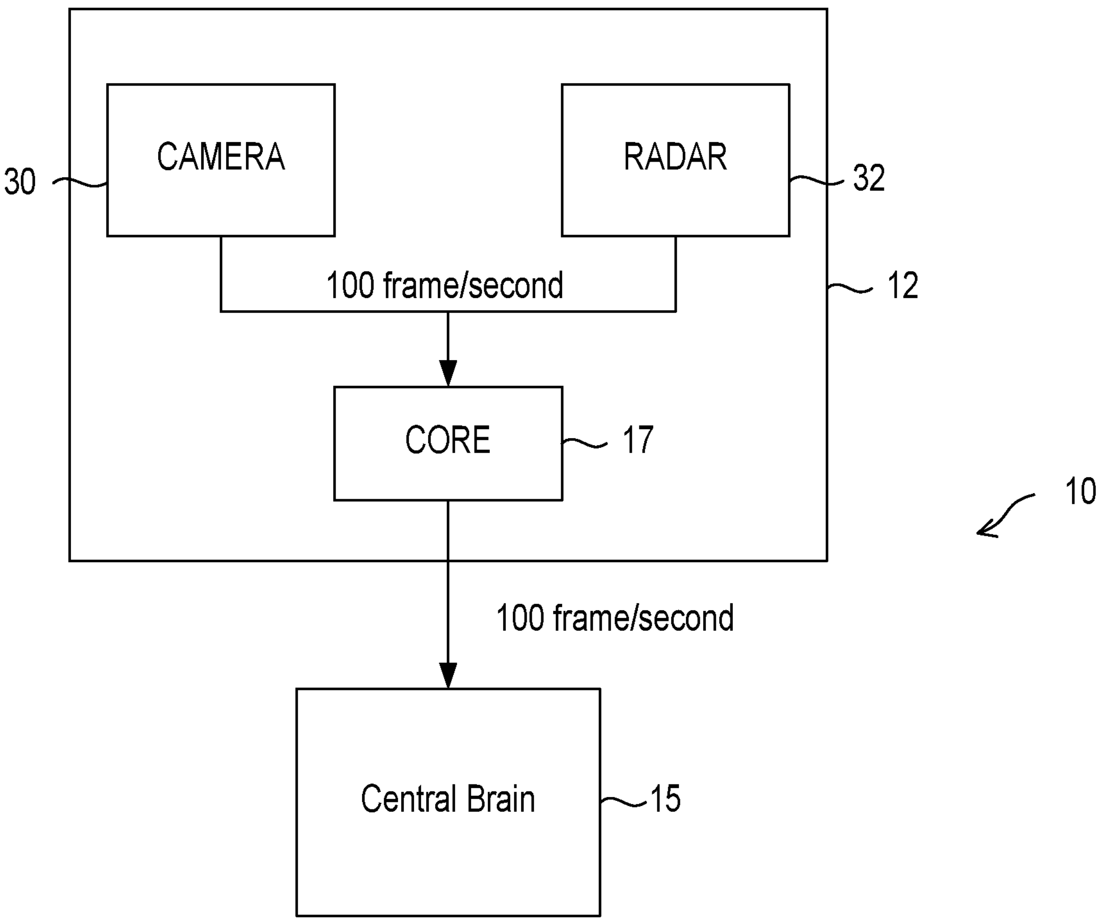
CAMERA
RADAR
30
32
100 frame/second
12
CORE
17
10
100 frame/second
Central Brain
15

FIG.7A

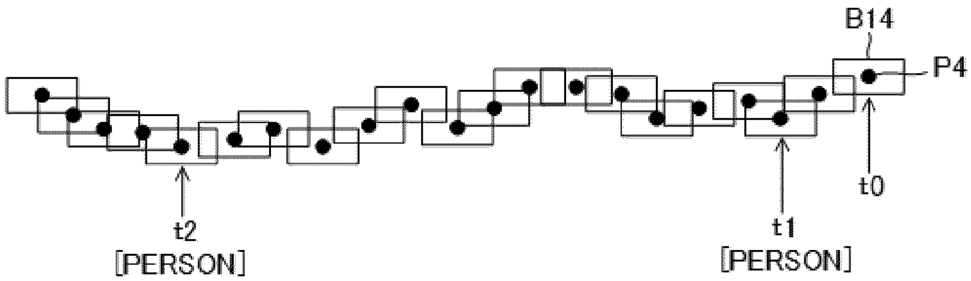
B14
P4
t2
[PERSON]
t1
[PERSON]
t0

FIG.7B

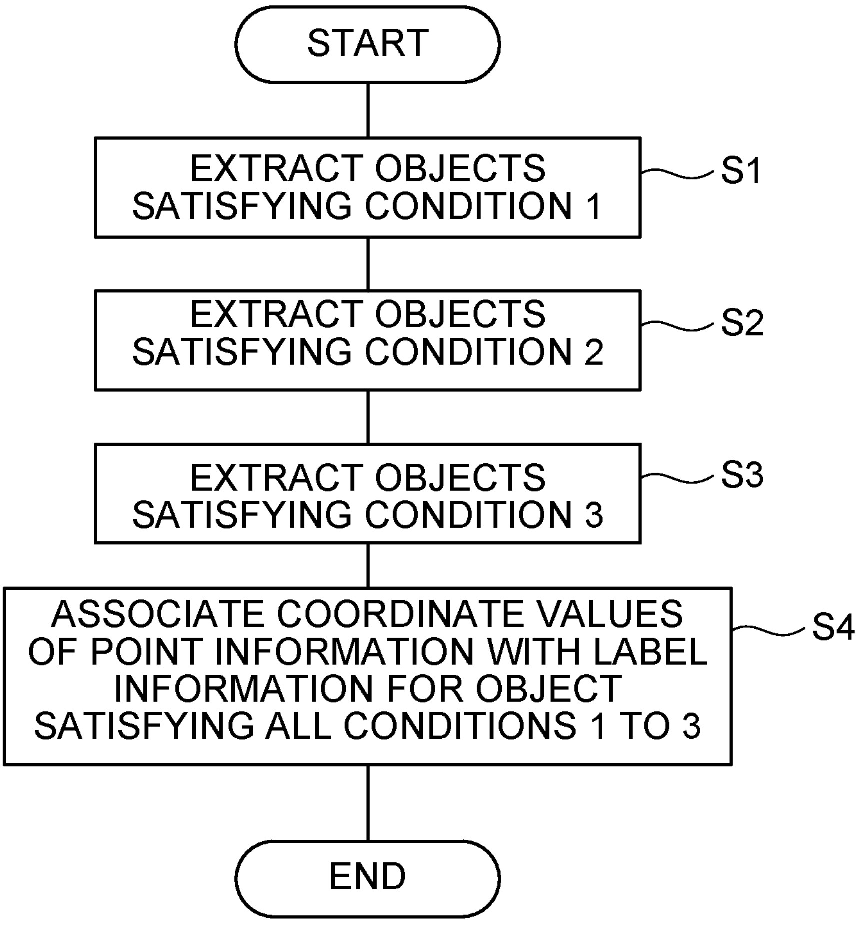
START
EXTRACT OBJECTS SATISFYING CONDITION 1
S1
EXTRACT OBJECTS SATISFYING CONDITION 2
S2
EXTRACT OBJECTS SATISFYING CONDITION 3
S3
ASSOCIATE COORDINATE VALUES OF POINT INFORMATION WITH LABEL INFORMATION FOR OBJECT SATISFYING ALL CONDITIONS 1 TO 3
S4
END

FIG.8

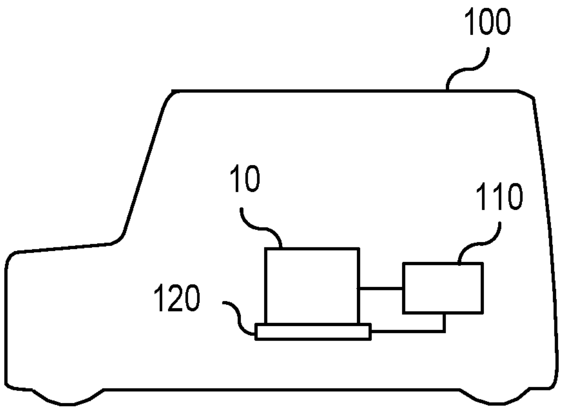

FIG.9

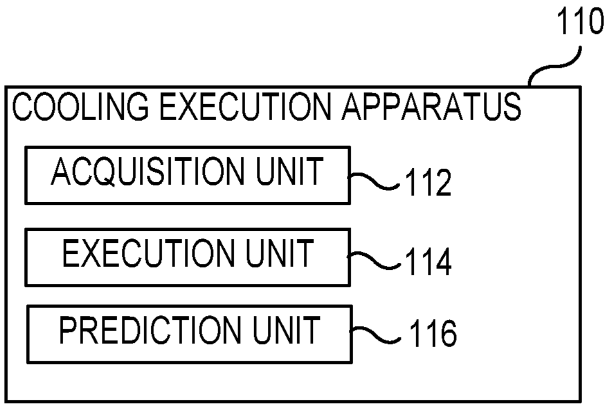
110
COOLING EXECUTION APPARATUS
ACQUISITION UNIT
112
EXECUTION UNIT
114
PREDICTION UNIT
116

FIG.10

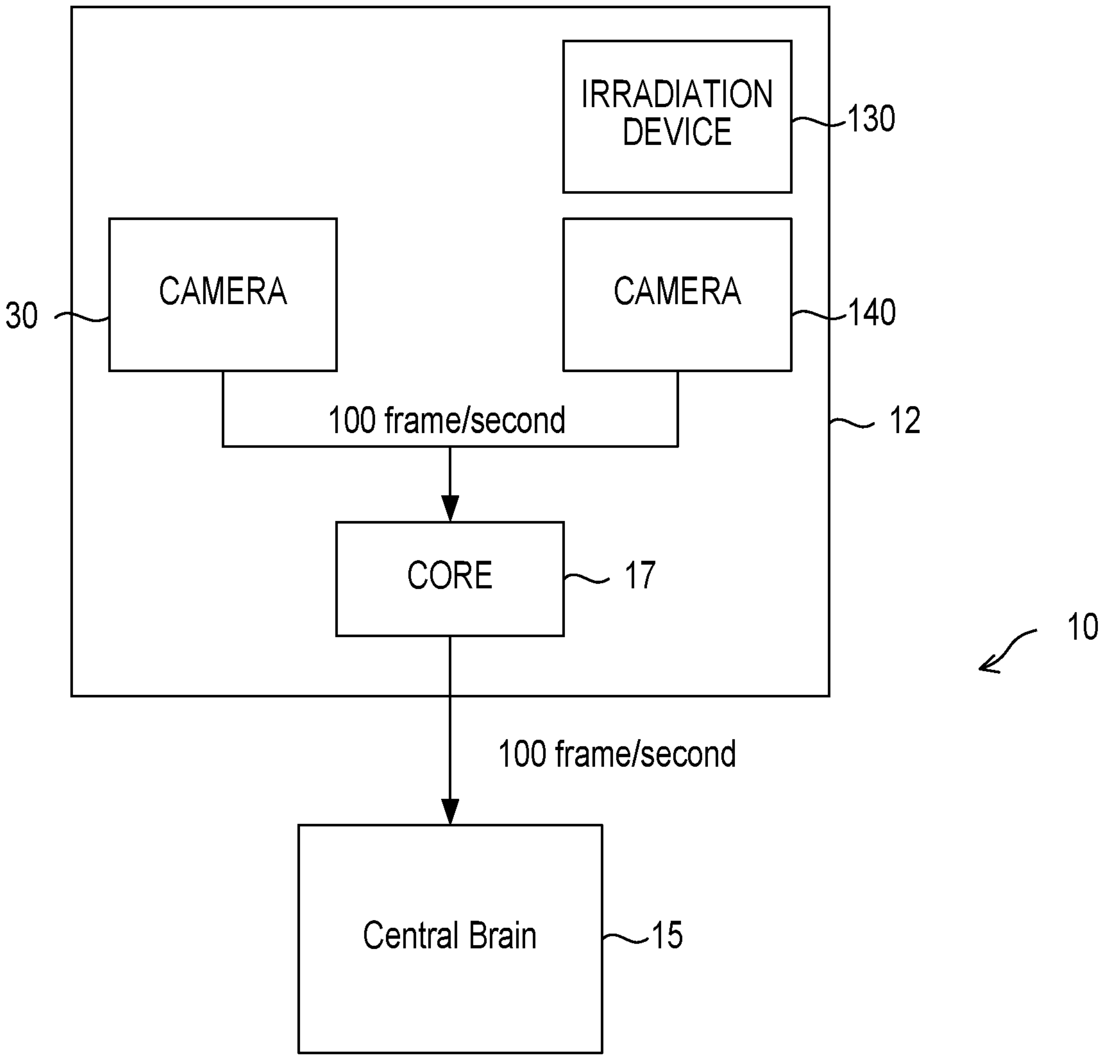
IRRADIATION DEVICE
130
CAMERA
30
CAMERA
140
100 frame/second
12
CORE
17
10
100 frame/second
Central Brain
15

FIG.11

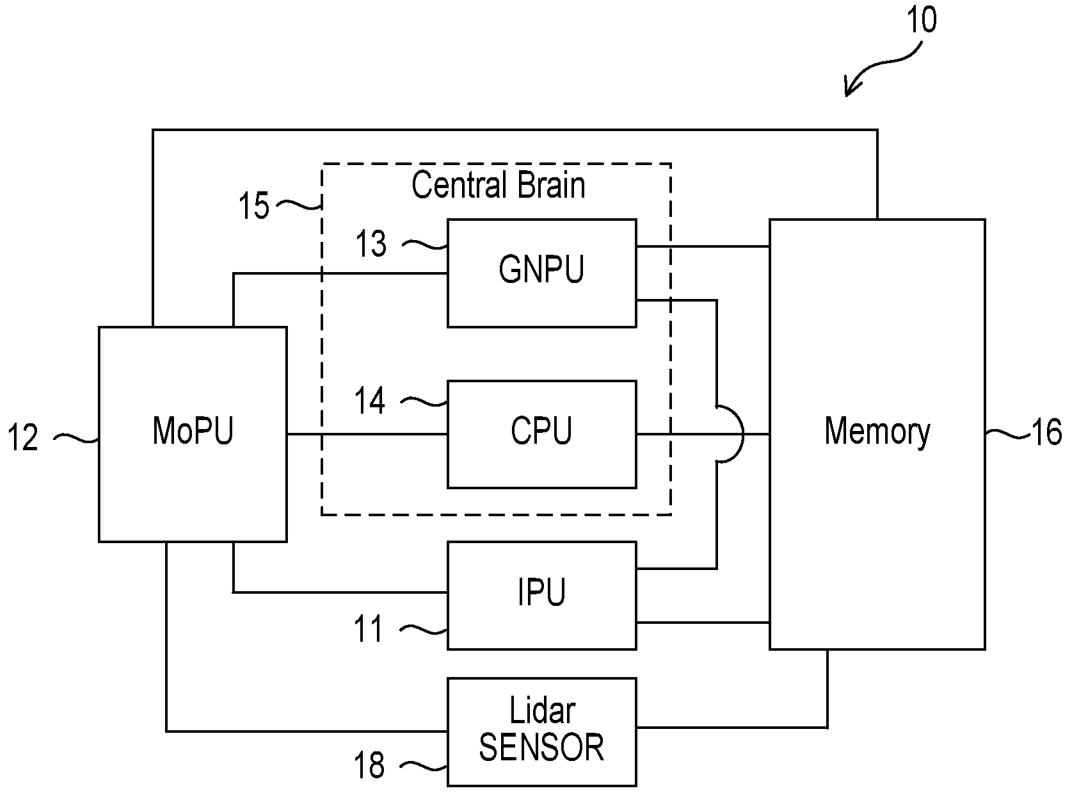
10
Central Brain
15
13
GNPU
12
MoPU
14
CPU
Memory
16
IPU
11
Lidar
SENSOR
18

FIG.12A

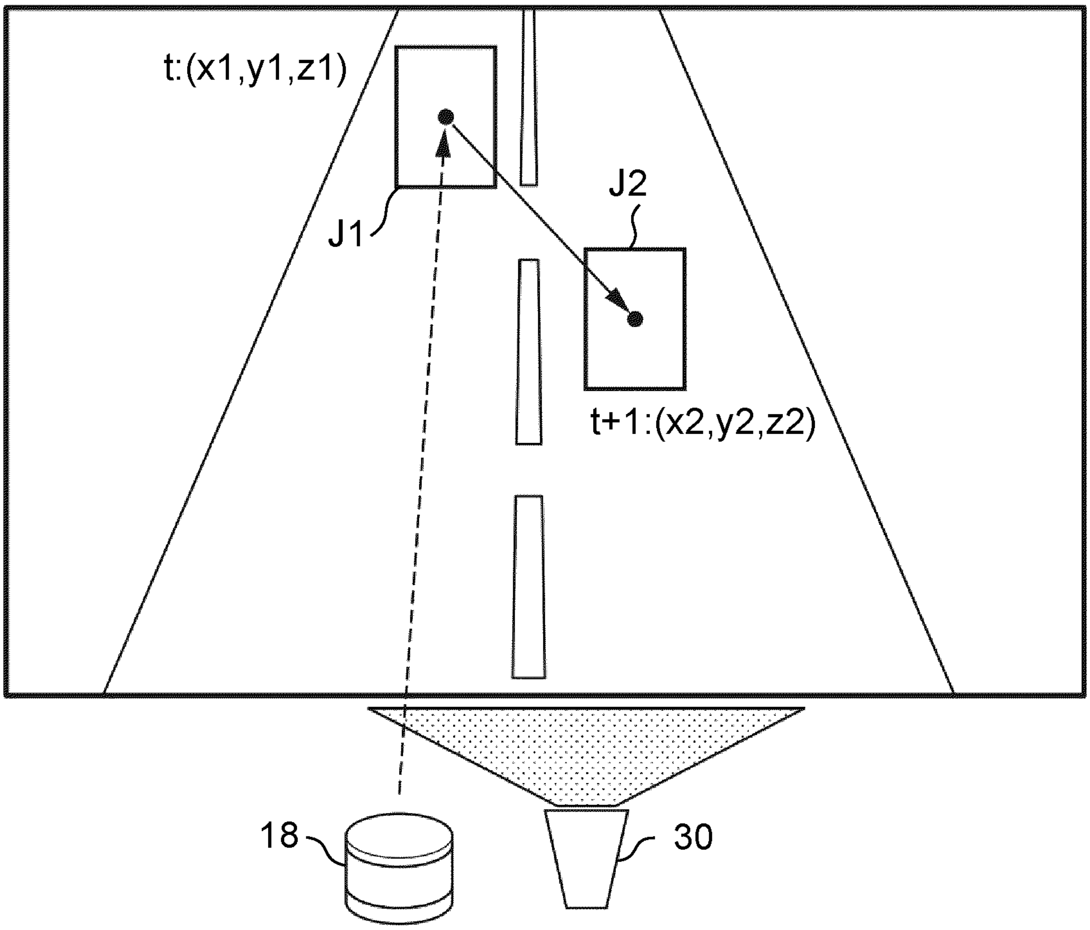

FIG.12B

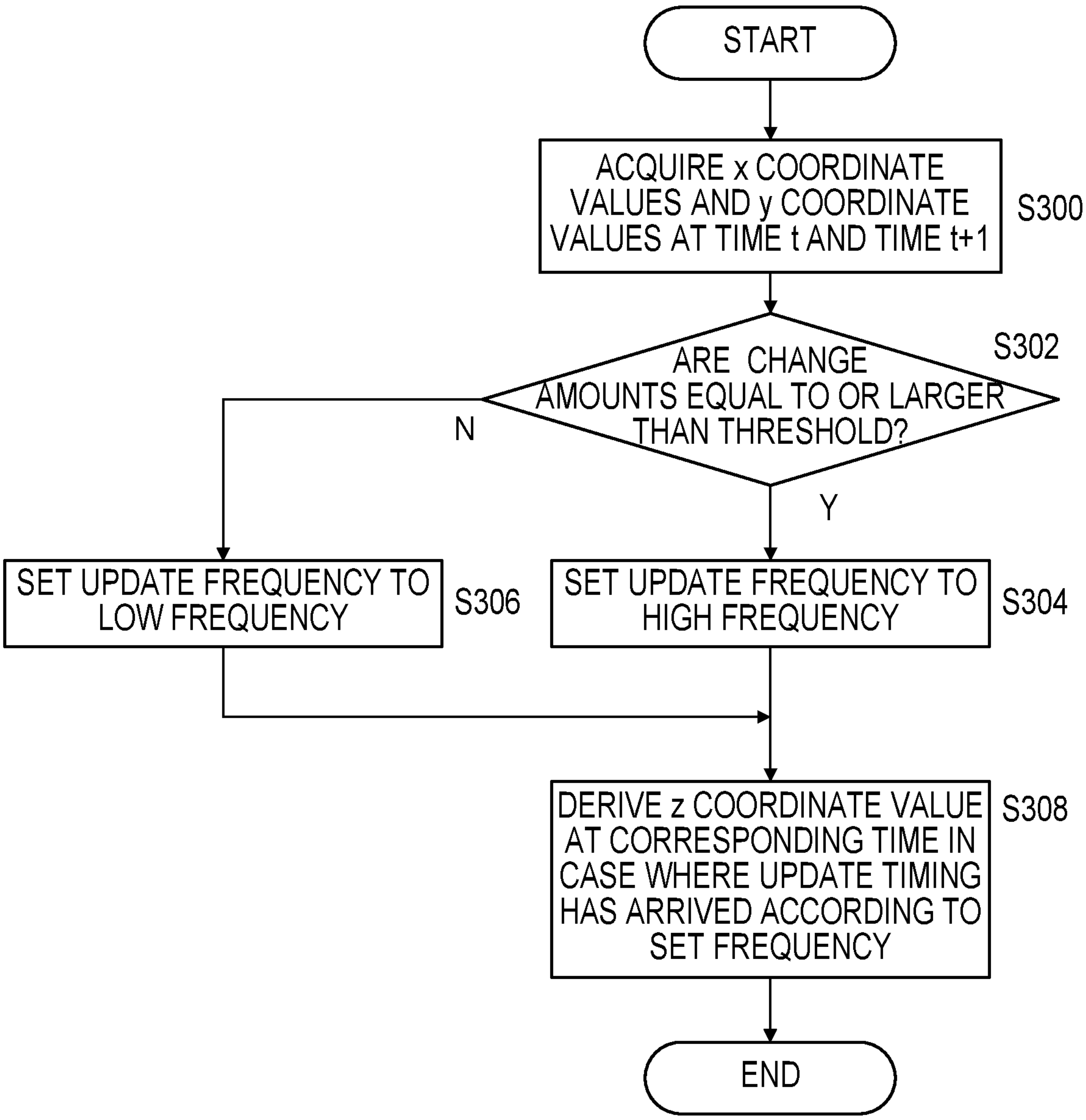
START
ACQUIRE x COORDINATE VALUES AND y COORDINATE VALUES AT TIME t AND TIME t+1
S300
ARE CHANGE AMOUNTS EQUAL TO OR LARGER THAN THRESHOLD?
S302
N
Y
SET UPDATE FREQUENCY TO LOW FREQUENCY
S306
SET UPDATE FREQUENCY TO HIGH FREQUENCY
S304
DERIVE z COORDINATE VALUE AT CORRESPONDING TIME IN CASE WHERE UPDATE TIMING HAS ARRIVED ACCORDING TO SET FREQUENCY
S308
END

FIG.12C

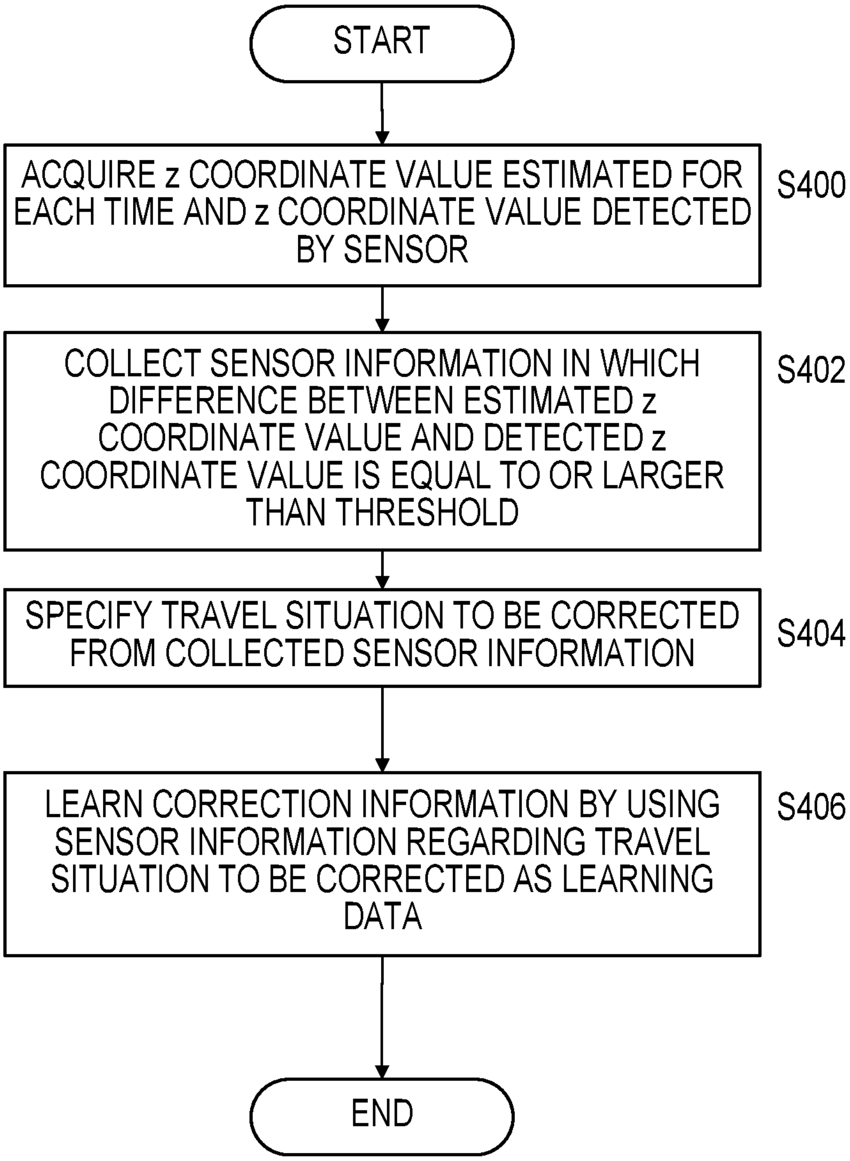
START
ACQUIRE z COORDINATE VALUE ESTIMATED FOR EACH TIME AND z COORDINATE VALUE DETECTED BY SENSOR
S400
COLLECT SENSOR INFORMATION IN WHICH DIFFERENCE BETWEEN ESTIMATED z COORDINATE VALUE AND DETECTED z COORDINATE VALUE IS EQUAL TO OR LARGER THAN THRESHOLD
S402
SPECIFY TRAVEL SITUATION TO BE CORRECTED FROM COLLECTED SENSOR INFORMATION
S404
LEARN CORRECTION INFORMATION BY USING SENSOR INFORMATION REGARDING TRAVEL SITUATION TO BE CORRECTED AS LEARNING DATA
S406
END

FIG.13

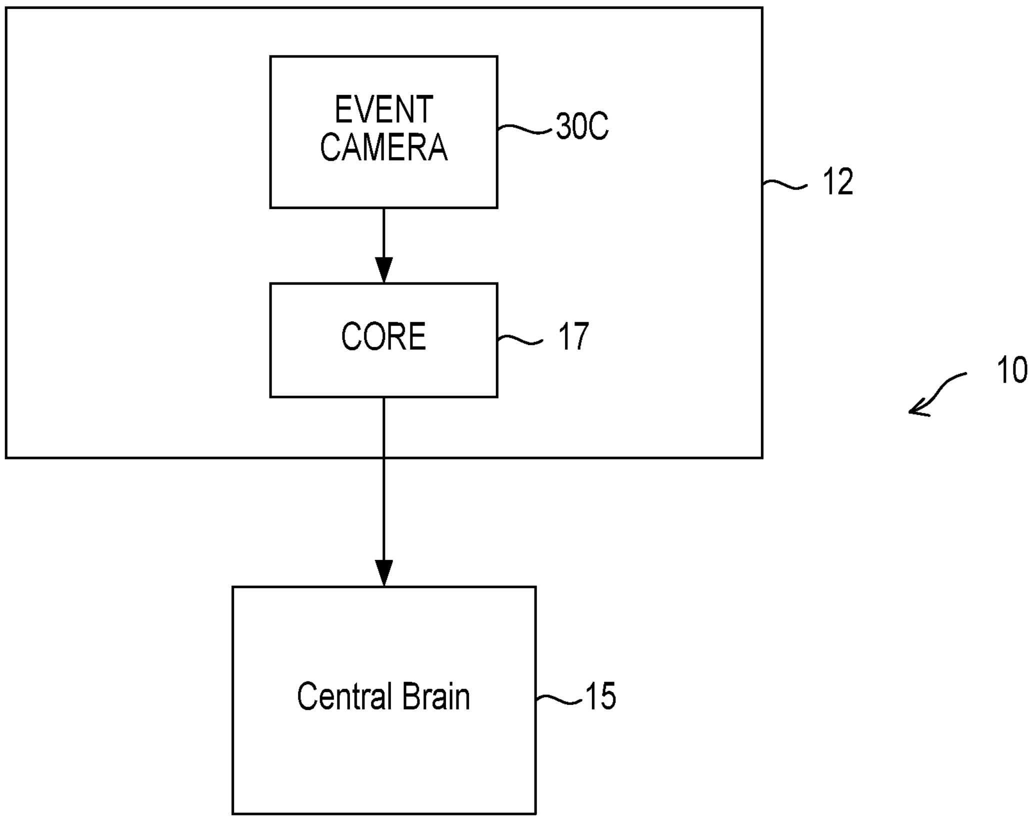

FIG.14A

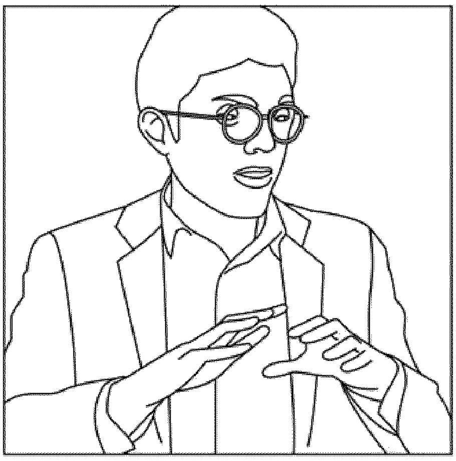

FIG.14B

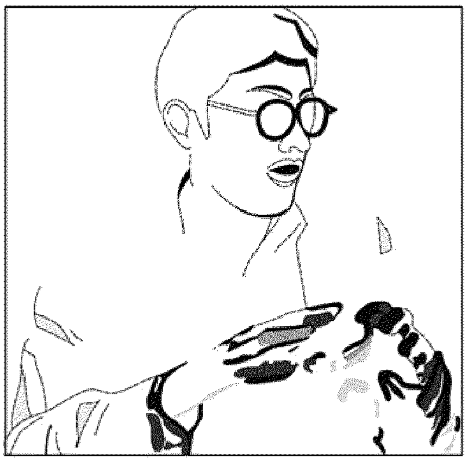

FIG.14C

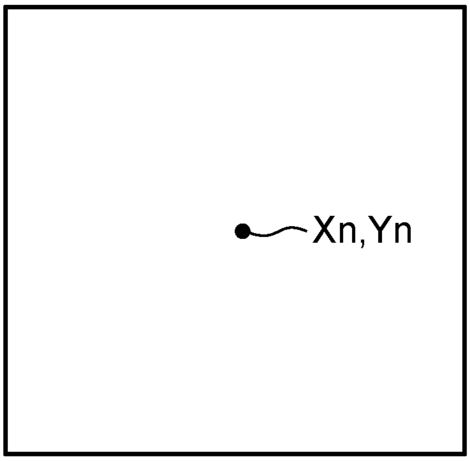

FIG.15

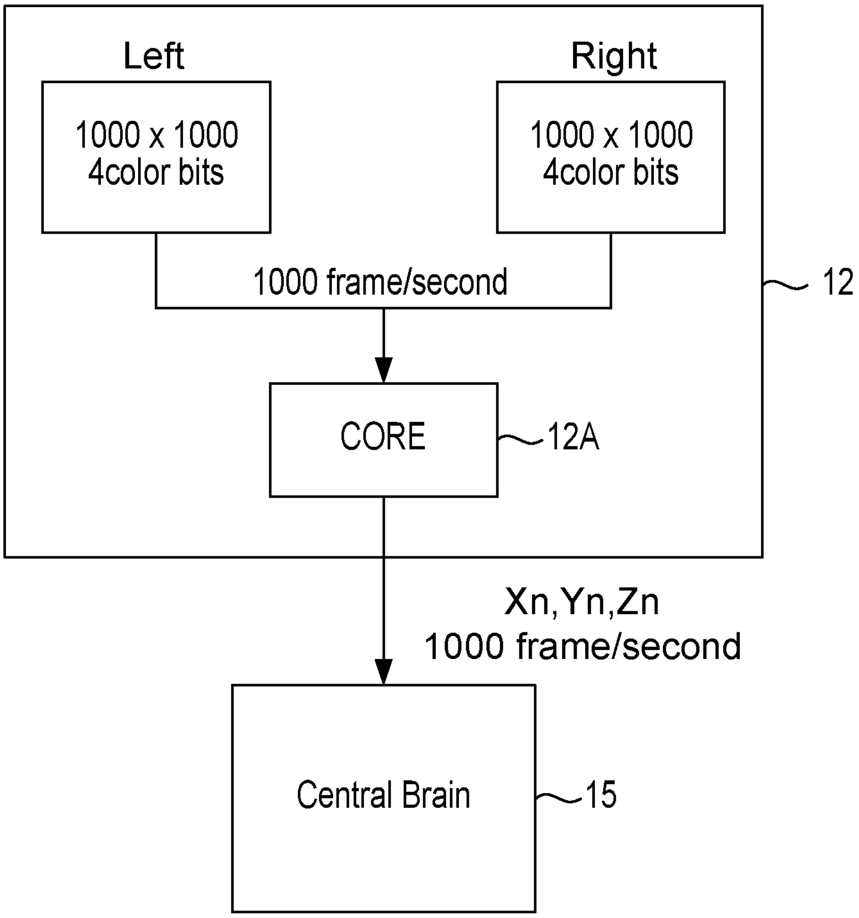
Left
1000 x 1000
4color bits
Right
1000 x 1000
4color bits
1000 frame/second
12
CORE
12A
Xn,Yn,Zn
1000 frame/second
Central Brain
15

FIG.16

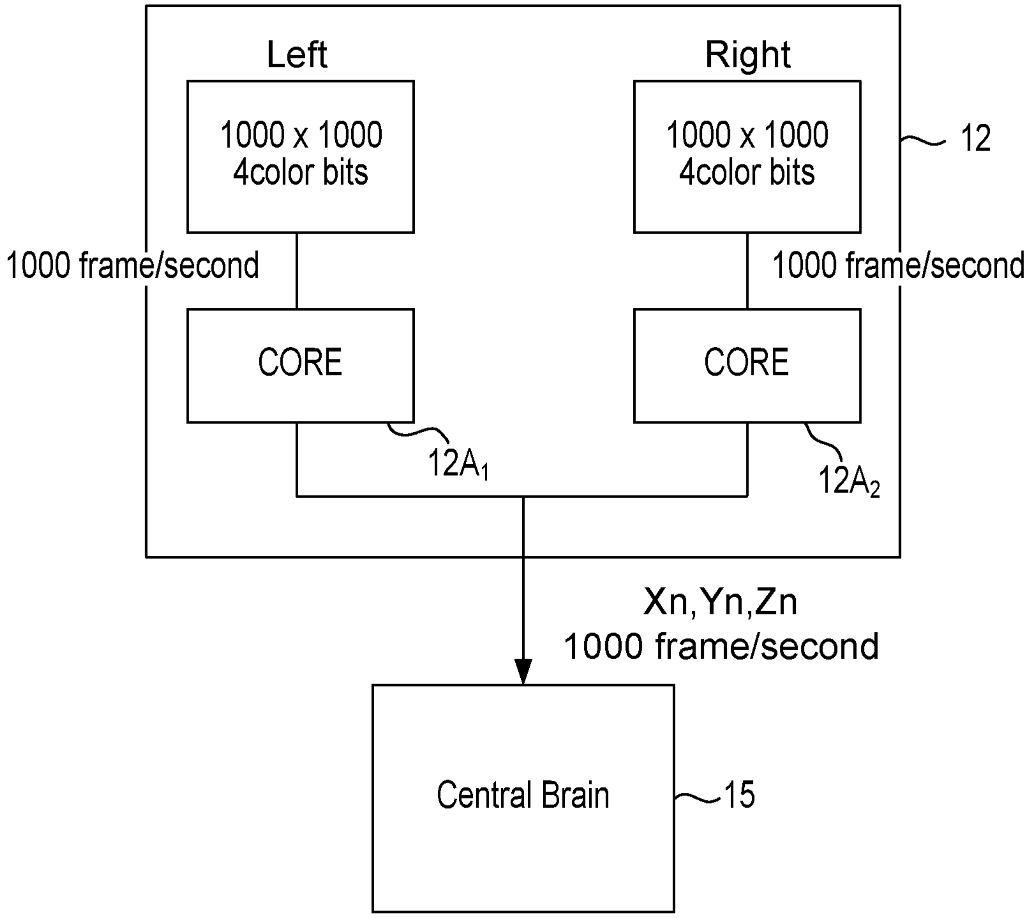
Left
Right
1000 x 1000
4color bits
1000 x 1000
4color bits
12
1000 frame/second
1000 frame/second
CORE
CORE
12A1
12A2
Xn,Yn,Zn
1000 frame/second
Central Brain
15

FIG.17

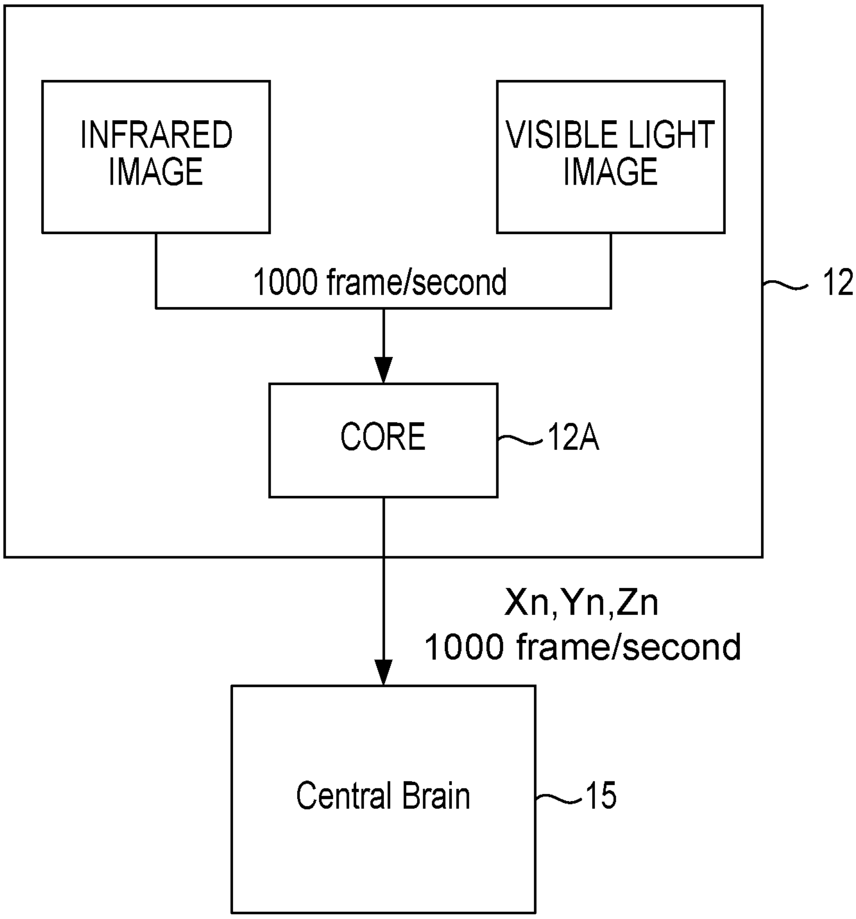
INFRARED IMAGE
VISIBLE LIGHT IMAGE
1000 frame/second
12
CORE
12A
Xn,Yn,Zn
1000 frame/second
Central Brain
15

FIG.18

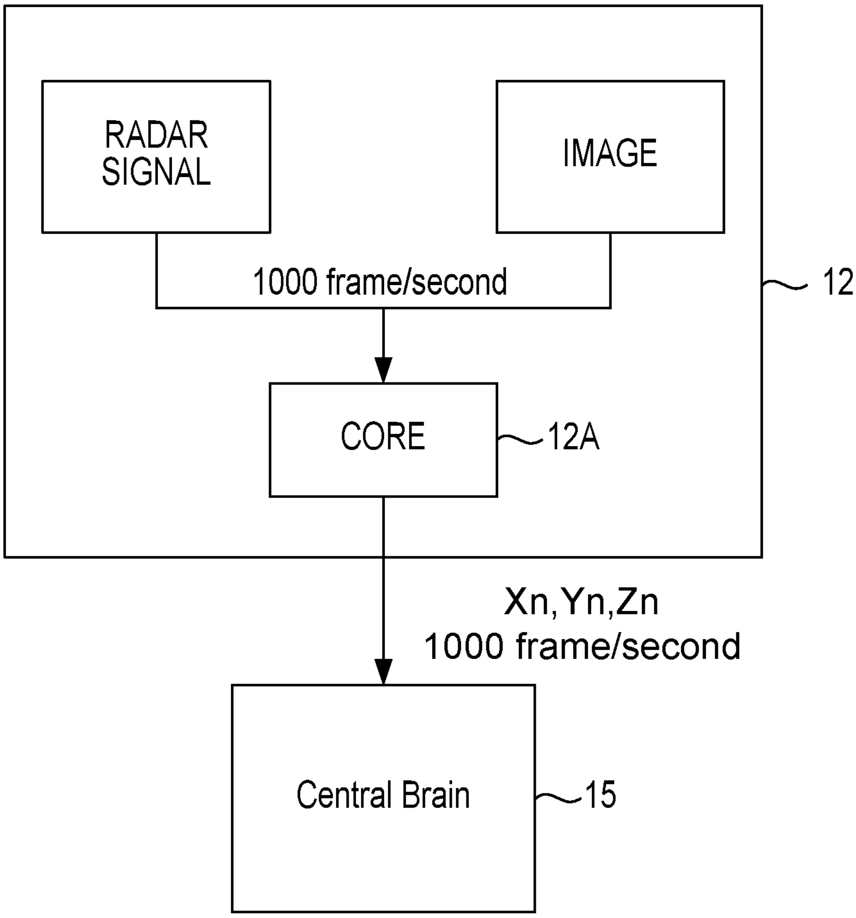
RADAR SIGNAL
IMAGE
1000 frame/second
12
CORE
12A
Xn,Yn,Zn
1000 frame/second
Central Brain
15

FIG.19

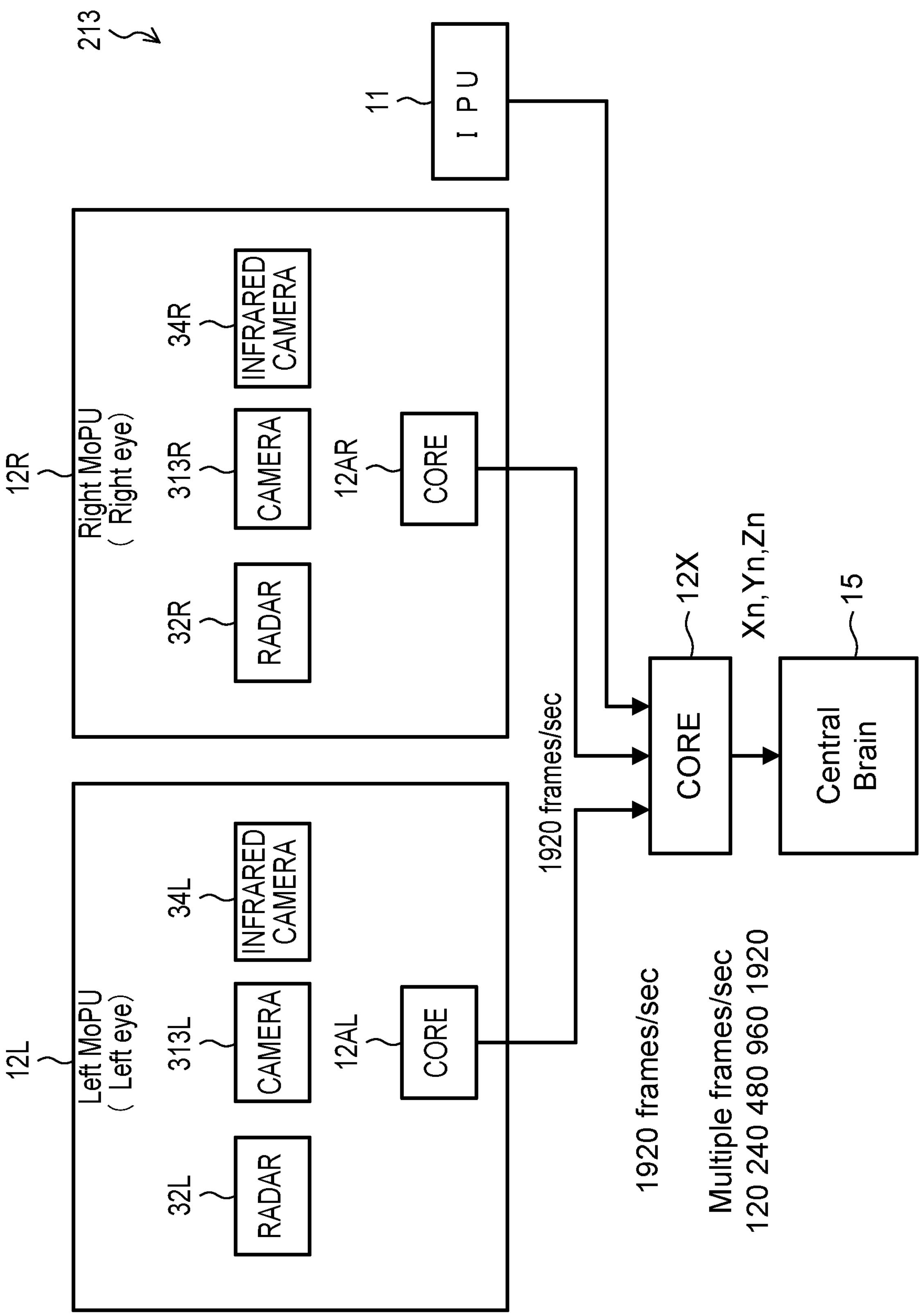
213
11
I P U
12R
Right MoPU
( Right eye)
32R
RADAR
313R
CAMERA
34R
INFRARED CAMERA
12AR
CORE
12L
Left MoPU
( Left eye)
32L
RADAR
313L
CAMERA
34L
INFRARED CAMERA
12AL
CORE
1920 frames/sec
12X
CORE
Xn,Yn,Zn
15
Central Brain
1920 frames/sec
Multiple frames/sec
120 240 480 960 1920

FIG.20

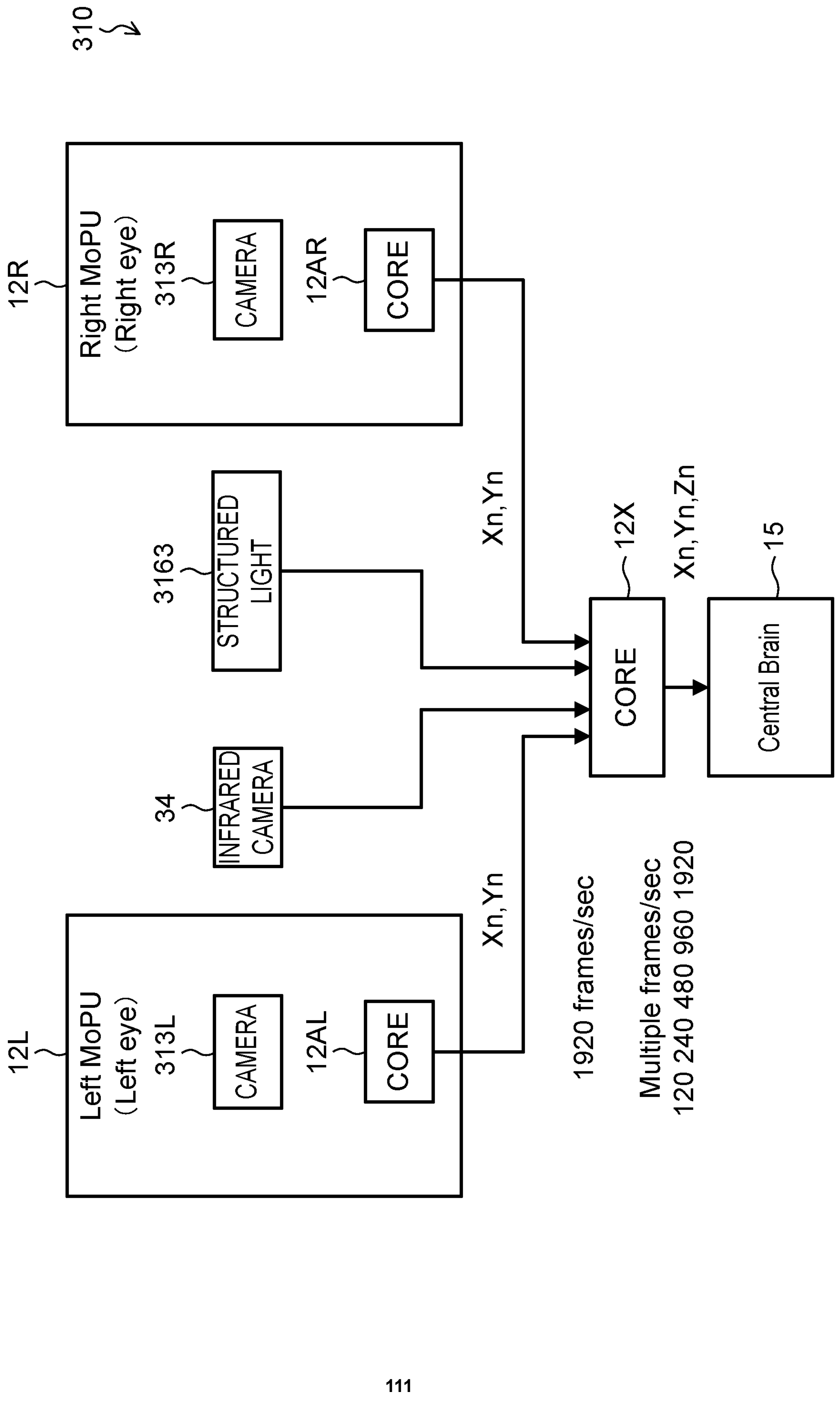
310
12R
Right MoPU
(Right eye)
313R
CAMERA
12AR
CORE
3163
STRUCTURED LIGHT
34
INFRARED CAMERA
12L
Left MoPU
(Left eye)
313L
CAMERA
12AL
CORE
Xn,Yn
Xn,Yn
12X
CORE
Xn,Yn,Zn
15
Central Brain
1920 frames/sec
Multiple frames/sec
120 240 480 960 1920

FIG.21A

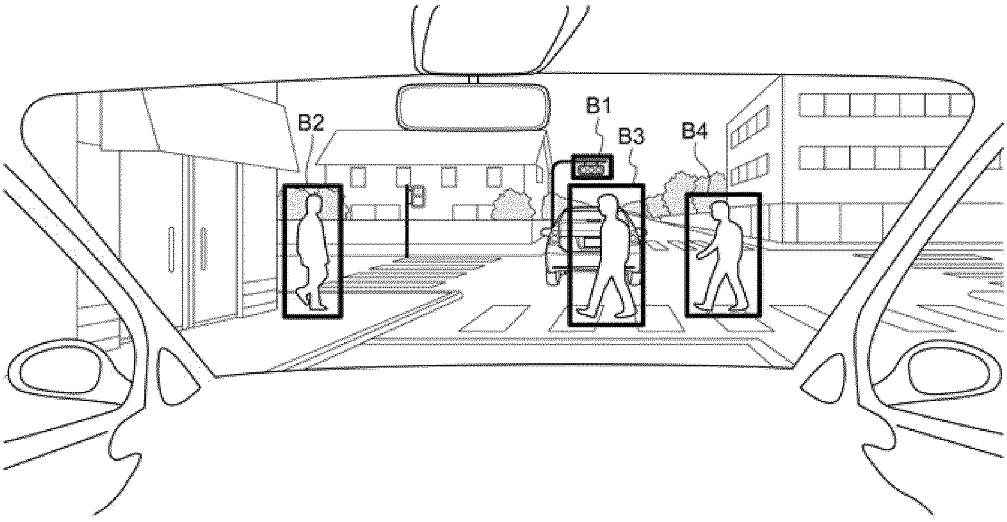


FIG.21B

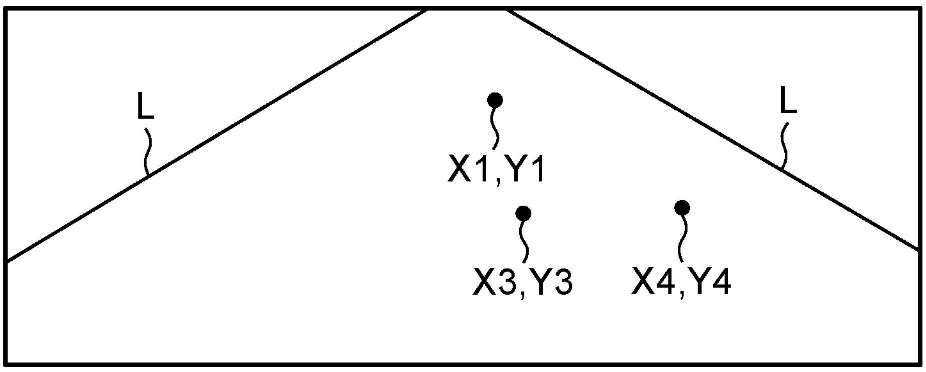

FIG.22

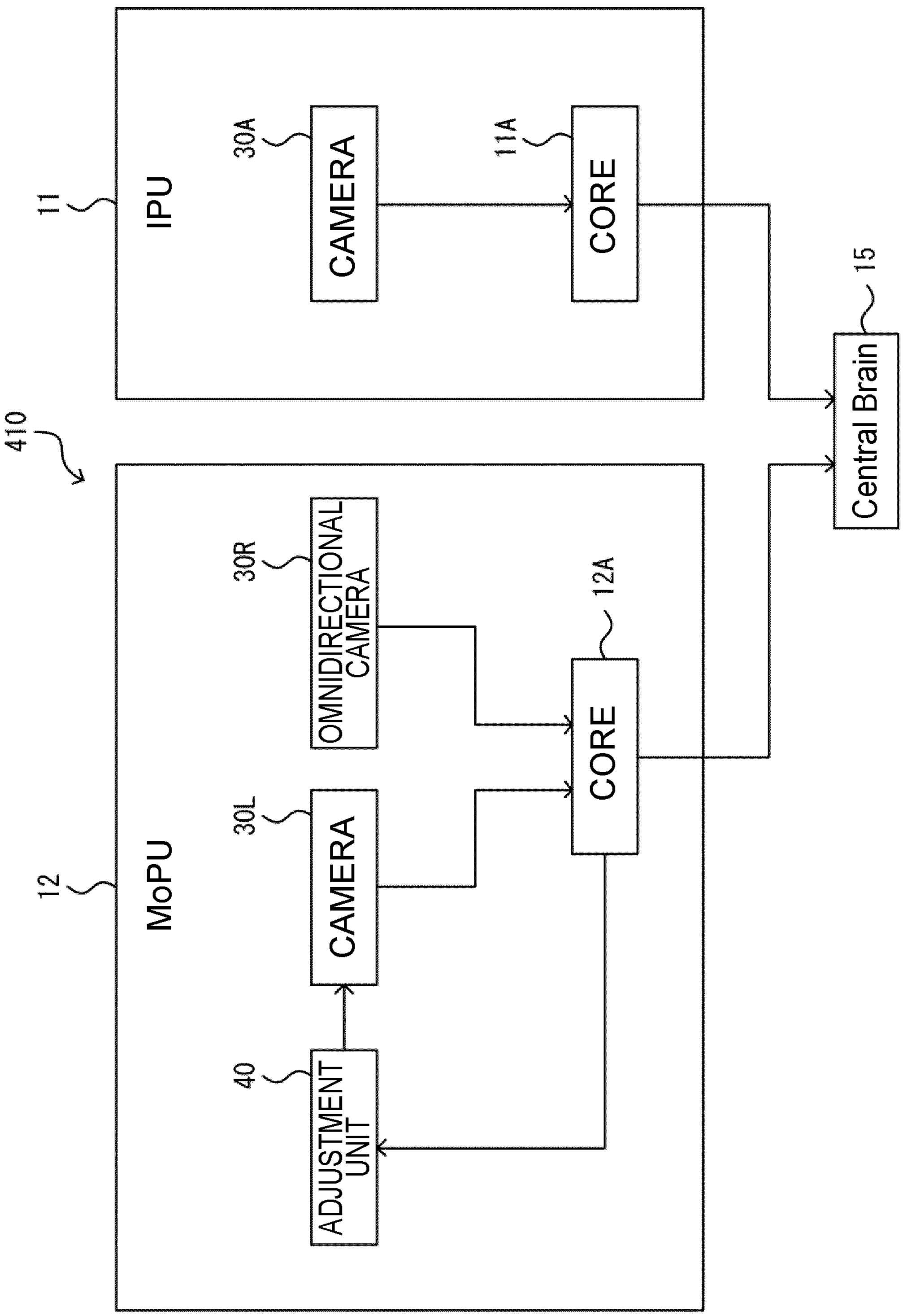

11
IPU
30A
CAMERA
11A
CORE
15
Central Brain
410
12
MoPU
30R
OMNIDIRECTIONAL CAMERA
12A
CORE
30L
CAMERA
40
ADJUSTMENT UNIT

FIG.23

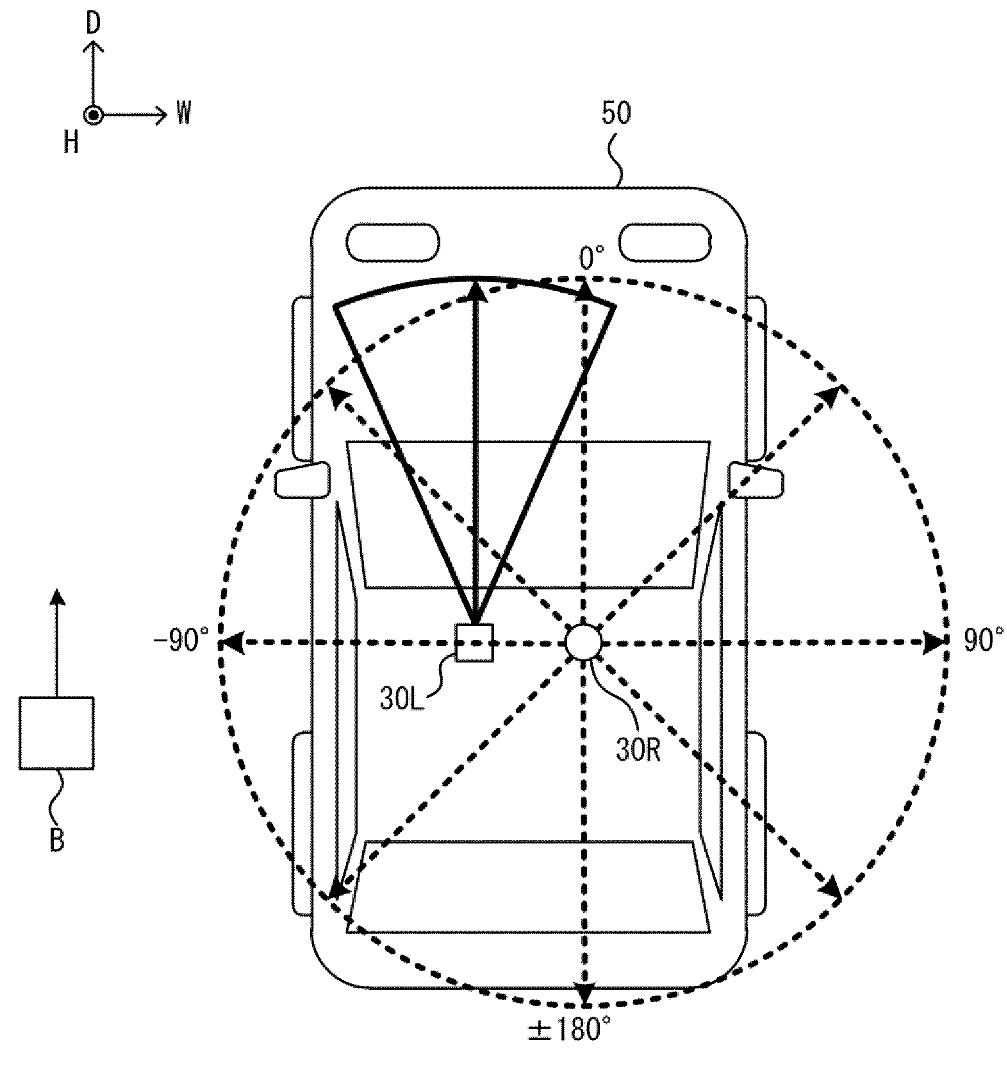

FIG.24

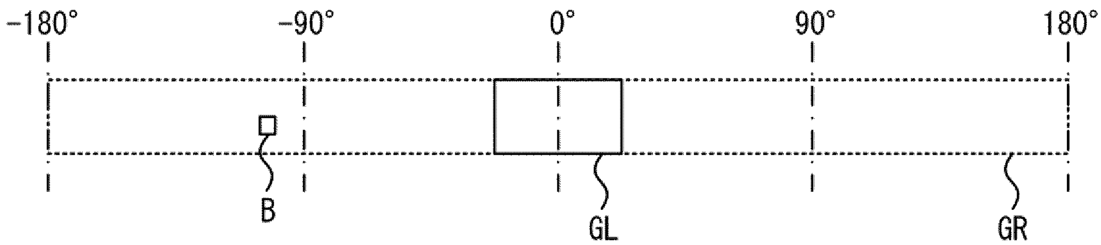

FIG.25

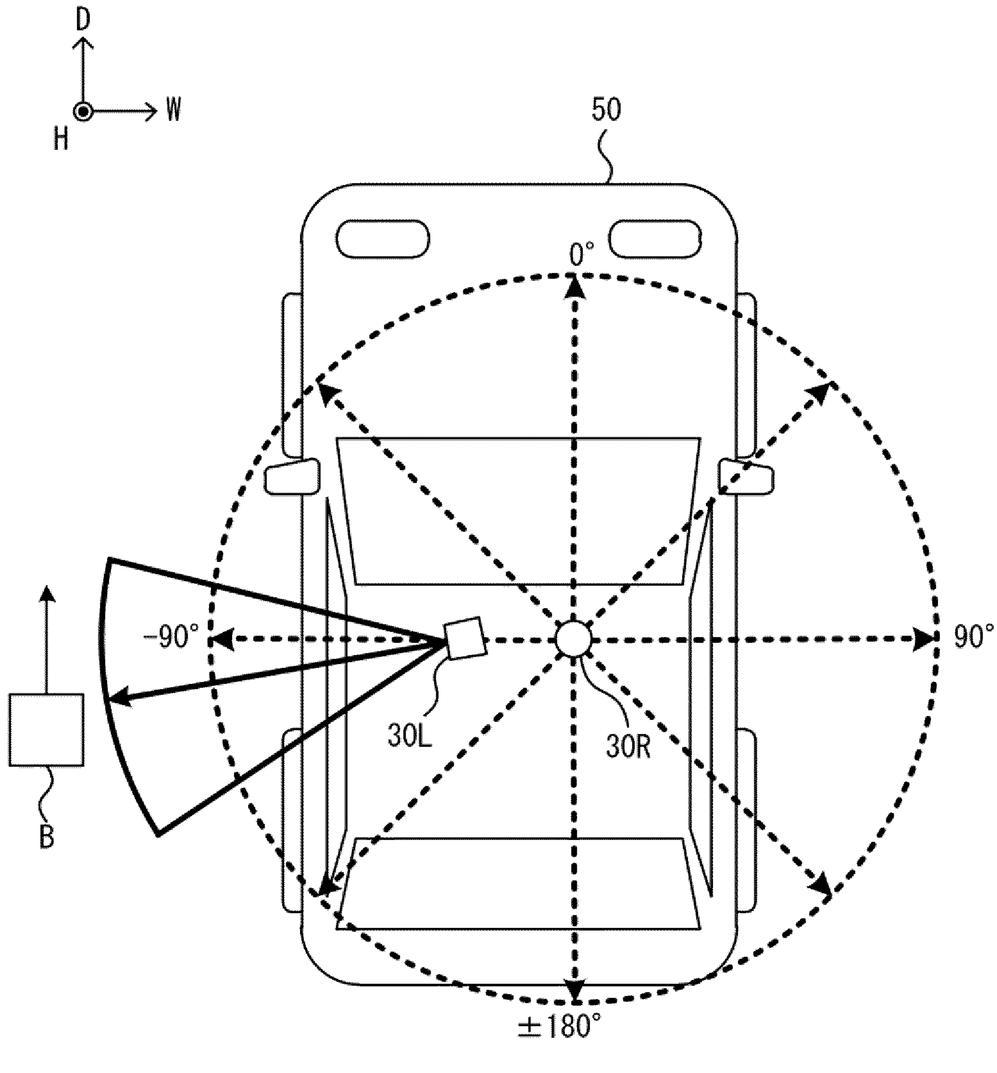

FIG.26

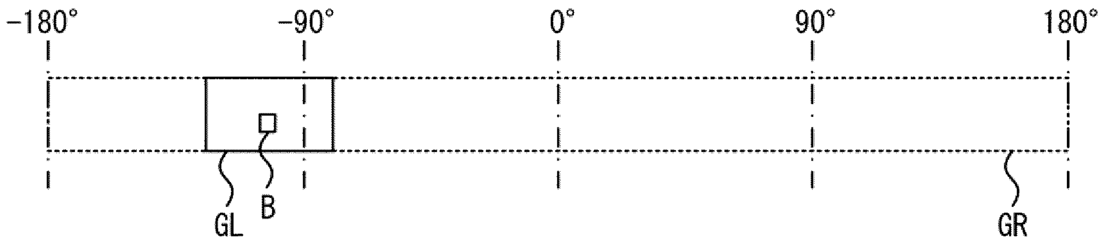

FIG.27

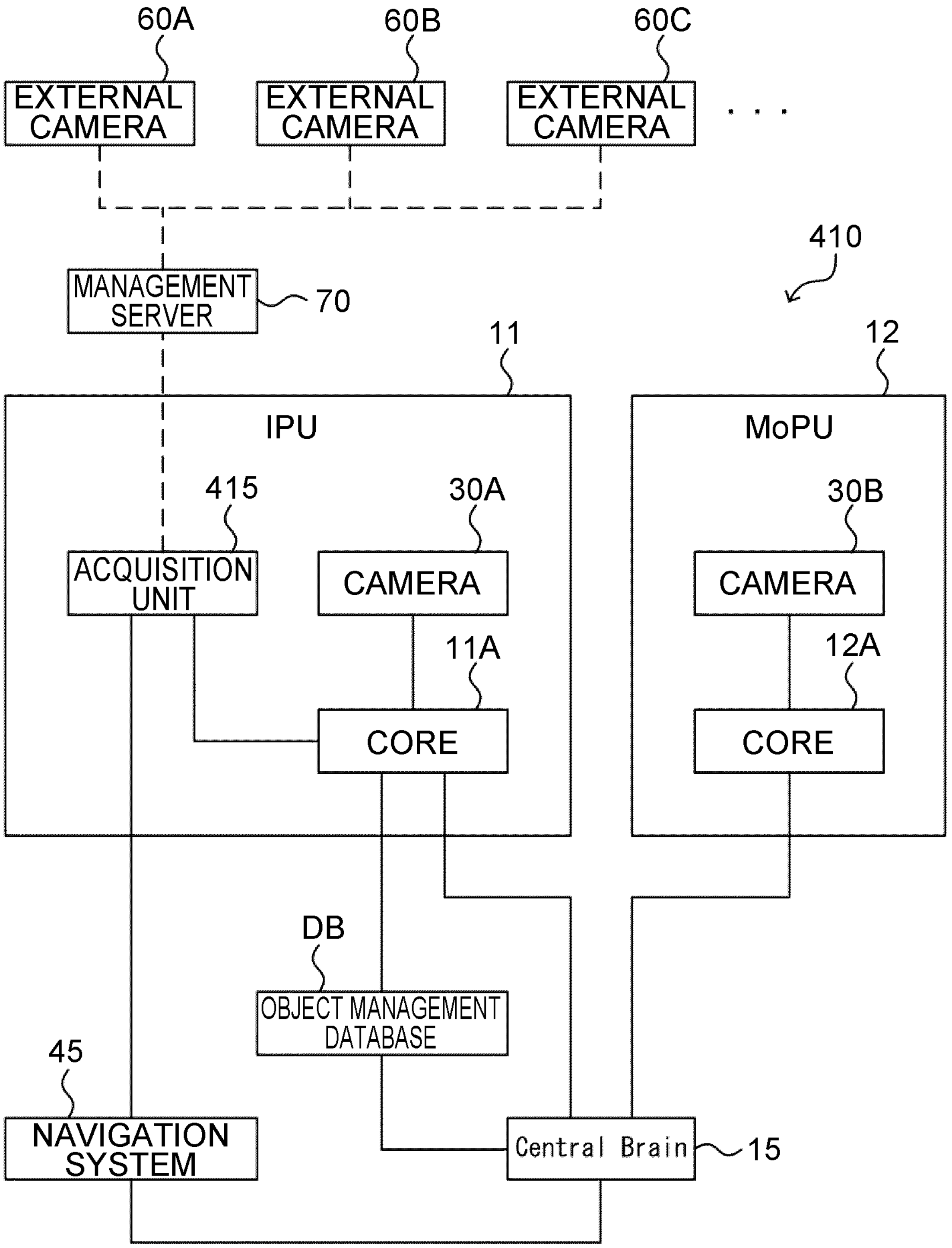
60A
60B
60C
EXTERNAL CAMERA
EXTERNAL CAMERA
EXTERNAL CAMERA
410
MANAGEMENT SERVER
70
11
12
IPU
MoPU
415
30A
30B
ACQUISITION UNIT
CAMERA
CAMERA
11A
12A
CORE
CORE
DB
OBJECT MANAGEMENT DATABASE
45
NAVIGATION SYSTEM
Central Brain
15

FIG.28

CAMARA MANAGEMENT DATABASE

| CAMERA ID | ADDRESS | INSTALLATION POSITION |
|---|---|---|
| C1 | 192. 0. xxx. xxx | N・・・, E・・・ |
| C2 | 192. 0. xxx. xxx | N・・・, E・・・ |
| C3 | 192. 0. xxx. xxx | N・・・, E・・・ |
| C4 | 192. 0. xxx. xxx | N・・・, E・・・ |
| C5 | 192. 0. xxx. xxx | N・・・, E・・・ |
| C6 | 192. 0. xxx. xxx | N・・・, E・・・ |
| C7 | 192. 0. xxx. xxx | N・・・, E・・・ |
| C8 | 192. 0. xxx. xxx | N・・・, E・・・ |
| C9 | 192. 0. xxx. xxx | N・・・, E・・・ |
| ⋮ | ⋮ | ⋮ |

FIG.29

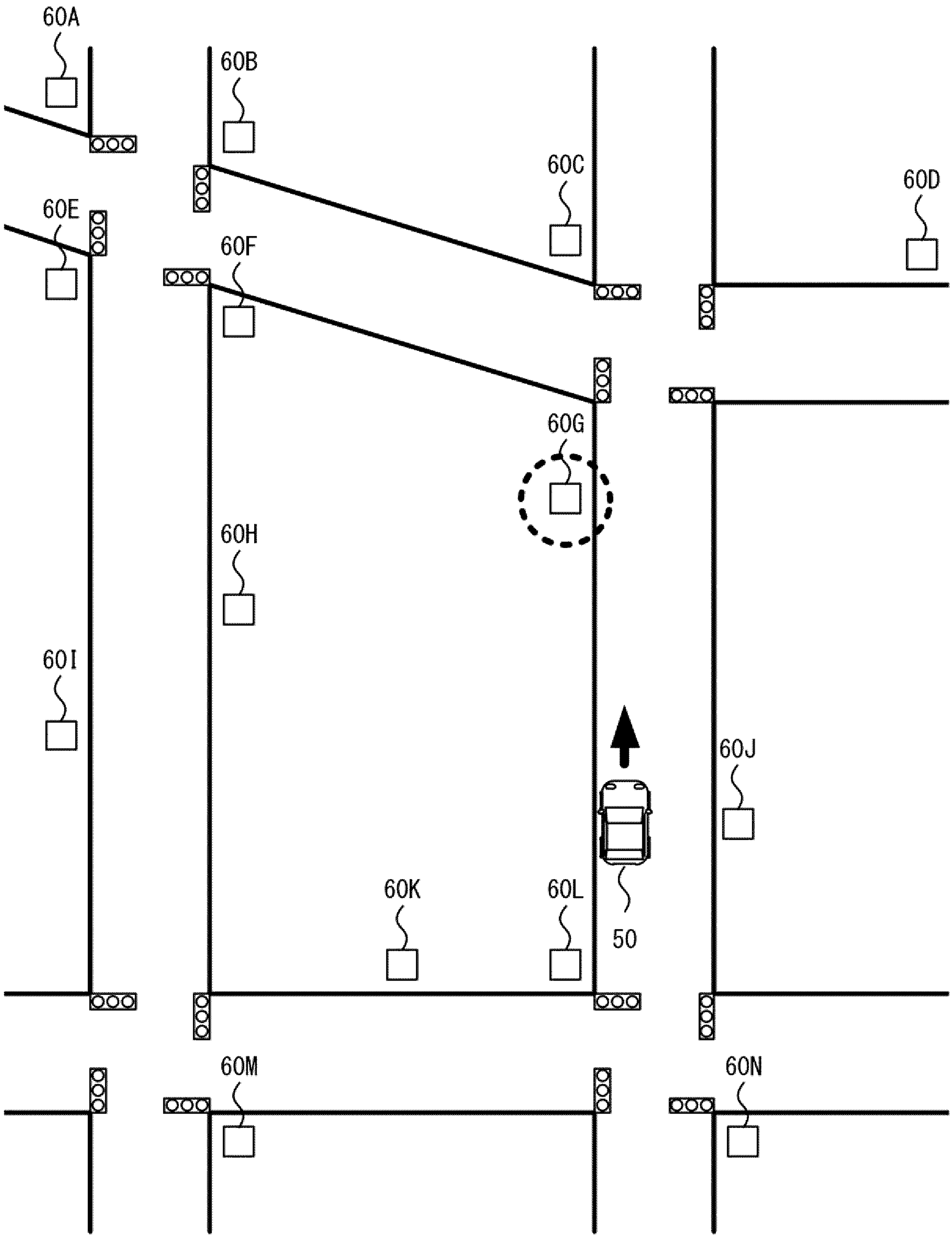

FIG.30

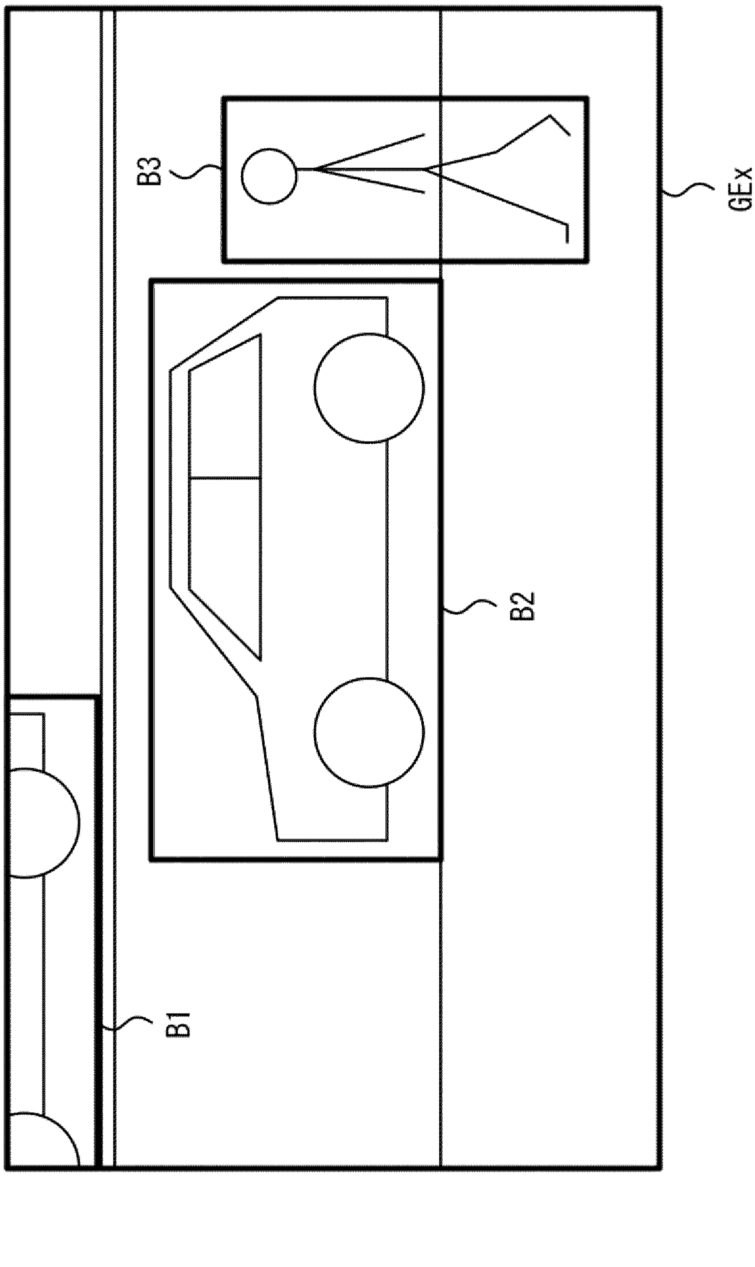

FIG.31

OBJECT MANAGEMENT DATABASE

| OBJECT ID | REGISTRATION DATE AND TIME | OBJECT POSITION | OBJECT TYPE | CAUTION FLAG |
|---|---|---|---|---|
| Ob1 | 2023/xx/xx xx:xx | N・・・, E・・・ | CAR | |
| Ob2 | 2023/xx/xx xx:xx | N・・・, E・・・ | CAR | |
| Ob3 | 2023/xx/xx xx:xx | N・・・, E・・・ | PERSON | ○ |
| Ob4 | 2023/xx/xx xx:xx | N・・・, E・・・ | CAR | |
| Ob5 | 2023/xx/xx xx:xx | N・・・, E・・・ | ANIMAL | ○ |
| Ob6 | 2023/xx/xx xx:xx | N・・・, E・・・ | SIGNAL | |
| Ob7 | 2023/xx/xx xx:xx | N・・・, E・・・ | CAR | |
| Ob8 | 2023/xx/xx xx:xx | N・・・, E・・・ | CAR | |
| Ob9 | 2023/xx/xx xx:xx | N・・・, E・・・ | PERSON | ○ |
| ⋮ | ⋮ | ⋮ | ⋮ | ⋮ |

FIG.32

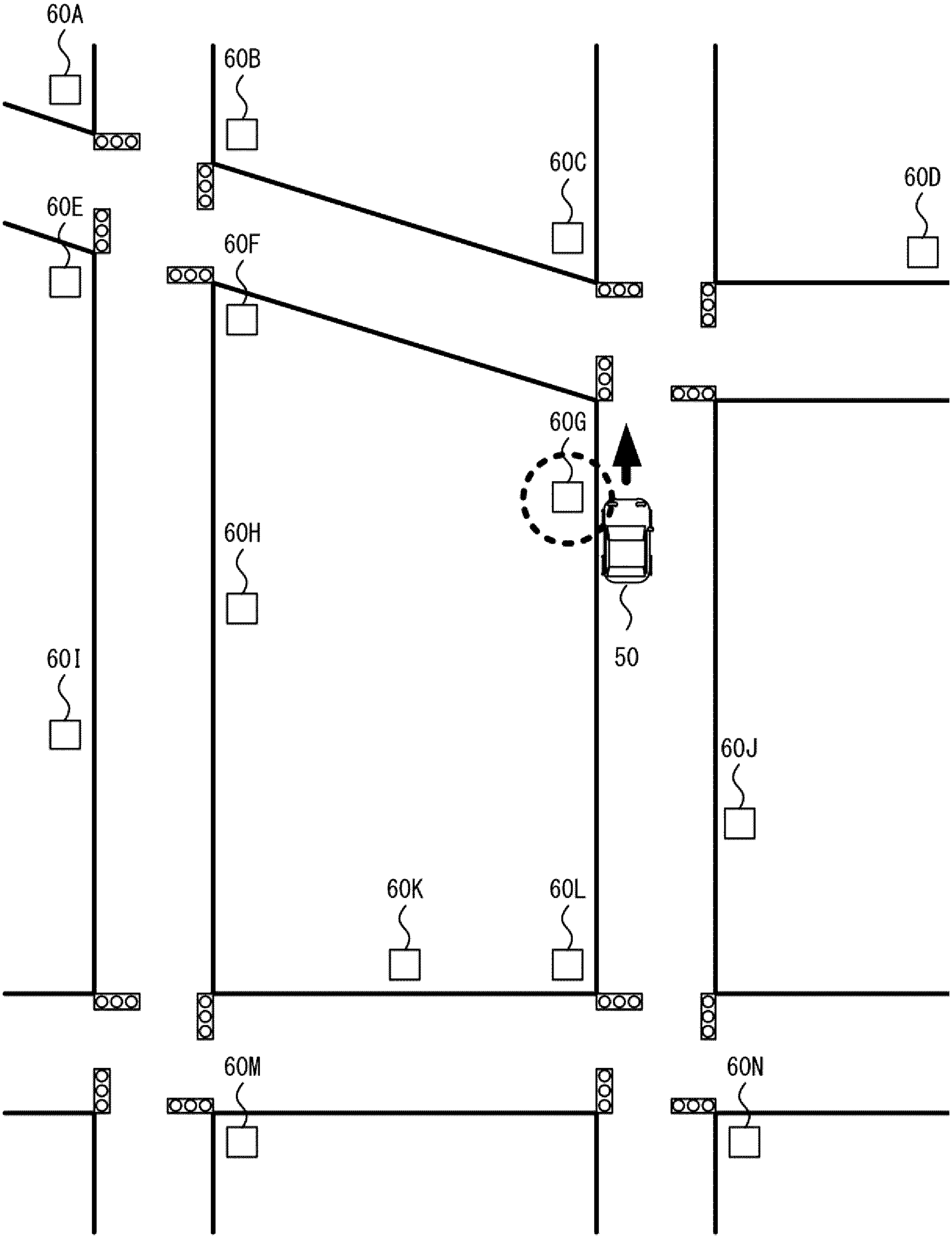

FIG.33

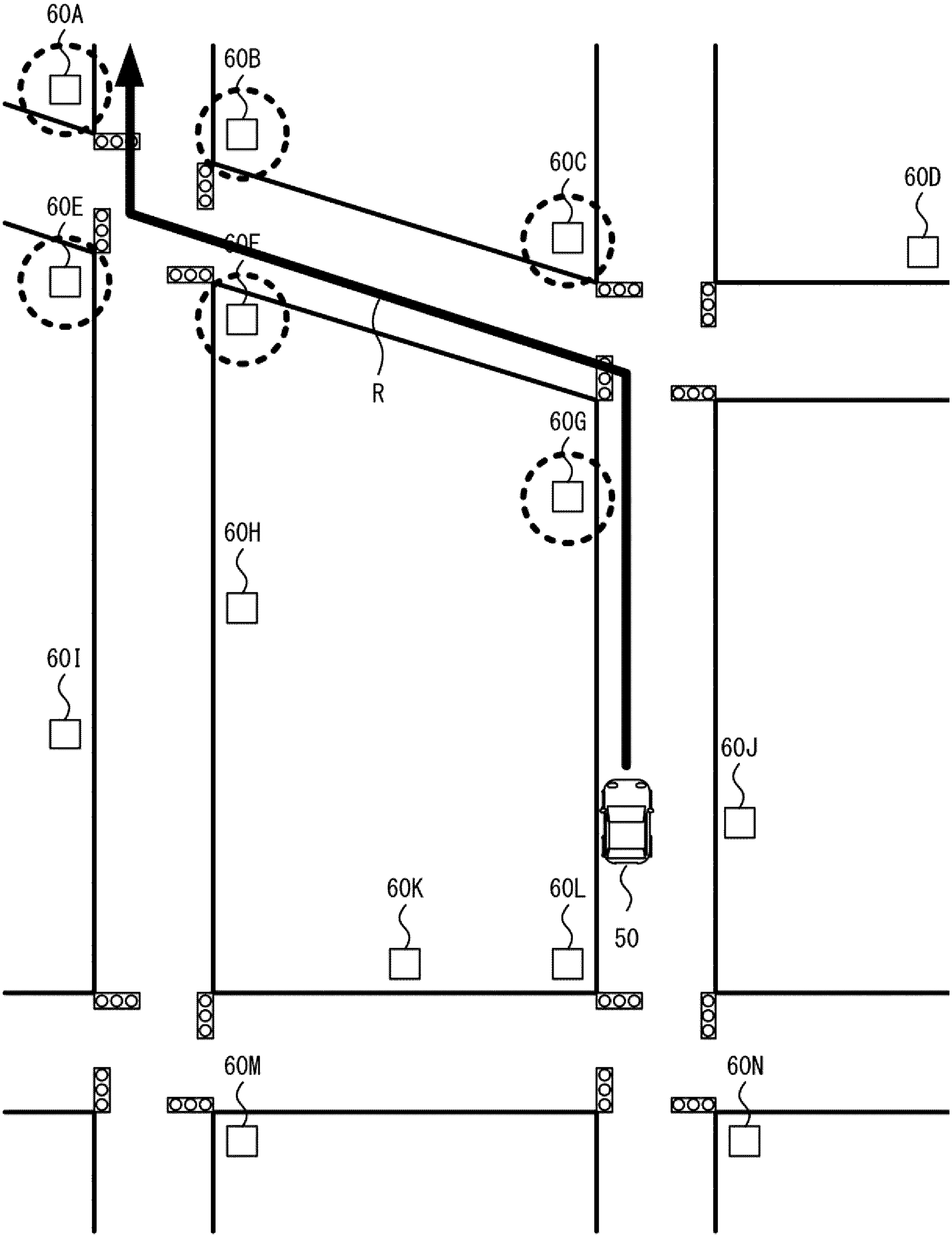

FIG.34

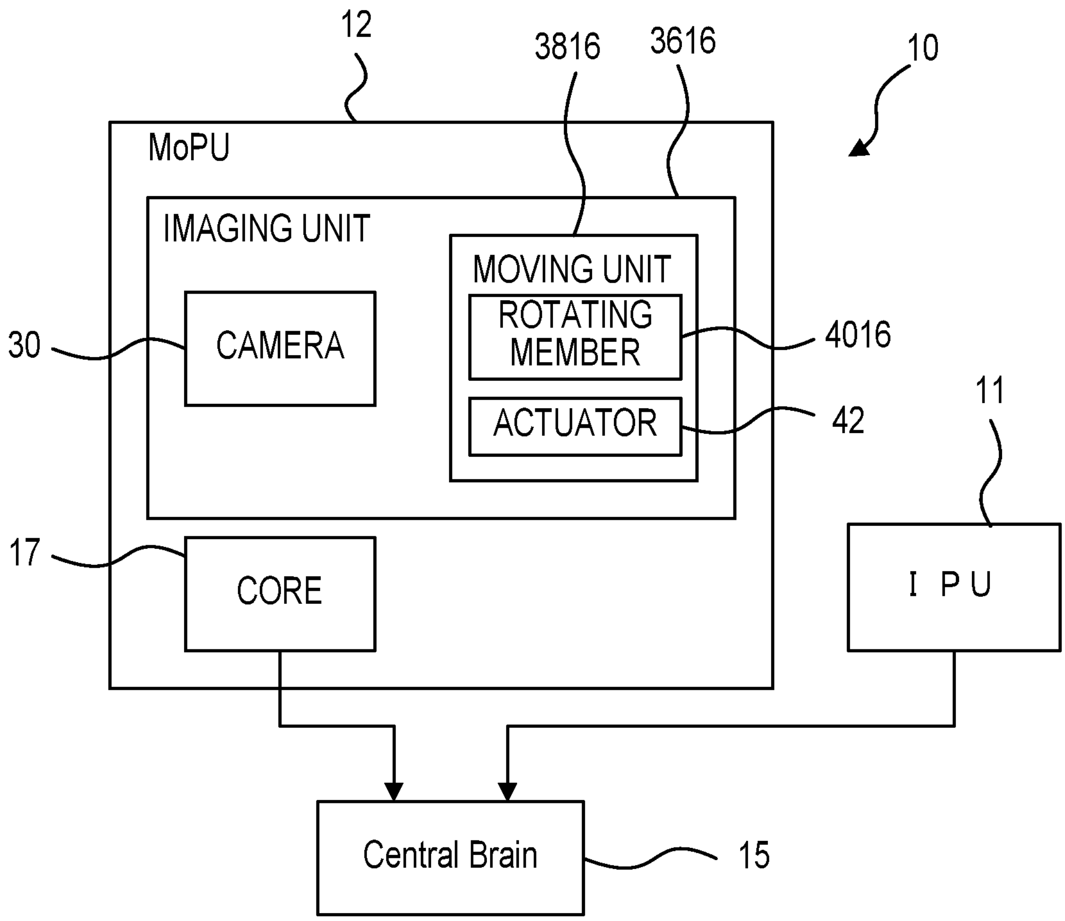
12
3816
3616
10
MoPU
IMAGING UNIT
MOVING UNIT
ROTATING MEMBER
CAMERA
30
4016
ACTUATOR
42
11
17
CORE
I PU
Central Brain
15

FIG.35

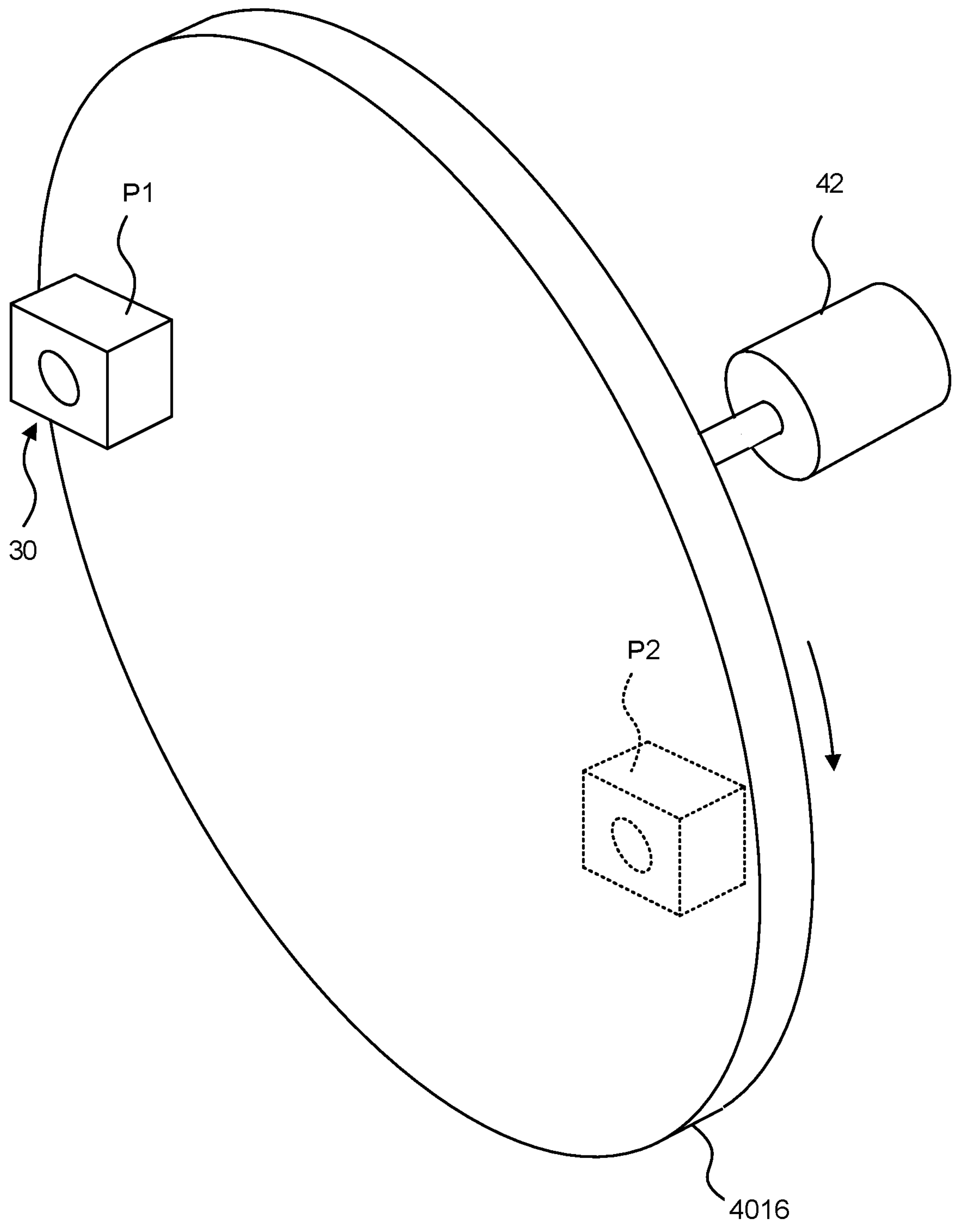

FIG.36A

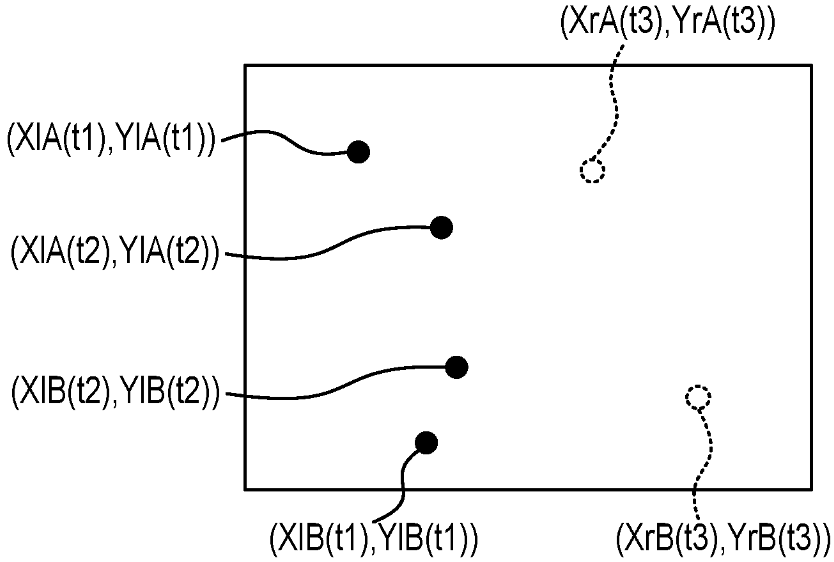


FIG.36B

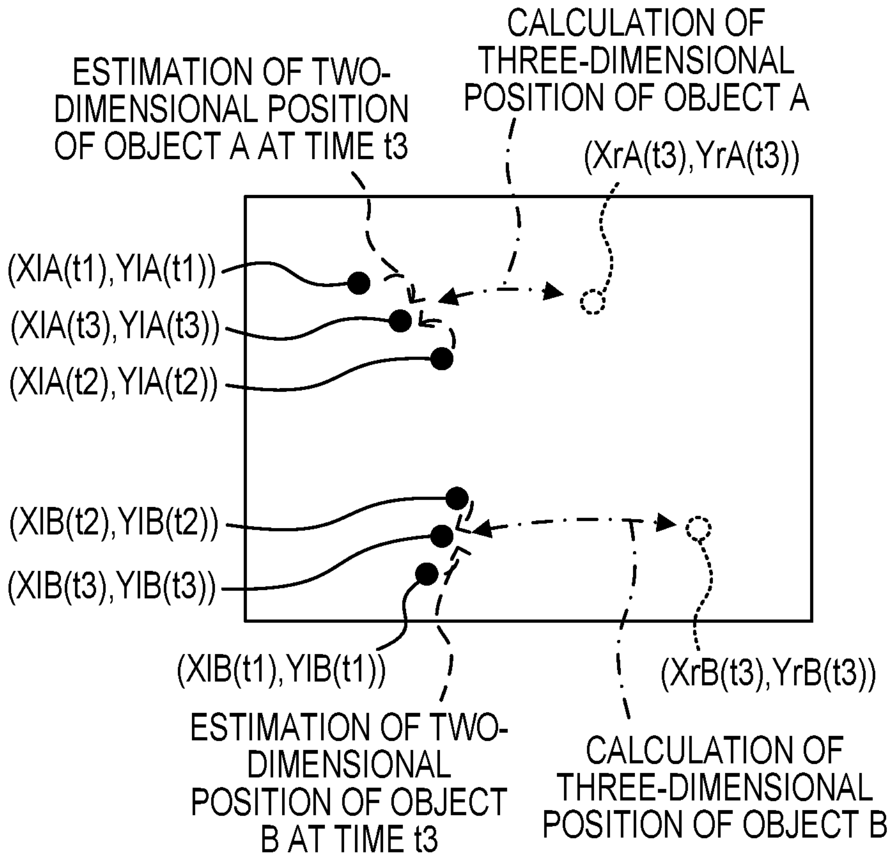

FIG.37

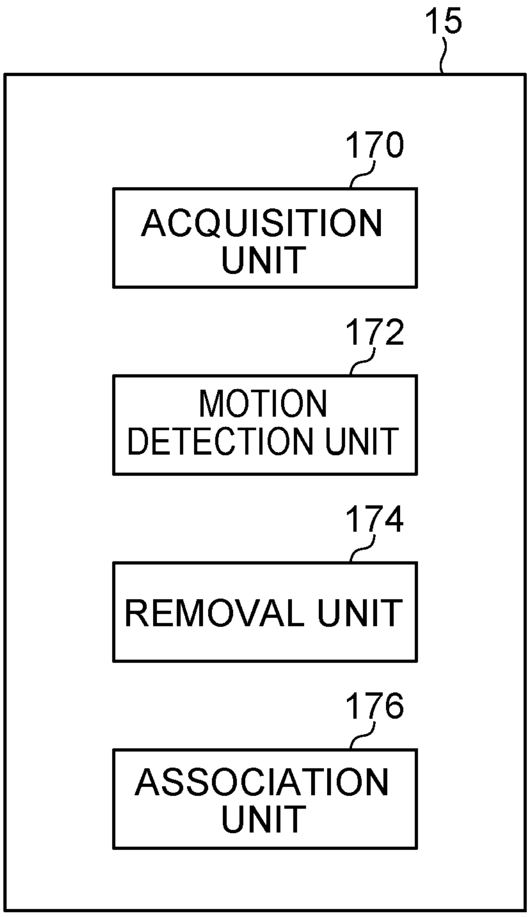
15
170
ACQUISITION UNIT
172
MOTION DETECTION UNIT
174
REMOVAL UNIT
176
ASSOCIATION UNIT

FIG.38A

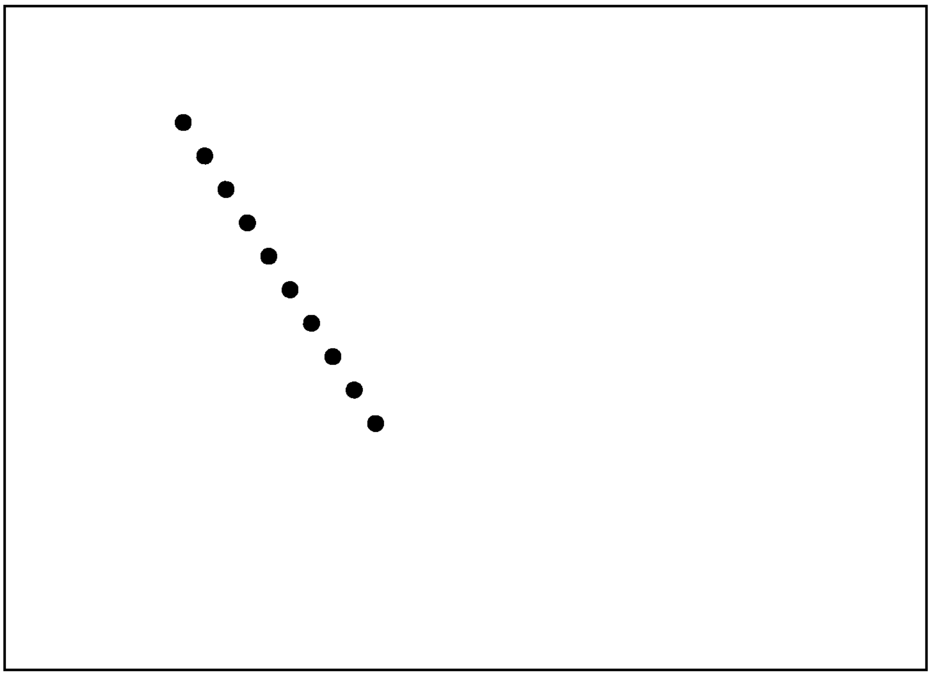

FIG.38B

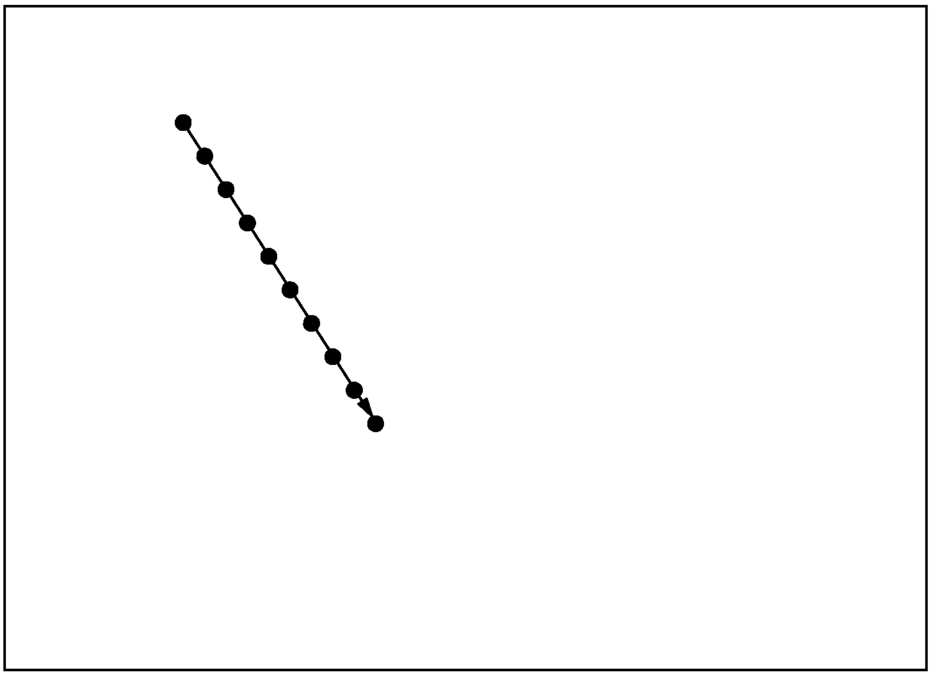

FIG.39

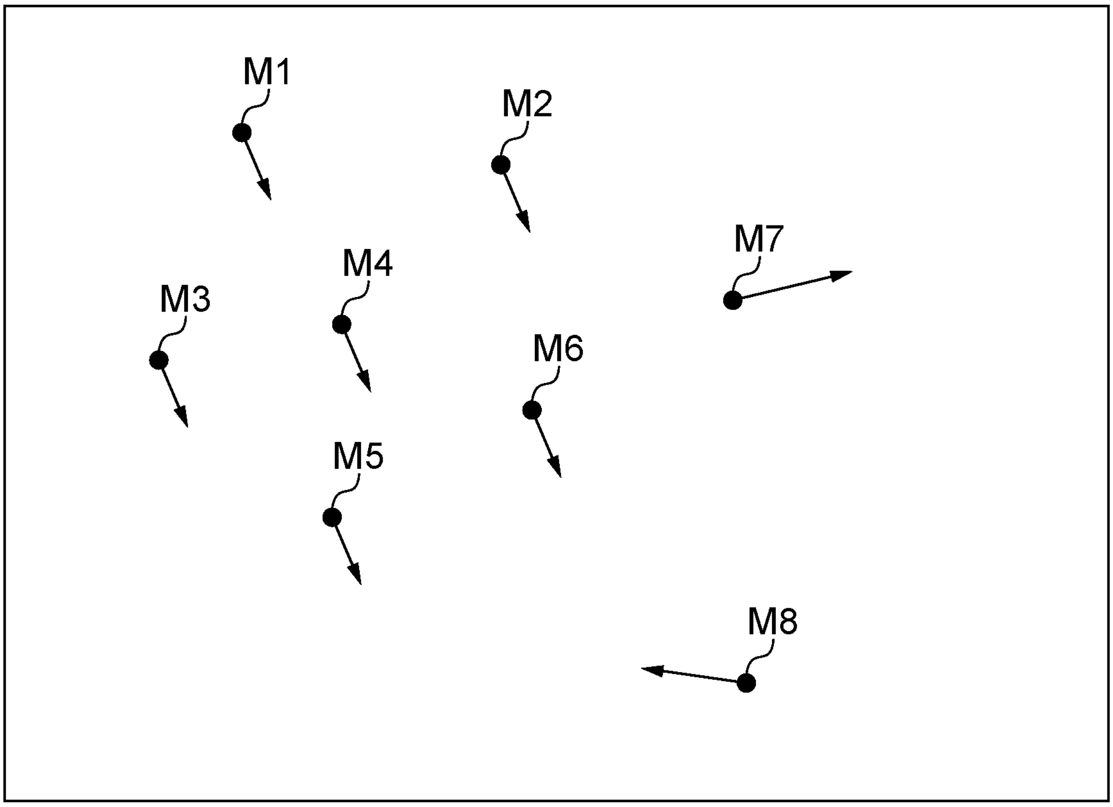

FIG.40

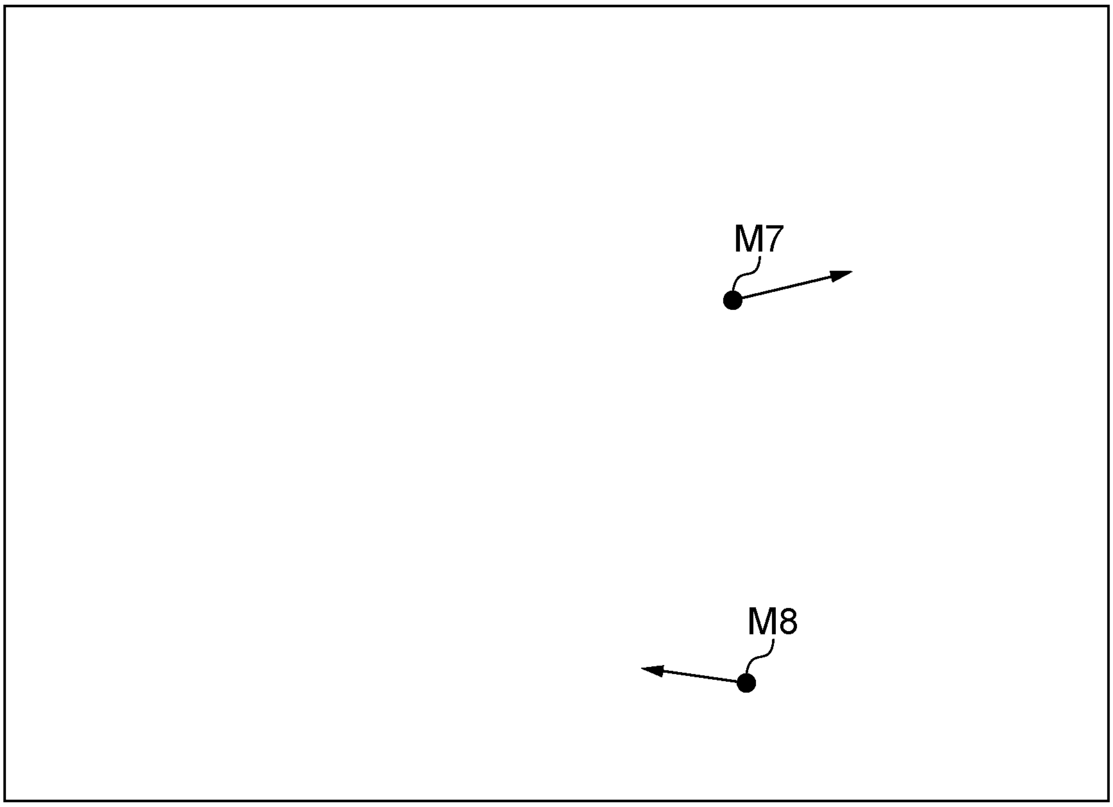

FIG.41

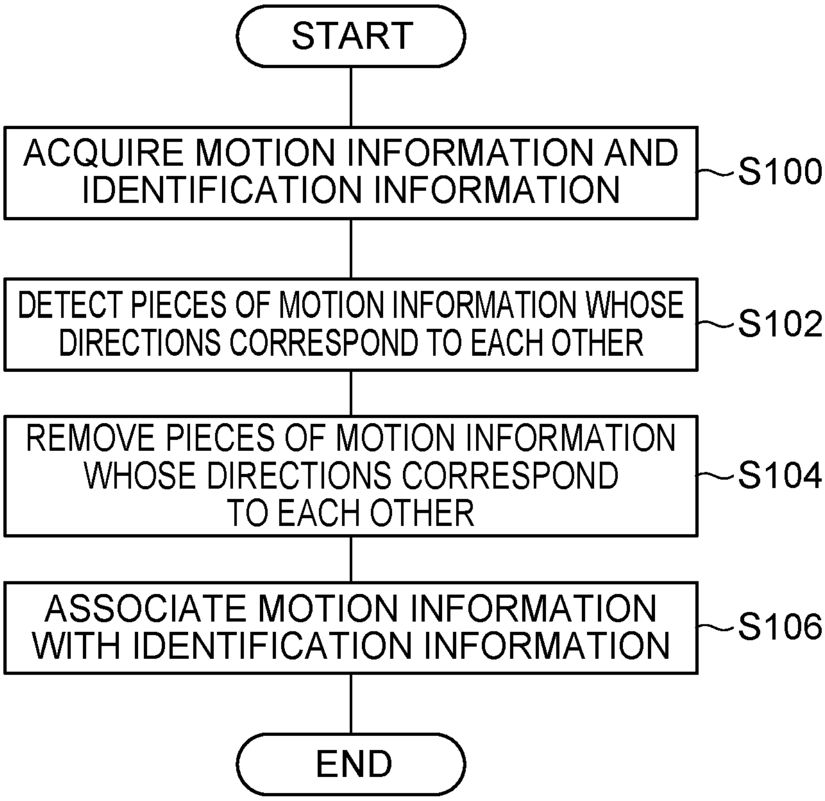
START
ACQUIRE MOTION INFORMATION AND IDENTIFICATION INFORMATION
S100
DETECT PIECES OF MOTION INFORMATION WHOSE DIRECTIONS CORRESPOND TO EACH OTHER
S102
REMOVE PIECES OF MOTION INFORMATION WHOSE DIRECTIONS CORRESPOND TO EACH OTHER
S104
ASSOCIATE MOTION INFORMATION WITH IDENTIFICATION INFORMATION
S106
END

FIG.42

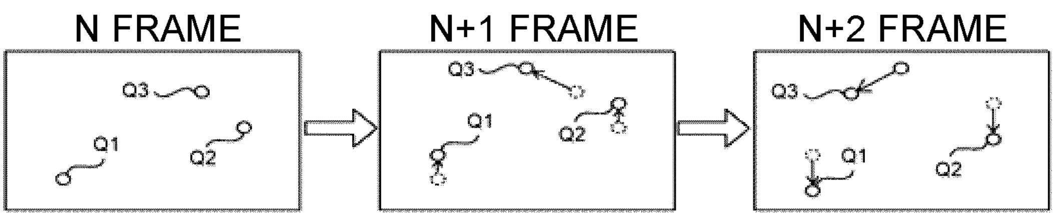

FIG.43

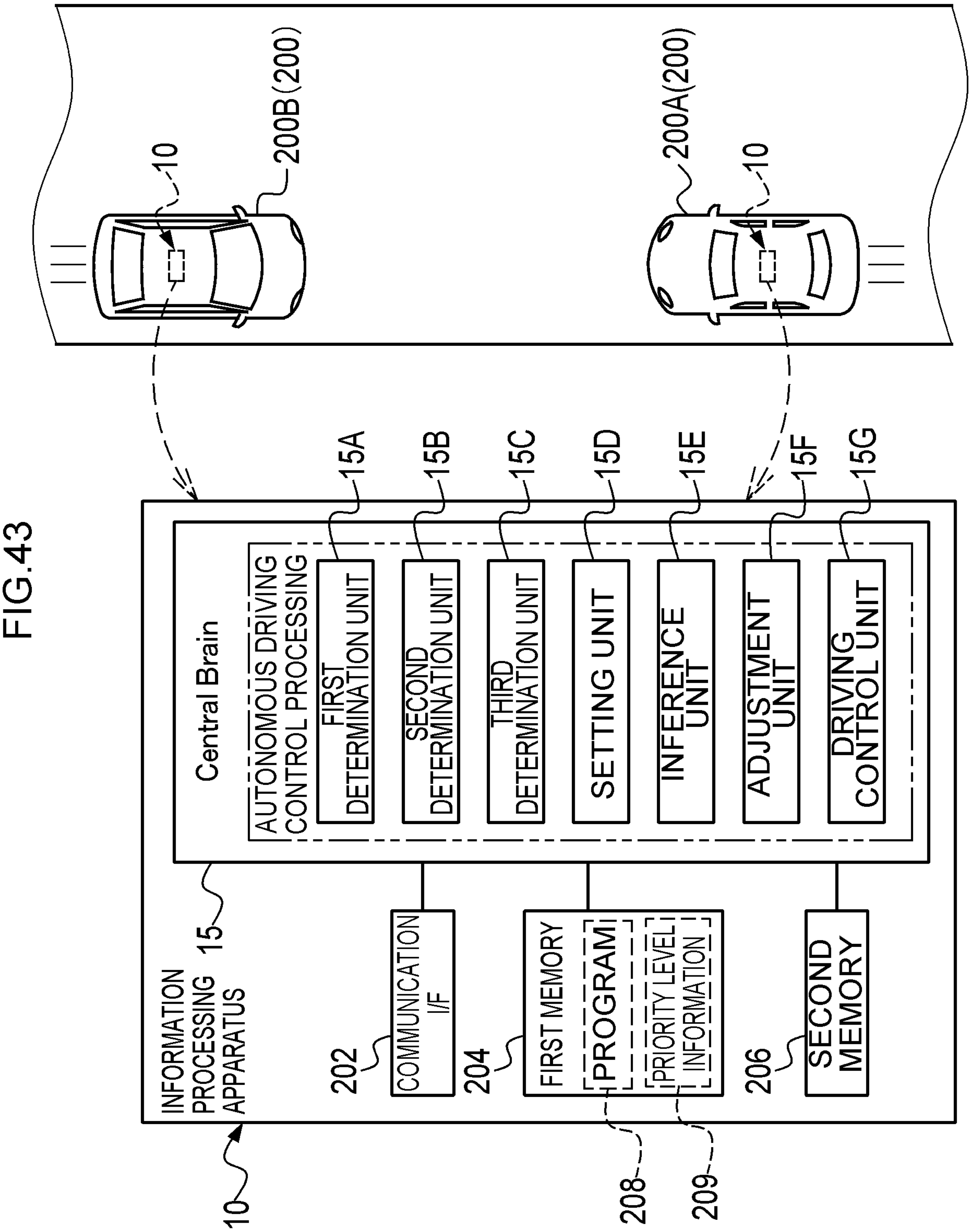
200B(200)
10
200A(200)
10
15A
15B
15C
15D
15E
15F
15G
Central Brain
AUTONOMOUS DRIVING CONTROL PROCESSING
FIRST DETERMINATION UNIT
SECOND DETERMINATION UNIT
THIRD DETERMINATION UNIT
SETTING UNIT
INFERENCE UNIT
ADJUSTMENT UNIT
DRIVING CONTROL UNIT
INFORMATION PROCESSING APPARATUS
15
202
COMMUNICATION I/F
204
FIRST MEMORY
PROGRAM
PRIORITY LEVEL INFORMATION
206
SECOND MEMORY
10
208
209

FIG.44

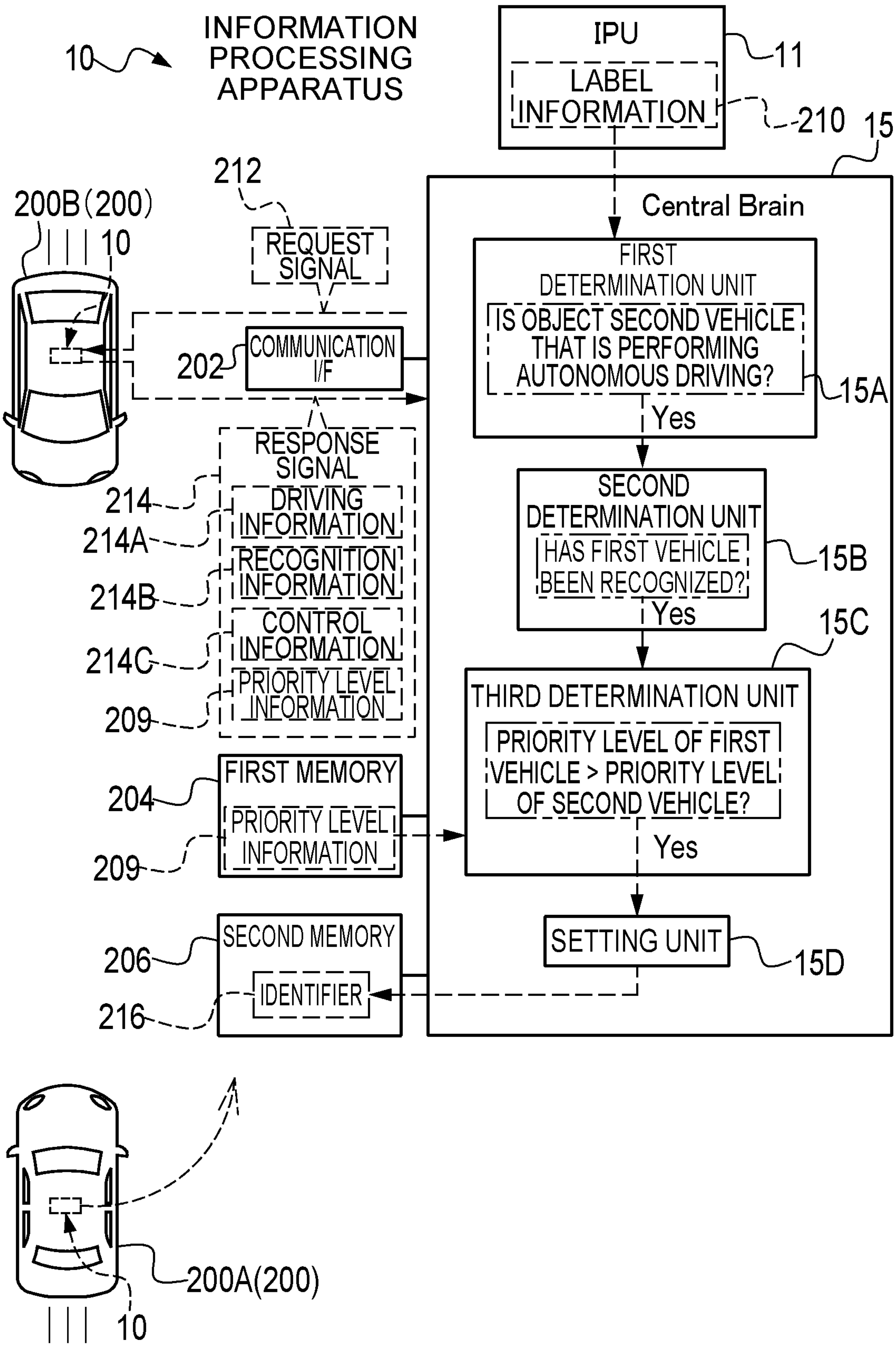

10
INFORMATION PROCESSING APPARATUS
IPU
11
LABEL INFORMATION
210
15
Central Brain
212
REQUEST SIGNAL
200B(200)
10
202
COMMUNICATION I/F
FIRST DETERMINATION UNIT
IS OBJECT SECOND VEHICLE THAT IS PERFORMING AUTONOMOUS DRIVING?
15A
Yes
RESPONSE SIGNAL
214
DRIVING INFORMATION
214A
RECOGNITION INFORMATION
214B
CONTROL INFORMATION
214C
PRIORITY LEVEL INFORMATION
209
SECOND DETERMINATION UNIT
HAS FIRST VEHICLE BEEN RECOGNIZED?
15B
Yes
15C
THIRD DETERMINATION UNIT
PRIORITY LEVEL OF FIRST VEHICLE > PRIORITY LEVEL OF SECOND VEHICLE?
Yes
204
FIRST MEMORY
PRIORITY LEVEL INFORMATION
209
SETTING UNIT
15D
206
SECOND MEMORY
IDENTIFIER
216
200A(200)
10

FIG.45

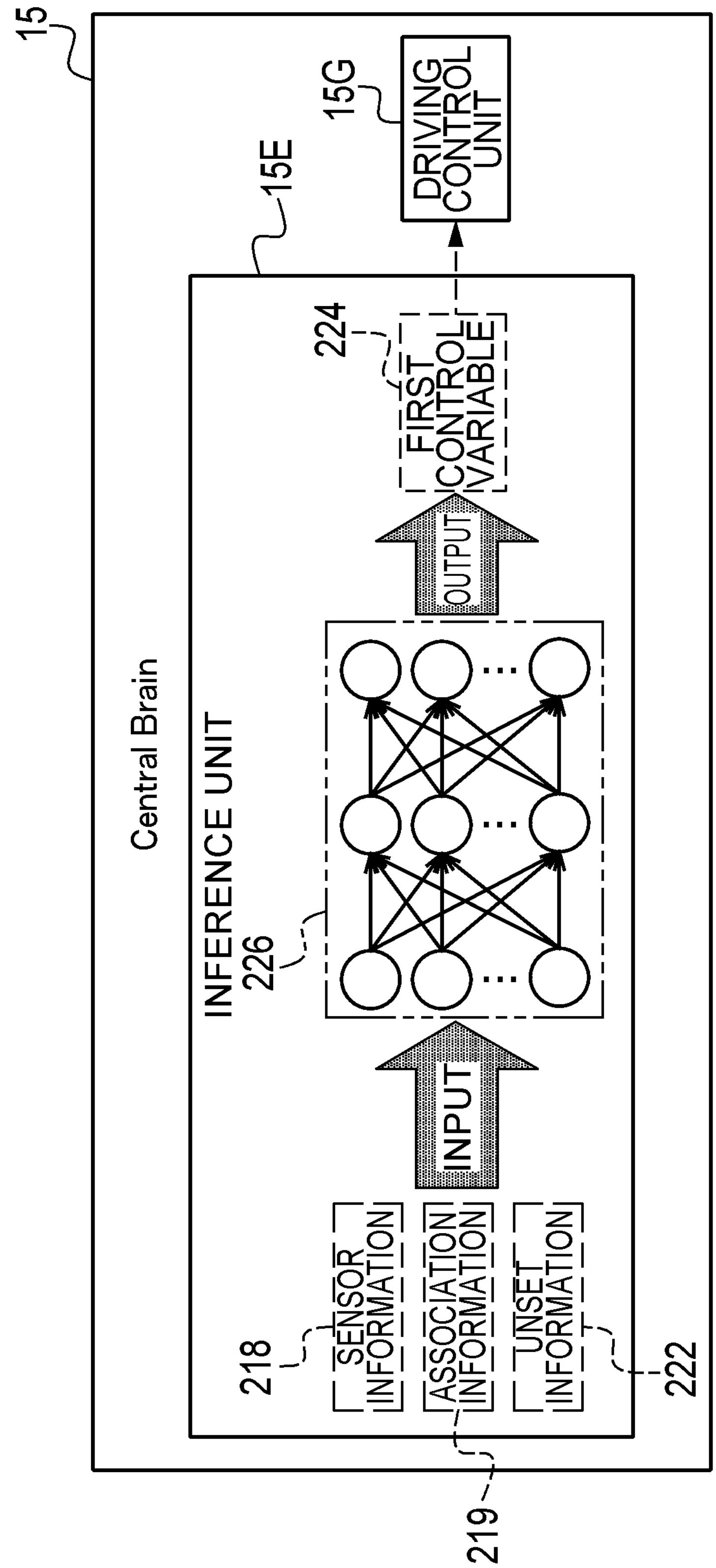
15
15E
15G
DRIVING CONTROL UNIT
Central Brain
INFERENCE UNIT
224
FIRST CONTROL VARIABLE
OUTPUT
226
INPUT
218
SENSOR INFORMATION
ASSOCIATION INFORMATION
UNSET INFORMATION
222
219

FIG.46

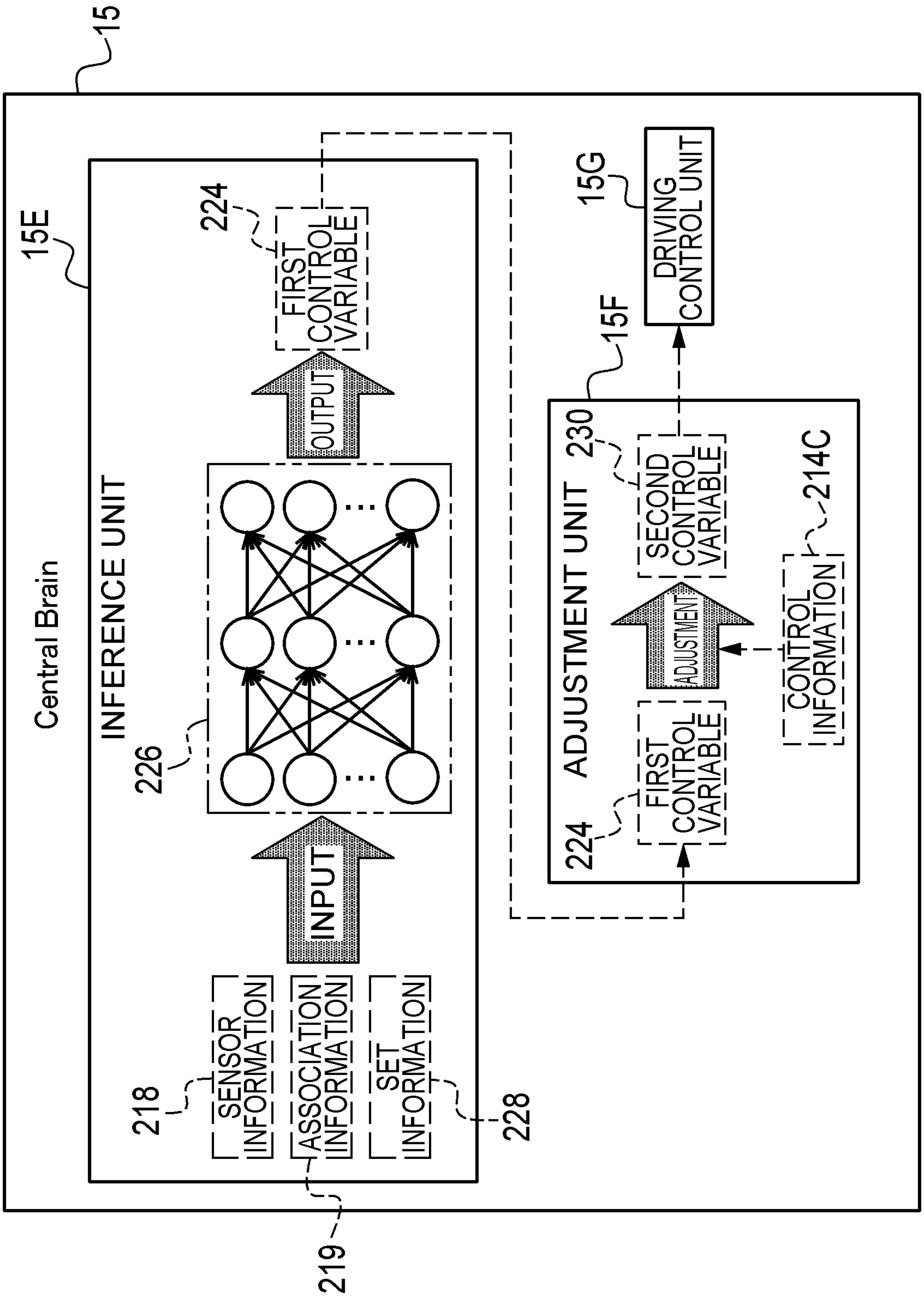
15
Central Brain
15E
INFERENCE UNIT
218
SENSOR INFORMATION
219
ASSOCIATION INFORMATION
228
SET INFORMATION
INPUT
226
OUTPUT
224
FIRST CONTROL VARIABLE
15F
ADJUSTMENT UNIT
224
FIRST CONTROL VARIABLE
ADJUSTMENT
230
SECOND CONTROL VARIABLE
214C
CONTROL INFORMATION
15G
DRIVING CONTROL UNIT

FIG.47

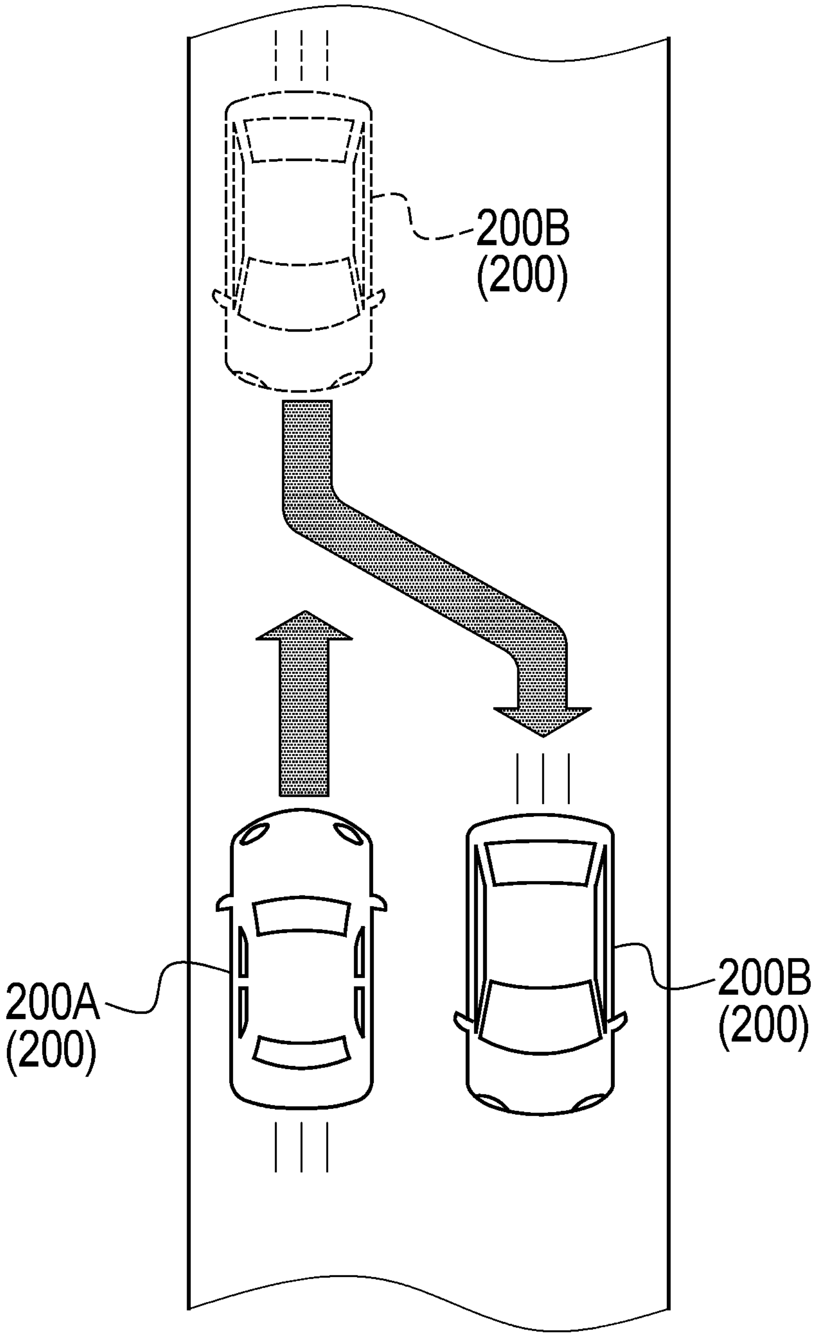

FIG.48

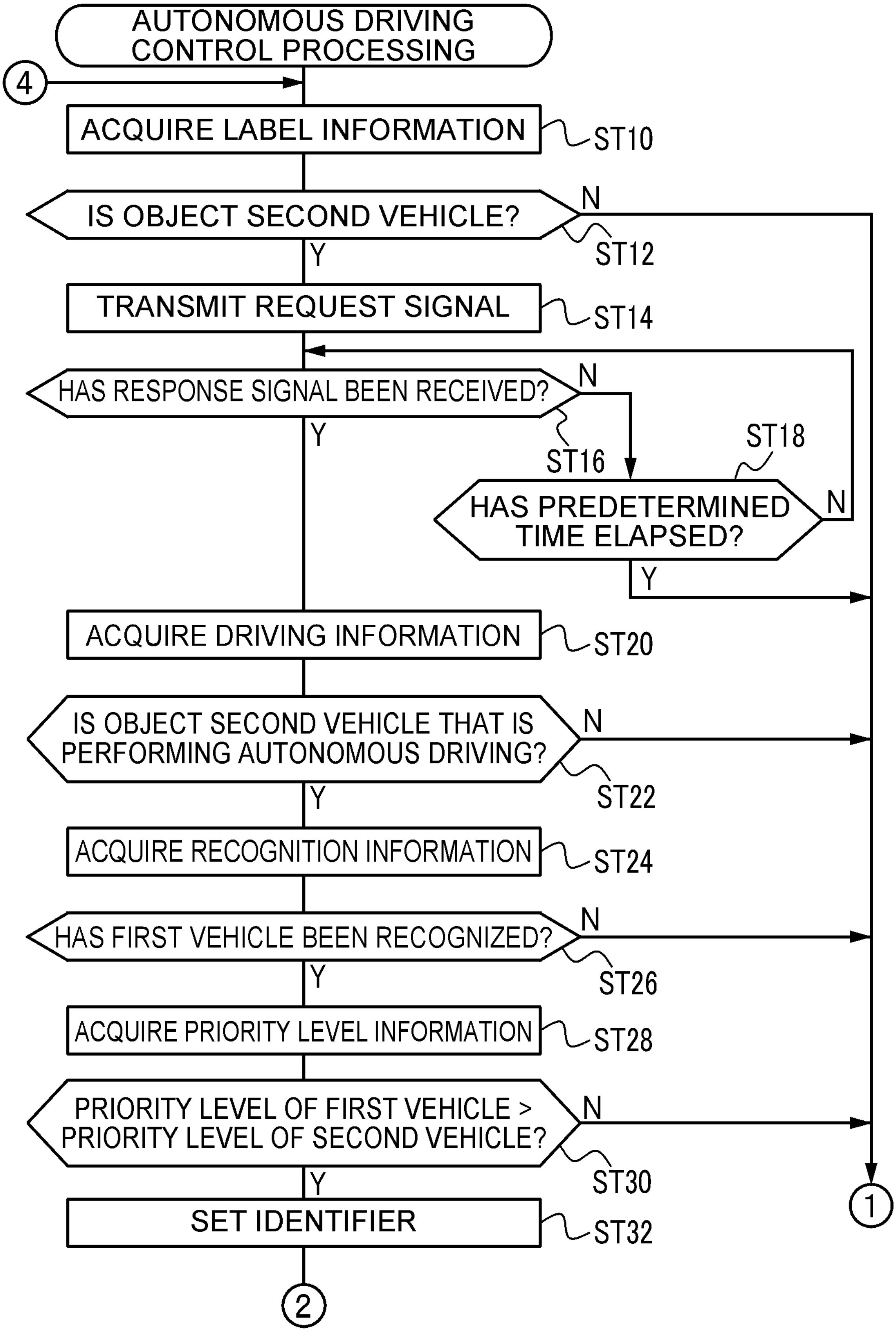
AUTONOMOUS DRIVING CONTROL PROCESSING
4
ACQUIRE LABEL INFORMATION
ST10
IS OBJECT SECOND VEHICLE?
N
Y
ST12
TRANSMIT REQUEST SIGNAL
ST14
HAS RESPONSE SIGNAL BEEN RECEIVED?
N
Y
ST16
ST18
HAS PREDETERMINED TIME ELAPSED?
N
Y
ACQUIRE DRIVING INFORMATION
ST20
IS OBJECT SECOND VEHICLE THAT IS PERFORMING AUTONOMOUS DRIVING?
N
Y
ST22
ACQUIRE RECOGNITION INFORMATION
ST24
HAS FIRST VEHICLE BEEN RECOGNIZED?
N
Y
ST26
ACQUIRE PRIORITY LEVEL INFORMATION
ST28
PRIORITY LEVEL OF FIRST VEHICLE > PRIORITY LEVEL OF SECOND VEHICLE?
N
Y
ST30
SET IDENTIFIER
ST32
1
2

FIG.49

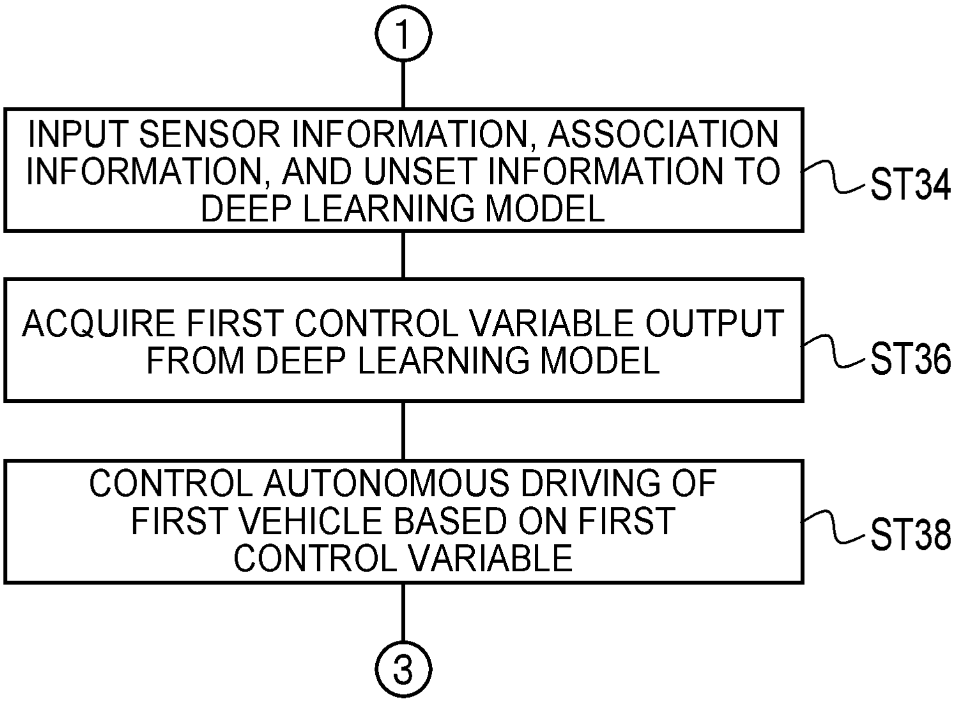
1
INPUT SENSOR INFORMATION, ASSOCIATION INFORMATION, AND UNSET INFORMATION TO DEEP LEARNING MODEL
ST34
ACQUIRE FIRST CONTROL VARIABLE OUTPUT FROM DEEP LEARNING MODEL
ST36
CONTROL AUTONOMOUS DRIVING OF FIRST VEHICLE BASED ON FIRST CONTROL VARIABLE
ST38
3

FIG.50

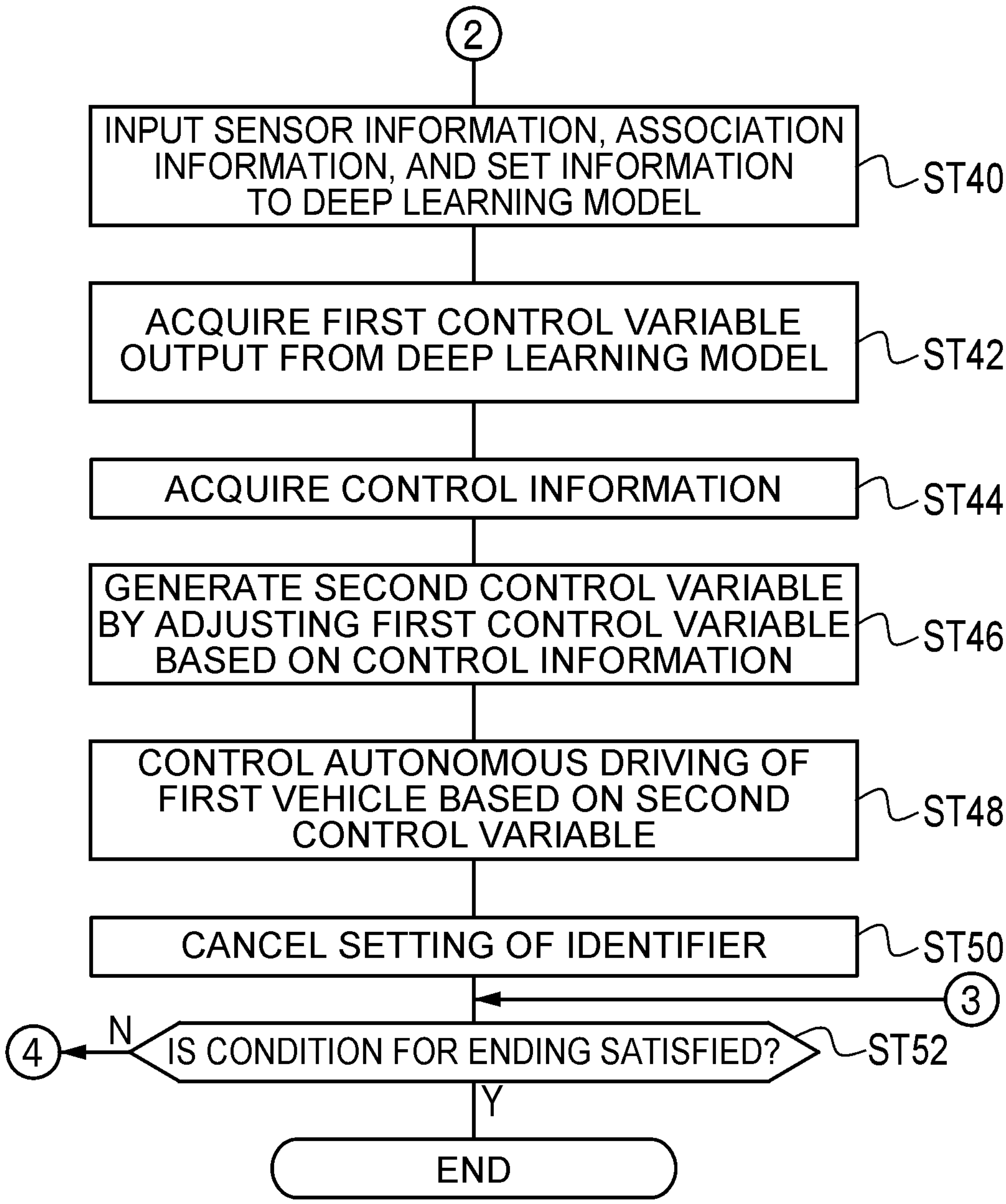
2
INPUT SENSOR INFORMATION, ASSOCIATION INFORMATION, AND SET INFORMATION TO DEEP LEARNING MODEL
ST40
ACQUIRE FIRST CONTROL VARIABLE OUTPUT FROM DEEP LEARNING MODEL
ST42
ACQUIRE CONTROL INFORMATION
ST44
GENERATE SECOND CONTROL VARIABLE BY ADJUSTING FIRST CONTROL VARIABLE BASED ON CONTROL INFORMATION
ST46
CONTROL AUTONOMOUS DRIVING OF FIRST VEHICLE BASED ON SECOND CONTROL VARIABLE
ST48
CANCEL SETTING OF IDENTIFIER
ST50
3
IS CONDITION FOR ENDING SATISFIED?
ST52
N
4
Y
END

FIG.51

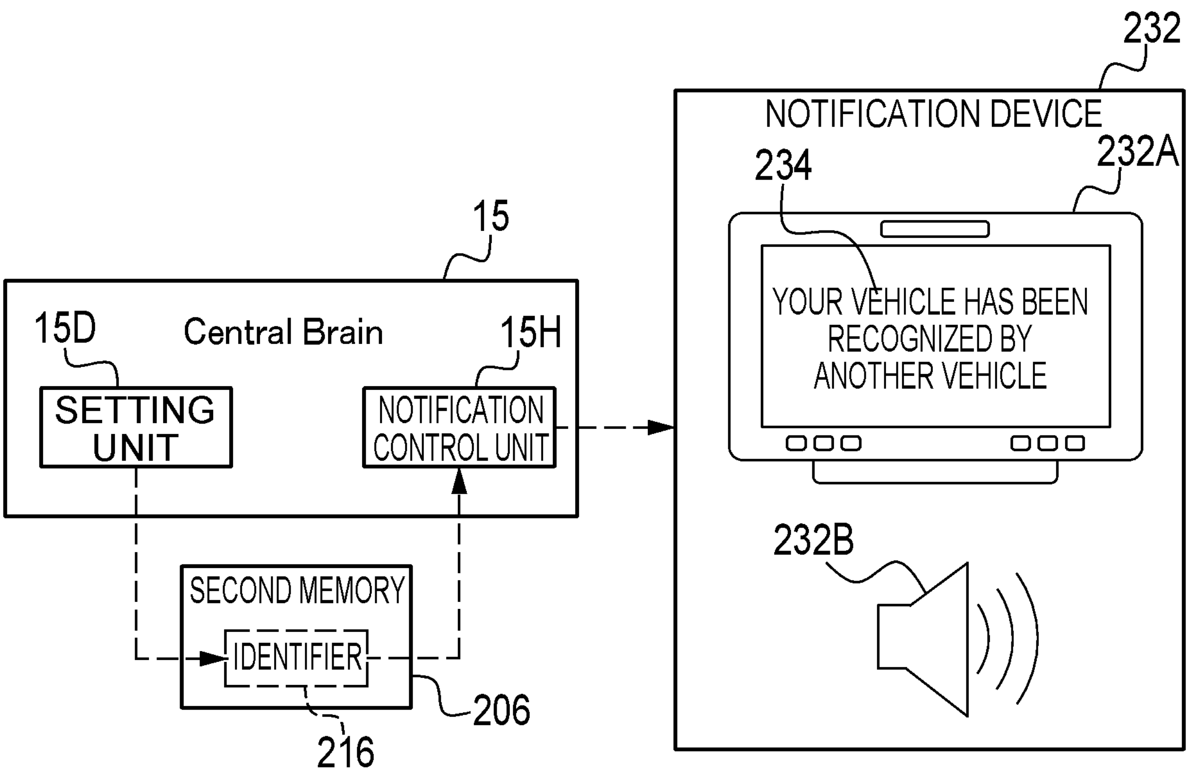
232
NOTIFICATION DEVICE
234
232A
15
YOUR VEHICLE HAS BEEN
RECOGNIZED BY
ANOTHER VEHICLE
15D
Central Brain
15H
SETTING UNIT
NOTIFICATION CONTROL UNIT
232B
SECOND MEMORY
IDENTIFIER
206
216

FIG.52A

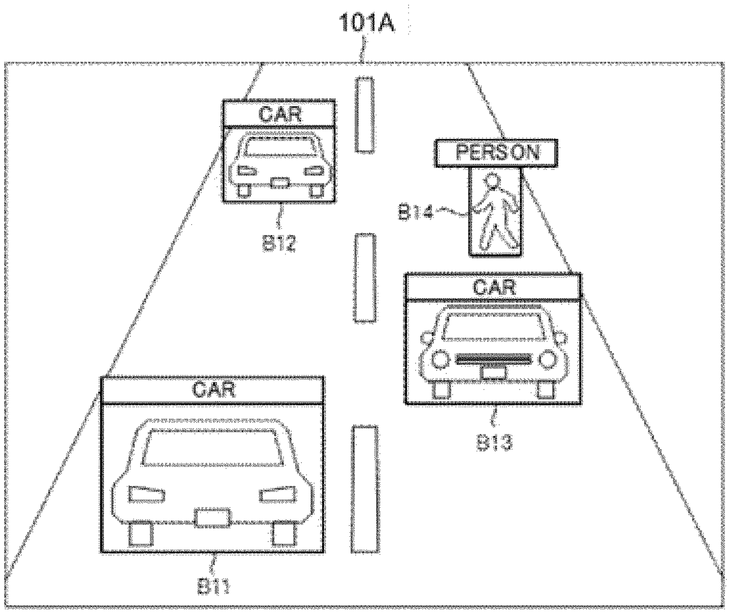


FIG.52B

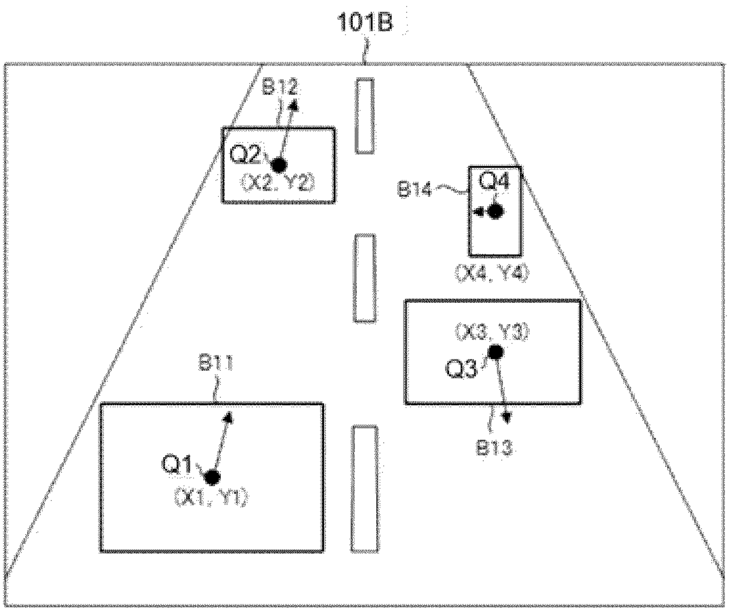

FIG.53

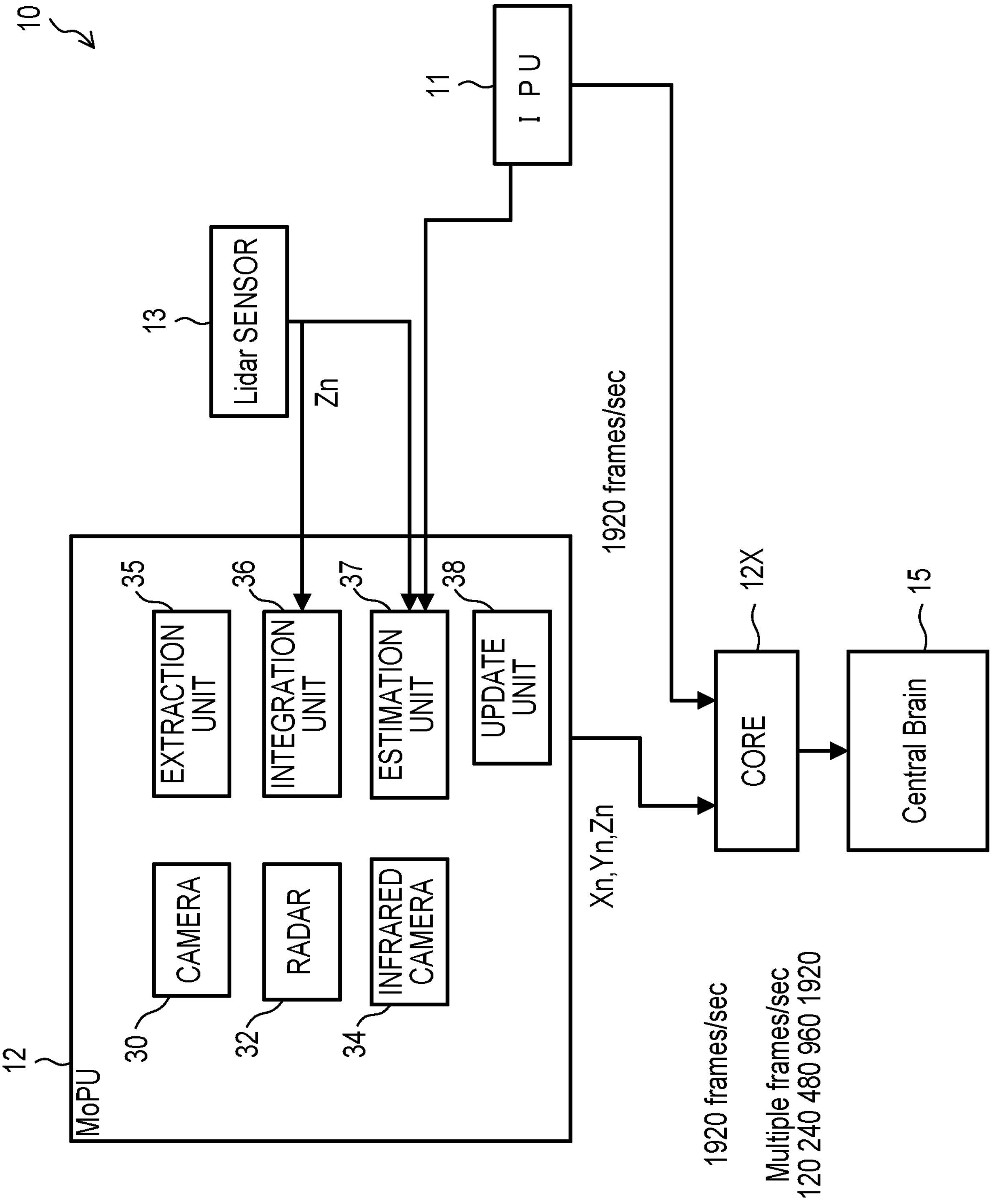
10
11
I P U
13
Lidar SENSOR
Zn
1920 frames/sec
12
MoPU
35
EXTRACTION UNIT
36
INTEGRATION UNIT
37
ESTIMATION UNIT
38
UPDATE UNIT
30
CAMERA
32
RADAR
34
INFRARED CAMERA
Xn,Yn,Zn
12X
CORE
15
Central Brain
1920 frames/sec
Multiple frames/sec
120 240 480 960 1920

FIG.54

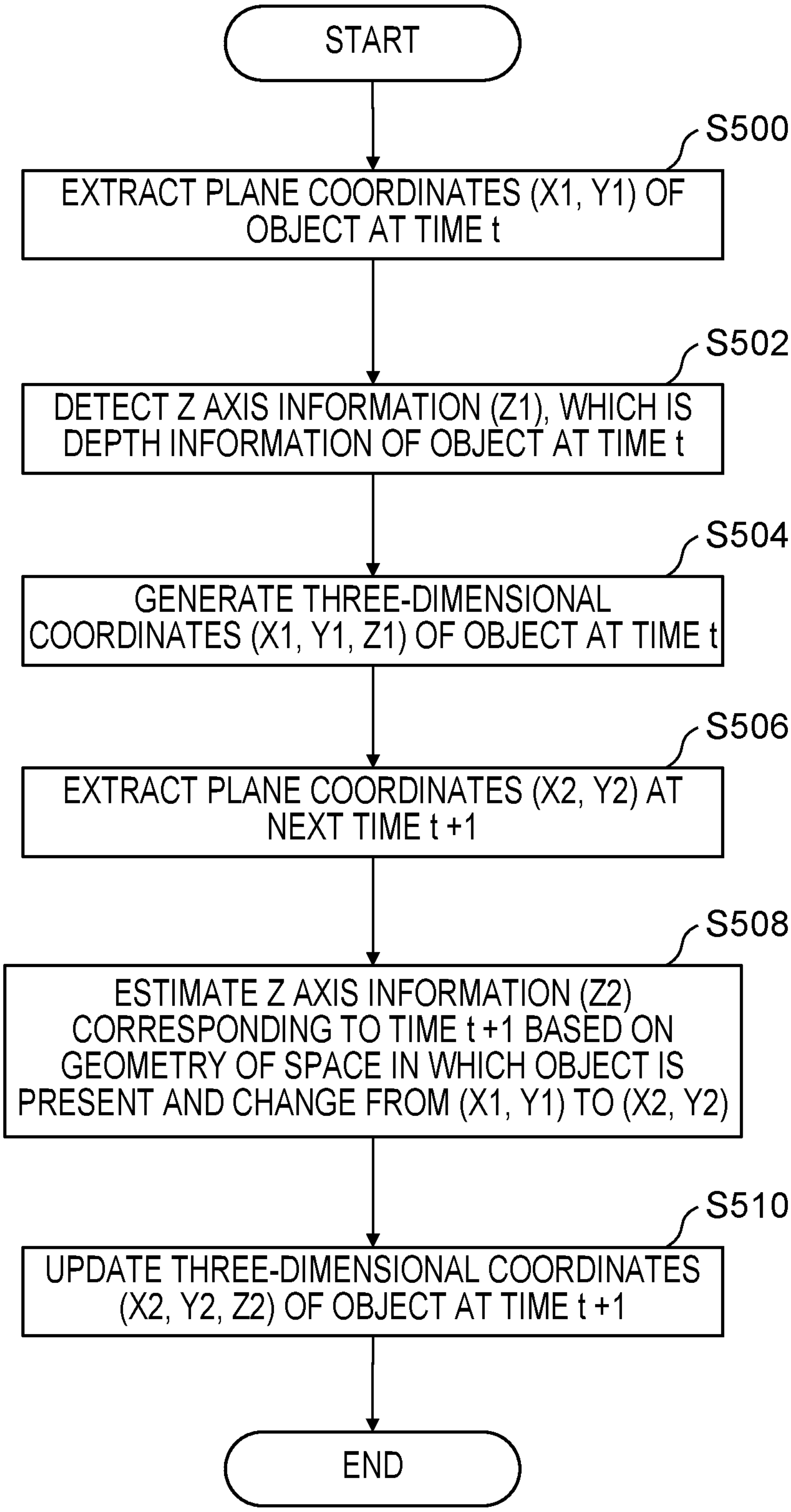
START
S500
EXTRACT PLANE COORDINATES (X1, Y1) OF OBJECT AT TIME t
S502
DETECT Z AXIS INFORMATION (Z1), WHICH IS DEPTH INFORMATION OF OBJECT AT TIME t
S504
GENERATE THREE-DIMENSIONAL COORDINATES (X1, Y1, Z1) OF OBJECT AT TIME t
S506
EXTRACT PLANE COORDINATES (X2, Y2) AT NEXT TIME t +1
S508
ESTIMATE Z AXIS INFORMATION (Z2) CORRESPONDING TO TIME t +1 BASED ON GEOMETRY OF SPACE IN WHICH OBJECT IS PRESENT AND CHANGE FROM (X1, Y1) TO (X2, Y2)
S510
UPDATE THREE-DIMENSIONAL COORDINATES (X2, Y2, Z2) OF OBJECT AT TIME t +1
END

FIG.55

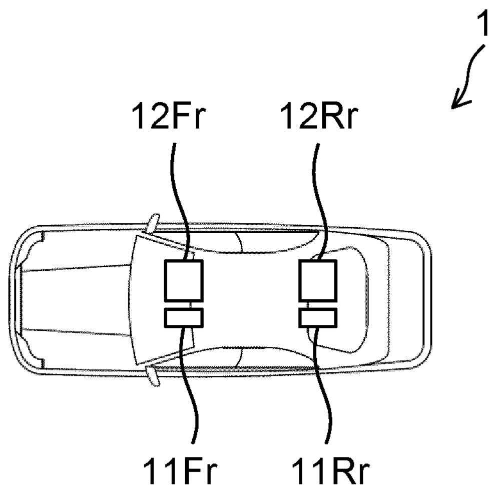

FIG.56

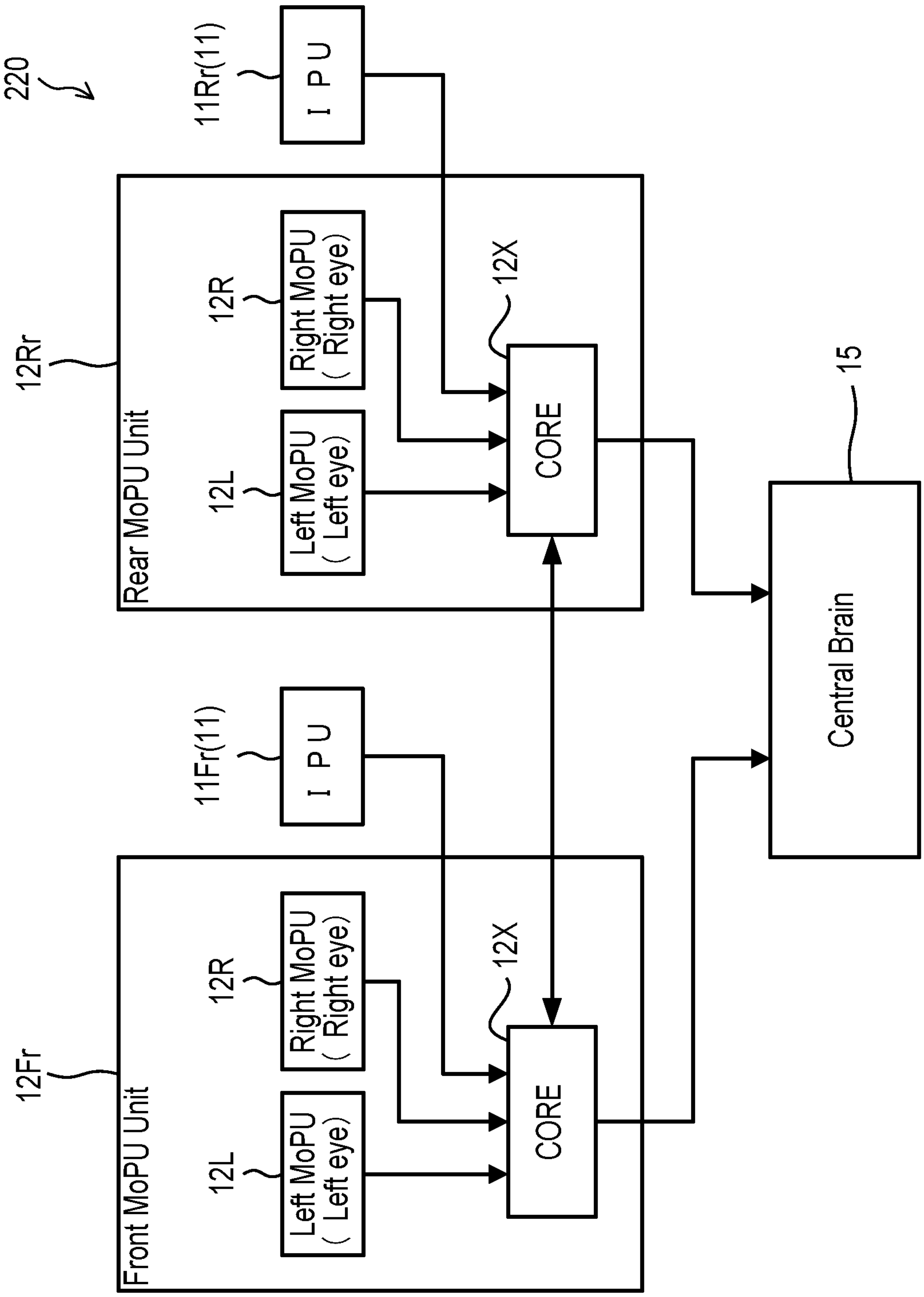
220
11Rr(11)
IPU
12Rr
Rear MoPU Unit
12L
Left MoPU
(Left eye)
12R
Right MoPU
(Right eye)
12X
CORE
15
Central Brain
11Fr(11)
IPU
12Fr
Front MoPU Unit
12L
Left MoPU
(Left eye)
12R
Right MoPU
(Right eye)
12X
CORE

FIG.57

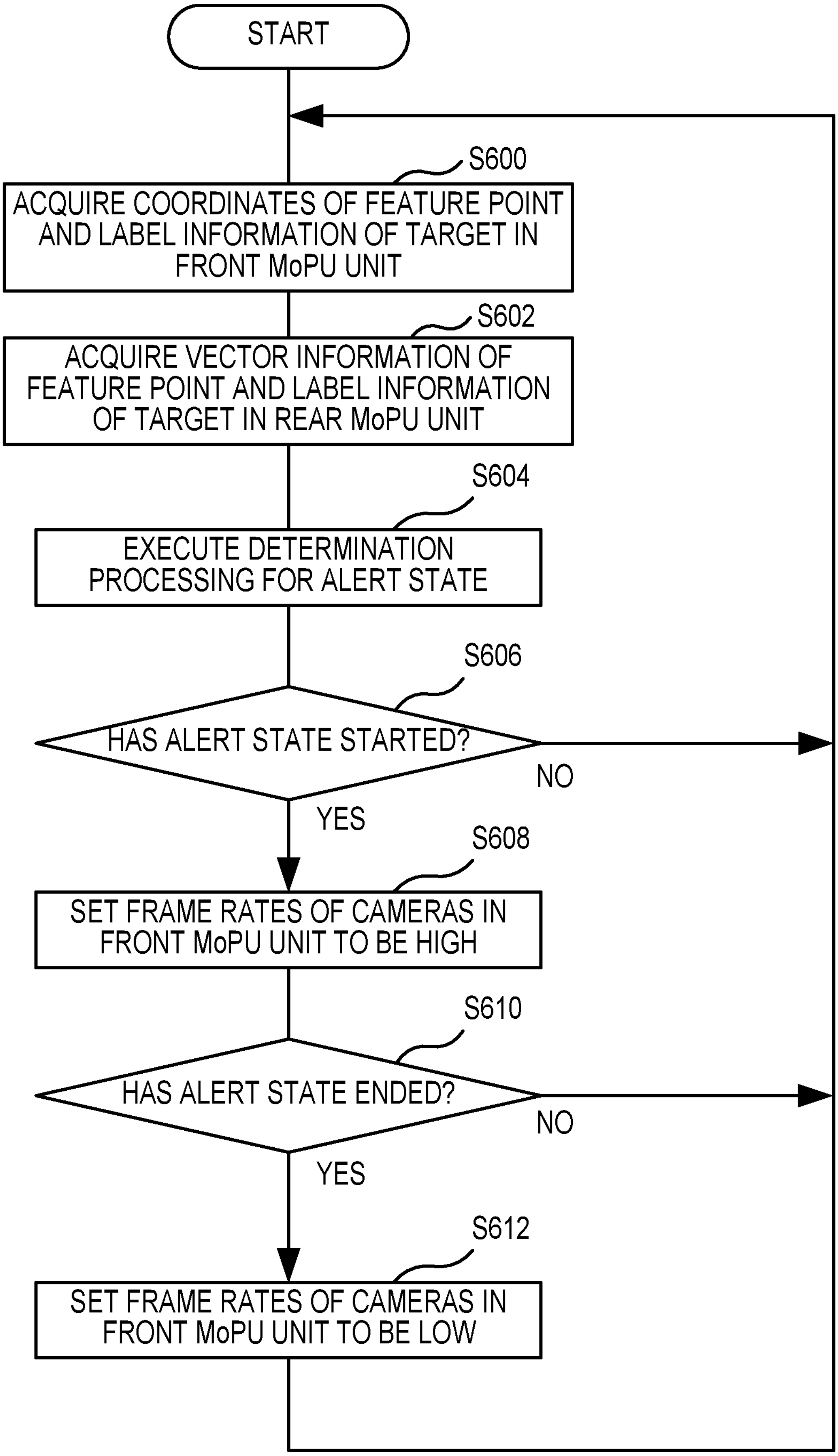
START
S600
ACQUIRE COORDINATES OF FEATURE POINT AND LABEL INFORMATION OF TARGET IN FRONT MoPU UNIT
S602
ACQUIRE VECTOR INFORMATION OF FEATURE POINT AND LABEL INFORMATION OF TARGET IN REAR MoPU UNIT
S604
EXECUTE DETERMINATION PROCESSING FOR ALERT STATE
S606
HAS ALERT STATE STARTED?
NO
YES
S608
SET FRAME RATES OF CAMERAS IN FRONT MoPU UNIT TO BE HIGH
S610
HAS ALERT STATE ENDED?
NO
YES
S612
SET FRAME RATES OF CAMERAS IN FRONT MoPU UNIT TO BE LOW

FIG.58

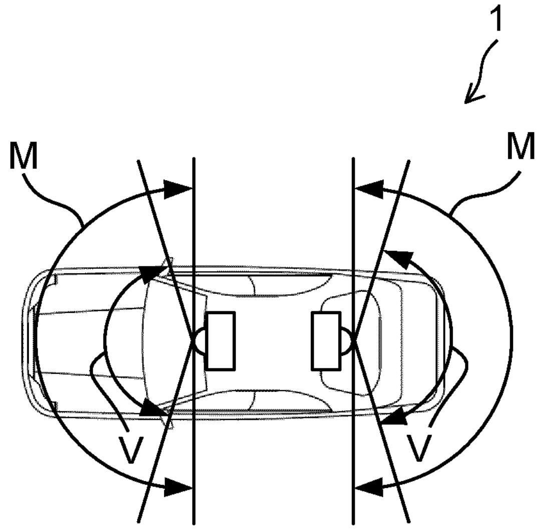

FIG.59

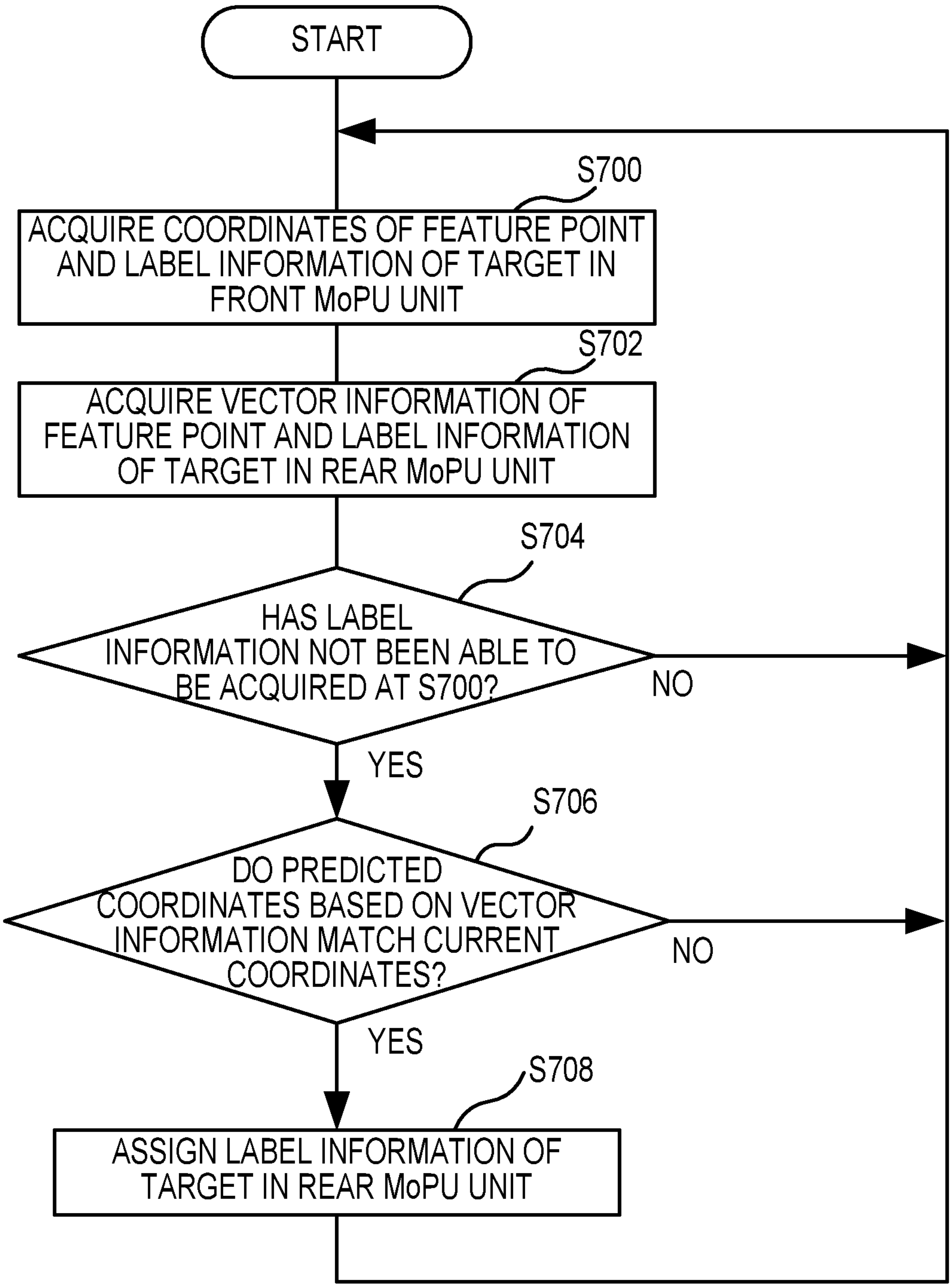
START
S700
ACQUIRE COORDINATES OF FEATURE POINT AND LABEL INFORMATION OF TARGET IN FRONT MoPU UNIT
S702
ACQUIRE VECTOR INFORMATION OF FEATURE POINT AND LABEL INFORMATION OF TARGET IN REAR MoPU UNIT
S704
HAS LABEL INFORMATION NOT BEEN ABLE TO BE ACQUIRED AT S700?
NO
YES
S706
DO PREDICTED COORDINATES BASED ON VECTOR INFORMATION MATCH CURRENT COORDINATES?
NO
YES
S708
ASSIGN LABEL INFORMATION OF TARGET IN REAR MoPU UNIT

FIG.60

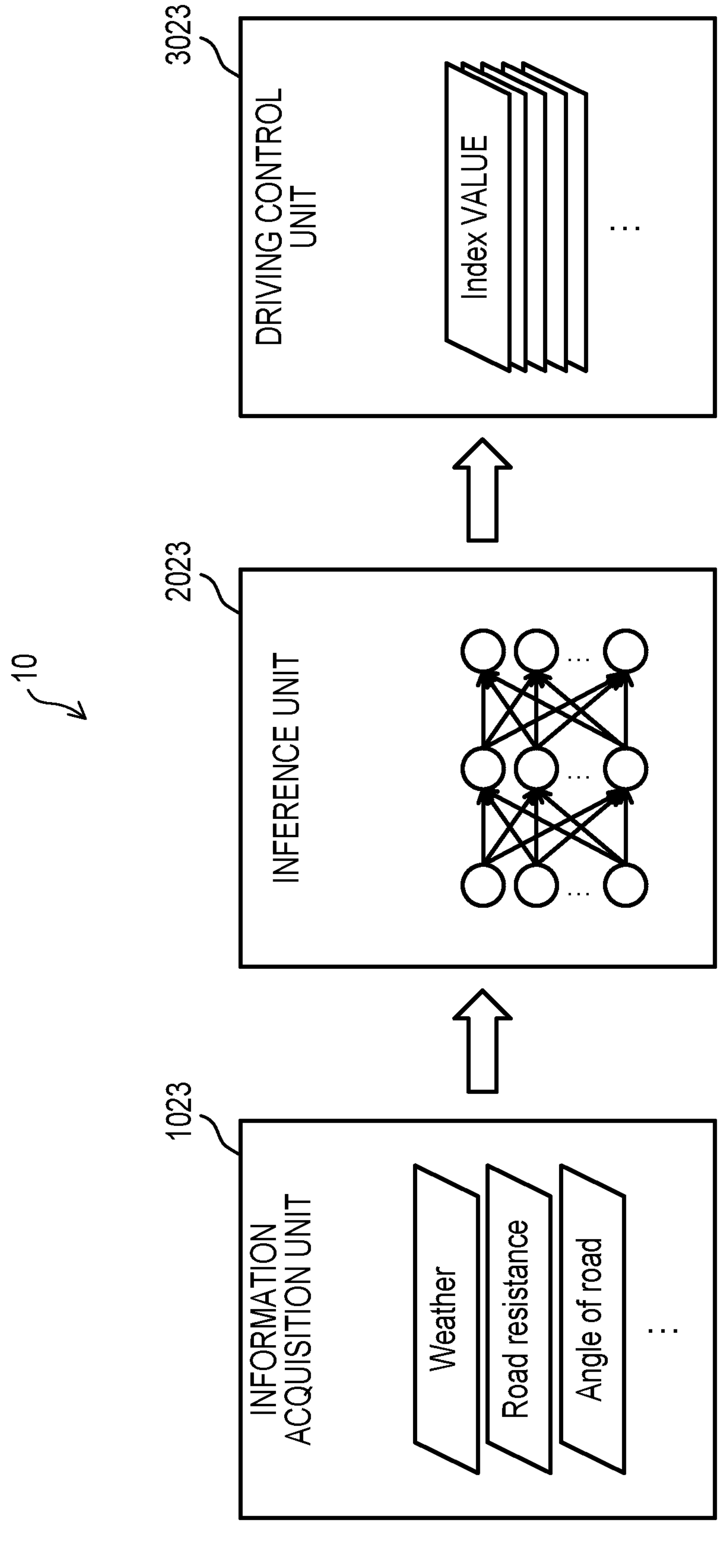
10
1023
INFORMATION ACQUISITION UNIT
Weather
Road resistance
Angle of road
…
2023
INFERENCE UNIT
3023
DRIVING CONTROL UNIT
Index VALUE
…

FIG.61

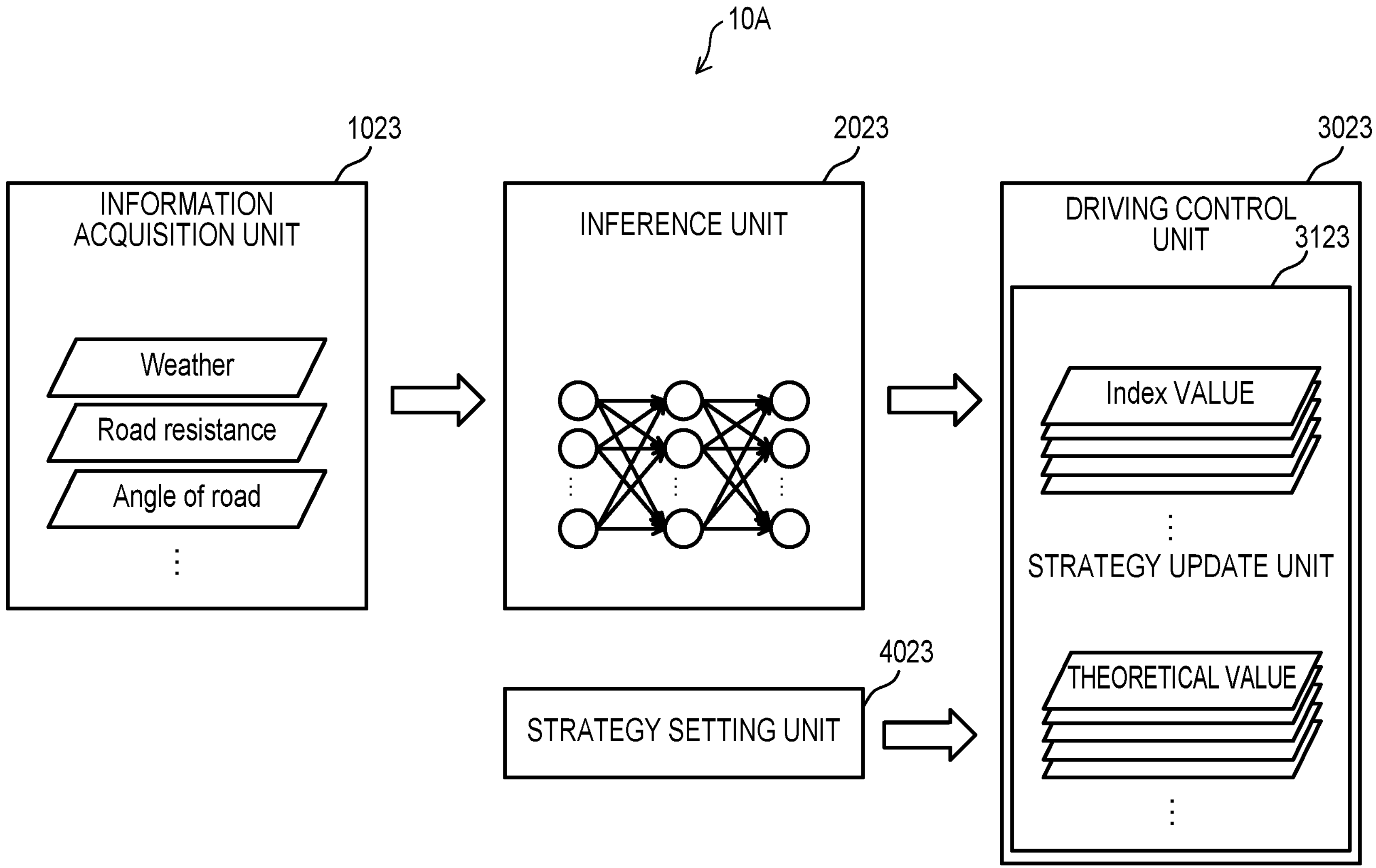
10A
1023
INFORMATION ACQUISITION UNIT
Weather
Road resistance
Angle of road
2023
INFERENCE UNIT
3023
DRIVING CONTROL UNIT
3123
Index VALUE
STRATEGY UPDATE UNIT
THEORETICAL VALUE
4023
STRATEGY SETTING UNIT

FIG.62

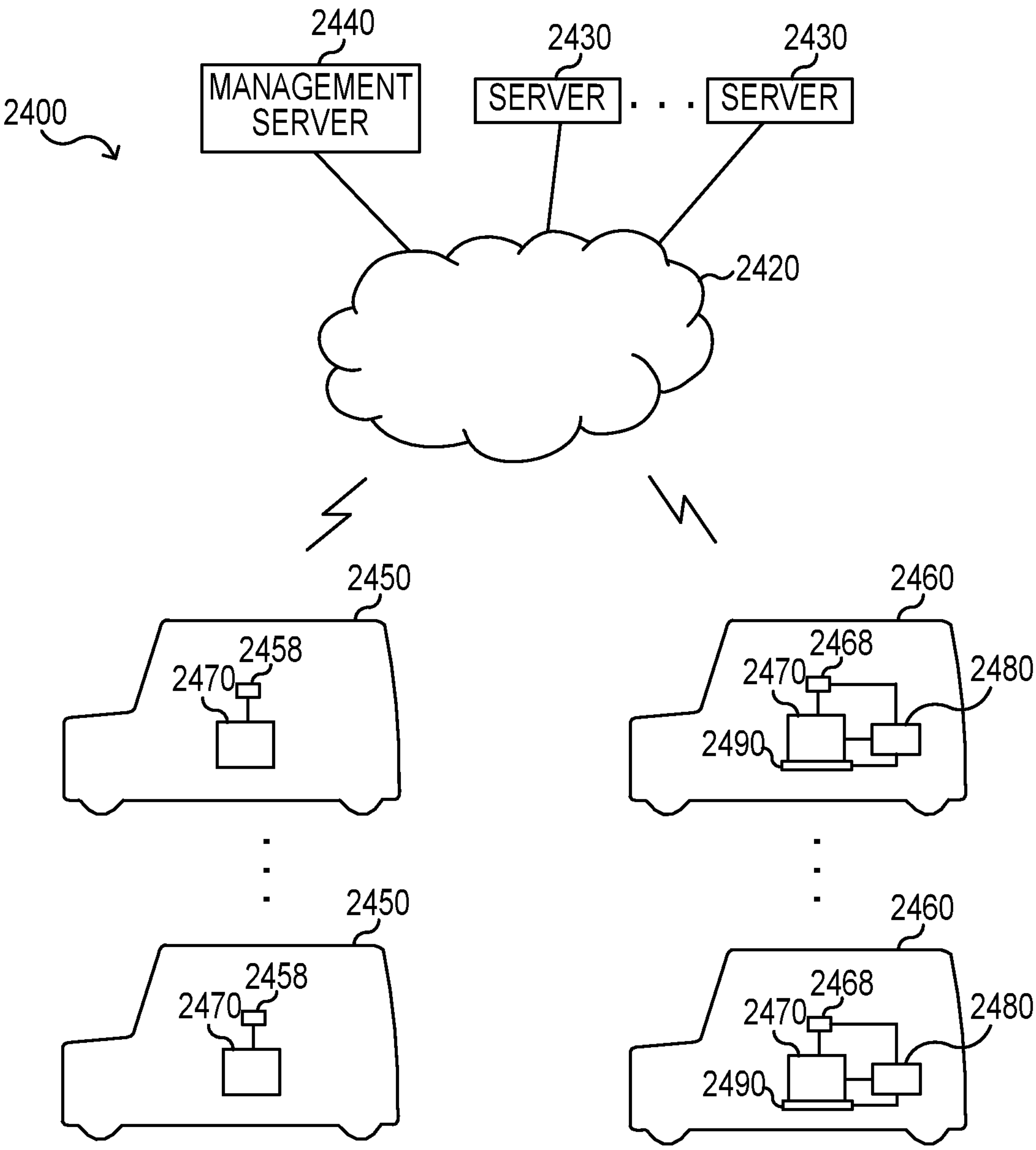
2440
MANAGEMENT SERVER
2430
SERVER
2430
SERVER
2400
2420
2450
2458
2470
2460
2468
2470
2480
2490
2450
2458
2470
2460
2468
2470
2480
2490

FIG.63

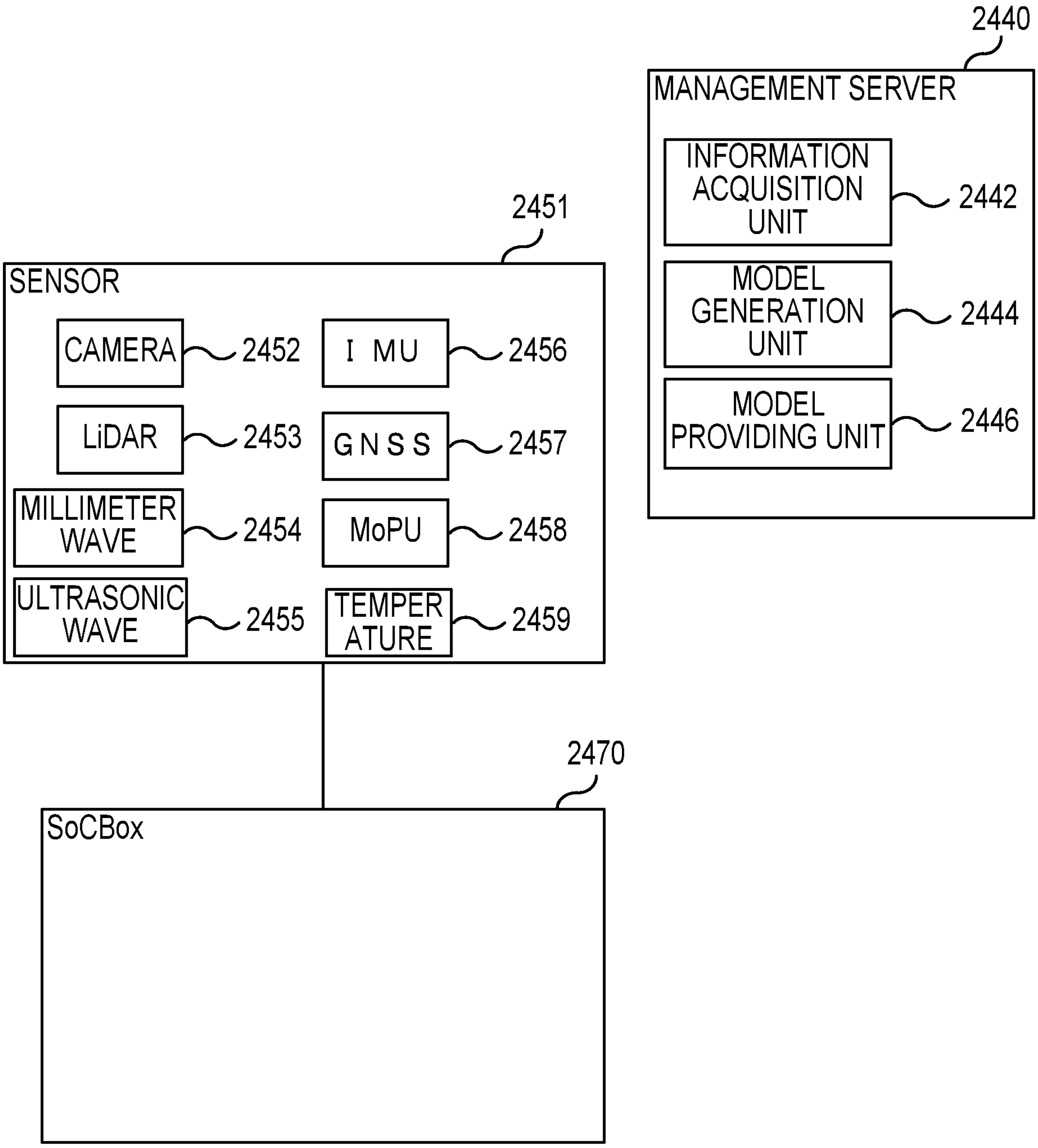
2440
MANAGEMENT SERVER
INFORMATION ACQUISITION UNIT
2442
MODEL GENERATION UNIT
2444
MODEL PROVIDING UNIT
2446
2451
SENSOR
CAMERA
2452
I MU
2456
LiDAR
2453
G N S S
2457
MILLIMETER WAVE
2454
MoPU
2458
ULTRASONIC WAVE
2455
TEMPER ATURE
2459
2470
SoCBox

FIG.64

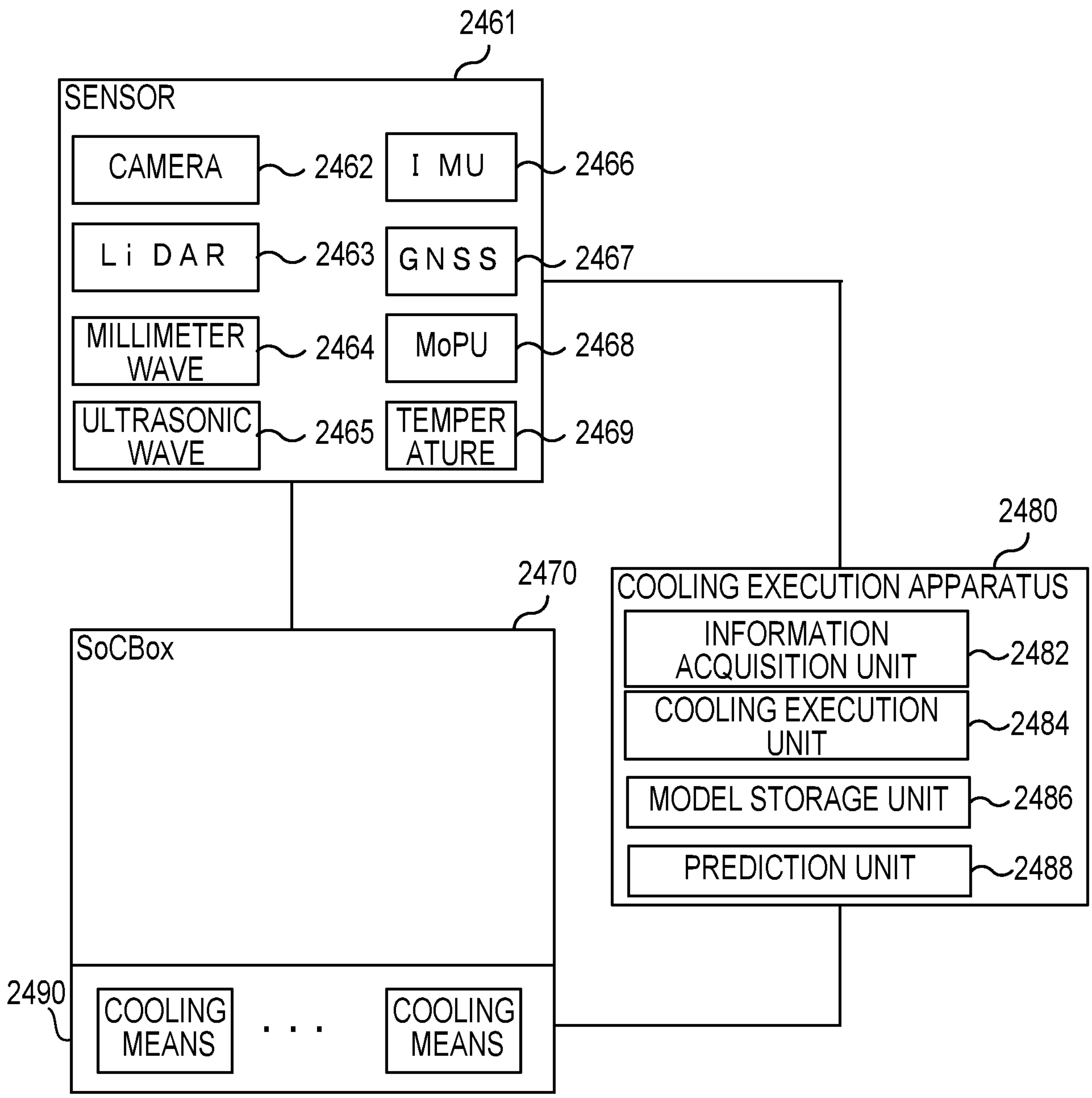
2461
SENSOR
CAMERA
2462
LiDAR
2463
MILLIMETER WAVE
2464
ULTRASONIC WAVE
2465
IMU
2466
GNSS
2467
MoPU
2468
TEMPERATURE
2469
2470
SoCBox
2490
COOLING MEANS
. . .
COOLING MEANS
2480
COOLING EXECUTION APPARATUS
INFORMATION ACQUISITION UNIT
2482
COOLING EXECUTION UNIT
2484
MODEL STORAGE UNIT
2486
PREDICTION UNIT
2488

FIG.65

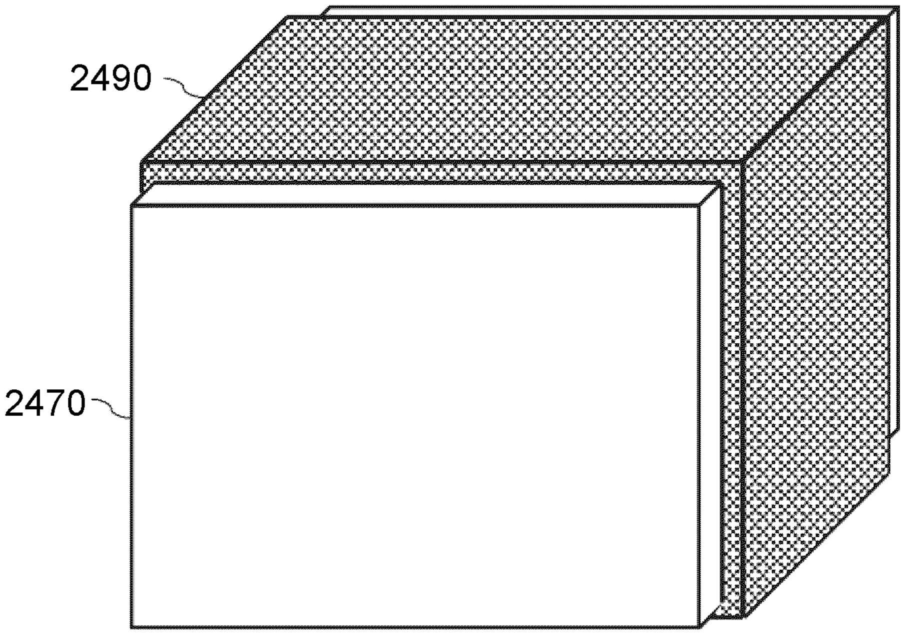

FIG.66

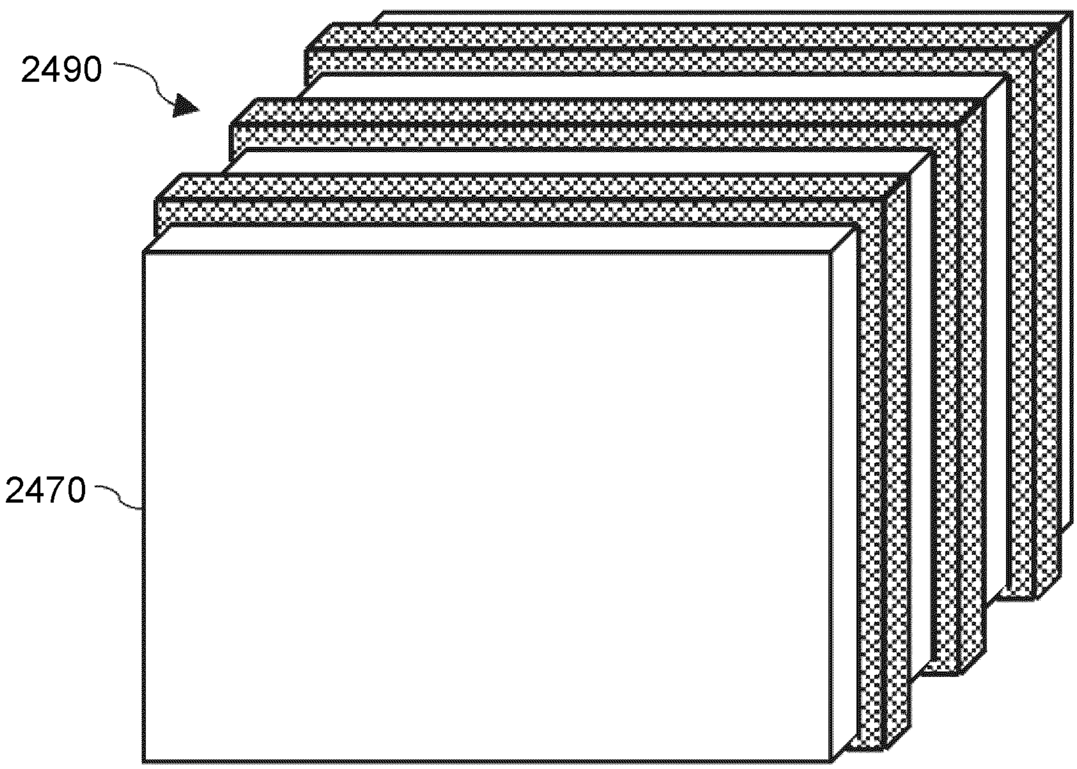

FIG.67

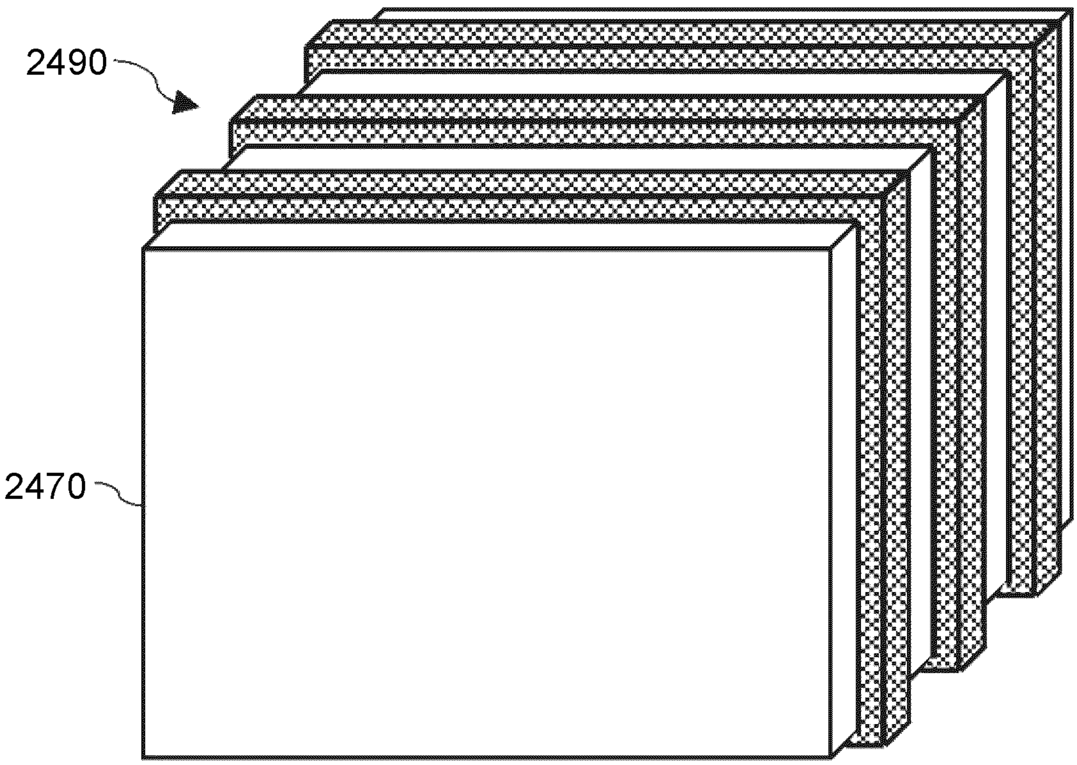

FIG.68

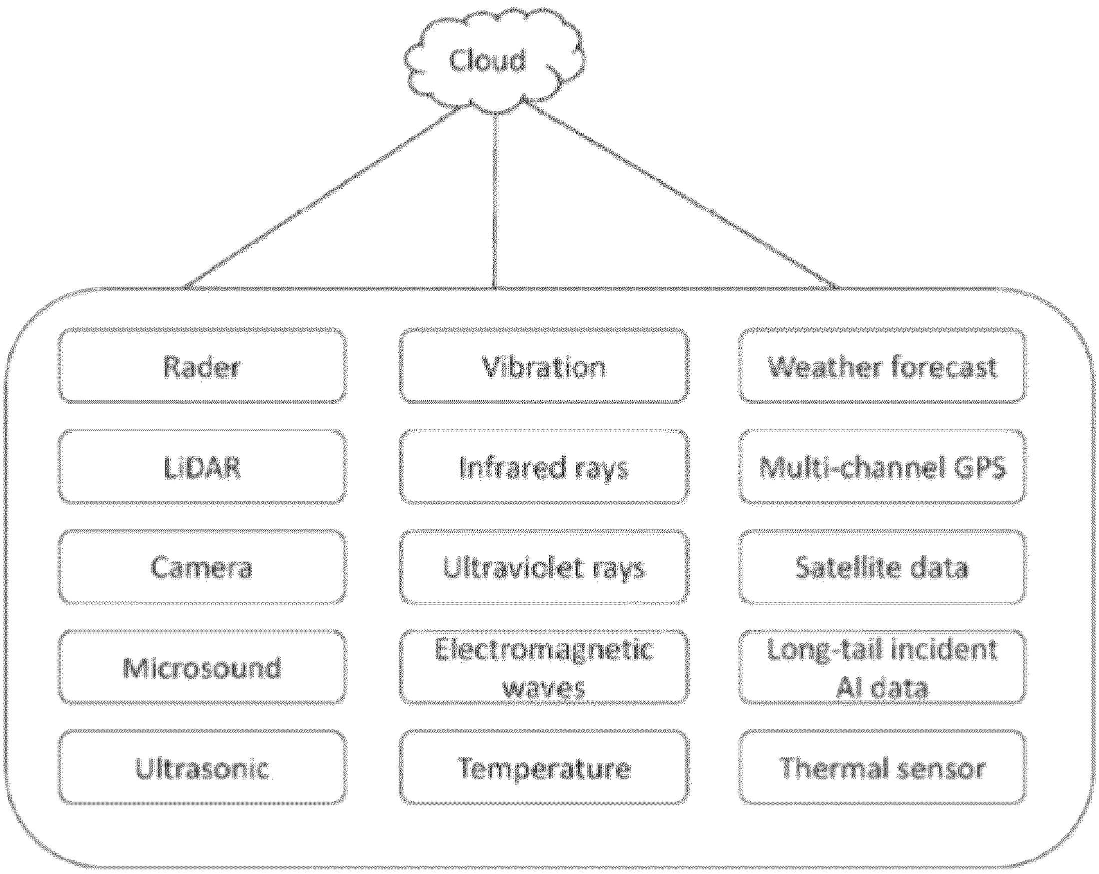
Cloud
Rader
Vibration
Weather forecast
LiDAR
Infrared rays
Multi-channel GPS
Camera
Ultraviolet rays
Satellite data
Microsound
Electromagnetic waves
Long-tail incident AI data
Ultrasonic
Temperature
Thermal sensor

FIG.69

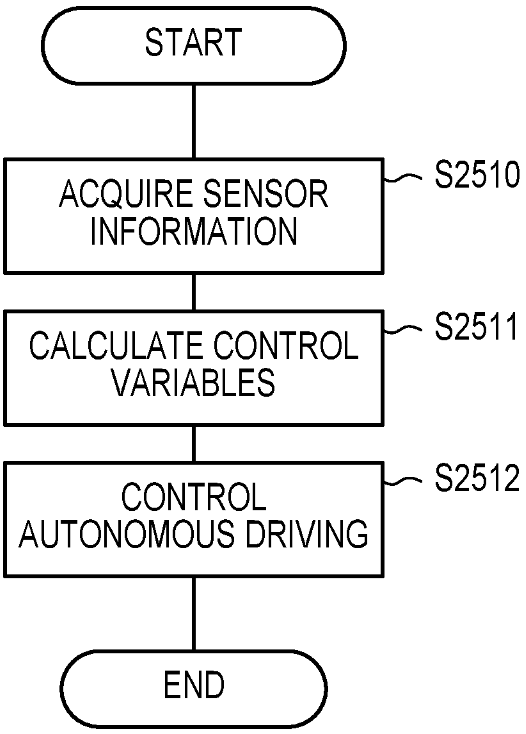
START
ACQUIRE SENSOR INFORMATION
S2510
CALCULATE CONTROL VARIABLES
S2511
CONTROL AUTONOMOUS DRIVING
S2512
END

FIG.70

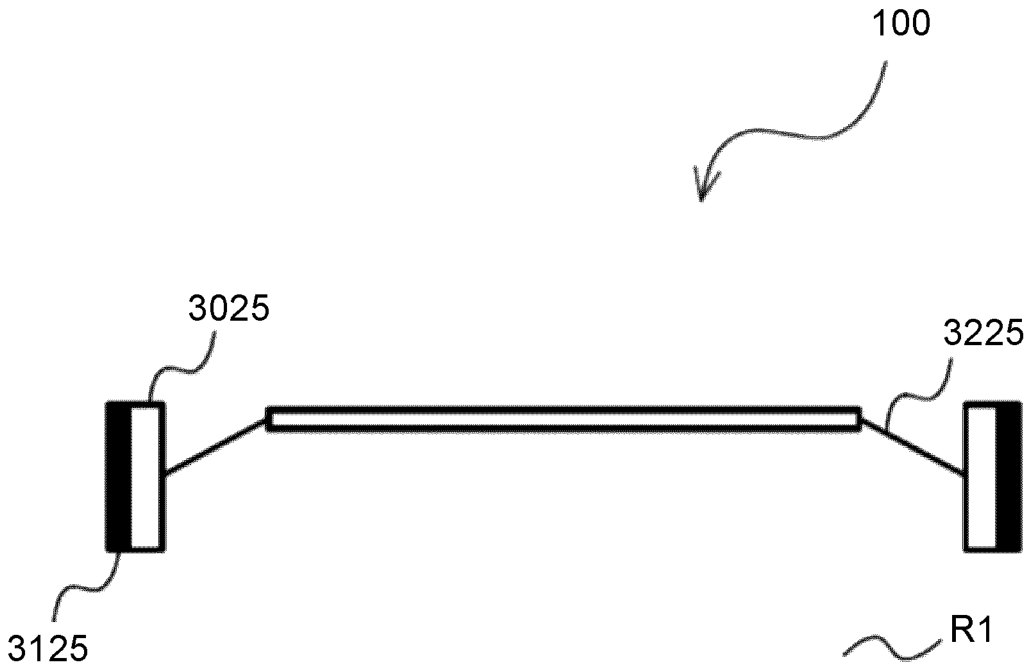

FIG.71

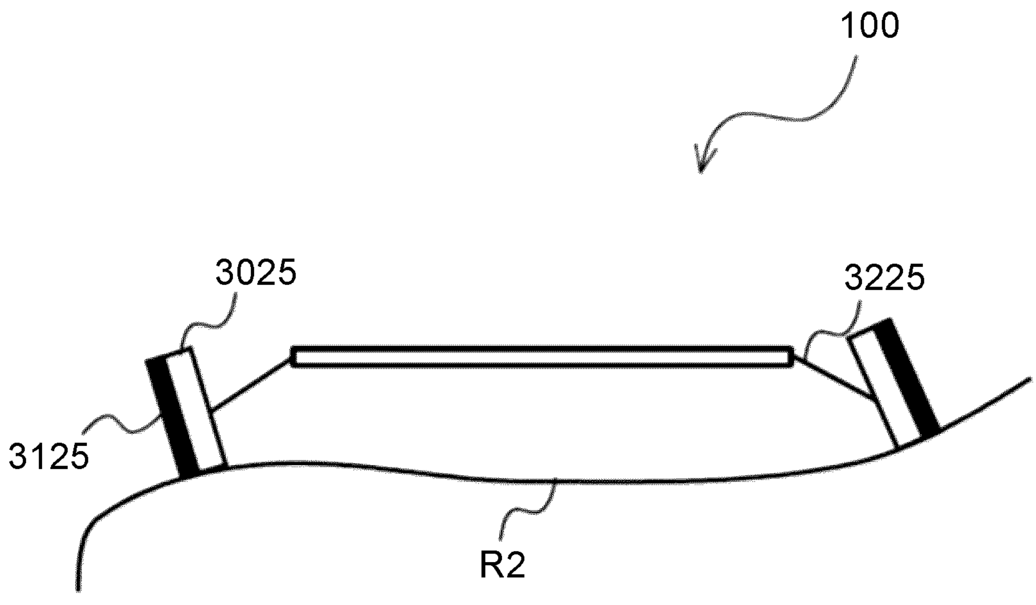

FIG.72

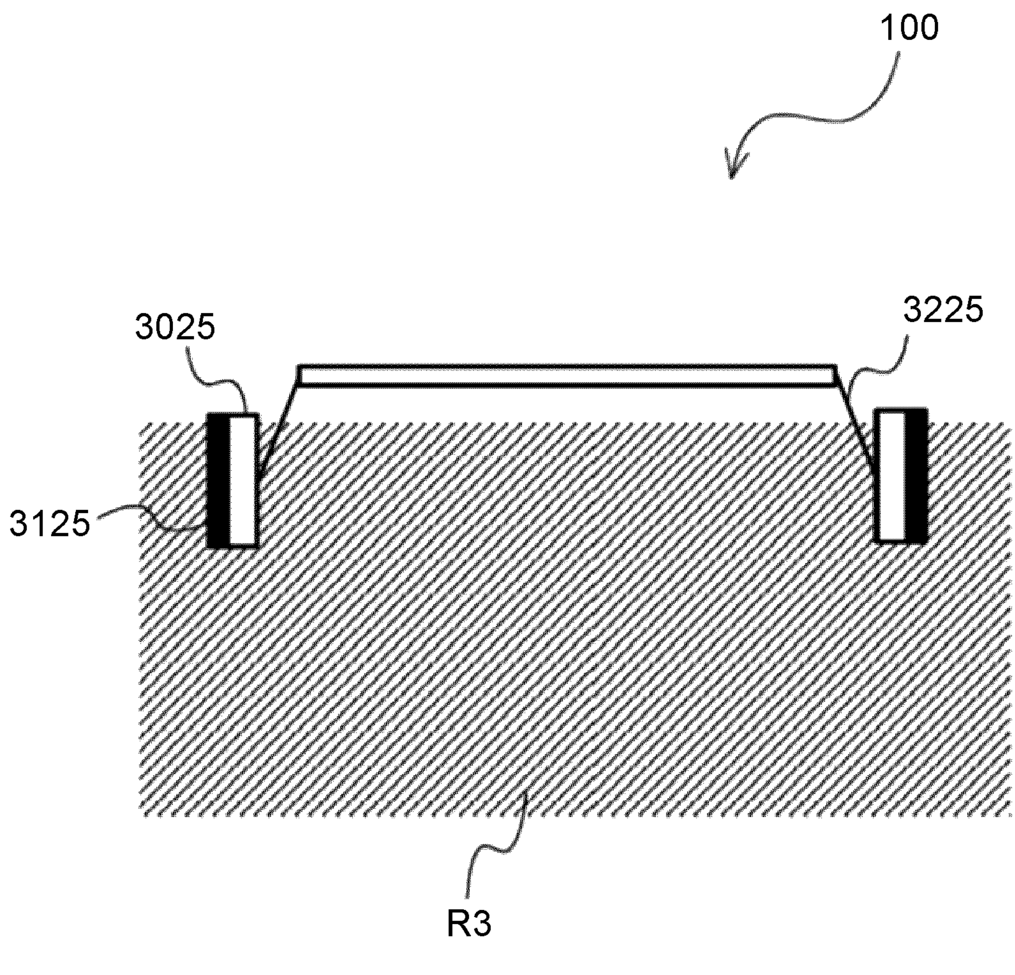

FIG.73

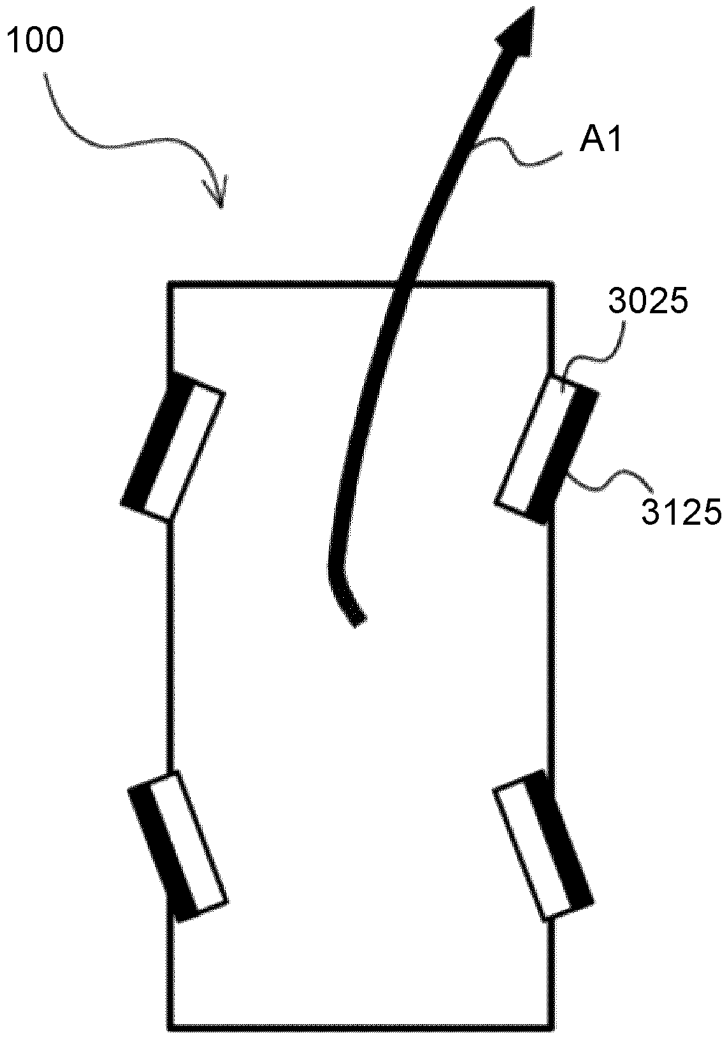

FIG.74

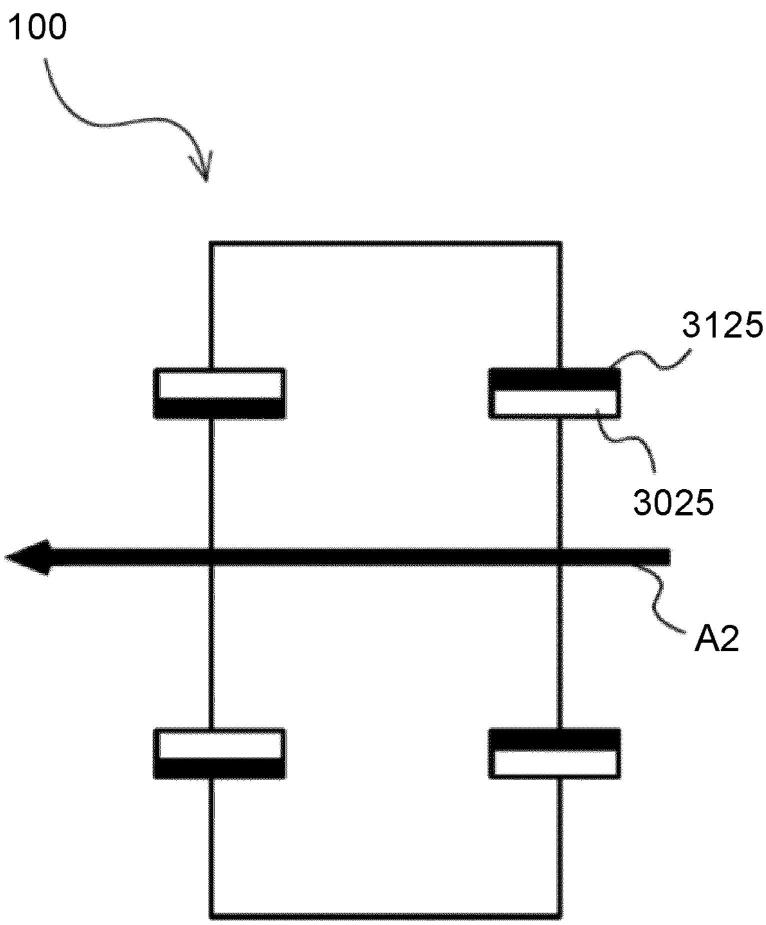

FIG.75

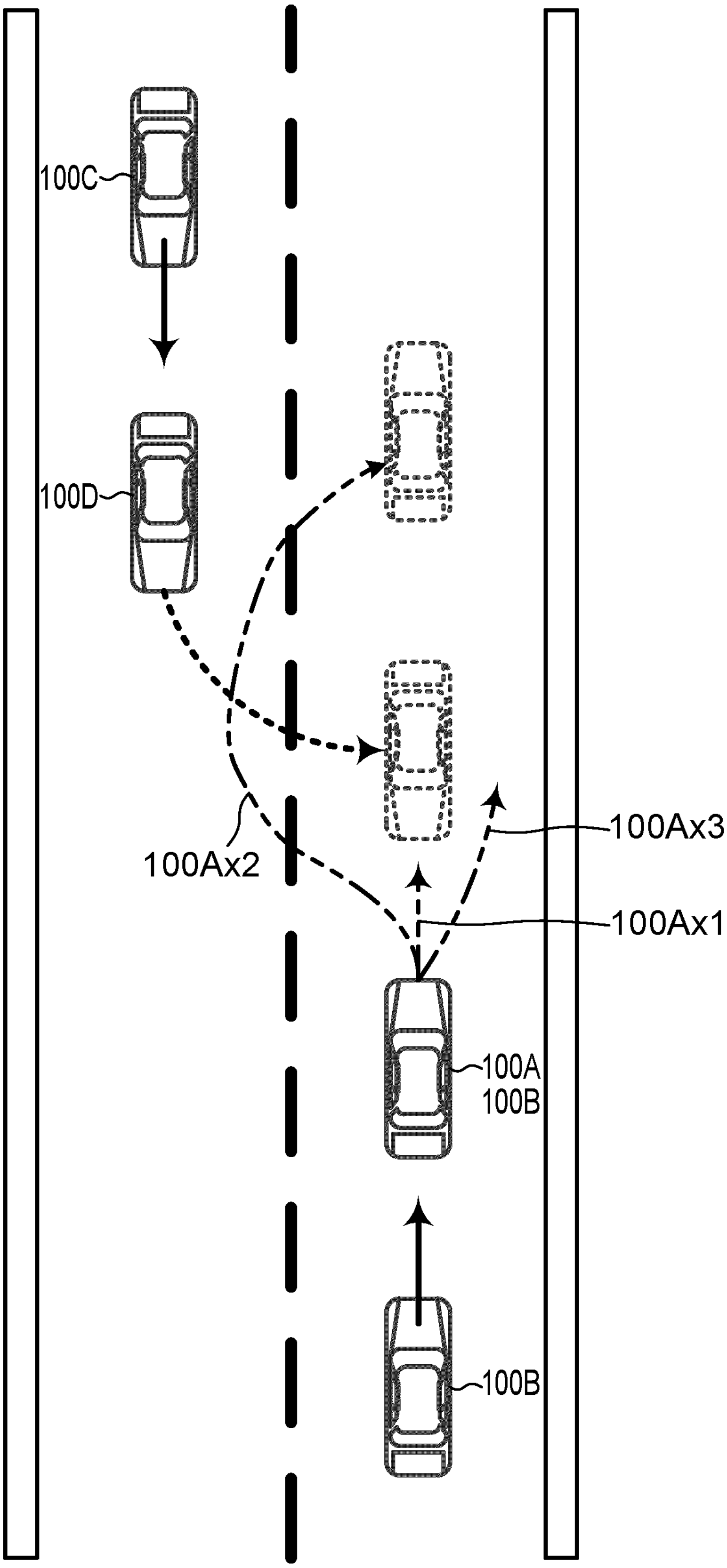

FIG.76

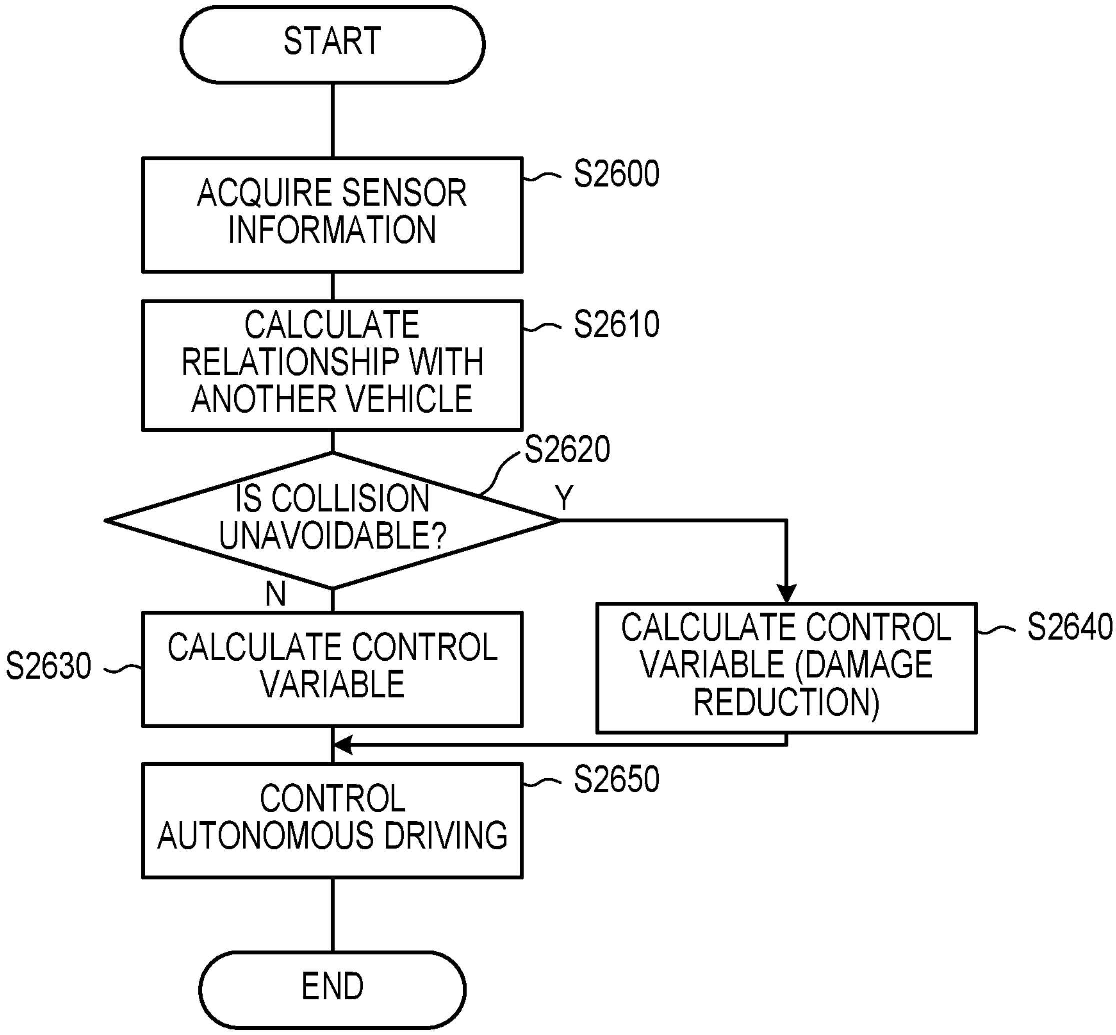
START
ACQUIRE SENSOR INFORMATION
S2600
CALCULATE RELATIONSHIP WITH ANOTHER VEHICLE
S2610
S2620
IS COLLISION UNAVOIDABLE?
Y
N
CALCULATE CONTROL VARIABLE
S2630
CALCULATE CONTROL VARIABLE (DAMAGE REDUCTION)
S2640
CONTROL AUTONOMOUS DRIVING
S2650
END

FIG.77

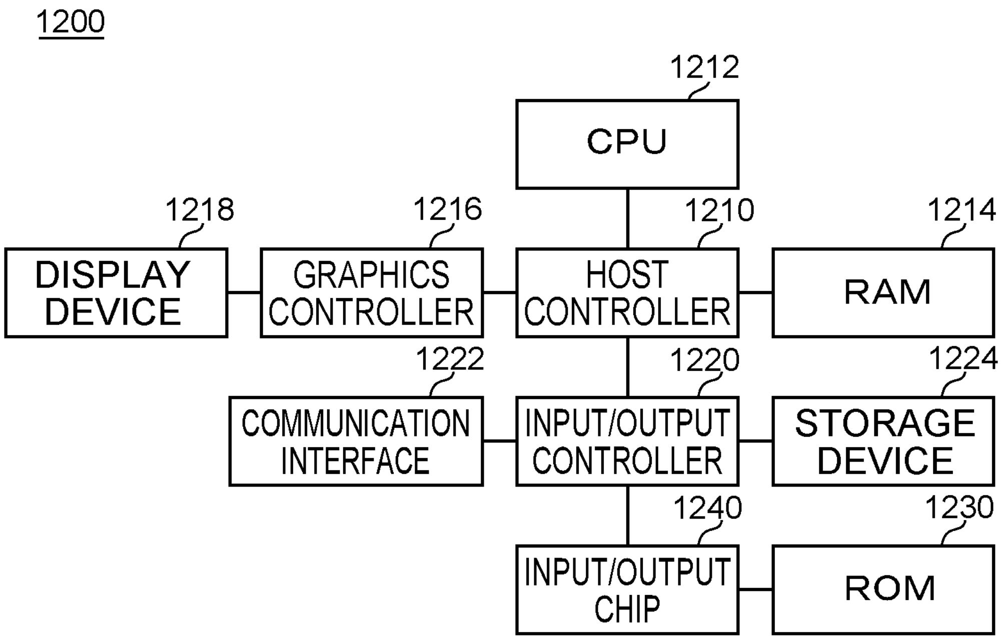
1200
1212
CPU
1218
1216
1210
1214
DISPLAY DEVICE
GRAPHICS CONTROLLER
HOST CONTROLLER
RAM
1222
1220
1224
COMMUNICATION INTERFACE
INPUT/OUTPUT CONTROLLER
STORAGE DEVICE
1240
1230
INPUT/OUTPUT CHIP
ROM

## INTERNATIONAL SEARCH REPORT

International application No.
**PCT/JP2023/038227**

**A. CLASSIFICATION OF SUBJECT MATTER**

***B60W 30/02***(2012.01)i; ***B60G 3/00***(2006.01)i; ***B60L 15/20***(2006.01)i; ***B60W 10/08***(2006.01)i; ***B60W 10/22***(2006.01)i; ***B60W 30/08***(2012.01)i; ***B60W 30/09***(2012.01)i; ***B60W 30/095***(2012.01)i; ***B60W 40/00***(2006.01)i; ***B60W 40/02***(2006.01)i; ***B60W 40/04***(2006.01)i; ***B60W 40/06***(2012.01)i; ***B60W 50/14***(2020.01)i; ***B60W 60/00***(2020.01)i; ***B62D 7/15***(2006.01)i; ***G01B 11/00***(2006.01)i; ***G01C 3/06***(2006.01)i; ***G01C 21/34***(2006.01)i; ***G01P 13/00***(2006.01)i; ***G05D 1/43***(2024.01)i; ***G06T 7/00***(2017.01)i; ***G06T 7/174***(2017.01)i; ***G06T 7/20***(2017.01)i; ***G06T 7/215***(2017.01)i; ***G06T 7/593***(2017.01)i; ***G06T 7/70***(2017.01)i; ***G06V 10/80***(2022.01)i; ***G06V 10/94***(2022.01)i; ***G06V 20/58***(2022.01)i; ***G08G 1/09***(2006.01)i; ***G08G 1/0968***(2006.01)i; ***G08G 1/16***(2006.01)i; ***H01L 23/473***(2006.01)i; ***H04N 7/18***(2006.01)i; ***H04N 23/45***(2023.01)i; ***H04N 23/60***(2023.01)i; ***H04N 23/61***(2023.01)i; ***H04N 23/66***(2023.01)i; ***H05K 7/20***(2006.01)i

FI: B60W30/02; G06T7/70 A; G06T7/70 Z; B60W60/00; G01C21/34; G08G1/0968; G06T7/20; G08G1/16 C; G01B11/00 H; G01C3/06 110V; G01P13/00 E; G06T7/00 650B; H01L23/46 Z; H05K7/20 D; B62D7/15 A; B60G3/00; B60W40/06; B60W10/08; B60W10/22; B60L15/20 S; B60W40/02; B60W30/095; H04N7/18 J; G06V20/58; G06T7/00 650Z; H04N23/66; H04N7/18 K; H04N7/18 E; H04N23/60; G06T7/00 650; G06T7/20 100; G01B11/00 A; G05D1/02 H; G08G1/09 H; B60W30/09; B60W50/14; G06T7/00 350B; G08G1/16 D; H04N23/61; H04N23/45; B60W40/04; G06V10/80; G06T7/215; G06T7/70 B; G06T7/593; G06T7/174; G06V10/94; G06T7/20 300Z; B60W30/08; H04N23/60 500; B60W40/00

According to International Patent Classification (IPC) or to both national classification and IPC

**B. FIELDS SEARCHED**

Minimum documentation searched (classification system followed by classification symbols)

B60W10/00-10/30; B60W30/00-60/00; G08G 1/00-99/00; G01C21/00-21/36; G01C23/00-25/00; G06T 7/00- 7/90

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

☑ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **20 December 2023** | **09 January 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

INTERNATIONAL SEARCH REPORT

International application No.
PCT/JP2023/038227

C. DOCUMENTS CONSIDERED TO BE RELEVANT

| Category* | Citation of document, with indication, where appropriate, of the relevant passages | Relevant to claim No. |
|---|---|---|
| X | WO 2021/198775 A1 (MOBILEYE VISION TECHNOLOGIES LTD.) 07 October 2021 (2021-10-07) paragraphs [0072]-[0131], fig. 1-3C | 1, 3, 37-44, 47, 50, 109, 133, 138-139, 141-142 |
| A | paragraphs [0072]-[0131], fig. 1-3C | 2, 4-36, 45-46, 48-49, 51-108, 110-132, 134-137, 140 |
| A | US 2020/0374470 A1 (SAMSUNG ELECTRONICS CO., LTD.) 26 November 2020 (2020-11-26) paragraphs [0023]-[0136], fig. 1A-8B | 1-142 |
| A | JP 2022-23887 A (AVIGILON CORP.) 08 February 2022 (2022-02-08) paragraphs [0045]-[0089], fig. 1-3 | 1-142 |
| A | JP 2021-165914 A (TOYOTA MOTOR CORP.) 14 October 2021 (2021-10-14) paragraphs [0020]-[0089], fig. 1-8 | 1-142 |

Form PCT/ISA/210 (second sheet) (January 2015)

**INTERNATIONAL SEARCH REPORT**
**Information on patent family members**

International application No.
**PCT/JP2023/038227**

| Patent document cited in search report | Publication date (day/month/year) | Patent family member(s) | Publication date (day/month/year) |
|---|---|---|---|
| WO 2021/198775 A1 | 07 October 2021 | US 2023/0127230 A1 | |
| | | CN 115735168 A | |
| US 2020/0374470 A1 | 26 November 2020 | WO 2019/098567 A1 | |
| | | KR 10-2019-0055582 A | |
| JP 2022-23887 A | 08 February 2022 | US 2018/0157939 A1 paragraphs [0070]-[0116], fig. 1-3 | |
| | | US 2020/0320356 A1 | |
| | | WO 2018/102919 A1 | |
| | | CA 3000127 A1 | |
| | | KR 10-2019-0099443 A | |
| | | CN 110235138 A | |
| | | AU 2022252799 A1 | |
| JP 2021-165914 A | 14 October 2021 | US 2021/0312199 A1 paragraphs [0026]-[0096], fig. 1-8 | |
| | | CN 113496201 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2022035198 A
- JP 2022170165 A
- JP 2022172777 A
- JP 2022175679 A
- JP 2022175698 A
- JP 2022181362 A
- JP 2022182131 A
- JP 2022186040 A
- JP 2022187648 A
- JP 2022187649 A
- JP 2022189546 A
- JP 2022209070 A
- JP 2023000321 A
- JP 2023036967 A
- JP 2023036968 A
- JP 2023036969 A
- JP 2023036972 A
- JP 2023036973 A
- JP 2023036974 A
- JP 2023036976 A
- JP 2023036977 A
- JP 2023059411 A
- JP 2023068062 A
- JP 2023069618 A
- JP 2023070394 A
- JP 2023075259 A
- JP 2023076253 A
- JP 2023076261 A
- JP 2023076943 A
- JP 2023076944 A
- JP 2023080353 A
- JP 2023083452 A
- JP 2023084121 A
- JP 2023084860 A
- JP 2023104424 A